## Europäisches Patentamt

## European Patent Office

## Office européen des brevets

(11) Publication number: **0 284 820**

**A2**

# EUROPEAN PATENT APPLICATION

(21) Application number: **88103400.3**

(51) Int. Cl.⁴: **H01L 23/48 , H01L 23/14**

(22) Date of filing: **04.03.88**

ADDITIONAL PRIORITIES:22.02.88 JP 38863
22.02.88 JP 38864 22.02.88 JP 38865.

(30) Priority: 04.03.87 JP 49584/87
05.03.87 JP 50936/87
18.03.87 JP 63497/87
18.03.87 JP 63498/87
19.03.87 JP 65208/87
19.03.87 JP 65209/87
20.03.87 JP 66484/87
20.03.87 JP 66485/87
26.03.87 JP 71977/87
26.03.87 JP 71978/87
26.03.87 JP 71979/87
31.03.87 JP 79007/87
31.03.87 JP 79008/87
31.03.87 JP 79009/87
02.04.87 JP 82037/87
02.04.87 JP 82038/87
02.04.87 JP 82039/87
22.02.88 JP 38860/87
22.02.88 JP 38861/87
22.02.88 JP 38862/87

(43) Date of publication of application:
05.10.88 Bulletin 88/40

(84) Designated Contracting States:
**DE FR GB IT NL**

(71) Applicant: **CANON KABUSHIKI KAISHA**
**30-2, 3-chome, Shimomaruko**
**Ohta-ku Tokyo(JP)**

(72) Inventor: **Yoshizawa, Tetsuo**
**2224-1-208, Hino-cho Konan-ku**
**Yokohama-shi Kanagawa-ken(JP)**
Inventor: **Nishida, Hideyuki**
**12-21, Chiyogaoka 4-chome Asao-ku**
**Kawasaki-shi Kanagawa-ken(JP)**
Inventor: **Imaizumi, Masaaki**
**13-9-101, Todoroki 2-chome Setagaya-ku**
**Tokyo(JP)**
Inventor: **Ichida, Yasuteru**
**4-20, Tsurukawa 2-chome**
**Machida-shi Tokyo(JP)**
Inventor: **Konishi, Masaki**
**3649-103, Kokubu**
**Ebina-shi Kanagawa-ken(JP)**
Inventor: **Kondo, Hiroshi**
**30-5, Chigusadai Midori-ku**
**Yokohama-shi Kanagawa-ken(JP)**
Inventor: **Sakaki, Takashi**
**1-1, Fujimi 1-chome Chiyoda-ku**
**Tokyo(JP)**

(74) Representative: **Grupe, Peter, Dipl.-Ing. et al**
**Patentanwaltsbüro**
**Tiedtke-Bühling-Kinne-Grupe-Pellmann-Grams-Struif-Winter-Roth Bavariaring 4**
**D-8000 München 2(DE)**

(54) **Electrically connecting member, and electric circuit member and electric circuit device with the connecting member.**

(57) An element for use in electrical connection comprises a holding member (125) having an insulator (111) and metallic powder dispersed in said insulator and a conductive member (107) laid in said holding member said conductive member has an end which is exposed on the surface of one side of said holding member and another end which is exposed on the surface of the other side of said holding member.

FIG. 9B

## Electrically Connecting Member, and Electric Circuit Member and Electric Circuit Device with the Connecting Member

### BACKGROUND OF THE INVENTION

#### Field of the Invention

The present invention relates to an electrically connecting member for electrically connecting between electric circuit parts, and to an electric circuit member and an electric circuit device using the connecting member.

#### Related Background Art

Hitherto, various methods have been known for constructing an electrical circuit member by electrically connecting a plurality of electric circuit components. These methods are exemplarily shown below.

#### (1) Wire bonding method

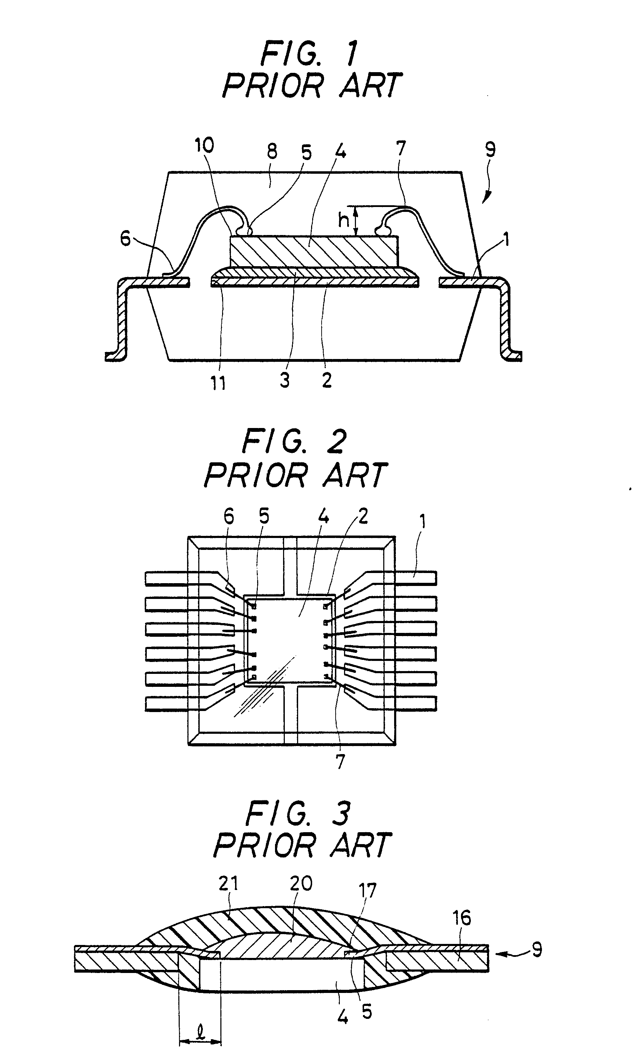

Figs. 1 and 2 show a typical example of a semiconductor device having components connected and sealed by wire bonding method. The wire bonding method will be explained hereinunder with reference to Figs. 1 and 2.

According to the wire bonding method, a semiconductor element 4 is fixed to and supported by an element mounting portion 2 by means of, for example, an Ag paste 3. Subsequently, the bonding portions 5 of the semiconductor element 4 and the desired connecting portions 6 of a lead frame 1 are bonded through an ultra-fine metallic wires 7 such as of gold.

After the connection is completed, the semiconductor element 4 and the lead frame 1 are sealed by means of a resin 8 and, thereafter, the unnecessary portion of the lead frame 1 extending outward from the sealing resin is cut and bent, whereby a semiconductor device 9 is obtained.

#### (2) TAB (Tape Automated Bonding) Method (see, for example, Japanese Patent Unexamined Publication No. 59-139636)

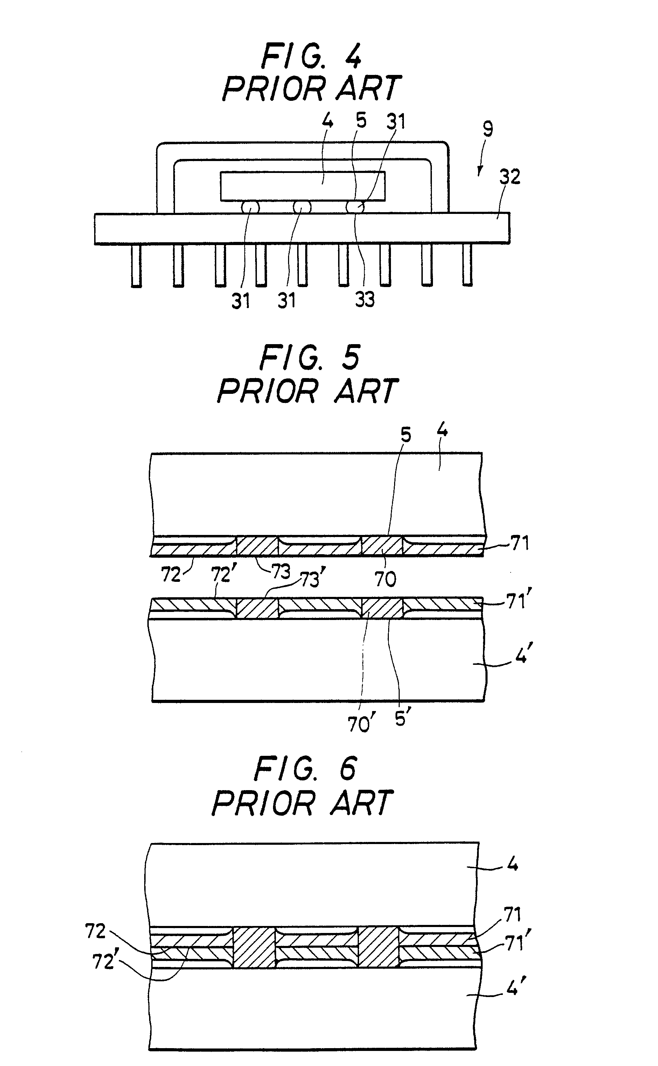

Fig. 3 shows a typical example of a semiconductor device having elements connected and sealed by TAB method. Briefly, this method is an automatic bonding method making use of tape carrier system. Referring to Fig. 3, after the carrier film substrate 16 and a semiconductor element 4 are located, the inner lead portion 17 of the carrier film substrate 16 and the connecting portion 5 of the semiconductor element 4 are heat-bonded. Thereafter, the inner lead 17 and the semiconductor element 4 are sealed by resins 20 and 21.

#### (3) CCB (Controlled Collapse Bonding) Method (see, for example, Japanese Patent Examined Publication No. 42-2096 and Japanese Patent Unexamined Publication No. 60-57944)

Fig. 4 shows a typical example of a semiconductor device having elements connected and sealed by CCB method. This method, which also is referred to as flip chip bonding method, will be explained with reference to Fig. 4. A semiconductor element 4, which is beforehand provided with solder bumps 31, are located and placed on a circuit board 32. Thereafter, the solder is heated and molten so that the semiconductor element 4 is connected to the circuit board 32. Then, after washing away the flux, the semiconductor element 4 is sealed so that a semiconductor device 9 is obtained.

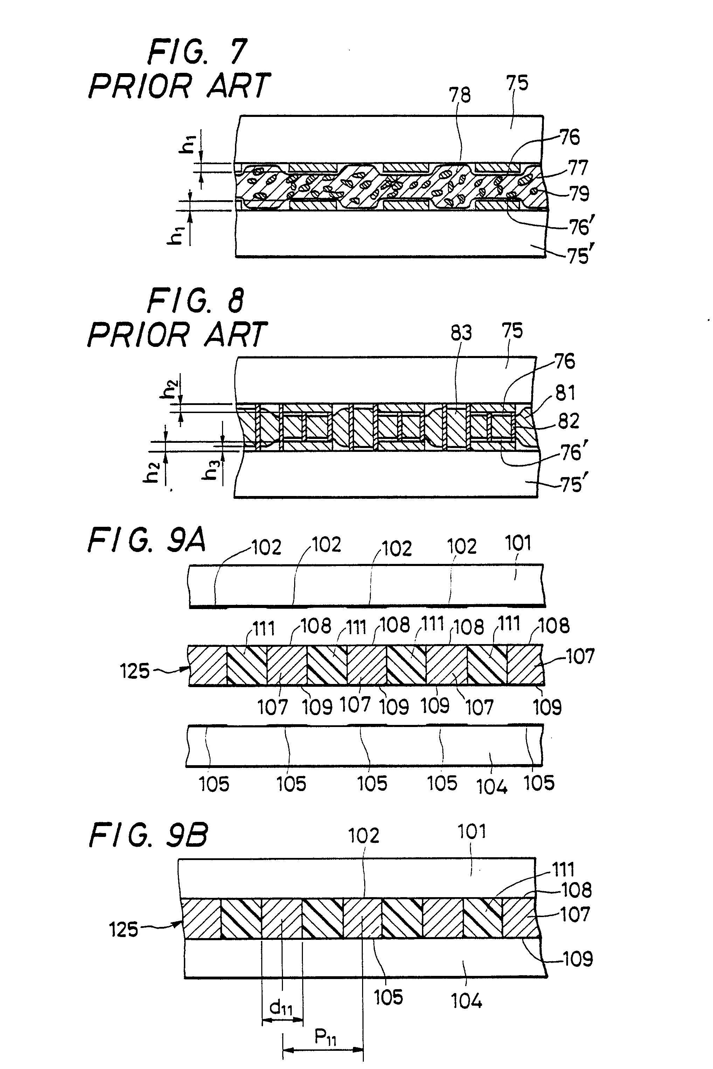

#### (4) Method Illustrated in Figs. 5 and 6

An insulating film 71 of, for example, polyimide is formed on the portion of a first semiconductor element 4 other than the connecting portion 5, while a metallic member 70 such as of Au is placed on the connecting portion 5. Then, the exposed surfaces 73, 72 of the metallic member 70 and the insulating film 71 are flattened. Similarly, an insulating film 71' of, for example, polyimide is formed on the portion of a second semiconductor element 4' other than the connecting portion 5', while a metallic member 70' such as of Au is placed on the connecting portion 5. Then, the exposed surfaces 73', 72' of the metallic member 70' and the insulating film 71' are flattened. Thereafter, the first semiconductor device 4 and the second semiconductor device 4' are located with respect to each other as shown in Fig. 6 and heat and pressure are applied to both semiconductor devices, whereby the connecting portions 5 and 5' of the first and second semiconductor elements 4 and 4' are connected to each other through the metallic members 70, 70'.

## (5) Method Illustrated in Fig. 7

A first circuit board 75 and a second circuit board 75′ are located with respect to each other through the intermediary of an anisotropic conductive film 78 having conductive particles dispersed in an insulating material 77. Then, pressure or pressure and heat are applied to the first and second circuit boards, whereby both circuit boards are connected at their connecting portions 76 and 76′

## (6) Method illustrated in Fig. 8

A first circuit board 75 and a second circuit board 75′ are located with respect to each other through the intermediary of an elastic connector 83 composed of an insulating material 81 and metallic wires of Fe. Cu or the like unidirectionally disposed in the insulating material 81. Then, pressure is applied to both circuit boards, whereby both circuit boards are connected at their connecting portions 76, 76′.

These known bonding methods, however, suffer from the following drawbacks.

## (1) Drawbacks of wire bonding method

(a) When the design is such that the connecting portion 5 of the semiconductor element 4 is within the area of the semiconductor element 4, the ultra-fine metallic wires 7, due to their extremely small diameters, tend to contact the outer peripheral portion 10 of the semiconductor element 4 or the outer peripheral region 11 of the element mounting portion 2. Such contact of the ultra-fine metallic wire 7 with the outer peripheral regions 10 and 11 causes a short-circuiting. Such a design also requires that the ultra-fine metallic wire 7 has an increased length, which in turn increases the risk for the ultra-fine wires 7 to be deformed during the transfer molding.

In order to obviate these problems, the connecting portions 5 have to be disposed on the restricted areas along the peripheral sides of the semiconductor element 4, with the result that the freedom in the circuit design is impaired.

(b) In forming a device by wire bonding method, it is necessary that the pitch of the connecting portions 5 on the semiconductor element 4 in terms of the distance between the centers of the adjacent connecting portions must be greater than a predetermined value, in order to eliminate any possibility of interference between adjacent ultra-fine metallic wires 7. This means that the maximum number of the connecting portions 5 is essentially determined by the size of the semiconductor element 4. According to the wire bonding method, therefore, the above-mentioned pitch is as large as about 0.2 mm, so that the number of the connecting portions 5 is undesirably limited.

(c) The height $\underline{h}$ of the ridge of the ultra-fine metallic wire 7 as measured from the connecting portion 5 of the semiconductor element 4 is usually from 0.2 to 0.4 mm. It is rather difficult to reduce this height to a value below 0.2 mm. Thus, the reduction of the thickness of the whole device is difficult to achieve.

(d) Wire bonding is generally time-consuming. Thus, an impractically long time is required particularly when the number of connecting points is large, resulting in a reduction in the production efficiency.

(e) The ultra-fine metallic wire 7 tends to be deformed or, in the worst case, broken when the transfer molding condition is exceeded for any reason.

(f) At each connecting portion 5 on the semiconductor element 4 is exposed Aℓ which is not alloyed with the ultra-fine metallic wire 7. This increases the tendency for Aℓ to be corroded, with the result that the reliability is impaired.

## (2) Drawbacks of the TAB Method

(a) If the design is such that the connecting portion 5 of the semiconductor element 4 is within the area of the semiconductor element 4, the length $t$ of the inner lead 17 of the carrier film board 16 is increased so that the inner lead 17 becomes liable to deform, with the result that the connection of the inner lead 17 to the desired connecting portion 5 is failed or the inner lead 17 contacts a portion of the semiconductor element 4 other than the connecting portion 5. In order to obviate this problem, it is necessary that the connecting portion 5 of the semiconductor element 4 is positioned on a peripheral portion of the semiconductor element 4, which undesirably restricts the freedom in design.

(b) The pitch of the connecting portions on the semiconductor element 4 has to be as large as 0.09 to 0.15 mm also in the case of the B method. Therefore, it is difficult to increase the number of connecting portions, as in the case of wire bonding method as explained in (2)(b) above.

(c) In order to prevent the inner lead portion 17 of the carrier film board 16 from contacting any portion of the semiconductor element 4 other than the connecting portion, the inner lead 17 is strictly required to have a predetermined connecting form, resulting in a raised production cost.

(d) In order to connect the connecting portions 5 of the semiconductor element 4 and the inner leads 17, it is necessary that gold bumps be provided either on the connecting portions 5 of the semiconductor element or on the inner lead 17, so that the cost is raised uneconomically.

### (3) Drawbacks of CCB Method

(a) Cost is raised due to the necessity for formation of solder bumps 31 on the connecting portions 5 of the semiconductor element 4. A too large amount of the solder bump causes bridging between adjacent solder bumps, while a to small amount of solder bump may cause insufficient electrical connection between the connecting portion 5 of the semiconductor element 4 and the connecting portion 33 of the board 32, thus impairing the reliability of the electrical connection. In addition, the reliability of the electrical connection is influenced by the amount and shape of the solder bump. In this regard, a reference is to be made to Technical Report of Brazing Technic Association No. 017-'84, issued from Brazing Technic Association. The fact that the amount of the solder bump affects the reliability of the electrical connection means that the amount of the solder bump has to be delicately controlled.

(c) When the solder bumps 31 are located within the area of the semiconductor element 4, it is very difficult to visually check whether the connection has been achieved in good manner.

(d) The semiconductor element exhibits inferior heat radiation characteristics. In this regard, a reference may be made to Electronic Packaging Technology 1987, 1 (Vol. 3, No. 1) P. 66 - 71, NIKKEI MICRODEVICES, May 1986, pp 97 - 108. Various measures have to be taken for the purpose of improving the heat radiation characteristic of the product.

### (4) Drawbacks of Method Illustrated in Figs. 5 and 6

(a) The number of steps of production process is increased and the production cost is raised correspondingly due to the necessity for flattening the exposed surface 72 of the insulating film 71 and the exposed surface 73 of the metallic member 70, as well as the exposed surface 72' of the insulating film 71' and the exposed surface 73' of the metallic member 70'.

(b) The state of connection between the metallic members 70 and 70' is impaired if there is any irregularity or unevenness in the exposed surface 72 of the insulating film 71 and the exposed surface 73 of the metallic member 70, or the exposed surface 72' of the insulating film 71' and the exposed surface 73' of the metallic member 70'. In consequence, the reliability of the electrical connection is reduced.

### (5) Drawbacks of Method Illustrated in Fig. 7

(a) Bonding is achieved by applying pressure to the bonding portions 76, 76' after locating two members. It is very difficult to apply this pressure uniformly on all the bonding portions. In consequence, the states of connection largely fluctuate, with the result that the value of contact resistance also fluctuates largely. Consequently, the reliability of the electrical connection is impaired. In addition, this bonding method is not suited to the production of devices which requires electric current to be supplied at a large rate, because the supply of such a large electric current inevitably causes a large heat generation.

(b) The fluctuation of the resistance value is inevitable due to the orientation of the conductive particles 79 of the anisotropic conductive film 78, even when the pressure is uniformalized. In consequence, the reliability of the connection is impaired, and the product produced by this bonding method cannot have a large electric current capacity.

(c) The value of the resistance between adjacent bonding portions is reduced when the pitch of the bonding portions is decreased. Thus, this bonding method is not suited to a high connecting density.

(d) The resistance value varies depending on the amount of fluctuation of the projection height $h_i$ of the bonding portions 76, 76' of the circuit boards 75, 75'. It is therefore necessary to accurately control the amount of fluctuation of the projection height $h_i$.

(e) When the anisotropic conductive film is used for the purpose of bonding between a semiconductor element and a circuit board or between a first semiconductor element and a second semiconductor element, a problem is encountered in that the cost is raised due to the necessity of provision of bumps on the bonding portions of the semiconductor devices, in addition to the drawbacks (a) to (d) mentioned above.

## (6) Drawbacks of Method Illustrated in Fig. 8

(a) A specific pressing jig is required for applying the bonding pressure.

(b) The electric resistance across the points of contact between the metallic wire 82 of the elastic connector 83 and the bonding portion 76 of the first circuit board 75, as well as between the metallic wire 82 of the elastic connector 83 and the bonding portion 76' of the first circuit board 75', varies depending on the pressure applied and the states of the contact surfaces. Thus, the reliability of the connection is not so high.

(c) The metallic wires 82 of the elastic connector 83 are rigid. When the pressing force is large, therefore, the risk is increased for the surfaces of the first and the second circuit boards 75 and 75' to be broken. On the other hand, a too small pressing force impaires the reliability of the connection.

(d) The values of electric resistance at the contact portions, as well as the tendency for the mechanical breakdown, are largely affected by fluctuation in the amount $h_2$ of projections of the bonding portions 76, 76' of the circuit boards 75, 75', as well as by fluctuation in the amount $h_3$ of projection of the metallic wire 82 of the elastic connector 83. It is therefore necessary to take a suitable countermeasure for eliminating such fluctuation in the projection amounts.

(e) Drawbacks similar to (a) to (d) above are encountered also when the elastic connector is used for the bonding between a semiconductor element and a circuit board or for the bonding between a first semiconductor element and a second semiconductor element.

## SUMMARY OF THE INVENTION

It is an object of the present invention to solve the above-mentioned problems and to provide a low cost electrically connecting member with a high density and a high reliability, an electric circuit member and an electric circuit device using the connecting member.

The present invention may provide highly concentrated multiple connections and an improvement in various properties such as a thermal property as well as replacement of connection from the conventional connecting methods.

It is another object to provide an element for use in electrical connection comprising a holding member having an insulator and metallic powder dispersed in said insulator and a conductive member laid in said holding member said conductive member having an end which is exposed on the surface of one side of said holding member and another end which is exposed on the surface of the other side of said holding member.

It is a further object to provide an element for use in electrical connection comprising a holding member having an insulator and metallic fiber dispersed in said insulator and a conductive member laid in said holding member said conductive member having an end which is exposed on the surface of one side of said holding member and another end which is exposed on the surface of the other side of said holding member.

It is a further object to provide an element for use in electrical connection comprising a holding member having an insulator and metallic body laid in said insulator and a conductive member laid in said holding member said conductive member having an end which is exposed on the surface of one side of said holding member and another end which is exposed on the surface of the other side of said holding member.

It is a further object to provide an element for use in electrical connection comprising a holding member having an inorganic insulator and a conductive member laid in said holding member said conductive member having an end which is exposed on the surface of one side of said holding member and another end which is exposed on the surface of the other side of said holding member.

It is a further object to provide an element comprising a holding member a conductive member laid in said holding member said conductive member having one end which is exposed on the surface of one side of said holding member and another end which is exposed on the surface of the other side of said holding member a first electrical circuit member having a first connecting portion to which said one end of said conductive member is connected and a second electrical circuit member having a second connecting portion to which said another end of said conductive member is connected said first connecting portion and said one end and/or said second connecting portion and said another end being connected by alloying.

It is a further object to provide an electrical circuit device comprising a holding member a conductive member laid in said holding member said conductive member having one end which is exposed on the surface of one side of said holding member and another end which is exposed on the surface of the other side of said holding member a first electrical circuit member having a first connecting portion to which said one end of said conductive member is connected a second electrical circuit member having a second connecting portion to which said another end of said conductive member is connected and a sealing element for sealing at least one of said first electrical circuit member and said second electrical circuit member by laying therein.

It is a further object to provide an electrical circuit device comprising a holding member a conductive member laid in said holding member said conductive member having one end which is exposed on the surface of one side of said holding member and another end which is exposed on the surface of the other side of said holding member a first electrical circuit member having a first connecting portion to which said one end of said conductive member is connected a second electrical circuit member having a second connecting portion to which said another end of said conductive member is connected and a cap for capsealing at least one of said first electrical circuit member and said second electrical circuit member.

BRIEF DESCRIPTION OF THE DRAWINGS

Figs. 1 to 8 show examples of conventional techniques: Figs. 1 and 3 to 8 are cross-sectional views and Fig. 2 is a perspective plan view;

Figs. 9A and 9B show an embodiment of the invention: Fig. 9A shows a state before connection and Fig. 9B shows a state after connection;

Figs. 10A, 10B and 10C are views for explaining an example of a manufacturing process for an electrically connecting member used in said embodiment: Fig. 10A is a cross-sectional view, Fig. 10B is an oblique view, and Fig. 10C also is a cross-sectional view;

Figs. 11A and 11B show another embodiment: Fig. 11A is an oblique view and Fig. 11B is a cross-sectional view;

Fig. 12 is a cross-sectional view of still another embodiment;

Fig. 13 is a cross-sectional view of a further embodiment;

Figs. 14A and 14B show a still further embodiment: Fig. 14A is a cross-sectional view showing a state before connection and Fig. 148 is a cross-sectional view showing a state after connection;

Figs. 15A, 15B, 16A and 16B show said embodiment; Figs. 15A and 16A are oblique views thereof and Figs. 15B and 16B are cross-sectional views;

Figs. 17A and 17B show still another embodiment: Fig. 17A is an oblique view showing a state before connection and Fig. 17B is a cross-sectional view showing a state after connection;

Figs. 18A and 18B are cross-sectional views showing still another embodiment: Fig. 18A shows a state before connection and Fig. 18B shows a state after connection;

Figs. 19A and 19B show an electrically connecting member of a further embodiment: Fig. 19A is an oblique view and Fig. 19B is a cross-sectional view;

Figs. 20A, 20B and 20C show an example of a manufacturing process of an electrically connecting member of still another embodiment: Figs. 20A and 20C are cross-sectional views and Fig. 20B is an oblique view;

Figs. 21A and 21B show an electrically connecting member of another embodiment: Fig. 21A is an oblique view and Fig. 21B is a cross-sectional view;

Figs. 22A and 22B are cross-sectional views showing another embodiment: Fig. 22A shows a state before connection and Fig. 22B shows a state after connection;

Figs. 23A, 23B and 23C are views for explaining an example of a manufacturing process of an electrically connecting member for use in said embodiment: Fig. 23A is a cross-sectional view, Fig. 23B is an oblique view, and Fig. 23C is a cross-sectional view;

Figs. 24A and 24B show another embodiment: Fig. 24A is an oblique view and Fig. 24B is a cross-sectional view;

Figs. 25A and 25B show another embodiment: Fig. 25A is a cross-sectional view showing a state before connection and Fig. 25B is a cross-sectional view showing a state after connection;

Figs. 26A, 26B, 27A and 27B show said embodiment: Figs. 26A and 27A are oblique views and Figs. 26B and 27B cross-sectional views;

Figs. 28A and 28B show another embodiment: Fig. 28A shows a state before connection and Fig. 28B shows a state after connection;

Figs. 29A and 29B show an electrically connecting member of another embodiment: Fig. 29A is an oblique view and Fig. 29B is a cross-sectional view,

Figs. 30A, 30B and 30C show an example of a manufacturing process of an electrically connecting member in another embodiment: Figs. 30A and 30C are cross-sectional views and Fig. 30B is an oblique view;

Figs. 31A and 31B are cross-sectional views showing another embodiment: Fig. 31A shows a state before connection and Fig. 31B shows a state after connection;

Figs. 32A, 32B and 32C are views for explaining an example of a manufacturing process of an electrically connecting member for use in said embodiment: Fig. 32A is a cross-sectional view, Fig. 32B is an oblique view, and Fig. 32C is a cross-sectional view;

Figs. 33A and 33B show another embodiment: Fig. 33A is a cross-sectional view showing a state before connection and Fig. 33B is a cross-sectional view showing a state after connection;

Figs. 34A, 34B, 35A and 35B show said embodiment Figs. 34A and 35A are oblique views and Figs. 34B and 35B are cross-sectional views;

Figs. 36A and 36B show another embodiment: Fig. 36A is an oblique view showing a state before connection and Fig. 36B is a cross-sectional view showing a state after connection;

Figs. 37A and 37B are cross-sectional views showing another embodiment: Fig. 37A shows a state before connection and Fig. 37B shows a state after connection;

Figs. 38A and 38B show an electrically connecting member in another embodiment: Fig. 38A is an oblique view and Fig. 38B is a cross-sectional view;

Figs. 39A, 39B and 39C show an example of a manufacturing process of an electrically connecting member in another embodiment; Figs. 39A and 39C are cross-sectional views and Fig. 39B is an oblique view;

Figs. 40A and 40B are cross-sectional views showing another embodiment: Fig. 40A shows a state before connection and Fig. 40B shows a state after connection;

Fig. 41 is a cross-sectional view of an electric circuit device of the present invention sealed by a resin;

Figs. 42A, 42B and 42C are views for explaining an example of a manufacturing process of an electrically connecting member for use in said embodiment: Fig. 42A is a cross-sectional view, Fig. 42B is an oblique view and Fig. 42C is a cross-sectional view;

Figs. 43A and 43B show another embodiment: Fig. 43A is an oblique view and Fig. 43B is a cross-sectional view;

Figs. 44A and 44B are cross-sectional views showing another embodiment;

Figs. 45A and 45B are cross-sectional views showing another embodiment;

Figs. 46A and 46B show another embodiment: Fig. 46A is a cross-sectional view showing a state before connection and Fig. 46B is a cross-sectional view showing a state after connection;

Figs. 47A, 47B, 48A and 48B show said embodiment: Figs. 47A and 48A are oblique views and Figs. 47B and 48B are cross-sectional views;

Figs. 49A and 49B show another embodiment: Fig. 49A is an oblique view showing a state before connection and Fig. 49B is a cross-sectional view showing a state after connection;

Figs. 50A and 50B are cross-sectional view showing another embodiment: Fig. 50A shows a state before connection and Fig. 50B shows a state after connection;

Figs. 51A and 51B show an electrically connecting member in another embodiment: Fig. 51A is an oblique view and Fig. 51B is a cross-sectional view;

Figs. 52A, 52B and 52C show an example of a manufacturing process in another embodiment: Figs. 52A and 52C are cross-sectional views and Fig. 52B is an oblique view;

Fig. 53 is a cross-sectional view of an electric circuit device of the present invention sealed by a resin;

Figs. 54A and 54B show another embodiment: Fig. 54A is an oblique view and Fig. 54B is a cross-sectional view;

Figs. 55A and 55B are cross-sectional views showing another embodiment;

Figs. 56A and 56B are cross-sectional views showing another embodiment;

Figs. 57A and 57B show another embodiment: Fig. 57A is an oblique view showing a state before connection and Fig. 57B is a cross-sectional view showing a state after connection;

Fig. 58 is a cross-sectional view of an electric circuit device of the present invention sealed by a resin;

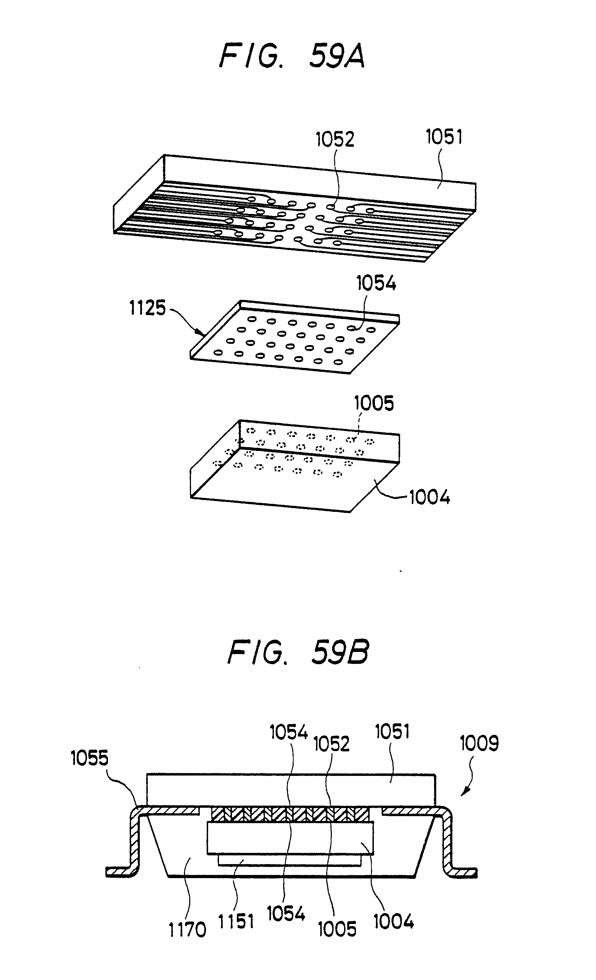

Figs. 59A and 59B show another embodiment: Fig. 59A is an oblique view and Fig. 59B is a cross-sectional view;

Figs. 60A and 60B are cross-sectional views showing another embodiment;

Figs. 61A and 61B are cross-sectional views showing another embodiment;

Figs. 62A and 62B show another embodiment: Fig. 62A is an oblique view showing a state before connection and Fig. 62B is a cross-sectional view showing a state after connection;

Fig. 63 is a cross-sectional view of an electric circuit device of the present invention sealed by a resin;

Figs. 64A and 64B show another embodiment: Fig. 64A is an oblique view and Fig. 64B is a cross-sectional view;

Figs. 65A and 65B are cross-sectional views showing another embodiment;

Figs. 66A and 66B are cross-sectional views showing another embodiment;

Figs. 67A and 67B show another embodiment: Fig. 67A is an oblique view showing a state before connection and Fig. 67B is a cross-sectional view showing a state after connection;

Figs. 68 is a cross-sectional view of an electric circuit device of the present invention sealed by a resin;

Figs. 69A and 69B show another embodiment: Fig. 69A is an oblique view and Fig. 69B is a cross-sectional view;

Figs. 70A and 70B are cross-sectional views showing another embodiment;

Fig. 71 is a cross-sectional view showing another embodiment;

Figs. 72A and 72B show another embodiment: Fig. 72A is an oblique view showing a state before connection and Fig. 72B is a cross-sectional view showing a state after connection;

Fig. 73 is a cross-sectional view of an electric circuit of the present invention sealed by a cap;

Figs. 74A and 74B show another embodiment: Fig. 74A is an oblique view and Fig. 74B is a cross-sectional view;

Fig. 75 is a cross-sectional view showing another embodiment;

Fig. 76 is a cross-sectional view showing another embodiment;

Figs. 77A and 77B show another embodiment: Fig. 77A is an oblique view showing a state before connection and Fig. 77B is a cross-sectional view showing a state after connection.

## DESCRIPTION OF THE PREFERRED EMBODIMENTS

According to the present invention, a first electric circuit component and a second electric circuit component are connected to each other through an electrical connecting member or electrical bonding intermediary.

Basically, the present invention provides an electric circuit device composed of a first electric circuit component provided with bonding portions, a second electric circuit component having bonding areas, and an electric bonding intermediary placed and connected between the first and second electric circuit components so as to attain electrical connection between the first and second electric circuit components at their bonding areas, wherein the electric bonding intermediary includes a pluralilty of conductive members of embedded in holding member in such a manner that they are electrically insulated from one another, with their one ends exposed in a first surface of the holding member facing the first electric circuit component while their other ends are exposed in a second surface of the holding member facing the second electric circuit component, the ends of the conductive members exposed in the same side as the first electric circuit component are connected to the bonding areas of the first electric circuit component, while the ends of the conductive members exposed in the same side as the second electric circuit component are connected to the bonding areas of the second electric circuit component.

The electric bonding intermediary may have a single-layered structure or may have a laminated structure composed of two or more layers.

[Electric Circuit Components Usable in Invention]

Examples of the electric circuit components suitably used in the invention are semiconductor devices or elements, circuit boards such as plastic circuit boards, ceramics circuit boards, and metallic circuit boards, and lead frames. Thus, the electric circuit device of the present invention is composed of a first electric circuit component which may be any one of the above-mentioned devices or circuit boards and a second electric circuit component which also may be any one of the above-mentioned devices or circuit boards.

It should be noted that one or more electrical circuit component to be connected to the electrical bonding intermediary may be provided on one of the surfaces of the holding member.

Thus, any type of electric parts having bonding areas are usable as the electric circuit component in the present invention, regardless of the number of the bonding areas, though the advantage brought about by the invention becomes more appreciable as the number of the bonding area is increased. It is also to be understood that there is no restriction in the positions of the bonding areas. It is to be noted, however, that the advantage of the present invention becomes more remarkable when the bonding areas are located in the inner portion of the electric circuit component.

[Conductive Member in Electric Bonding Intermediary Used in Invention]

The conductive member according to the invention includes, for example metallic material. Gold is used most suitably as the material of the metallic members of the electric bonding intermediary used in the present invention, but other metals or alloys can also be used satisfactorily, such as Ag, Be, Ca, Mg. Mo, Ni, W, Fe, Ti, In, Ta, Zn, Cu, Aℓ, Sn, Pb-Sn, and so forth.

Additionally, with regard to metallic member, the same metals or different metals may be present in the same electrical bonding intermediary. One of the metallic members of the electrical bonding intermediary, may be formed by the same metals or alloys, or different metals or alloys. Further, the material in which the organic and/on inorganic material is included in the metal may be used as a metallic member if it has the electrical conductivity. Still further, the conductive material combined with organic and inorganic materials may also used. It is to be noted that the super conductive material may be used as the conductive member.

The metallic member can have any desired cross-sectional shape such as circular, square of other shape.

The diameter or size of the metallic member also can be selected freely. For instance, the diameter is determined to be not smaller than 20 μm, taking into account the pitch of the bonding areas on the electric circuit components, through it may be determined to be not greater than 20 μm.

The exposed portion of the metallic member may be flush with the insulating holder or may be projected therefrom. The arrangement may be such that the metallic members project only at one side of the holder or at both sides thereof. The projected ends of the metallic members may be shaped in the form of bumps.

The pitch of the metallic members may be equal to or smaller than the pitch of the bonding areas of the electric circuit components. When the smaller pitch is adopted, the connection between the electric circuit component and the electric bonding intermediary can be attained without requiring precise location of these two members.

It is not always necessary that metallic member extends vertically through the insulating holder. In other words, the metallic members may extend slantwise from the end adjacent to the first electric circuit component to the end adjacent to the second electric circuit component.

[Holding Member of Electric Bonding Intermediary Used in the Invention]

The holding member of the electric bonding intermediary used in the present invention may include, for example, a member using electrically insulating material. The organic and inorganic material may be used as the electrically insulating material. The metallic material may also be used when it is treated to electrically insulate the conductive members each other. In addition, one kind or a plurality of kinds of powder, fiber or material having desired shape all of which comprise the inorganic or metallic material may be dispersed in the organic material. In contrast, one kind or a plurality of kinds of power, fiber or material having desired shape all of which comprise the organic or metallic material may be dispersed in the inorganic material. Furthermore, one kind or a plurality of kinds of powder, fiber or material having desired shape all of which comprise the organic or inorganic material may be dispersed in the metallic material. In case that the holding member comprises the metallic material, elecrically insulating material such as resin may be provided between the electrically conductive member and the holding member. For instance, an insulating resin as organic material can be used satisfactorily. The type of the insulating resin is not limited. Both thermosetting, ultraviolet curing resin and thermoplastic resins can be used equally well.

Examples of the resins suitably used are polyimide resin, polyphenylene sulfide resin, polyether sulfone resin, polyether imide resin, polysulfone resin, silicone reisn, fluororesin, polycarbonate resin, polydiphenylether resin, polybenzyl imidazole resin, phenol resin, urea resin, melamine resin, alkyd resin, epoxy resin, polyamideimide resin, polypropylene resin, polyvinyl chloride resin, polystyrene resin, methacrylate methyl, polyphenylene oxide, methacrylic resins, vinylidene chloride, and so forth.

It is advisable to use a resin having a superior heat conductivity so that the heat generated by the semiconductor device can be efficiently radiated. It is also preferred that the resin used as the material of the insulating holder has a thermal expansion coefficient which well approximates that of the circuit substrate so that any trouble attributable to thermal expansion and contraction may be eliminated, thus assuring high reliability of the product device.

[Examples of Electric Bonding Intermediary]

The electric bonding intermediary used in the present invention can have various forms as exemplarily shown in I to VI below.

I. First Example of Electric Bonding Intermediary

This electric bonding intermediary has a plurality of conductive member (to be referred "metallic members" hereinafter) embedded in an insulator. The metallic members are electrically insulated from one another by the material of the insulator. One ends of the metallic members are exposed in the face of the insulator adjacent to the first electric circuit component, while other ends are exposed in the face of the insulator adjacent to the second electric circuit component.

II. Second Example of Electric Bonding Intermediary

This electric bonding intermediary has a plurality of metallic members embedded in an insulator. The metallic member are elecrically insulated from one another by the material of the insulator. One ends of the metallic members are exposed in the face of the insulator adjacent to the first electric circuit component, while other ends are exposed in the face of the insulator adjacent to the second electric circuit component. Fillers such as powder particles and/or fibers of a metal or an alloy are dispersed in the insulator.

Metals suitably used as the material of the powder particles or fibers are Ag, Cu, Au, Aℓ, Be, Ca, Mg, Mo, Ni. Si and W. Alloys of these metals also are usable as the material of the powder particles or fibers. Thus, the electric bonding intermediary of this example has an insulator in which are dispersed fillers such as powder particles and/or fibers of one, two or more of these metals and alloys. That is, the insulator may contain either one or both of powder particles and the fibers. The powder particles and the fibers may or may not have been subjected to a surface treatment such as plating.

Factors such as the size, shape, location and quantity of the powder particles and fibers dispersed in the insulator may be determined suitably such that the dispersed powder particles and the fibers do not cause troubles such as mutual contact between adjacent metallic members, short-circuiting, breakdown of the metallic members, and so forth. It is, however, preferred that the size of the powder particles or the fibers is smaller than the distance between adjacent metallic members, so that adjacent metallic members may not electrically contact with each other through the powder particles and fibers. The dispersed powder particles and/or the fibers may be exposed to the outside provided that they do not impair the desired electrical connection between the electric circuit component. The powder particles, as well as the fibers, may or may not contact with adjacent ones.

When one of the aforementioned resins is used as the material of the insulator, the dispersion of the powder particles or the fibers can be effected by adding the powder particles and/or the fibers to the resin and then mixing the resin, although other dispersion method may be employed.

This electric bonding intermediary features a high heat conductivity by virtue of the dispersion of the powder particles and/or fibers of a metal or an alloy. This type of electric bonding intermediary, therefore, can suitably be used in such a case that the first electric circuit component produces much heat, while the second electric circuit component is comparatively resistant to heat. In such a case, the heat generated in the first electric circuit component is transmitted through the electric bonding intermediary to the second electric circuit component and then radiated from the latter. It is thus possible to obtain an electric circuit device having superior heat radiation characteristic.

### III. Third Example of Electric Bonding Intermediary

This electric bonding intermediary has a plurality of metallic members embedded in an insulator. The metallic members are electrically insulated from one another by the material of the insulator. One ends of the metallic members are exposed in the face of the insulator adjacent to the first electric circuit component, while other ends are exposed in the face of the insulator adjacent to the second electric circuit component. Fillers such as powder particles and/or fibers of an inorganic material are dispersed in the insulator.

The term "inorganic material" in this specification is used to generally mean a material other than metallic materials and organic materials. Examples of such inorganic material are ceramics such as SiC, BeO, $B_2C$, TaC, $TiB_2$, $CrB_2$, TiN, BP, BN, AℓN, $Si_3N_4$ and $SiO_2$, diamond, C, B, glass, and so forth. Thus, the electric bonding intermediary of this example has an insulator in which are dispersed powder particles and/or fibers of one, two or more of these inorganic materials. That is, the insulator may contain either one or both of powder particles and the fibers.

Factors such as the size, shape, location and quantity of the powder particles and fibers dispersed in the insulator may be determined suitably such that the dispersed powder particles and the fibers do not cause troubles such as mutual contact between adjacent metallic members, short-circuiting, breakdown of the metallic members, and so forth. It is, however, preferred that the size of the powder particles or the fibers is smaller than the distance between adjacent metallic members, so that adjacent metallic members may not electrically contact with each other through the powder particles and fibers. The dispersed powder particles and/or the fibers may or may not be exposed to the outside. The powder particles. as well as the fibers, may or may not contact with adjacent ones.

When one of the aforementioned resins is used as the material of the insulator, the dispersion of the powder particles or the fibers can be effected by adding the powder particles and/or the fibers to the resin and then mixing the resin. although other dispersion method may be employed.

This electric bonding intermediary features a high heat conductivity from the first electric circuit component to the second electric circuit component, by virtue of the dispersion of the powder particles and/or fibers. This type of electric bonding intermediary, therefore, can suitably be used in such a case that the first electric circuit component produces much heat, while the second electric circuit component is comparatively resistant to heat. In such a case, the heat generated in the first electric circuit component is transmitted through the electric bonding intermediary to the second electric circuit component and then radiated from the latter. It is thus possible to obtain an electric circuit device having superior heat radiation characteristic.

The inorganic powder particles or fibers produce only small thermal stress when the electric bonding intermediary is heated. It is therefore possible to obtain high reliability of the electric circuit components and, hence, high reliability of semiconductor devices.

### IV. Fourth Example of Electric Bonding intermediary

This electric bonding intermediary has a plurality of metallic members embedded in an insulator. The metallic members are electrically insulated from one another by the material of the insulator. One ends of the metallic members are exposed in the face of the insulator adjacent to the first electric circuit component, while other ends are exposed in the face of the insulator adjacent to the second electric circuit component. Metallic pieces and/or inorganic pieces of any desired forms are embedded in the insulator. The metallic pieces and/or inorganic pieces embedded in the insulator may have any suitable form such as tabular form, rod-like form with various cross-sectional shapes, spheres, and so forth.

Examples of material of the metallic pieces suitably used are Ag, Cu, Au, A , Be, Ca, Mg, Mo, Ni, Si, W, Fe, Sn, Zn, and so forth, as well as alloys of these metals. Examples of material of the inorganic pieces are ceramics such as $SiC$, $BeO$, $B_4C$, $TaC$, $TiB_2$, $CrB_2$, $TiN$, $BP$, $BN$, $AlN$, $Si_3N_4$, $SiO_2$, $B_2O_3$, $Al_2O_3$, $Na_2O$, $K_2O$, $CaO$, $ZnO$, $BaO$, $PbO$, $Sb_2O_3$, $As_2O_3$, $La_2O_3$, $ZnO_2$, $P_2O_5$, $TiO_2$, $MgO$ and $Ta_2O_5$, diamond, $C$, $B$, glass, and so forth. Thus, the electric bonding intermediary of this example has an insulator which contains two or more of these inorganic materials. That is, the insulator may contain at least one kind of metallic filler and/or at least one kind of inorganic filler.

Factors such as the size, shape, location and quantity of the metallic pieces and/or the inorganic pieces in the insulator may be determined suitably such that the dispersed metallic or inorganic pieces do not cause troubles such as mutual contact between adjacent metallic members, short-circuiting, breakdown of the metallic members, and so forth.

The metallic fillers and/or the inorganic fillers need not be uniformly dispersed. Namely, they may be dispersed locally only in limited regions in the insulator. In other words, the insulator may have local regions which are devoid of such fillers. The metallic pieces and/or inorganic pieces may or may not be exposed to the outside and may or may not contact with adjacent ones.

This electric bonding intermediary features a high heat conductivity from the first electric circuit component to the second electric circuit component and vice versa, by virtue of the presence of the metallic pieces or inorganic pieces of desired shape in the insulator. This type of electric bonding intermediary, therefore, can suitably be used in such a case that the first electric circuit component produces much heat, while the second electric circuit component is comparatively resistant to heat. In such a case, the heat generated in the first electric circuit component is transmitted through the electric bonding intermediary to the second electric circuit component and then radiated from the latter. It is thus possible to obtain an electric circuit device having superior heat radiation characteristic.

Preferably, the insulator contains pieces of an inorganic material which has a thermal expansion coefficient approximating that of the electric circuit component, so that the insulator of the electric bonding intermediary exhibits a thermal expansion coefficient approximating that of the electric circuit component, thereby preventing undesirable effects such as rupture of the insulator or the metallic members, as well as degradation of the characteristics of the electric circuit part, thus assuring high reliability of the semiconductor device.

This example of the electric bonding intermediary offers remarkable advantage particularly when a large difference of thermal expansion coefficient exists between the first electric circuit component and the second electric circuit component.

It is also to be understood that the metallic fillers embedded in the insulator effectively prevents any noise of the electric circuit component from leaking outside, while excluding external noises.

### V. Fifth Example of Electric Bonding Intermediary

This electric bonding intermediary has a plurality of metallic members embedded in a metallic or alloy holder through the intermediaries of insulating members. One ends of the metallic members are exposed in the face of the holder adjacent to the first electric circuit component, while other ends are exposed in the face of the holder adjacent to the second electric circuit component.

Examples of the metallic or alloy material suitably used as the material of the holder are Ag, Cu, Au, Al, Be, Ca, Mg, Mo, Ni, Si, W, Fe, Ti, In, Sn, Zn, and so forth, as well as alloys of these metals.

The provision of the insulating material between each metallic member and the holder may be realized in various methods.

For instance, when the holder is made of a material which can be anode-oxidated, e.g., Al or Ti, bores are formed in predetermined portions of the holder so as to receive the metallic members and then the holder is subjected to anode oxidation so that anode-oxidation films which effectively serve as insulating layers are formed on the surfaces of the bores.

It is also possible to form, on the surfaces of the bores formed in the holder an oxide film, a nitride film, a boride film or a carbide film, by subjecting the holder to oxidation, nitriding, boriding or carburizing.

It is also possible to form the insulating material by subjecting the holder to flame spraying or evaporation with, for example, ceramics, after forming bores in the holder.

The insulating material also may be formed by applying a resin to the surfaces of bores formed in the holder.

In a further method, a suitable treatment such as oxidation, nitriding, boriding or carburizing is effected on the boundaries between the metallic members and the holder so that the metallic members are electrically isolated from the holder. In this method, the holder and the metallic member are made of the same metal or alloy. The formation of the insulating material may be effected on both sides of the electric bonding intermediary, or only on the side of the electric bonding intermediary adjacent to the first electric circuit component or the side adjacent to the second electric circuit component.

In a still further method, an intermediary member made of a resin or an inorganic material is disposed between each metallic member and the wall of the bore in the holder receiving each metallic member. For instance, a tubular member is fitted in each bore so as to fit on each metallic member.

When the intermediary member is made of a resin, the invention does not restrict the type of resin. For instance, an electrically insulating resin material can suitably be used.

Examples of the resins suitably used are polyimide resin, polyphenylene sulfide resin, polyether sulfone resin, polyether imide resin, polysulfone resin, silicone resin, fluororesin, polycarbonate resin, polydiphenylether resin, polybenzyl imidazole resin, phenol resin, urea resin, melamine resin, alkyd resin, epoxy resin, polyamideimide resin, polypropylene resin, polyvinyl chloride resin, polystyrene resin, and so forth.

When such a resin is used, the resin may contain fillers such as powder particles and/or fibers of a metallic material or an inorganic material dispersed therein. When such dispersion is employed, the invention does not limit the shape, size and location of the powder particles or fibers, although due consideration has to be paid such as to prevent any electrical contact between the metallic members and the holder through such powder particles or fibers. It is also possible to disperse tabular member, rod-shaped members or spherical members of a metallic or inorganic material in the resin. The locations, shapes and sizes of the tabular, rod-shaped or spherical members can also be selected freely also in this case.

When the intermediary member disposed between each metallic member and the wall of each bore in the holder is made of an inorganic material, the inorganic material may be one selected from ceramics such as $SiO_2$, $B_2O_3$, $Al_2O_3$, $Na_2O$, $K_2O$, CaO, ZnO, BaO, PbO, $Sb_2O_3$, $As_2O_3$, $La_2O_3$, $ZrO_2$, BaO, $P_2O_5$, $TiO_2$, MgO, SiC, BeO, BP, BN, AlN, $B_4C$, TaC, $TiB_2$, $CrB_2$, TiN, $Si_3N_4$, and $Ta_2O_5$, diamond, C, B, glass, and so forth.

Preferably, the resin used has a high heat conductivity so that heat produced by the semiconductor device may be radiated through the resin or inorganic material.

This electric bonding intermediary features a high heat conductivity from the first electric circuit component to the second electric circuit component and vice versa, by virtue of the holder which is made of a metal or an alloy. This type of electric bonding intermediary, therefore, can suitably be used in such a case that the first electric circuit component produces much heat, while the second electric circuit component is comparatively resistant to heat. In such a case, the heat generated in the first electric circuit component is transmitted through the electric bonding intermediary to the second electric circuit component and then radiated from the latter. It is thus possible to obtain an electric circuit device having superior heat radiation characteristic.

It is also to be understood that the metallic or alloy holder effectively prevents any noise of the electric circuit component from leaking outside, while excluding external noises.


VI. Sixth Example of Electric Bonding intermediary

This electric bonding intermediary has metallic members embedded in a holder made of an inorganic material. One ends of the metallic members are exposed in the face of the holder adjacent to the first electric circuit component, while the other ends are exposed in the face adjacent to the second electric circuit component.

Examples of the resin suitable for use as the material of the holder are $SiO_2$, $B_2O_3$, $Al_2O_3$, $Na_2O$, $K_2O$, CaO, ZnO, BaO, PbO, $Sb_2O_3$, $As_2O_3$, $La_2O_3$, $ZrO_2$, BaO, $P_2O_5$, $TiO_2$, MgO, SiC, BeO, BP, BN, AlN, $B_4C$, TaC, $TiB_2$, $CrB_2$, TiN, $Si_3N_4$, and $Ta_2O_5$, diamond, C, B, glass, and so forth.

The inorganic material of the holder of the electric bonding intermediary can contain fillers such as of a metal, resin or the like dispersed therein in such a manner as to avoid short-circuiting between metallic members.

When the inorganic material used as the material of the holder is an electrically conductive material, an intermediate member made of an electrically insulating material such as an inorganic material or a resin is placed between each electric member and the holder so as to electrically insulate the metallic member.

The use of the intermediate member is not necessary when the inorganic material used as the material of the holder is a non-conductive material. In such a case, however, an intermediate member such as of a metal, an inorganic material or a resin may be used for the purpose of improving conduction of heat thereby enhancing heat radiation.

Examples of the metallic material suitably used as the material of such an intermediate member are Ag, Cu, Au, Al, Be, Ca, Mg, Mo, Ni, Si, W, Fe, Ti, In, Sn, Zn and so forth, as well as alloys of thee metals.

The invention does not impose any restriction on the type of the resin used as the material of the intermediate member. Thus, any thermosetting resin, ultraviolet setting resin and thermoplastic resin can be used suitably. Examples of the resins suitably used are polyimide resin, polyphenylene sulfide resin, polyether sulfone resin, polyether imide resin, polysulfone resin, silicone resin, fluororesin, polycarbonate resin, polydiphenylether resin, polybenzyl imidazole resin, phenol resin, urea resin, melamine resin, alkyd resin, epoxy resin, polyamideimide resin, polypropylene resin, polyvinyl chloride resin, polystylene resin, and so forth.

The resin contain metallic and/or inorganic fillers in the form of powder particles and.or fibers dispersed therein. The shape, size, location and quantity of such fillers are not limited, although due consideration has to be paid to avoid any electrical contact between the metallic members and the holder through such fillers. The resin also may contain at least one of tabular fillers, rod-shaped fillers and spherical fillers of either one or both of a metallic material and an inorganic material. The shape, size, location and quantity of such fillers also are unlimited. The fillers in the form of powder particles. fibers, tabular members and spherical members may contact with one another. These fillers also may partially exposed to the outside of the holder. It is, however. essential that the fillers are dispersed in such a manner as to avoid any short-circuiting between different metallic members, breakage of the metallic members. and other inconveniences.

It is advisable that the metal. resin or the inorganic material used as the material of the intermediate member has high heat conductivity so that the heat generated in the semiconductor device may efficiently radiate through the intermediate member.

In this electric bonding intermediary. the holder is made of an inorganic material which usually has an appreciable level of heat conductivity, so that efficient conduction of heat from the first electric circuit component to the second electric circuit component and vice versa is assured. Thus, this example of the electric bonding intermediary features a high level of heat conductivity and, therefore, can suitably be used in such cases where a component having a large heat generation is used as the first electric circuit component while the second electric circuit component has a high durability to heat. In such cases, the heat generated in the first electric circuit component is quickly transmitted to the second electric circuit component and efficiently radiated therefrom. It is thus possible to obtain an electric circuit device having superior heat radiation characteristics.

If there exists a large difference in the thermal expansion coefficient between the electric circuit component and the electric bonding intermediary, a large thermal stress is generated in the product device when heat is applied to or generated in the device, with the result that the reliability of the product, e.g., semiconductor device, is seriously impaired due to, for example, cracking or rupture of the holder, metallic member or the electric circuit component.

In the case of this example of the electric bonding intermediary, the holder of the bonding intermediary made of an inorganic material exhibits thermal expansion which well approximates that of the substrates of the electric circuit components which are usually made of an inorganic material. In consequence, when the product device is heated, the thermal stress is sufficiently suppressed to avoid occurrence of above-mentioned failure or trouble, thus ensuring high level of reliability of product electric circuit device. e.g., a semiconductor device.

[Example of Bonding Between First and Second Electric Circuit Components through Bonding Intermediary According to Invention]

The bonding between the first and second electric circuit components through the bonding intermediary of the invention can broadly be sorted into the following three types A, B and C.

## Bonding of Type A

The first and the second electric circuit components are bonded to each other through the bonding intermediary. The bonding is effected by any known method such as a mechanical method consisting in pressing the electric circuit components together while placing the bonding intermediary therebetween.

## Bonding of Type B

In this type of bonding, the bonding areas of the first electric circuit component are bonded by alloying to the ends of the metallic members exposed in the side of the bonding intermediary adjacent to the first electric circuit component or, alternatively, the bonding areas of the second electric circuit component are bonded by alloying to the ends of the metallic members exposed in the side of the bonding intermediary adjacent to the second electric circuit component. In this type of bonding, therefore, alloying of the bonding areas is effected on either one of the first electric circuit component and the second electric circuit component.

The alloying may simply be effected by placing corresponding bonding areas in contact with each other and heating them at a suitable temperature. As a result of the heating, diffusion of atoms and other phenomenon take place to form a solid-solution or intermetallic compound layer at the boundary, thus alloying and bonding the bonding areas of the two members. When Au is used as the material of the metallic members of the electric bonding intermediary while the bonding area of the electric circuit component is constituted by Aℓ, the alloying heating temperature preferably ranges between 200 and 350°C.

The bonding between the bonding intermediary and the other electric circuit component which is not alloyed may be achieved by any suitable method, e.g., by pressing them together.

According to this type of bonding, superior reliability of connection is achieved without any substantial fluctuation in the resistance value, because one of the electric circuit component is bonded to the bonding intermediary through alloying.

In this type of bonding, as explained before, the alloying of the bonding area for the electrical connection is effected on only one of the first and the second circuit components. Therefore, when one of the first and the second circuit components involves a risk of degradation due to heat applied during alloying, such electric circuit component is bonded by other means than alloying, e.g., by mechanical pressing, while the bonding by alloying is conducted with the other electric circuit component.

The occasion may demand that either one of the electric circuit components is freely demountable even after the completion of the electric circuit device. In such a case, the electric circuit component which is to be demountable is connected by a mere pressing, without being alloyed.

## Bonding of Type C

In this type of bonding, the bonding areas of the first electric circuit component are bonded by alloying to the ends of the metallic members exposed in the side of the bonding intermediary adjacent to the first electric circuit component and, at the same time, the bonding areas of the second electric circuit component are bonded by alloying to the ends of the metallic members exposed in the side of the bonding intermediary adjacent to the second electric circuit component. In this type of bonding, therefore, alloying of the bonding areas is effected on both of the first electric circuit component and the second electric circuit component. The alloying method may be similar to that used in the type B of bonding.

In this type of bonding, both electric circuit components are rigidly (strongly) bonded together, by virtue of the alloying bonding between the bonding intermediary and the bonding areas of both electric circuit components. In consequence, electric circuit device of superior mechanical strength can be produced with extremely low rate of rejection.

In addition, since both electric circuit components are boded through alloying, it is not necessary to employ any jig or the like means for holding the electric circuit component during the production of the electric circuit device, thus facilitating the production, as well as the management of the product device.

Furthermore, the resistance of the electrical connection between both electric circuit components is reduced as compared with the type B of bonding which employs alloying of only one of the electric circuit components, because both the first and the second electric circuit components are bonded through alloying.

(Alloying)

Alloying as used in the specification is defined as follows.

In case that an electrically conductive member and connecting portions of an electric circuit device to be connected are made of the same pure metal, connection therebetween by alloying has the same crystal structure as the conductive member and the connecting portions. An example of the alloying is heating at an appropriate temperature after contacting an edge of the conductive member with a connecting portion corresponding to the edge. The heating causes diffusion of atoms near the contact. The diffusion area becomes an alloy condition to form the connection.

In case that the conductive member and the connecting portions to be connected are made of respective pure metals different from each other, the connection is an alloy of the metals. The alloying process is heating at an appropriate temperature after contacting an edge of the conductive member and the connecting portion corresponding to the edge. The heating causes diffusion of atoms near the contact area, forming a layer of a solid solution or an intermetallic compound. The layer becomes the connection.

In case that one of the conductive member and the connecting portion is made of a pure metal and the other is of an alloy, or that the both are of alloys identical to or different from each other, the connection becomes their alloy.

Regarding a plurality of the conductive members in an electrically connecting member, there are various cases as follows: All of them are made of an identical metal or alloy; They are made of respective, different metals or alloys; Some of them are made of the same metal or alloy and the others are made of different metals or alloys; etc. In either case, the alloying is effected. As regards the connecting portions, the fact is the same.

It is essential that the conductive member and the connecting member be an alloy or alloys at their contacting areas. But the other areas of the members can be a state in which a resin is impregnated in glass fibers.

It is preferable that the contact areas have small surface roughness, preferably less than 0.3 $\mu$m, in order to enhance a strength of the connection. Furthermore, a layer of plating of an easily alloyed metal or an alloy may be given on a surface to be connected.

(Seal)

In the present invention, the electric circuit parts may be sealed by a sealing material.

The sealing may be effected on one or a plurality of the electric circuit parts.

(Materials for the sealing)

In the present invention a thermoplastic resin may be used as a sealing material. The thermoplastic material can be selected from the following: polyimide, polyphenylene sulfide, polyether sulfone, polyether imide, polysulfone, fluororesin, polycarbonate, polydiphenylether, polybenzylimidazole, polyamidimide, polypropylene, polyvinyl chloride, polystyrene, methyl methacrylate, other resins.

The sealing may be one of the above resins or the resin with dispersion of either or both of powers and fibers of one or more of metals, alloys and inorganic materials. The dispersion may be performed by adding the powders or fibers to the resin and agitating them. However, the dispersion may also be done by any other method.

The metals or the alloys may be selected from Ag, Cu, Au, Al, Be, Ca, Mg, Mo, Fe, Ni, Si, Co, Mn, W, etc.

The inorganic materials may be selected from ceramics: $SiO_2$, $B_2O_3$, $Al_2O_3$, $Na_2O$, $K_2O$, CaO, ZnO, BaO, PbO, $Sb_2O_3$, $As_2O_3$, $La_2O_3$, $ZrO_2$, BaO, $P_2O_5$, $TiO_2$, MgO, SiC, BeO, BP, BN, AIN, $B_4C$, TaC, $TiB_2$, $CrB_2$, TiN, $Si_3N_4$, $Ta_2O_5$, etc.; diamond: glass: carbon; boron; and other inorganic materials.

A size, a shape, a dispersion position, and an amount of dispersed powders and fibers may be chosen within a range where metal members embedded in insulator are without contact or short-circuit with each other through the powders or the fibers. It is, however, preferable that the size of the powders and the fibers is smaller than a distance between two neighboring metal member. That is, the electrically conductive members should not preferably contact with each other even through the powders and the fibers. The powders and the fibers may or may not be exposed outside the insulator. The powders and the fibers may or may not contact with each other.

If either or both of the powders and the fibers of one or more of the metals, the alloys and the ceramics are dispersed in the sealing, the electric circuit device has a superior heat dissipation because heat generated in the electric circuit parts is transmitted earlier to the outside. Further, the electric circuit device has a high shielding property.

(Sealing process)

The sealing process is i) setting in a molding cavity the electric circuit member which comprises an electrically connecting member and electric circuit members connected to the connected member, ii) injecting a sealing material into the cavity by injection molding to seal them. The electric circuit member may be sealed by such injection molding, extrusion molding, cast molding, blow molding and any other method.

(Plate)

In the present invention, a plate may be sticked to at least one of surfaces of the sealings.

The plate may also be sticked to another face of the electric circuit part opposite the electrically connecting member. It's unnecessary that the plate is sticked to all the electric circuit parts. It is sufficient that a plate is sticked to at least a portion of at least one electric circuit member.

Furthermore, at least one plate or a plate assembly may be placed near a face of the circuit part opposite the connecting member or a side face thereof. Such plate is not always placed near all the electric circuit parts. It is essential that a plate is placed near at least one electric circuit part.

The plate may be made of any material different from that of the sealing.

The plate has a thickness, e.g. preferably of 0.05 to 0.5 mm in case of a stainless steel plate.

There is no limitation for the sticking of the plate. For example, the plate may be sticked by an adhesive. Any other method can be employed if the plate may hold the electric circuit device.

The thus disposed plate may prevent a stress concentration due to an interval stress or an external stress, and as a result cracks caused by the stress concentration. The plate lengthens a pass from the outside to the electric circuit parts, thus making it difficult for foreign materials such as water to reach the electric circuit parts. This enhances a reliability of the device.

If the plate is made of metals such as stainless steel; ceramics, carbon and diamond with high heat conductivity, heat generated by the electric circuit parts may be dissipated fast to the outside, thus resulting in providing an electric circuit device superior in heat dissipation property. Furhter, if the plate is made of a metal, noises from the outside and electromagnetic noises generated from the electric circuit parts may effectively be shielded, providing an electric circuit device superior in a shielding property.

(Cap)

The electric circuit device of the present invention may have a cap for cap-sealing the electric circuit parts.

The "cap-sealing" means covering and sealing the electric circuit parts to provide an internal hollowed space.

The cap may be provided for one or plural electric circuit parts.

In the cap-sealing, the sealing should preferably be effected such that the electric circuit parts are held tight on the electrically connecting member. For example, an inside face of the cap is shaped corresponding to an outer surface of the electric circuit parts and is made contacting the outer surface of the circuit part to effect the cap-sealing.

The cap may be sticked to an electric circuit part or another cap which is provided for another electric circuit part to be cap-sealed if any by an adhering method with an adhesive, a mechanical method, a fusion, and any other method.

(Materials for the cap)

The cap may be made of either of metals, inorganics or organics.

The metals may be, for example, ceramics such as $SiO_2$, $B_2O_3$, $Al_2O_3$, $Na_2O$, $K_2O$, $CaO$, $ZnO$, $BaO$, $PbO$, $Sb_2O_3$, $As_2O_3$, $La_2O_3$, $ZrO_2$, $BaO$, $P_2O_5$, $TiO_2$, $MgO$, $SiC$, $BeO$, $BP$, $BN$, $AlN$, $B_4C$, $TaC$, $TiB_2$, $CrB_2$, $TiN$, $Si_3N_4$, $Ta_2O_5$; diamond; glass; carbon; boron; others.

In the inorganic materials a metal material, a resin or other material may be dispersed.

The organic materials may be any of thermosetting resins, ultraviolet curable resins, and thermoplastic resins.

Further, either of both of powders and fibers of metals and inorganics may be dispersed in the resins. If dispersed, a shape, a size, a dispersion position and an amount of the dispersed powders and the fibers are not limited. Also, at least one of plates, rods and balls of either or both of metals and/or inorganics may be embedded within the resins. A location of the embedding, a shape, a size and an amount of the embedded plates rods and/or balls are not limited. The powders, the fibers, the plates, the rods and the balls may contact with each other in the resins.

(Adjusting member)

In the present invention, an adjusting member may be disposed between the cap and the electric circuit part.

The adjusting member may be made of either of metals, inorganics and organics, which is preferably elastic.

A shape of the adjusting member is not limited to a specific one if it can adjust a height of the electric circuit part.

The intervention of the adjusting member between the electric circuit part and the cap allows adjustment of the height of the electric circuit part, resulting in avoiding preparation of various inside shapes of the cap fitting the electric circuit part. Also, deviation of dimensions upon assembling may be adjusted by the adjusting member. Such an adjusting member is especially effective to the cap-sealing of various electric circuit devices.

(First Embodiment)

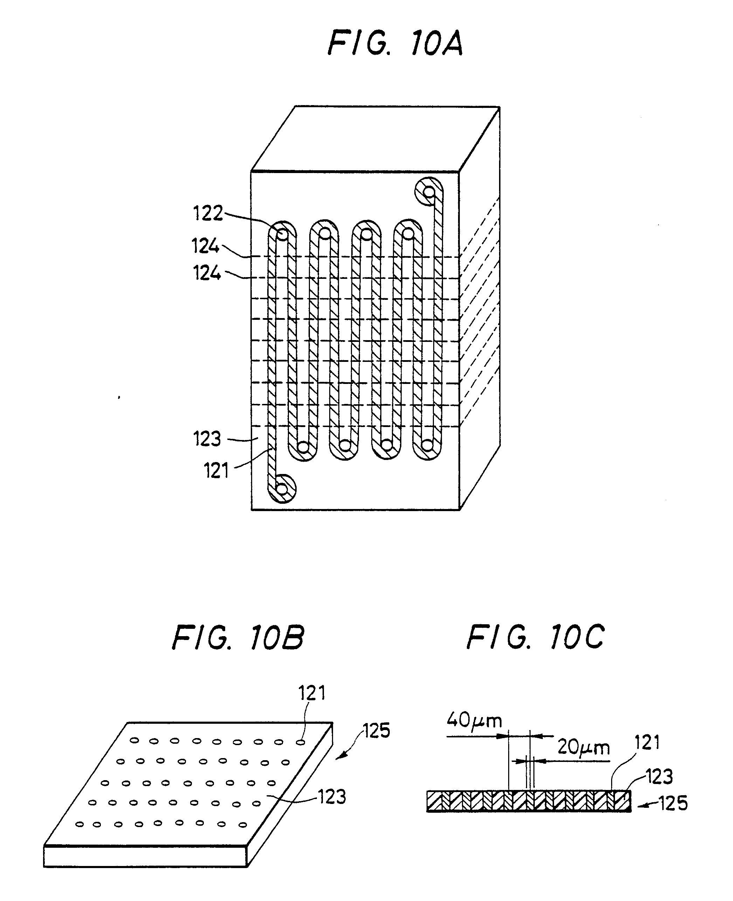

A first embodiment of the present invention will be described with specific reference to Figs. 9A, 9B and 10A to 10C.

The first embodiment is an electric circuit device which includes a circuit board 101 as a first electric circuit component with bonding areas 102, a second circuit board 104 as a second electric circuit component with bonding areas 105, and an electric bonding intermediary 125 placed between both circuit boards 101, 104 and connected to the bonding areas 102, 105 thereby providing electrical connection between the first and the second circuit boards, wherein the electric bonding intermediary 125 includes an insulator 111 and a plurality of metallic members 107 of a metal or an alloy embedded in the insulator 101 in such a manner that the metallic members 107 are electrically insulated from one another and that one ends of the metallic members 107 are exposed on one side of the insulator adjacent to the first circuit board 101 while other ends are exposed on the other side of the insulator 111 adjacent to the second circuit board 104, and wherein bonding is attained by alloying between the bonding areas 102 of the first circuit board 101 and the ends of the metallic members 107 exposed to the same side as the first circuit board 101 or, alternatively, between the bonding areas 105 of the second circuit board 104 and the ends of the metallic members 107 exposed to the same side as the second circuit board 104.

This embodiment will be described in more detail hereinunder. The electric bonding intermediary 125 will be described first through explanation of an example of a process for producing the same.

Figs. 10A to 10C illustrate an example of the process for producing the electric bonding intermediary 125 used in the first embodiment.

As shown in Fig. 10A, a metallic wire 121 made of a metal such as gold or a suitable alloy and having a diameter of about 20 $\mu$m is turned around a plurality of bars 122 at a pitch of 40 $\mu$m, and the wire 121 together with the bars 122 are embedded in a resin body 123 such as of polyimide resin. The resin after setting serves as an insulator. After the setting of the resin, the resin body 123 is sliced as indicated by broken lines 124, whereby a plurality of electric bonding intermediary 125 are obtained as shown in Figs. 10B and 10C.

In this electric bonding intermediary 125, the metallic wires 121 as the metallic members are insulated from one another by the resin 123. It will be seen that one ends of the metallic wires 121 are exposed on the surface of the electric bonding intermediary 125 adjacent to the first circuit board 101, while the other ends of the same are exposed on the surface of the electric bonding intermediary 125 adjacent to the second circuit board 104. These exposed portions of the metallic wires 121 constitute bonding areas 108, 109 where the bonding intermediary is to be bonded to the circuit boards 101 and 104.

The first and the second circuit boards 101 and 104 are then set together with the electric bonding intermediary 125 interposed therebetween. As will be seen from Figs. 9A and 9B, the circuit boards 101, 104 are provided with a multiplicity of bonding areas 102, 105 within the areas thereof.

The bonding areas 102 of the first circuit board 101 are exposed at positions corresponding to the bonding areas 105 of the second circuit board 104 and the bonding areas 108, 109 of the electric bonding intermediary 125.

Then, the first circuit board 101 and the electric bonding intermediary 125 are located with respect to each other such that the bonding areas 102 on the first circuit board 101 and the bonding areas 108 of the electric bonding intermediary 125 are aligned, and then the aligned bonding areas are mutually alloyed. Alternatively, the second circuit board 104 and the electric bonding intermediary 125 are located with respect to each other such that the bonding areas 105 on the second circuit board 104 and the bonding areas 109 of the electric bonding intermediary 125 are aligned, and then the aligned bonding areas are mutually alloyed. Then, the other circuit board is connected by, for example, mechanical pressing.

Thus, the first embodiment can be assembled by either one of the following two methods (1) and (2).

(1) The first circuit board 101 is first located with respect to the electric bonding intermediary 125 and the bonding areas 102 of the first circuit board 101 are bonded by alloying to the bonding areas 108 of the electric bonding intermediary 125. Then, the second circuit board 104 is located with respect to the electric bonding intermediary 125 and the bonding areas 105 of the second circuit board 104 are bonded to the bonding areas 109 of the electric bonding intermediary 125 by pressing.

(2) The second circuit board 104 is first located with respect to the electric bonding intermediary 125 and the bonding areas 105 of the second circuit board 104 are bonded by alloying to the bonding areas 109 of the electric bonding intermediary 125. Then, the first circuit board 101 is located with respect to the electric bonding intermediary 125 and the bonding areas 102 of the first circuit board 101 are bonded to the bonding areas 108 of the electric bonding intermediary 125 by pressing.

The state of electrical connection or bonding in the first embodiment thus constructed was examined and superior reliability of the electrical connection was confirmed.

(Second Embodiment)

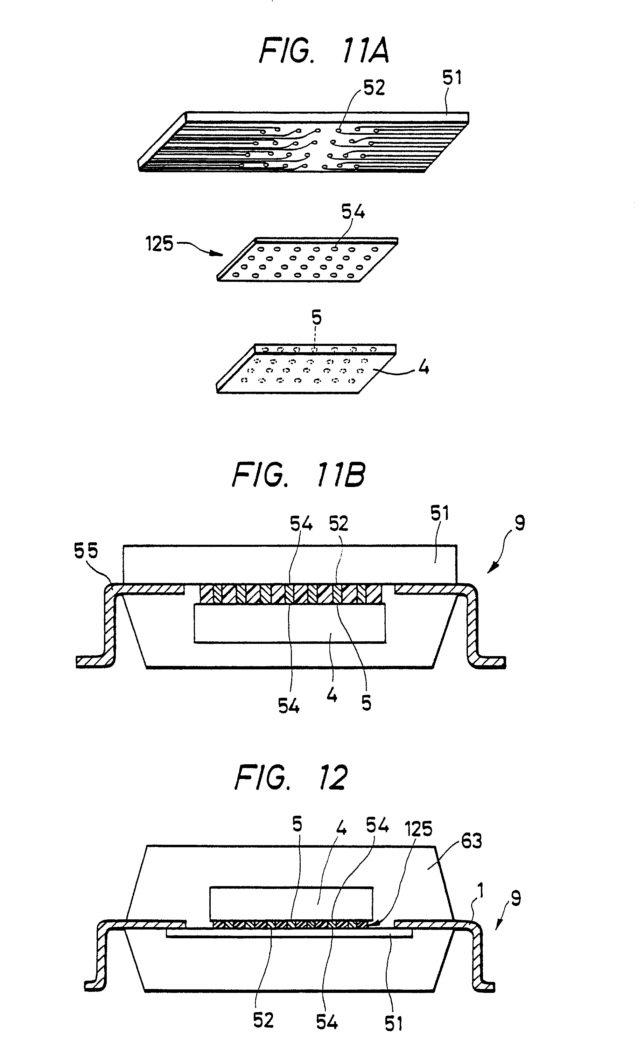

Figs. 11A and 11B show a second embodiment of the invention.

The second embodiment was constructed by using, as the first electric circuit component, a circuit board 51 having bonding areas 52 and, as the second electric circuit component, a semiconductor device 4 having a multiplicity of bonding areas 5 within the area thereof.

The bonding by alloying was effected to achieve electrical connection between the bonding areas 5 of the semiconductor device 4 and the bonding areas 54 of the electric bonding intermediary 125.

The electric bonding intermediary 125 was designed to be equal in size to the semiconductor device 4.

After the bonding by alloying, a lead frame 55 was connected to the underside of the circuit board 51.

Other portions are materially the same as those in the first embodiment.

Superior reliability of the electrical connection was confirmed also in this embodiment.

(Third Embodiment)

Fig. 12 shows a third embodiment of the present invention.

The third embodiment was constructed by using the semiconductor device 4 as the first electric circuit component and the circuit board 51 as the second electric circuit component.

After the completion of the connection, a lead frame 1 was connected to the upper side of the circuit board 51 and then the upper surface of the thus obtained assembly was sealed with a resin 63.

Other portions are materially the same as those of the first embodiment.

Superior reliability of the electrical connection was confirmed also in this embodiment.

(Fourth Embodiment)

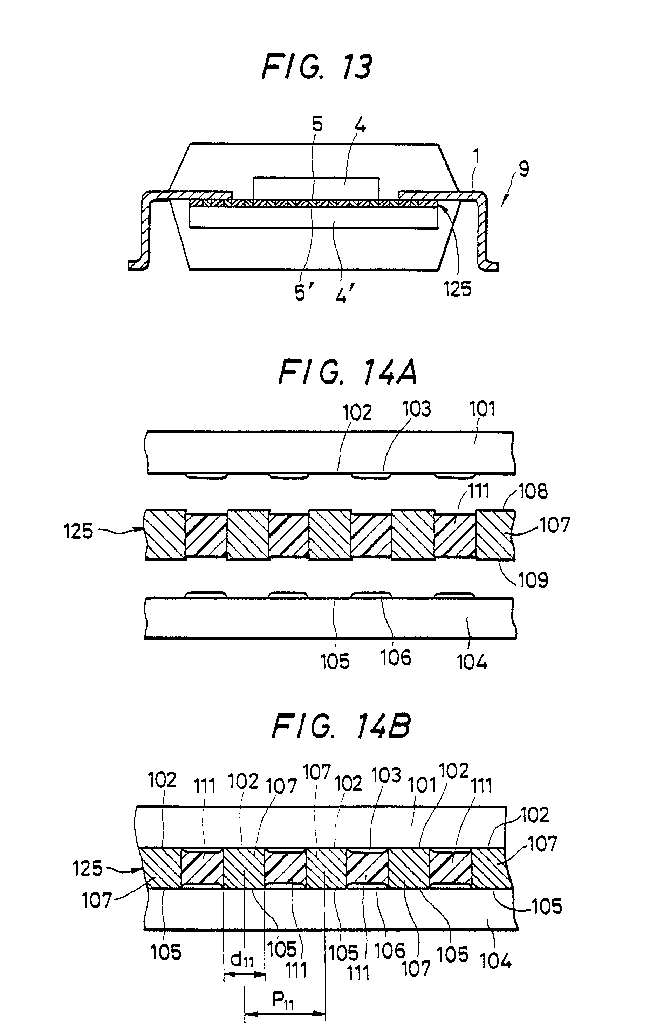

Fig. 13 shows a fourth embodiment of the invention.

The fourth embodiment was constructed by using the semiconductor device 4 as the first electric circuit component and another semiconductor device 4' as the second electric circuit component.

In this embodiment, the electric bonding intermediary was designed to correspond in size to the semiconductor device 4' and a lead frame 1 was connected to the ends of the metallic members of the bonding intermediary 125 exposed to the same side as the semiconductor device 4.

Other portions are materially the same as those of the third embodiment.

Superior reliability of the electrical connection was confirmed also in this embodiment.

(Fifth Embodiment)

Figs. 14A and 14B show a fifth embodiment of the invention. In the fifth embodiment, circuit boards 101, 104, which are coated by insulating films 103, 106 at portions other than the bonding areas, are used as the first and second electric circuit components, respectively.

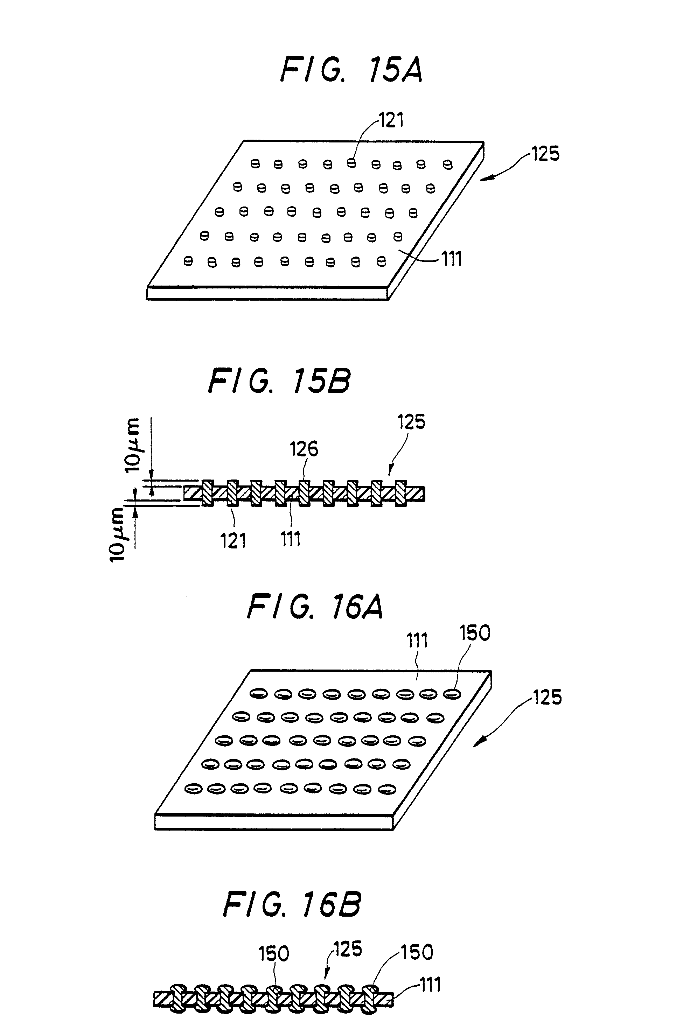

As will be understood from Figs. 15A and 15B, in the electric bonding intermediary 125 used in this embodiment, the exposed ends of the metallic members 107 are slightly projected from the surfaces of the resin insulator 111.

This type of electric bonding intermediary 125 can be fabricated by preparing a member of the type shown in Figs. 10B and 10C described before, and subjecting the surfaces of the member to an etching until the metallic wires 121 project from the surfaces of the polyimide resin body 123 by a length of, for example, 10 μm or so.

The fabrication of this type of electric bonding intermediary by etching is only illustrative and other suitable chemical or mechanical methods can be used equally well.

Other portions are materially the same as those of the first embodiment.

It is possible to form bumps 150 as shown in Figs. 16A and 16B, by placing the electric bonding intermediary 125 between a pair of dies having recesses corresponding to the metallic wires 121 and then compacting the dies so as to collapse the projecting portions 126 of the metallic wires 121. The provision of the bumps 150 effectively prevent the metallic wires from coming off the insulator 111.

The bumps may also be formed by heating and melting the projections or other suitable method.

High reliability of electrical connection was confirmed also in this case.

(Sixth Embodiment)

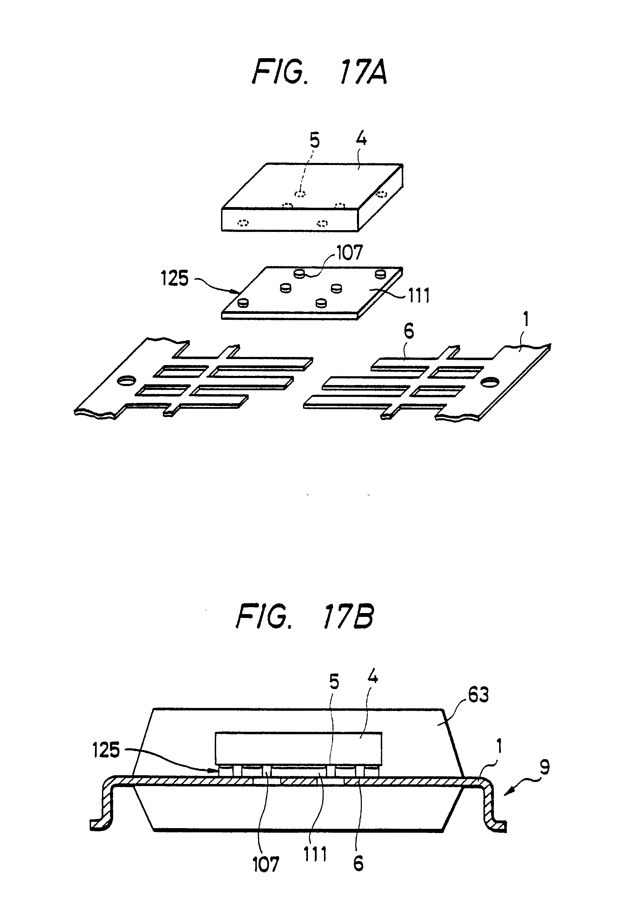

Figs. 17A and 17B show a sixth embodiment. This embodiment features the use of a semiconductor device 4 as the first electric circuit component and a lead frame 1 as the second circuit component.

Other portions are materially the same as those in the fifth embodiment.

A superior reliability of the electrical connection was confirmed also in this embodiment.

(Seventh Embodiment)

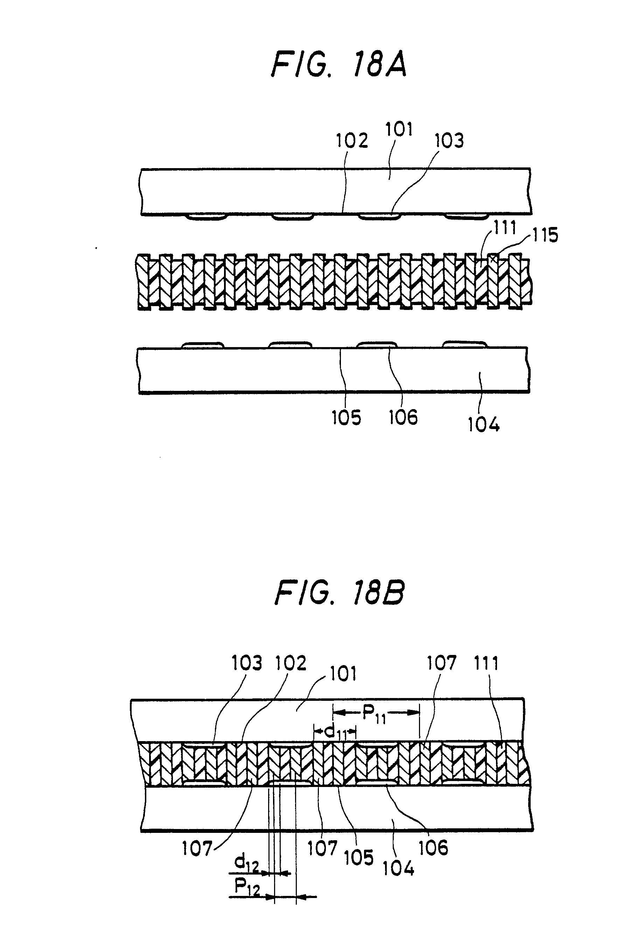

Figs. 18A and 18B show a seventh embodiment.

This embodiment features the use of an electric bonding intermediary 125 which is a modification of that 125 used in the fifth embodiment. More specifically, the bonding intermediary 125 used in the seventh embodiment has a smaller pitch of the metallic members than that in the fifth embodiment. Thus, in the seventh embodiment, the pitch of the metallic members 107 used in the electric bonding intermediary is smaller than the pitch of the bonding areas of the first electric circuit component.

The fifth embodiment described before essentially requires that the electric bonding intermediary 125 be located with respect to the first and the second circuit boards 101, 104 because the bonding areas of the electric bonding intermediary 125 are positioned to correspond to the bonding areas of the first and the second circuit boards 101, 104. In the seventh embodiment, however, it is not necessary to precisely locate the electric bonding intermediary with respect to both circuit boards 101, 104, though these circuit boards 101, 104 have to be precisely located with respect to each other. Thus, in the seventh embodiment, it is possible to attain the electrical connection without requiring any precise location of the electric bonding intermediary 125 provided that the size and pitch (d11, P11) of the bonding areas of the first and second circuit boards and those (d12, P12) of the bonding areas of the electric bonding intermediary are suitably determined in relation to each other.

A superior reliability of the electrical connection was confirmed also in this case.

(Eighth Embodiment)

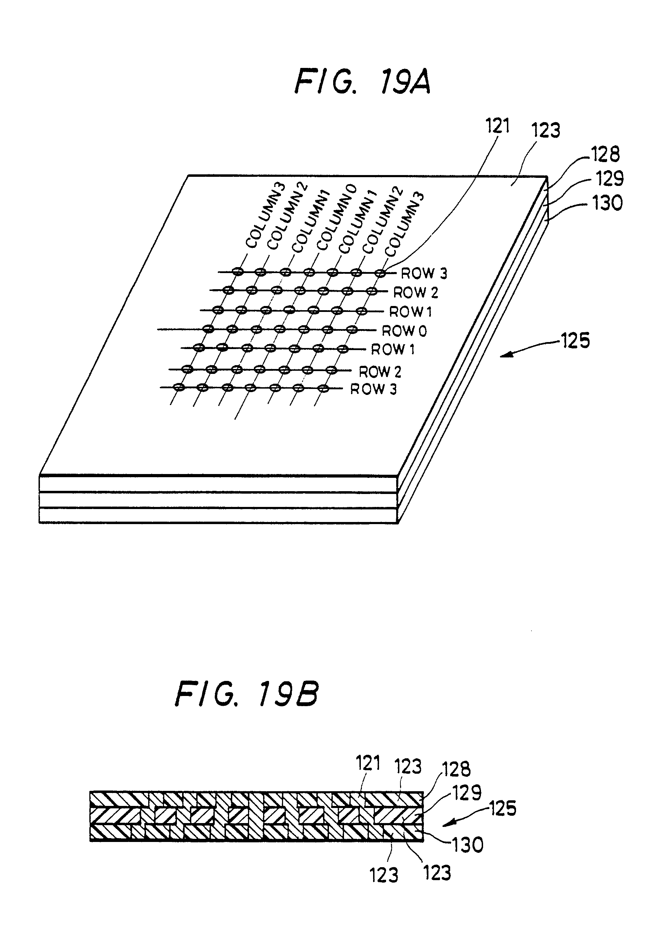

Figs. 19A and 19B show an electric bonding intermediary suitable for use in eighth embodiment of the present invention, in perspective view and in sectional view, respectively.

An example of the method for fabricating this electric bonding intermediary will be described hereinunder. Three pieces 128, 129 and 130 of elementary electric bonding intermediary are prepared by the method which was explained before in connection with the first embodiment.

In the first piece 128 of the electric bonding intermediary, the metallic wires 121 are so located that the position of the metallic wire 121 in a row $m$ and a column $n$ is offset from the center by amounts $ma$ and $nb$ in the line and column directions. In the second piece 129 of the electric bonding intermediary, the metallic wires 121 are so located that the position of the metallic wire 121 in row $m$ and column $n$ is offset from the center by amounts $mac$ and $nbc$ in the line and column directions. In the third piece 130 of the electric bonding intermediary, the metallic wires 121 are so located that the position of the metallic wire 121 in row $m$ and column $n$ is offset from the center by amounts $mad$ and $nbd$ in the line and column directions. The values $a$, $b$, $c$ and $d$ are so determined that the metallic members in each piece can make electric contact only with the metallic members which are immediately above and below these metallic members but do not contact with metallic members laterally offset therefrom. Then, the electric bonding intermediary 125 is completed by stacking three pieces of the member and then bonding them together by, for example, applying heat and pressure.

Although the metallic members in each piece of elementary bonding intermediary member are regularly arranged in the form of a matrix having $m$ rows and $n$ columns, this is not exclusive and the metallic members in each piece may be disposed in a random manner, provided that the metallic members in each piece can make electric contact only with the metallic members which are immediately above and below these metallic members but do not contact with metallic members laterally offset therefrom.

It is also to be understood that the electric bonding intermediary may be composed of two pieces of elementary members or four or more elementary members, although a bonding intermediary consisting of three elementary members was specifically mentioned.

The bonding by application of heat and pressure also is illustrative, and various other suitable methods such as a mere pressing and adhesion can be employed as the occasion demands.

The electric bonding intermediary may be modified such that it has projections as is the case of the bonding intermediary shown in Figs. 15A, 15B or such that it has bumps as is the case of the bonding intermediary shown in Figs. 16A, 16B.

Superior reliability of electrical connection was confirmed also in this case.

(Ninth Embodiment)

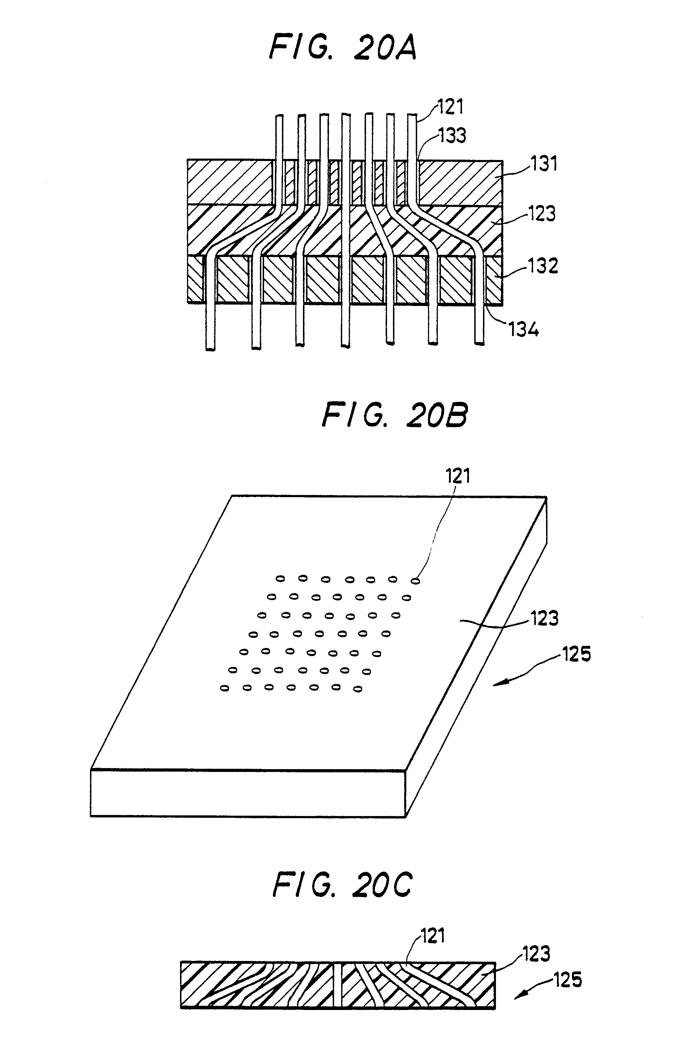

Fig. 20A is a sectional view of a half-finished electric bonding intermediary suitable for use in the ninth embodiment of the present invention. Figs. 20B and 20C are a perspective view and a sectional view of the bonding intermediary.

This bonding intermediary is prepared by the following method. A pair of metal wire guide plates 131 and 132 are prepared and metal wires 121 are threaded through holes 133, 134 formed in these guide plates 131, 132. Then, the wires are tensed at a suitable level of tension. Subsequently, the space between the guide plates 131, 132 is filled with a resin 123. After the setting of the resin, the guide plates 131, 132 are demounted, whereby the electric bonding intermediary 125 is formed. The electric bonding intermediary may be modified such that it has projections as is the case of the bonding intermediary shown in Figs. 15A, 15B or such that it has bumps as is the case of the bonding intermediary shown in Figs. 16A, 16B. Each of the first and second electric circuit components 101 and 104 may be one selected from a group of components including semiconductor devices, circuit boards and lead frames.

(10th Embodiment)

A 10th embodiment of the present invention will be described with specific reference to Figs. 9A, 9B and 10A to 10C.

The 10th embodiment is an electric circuit device which includes a circuit board 101 as a first electric circuit component with bonding areas 102, a second circuit board 104 as a second electric circuit component with bonding areas 105, and an electric bonding intermediary 125 placed between both circuit boards 101, 104 and bonded to the bonding areas 102, 105 thereby providing electrical connection between the first and the second circuit boards, wherein the electric bonding intermediary 125 includes an insulator 111 and a plurality of metallic members 107 of a metal or an alloy embedded in the insulator 101 in such a manner that the metallic members 107 are electrically insulated from one another and that one ends of the metallic members 107 are exposed on one side of the insulator adjacent to the first circuit board 101 while other ends are exposed on the other side of the insulator 111 adjacent to the second circuit board 104, and wherein bonding is attained by alloying between the bonding areas 102 of the first circuit board 101 and the ends of the metallic members 107 exposed to the same side as the first circuit board 101 and also between the bonding areas 105 of the second circuit board 104 and the ends of the metallic members 107 exposed to the same side as the second circuit board 104.

This embodiment will be described in more detail hereinunder. The electric bonding intermediary 125 will be described first through explanation of an example of a process for producing the same.

Figs. 10A to 10C illustrate an example of the process for producing the electric bonding intermediary 125 used in the first embodiment.

As shown in Fig. 10A, a metallic wire 121 made of a metal such as gold or a suitable alloy and having a diameter of about 20 μm is turned around a plurality of bars 122 at a pitch of 40 μm, and the wire 121 together with the bars 122 are embedded in a resin body 123 such as of polyimide resin. The resin after setting serves as an insulator. After the setting of the resin, the resin body 123 is sliced as indicated by broken lines 124, whereby a plurality of electric bonding intermediary 125 are obtained as shown in Figs. 10B and 10C.

In this electric bonding intermediary 125, the metallic wires 121 as the metallic members are insulated from one another by the resin 123. It will be seen that one ends of the metallic wires 121 are exposed on the surface of the electric bonding intermediary 125 adjacent to the first circuit board 101, while the other ends of the same are exposed on the surface of the electric bonding intermediary 125 adjacent to the second circuit board 104. These exposed portions of the metallic wires 121 constitute bonding areas 108, 109 where the bonding intermediary is to be bonded to the circuit boards 101 and 104.

The first and the second circuit boards 101 and 104 are then set together with the electric bonding intermediary 125 interposed therebetween. As will be seen from Figs. 9A and 9B, the circuit boards 101, 104 are provided with a multiplicity of bonding areas 102, 105 within the areas thereof.

The bonding areas 102 of the first circuit board 101 are exposed at positions corresponding to the bonding areas 105 of the second circuit board 104 and the bonding areas 108, 109 of the electric bonding intermediary 125.

Then, the first circuit board 101 and the electric bonding intermediary 125 are located with respect to each other such that the bonding areas 102 on the first circuit board 101 and the bonding areas 108 of the electric bonding intermediary 125 are aligned, and then the aligned bonding areas are mutually alloyed. Alternatively, the second circuit board 104 and the electric bonding intermediary 125 are located with respect to each other such that the bonding areas 105 on the second circuit board 104 and the bonding areas 109 of the electric bonding intermediary 125 are aligned, and then the aligned bonding areas are mutually alloyed. Then, the other circuit board is connected by, for example, mechanical pressing.

The bonding of the first circuit board 101, electric bonding intermediary 125 and the second circuit board 104 can be conducted by any one of the following three methods (1), (2) and (3).

(1) The first circuit board 101, the electric bonding intermediary 125 and the second circuit board 104 are located with respect to one another, and then alloying operation is effected simultaneously at the juncture between the bonding area 102 of the first circuit board 101 and the bonding area 108 of the electric bonding intermediary 125 and at the juncture between the bonding area 105 of the second circuit board 104 and the bonding area 109 of the electric bonding intermediary 125, thereby simultaneously bonding both circuit boards to the electric bonding intermediary 125.

(2) The first circuit board 101 is first located with respect to the electric bonding intermediary 125 and the bonding areas 102 of the first circuit board 101 are bonded by alloying to the bonding areas 108 of the electric bonding intermediary 125. Then, the second circuit board 104 is located with respect to the electric bonding intermediary 125 and the bonding areas 105 of the second circuit board 104 are bonded by alloying to the bonding areas 109 of the electric bonding intermediary 125.

(3) The second circuit board 104 is first located with respect to the electric bonding intermediary 125 and the bonding areas 105 of the second circuit board 104 are bonded by alloying to the bonding areas 109 of the electric bonding intermediary 125. Then, the first circuit board 101 is located with respect to the electric bonding intermediary 125 and the bonding areas 102 of the first circuit board 101 are bonded by alloying to the bonding areas 108 of the electric bonding intermediary 125.

The state of electrical connection or bonding in the 10th embodiment thus constructed was examined and superior reliability of the electrical connection was confirmed.

(11th Embodiment)

Figs. 11A and 11B show an 11th embodiment of the invention.

The 11th embodiment was constructed by using, as the first electric circuit component, a circuit board 51 having bonding areas 52 and, as the second electric circuit component, a semiconductor device 4 having a multiplicity of bonding areas 5 within the area thereof.

The bonding by alloying was effected to achieve electrical connection between the bonding areas 5 of the semiconductor device 4 and the bonding areas 54 of the electric bonding intermediary 125.

The electric bonding intermediary 125 was designed to be equal in size to the semiconductor device 4.

After the bonding by alloying, a lead frame 55 was connected to the underside of the circuit board 51.

Other portions are materially the same as those in the 10th embodiment.

Superior reliability of the electrical connection was confirmed also in this embodiment.

(12th Embodiment)

Fig. 12 shows a 12th embodiment of the present invention.

The 12th embodiment was constructed by using the semiconductor device 4 as the first electric circuit component and the circuit board 51 as the second electric circuit component.

After the completion of the connection, a lead frame 1 was connected to the upper side of the circuit board 51 and then the upper surface of the thus obtained assembly was sealed with a resin 63.

Other portions are materially the same as those of the 10th embodiment.

Superior reliability of the electrical connection was confirmed also in this embodiment.

(13th Embodiment)

Fig. 13 shows a 13th embodiment of the invention.

The 13th embodiment was constructed by using the semiconductor device 4 as the first electric circuit component and another semiconductor device 4' as the second electric circuit component.

In this embodiment, the electric bonding intermediary 125 was designed to correspond in size to the semiconductor device 4' and a lead frame 1 was connected to the ends of the metallic members of the bonding intermediary 125 exposed to the same side as the semiconductor device 4.

Other portions are materially the same as those of the 12th embodiment.

Superior reliability of the electrical connection was confirmed also in this embodiment.

(14th Embodiment)

Figs. 14A and 14B show a 14th embodiment of the invention. In this 14th embodiment, circuit boards 101, 104, which are coated by insulating films 103, 106 at portions other than the bonding areas, are used as the first and second electric circuit components, respectively.

As will be understood from Figs. 15A and 15B, in the electric bonding intermediary 125 used in this embodiment, the exposed ends of the metallic members 107 are slightly projected from the surfaces of the resin insulator 111.

This type of electric bonding intermediary 125 can be fabricated by preparing a member of the type shown in Figs. 10B and 10C described before, and subjecting the member to an etching until the metallic wires 121 project from the surfaces of the polyimide resin body 123 by a length of, for example, 10 $\mu$m or so.

The fabrication of this type of electric bonding intermediary by etching is only illustrative and other suitable chemical or mechanical methods can be used equally well.

Other portions are materially the same as those of the 10th embodiment.

It is possible to form bumps 150 as shown in Figs. 16A and 16B, by placing the electric bonding intermediary 125 between a pair of dies having recesses corresponding to the metallic wires 121 and then compacting the dies so as to collapse the projecting portions 126 of the metallic wires 121. The provision of the bumps 150 effectively prevent the metallic wires from coming off the insulator 111.

The bumps may also be formed by heating and melting the projections or other suitable method.

High reliability of electrical connection was confirmed also in this case.

(15th Embodiment)

Figs. 17A and 17B show a 15th embodiment. This embodiment features the use of a semiconductor device 4 as the first electric circuit component and a lead frame 1 as the second circuit component.

Other portions are materially the same as those in the fifth embodiment.

A superior reliability of the electrical connection was confirmed also in this embodiment.

(16th Embodiment)

Figs. 18A and 18B show a 16th embodiment. This embodiment features the use of an electric bonding intermediary 125 which is a modification of that 125 used in the 14th embodiment. More specifically, the bonding intermediary 125 used in the 16th embodiment has a smaller pitch of the metallic members than that in the 14th embodiment. Thus, in the 16th embodiment, the pitch of the metallic members 107 used in the electric bonding intermediary is smaller than the pitch of the bonding areas of the first electric circuit component.

The 14th embodiment described before essentially requires that the electric bonding intermediary 125 be located with respect to the first and the second circuit boards 101, 104 because the bonding areas of the electric bonding intermediary 125 are positioned to correspond to the bonding areas of the first and the second circuit boards 101, 104. In the 14th embodiment, however, it is not necessary to precisely locate the electric bonding intermediary 125 with respect to both circuit boards 101, 104, though the circuit boards 101, 104 have to be precisely located with respect to each other. Thus, in the 14th embodiment, it is possible to attain the electrical connection without requiring any precise location of the electric bonding intermediary 125 provided that the size and pitch (d11, P11) of the bonding areas of the first and second circuit boards and those (d12, P12) of the bonding areas of the electric bonding intermediary are suitably determined in relation to each other.

A superior reliability of the electrical connection was confirmed also in this case.

(17th Embodiment)

Figs. 19A and 19B show an electric bonding intermediary suitable for use in 17th embodiment of the present invention, in perspective view and in sectional view, respectively.

An example of the method for fabricating this electric bonding intermediary will be described hereinunder. Three pieces 128, 129 and 130 of elementary electric bonding intermediary are prepared by the method which was explained before in connection with the first embodiment.

In the first piece 128 of the electric bonding intermediary, the metallic wires 121 are so located that the position of the metallic wire 121 in a row $m$ and a column $n$ is offset from the center by amounts $ma$ and $nb$ in the row and column directions. In the second piece 129 of the electric bonding intermediary, the metallic wires 121 are so located that the position of the metallic wire 121 in the row $m$ and column $n$ is offset from the center by amounts $mac$ and $nbc$ in the row and column directions. In the third piece 130 of the electric bonding intermediary, the metallic wires 121 are so located that the position of the metallic wire 121 in row $m$ and column $n$ is offset from the center by amounts $mad$ and $nbd$ in the line and column directions. The values $a$, $b$, $c$ and $d$ are so determined that the metallic members in each piece can make electric contact only with the metallic members which are immediately above and below these metallic members but do not contact with metallic members laterally offset therefrom. Then, the electric bonding intermediary 125 is completed by stacking three pieces of the member and then bonding them together by, for example, applying heat and pressure.

Although the metallic members in each piece of elementary bonding intermediary member are regularly arranged in the form of a matrix having $m$ rows and $n$ columns, this is not exclusive and the metallic members in each piece may be disposed in a random manner, provided that the metallic members in each piece can make electric contact only with the metallic members which are immediately above and below these metallic members but do not contact with metallic members laterally offset therefrom.

It is also to be understood that the electric bonding intermediary may be composed of two pieces of elementary members or four or more elementary members, although a bonding intermediary consisting of three elementary members was specifically mentioned.

The bonding by application of heat and pressure also is illustrative, and various other suitable methods such as a mere pressing and adhesion can be employed as the occasion demands.

The electric bonding intermediary may be modified such that it has projections as is the case of the bonding intermediary shown in Figs. 15A, 15B or such that it has bumps as is the case of the bonding intermediary shown in Figs. 16A, 16B.

Superior reliability of electrical connection was confirmed also in this case.

(18th Embodiment)

Fig. 20A is a sectional view of a half-finished electric bonding intermediary suitable for use in the 18th embodiment of the present invention. Figs. 20B and 20C are a perspective view and a sectional view of the bonding intermediary.

This bonding intermediary is prepared by the following method. A pair of metal wire guide plates 131 and 132 are prepared and metal wires 121 are threaded through holes 133, 134 formed in these guide plates 131, 132. Then, the wires are tensed at a suitable level of tension. Subsequently, the space between the guide plates 131, 132 is filled with a resin 123. After the setting of the resin, the guide plates 131, 132 are demounted, whereby the electric bonding intermediary 125 is formed. The electric bonding intermediary may be modified such that it has projections as is the case of the bonding intermediary shown in Figs. 15A, 15B or such that it has bumps as is the case of the bonding intermediary shown in Figs. 16A, 16B. Each of the first and second electric circuit components 101 and 104 may be one selected from a group of components including semiconductor devices, circuit boards and lead frames.

(19th Embodiment)

A 19th embodiment of the present invention will be described with specific reference to Figs. 9A, 9B and 10A to 10C.

The 19th embodiment has an electric bonding intermediary 125 which includes an insulator 111 and a plurality of metallic members 107 of a metal or an alloy embedded in the insulator 101 in such a manner that the metallic members 107 are electrically insulated from one another and that one ends of the metallic members 107 are exposed on one side of the insulator adjacent to the first circuit board 101 while other ends are exposed on the other side of the insulator 111 adjacent to the second circuit board 104, the insulator 111 containing fillers (not shown) of a metal or an alloy in the form of powder particles or fibers dispersed therein. The electric circuit device of the 19th embodiment includes the circuit board 101 as a first electric circuit component with bonding areas 102, the second circuit board 104 as a second electric circuit component with bonding areas 105, and the electric bonding intermediary 125 placed between both circuit boards 101, 104 and connected to the bonding areas 102, 105 thereby providing electrical connection between the first and the second circuit boards 101 and 104.

This embodiment will be described in more detail hereinunder. The electric bonding intermediary 125 will be described first through explanation of an example of a process for producing the same.

Figs. 10A to 10C illustrate an example of the process for producing the electric bonding intermediary 125 used in the 19th embodiment.

As shown in Fig. 10A, a metallic wire 121 made of a metal such as gold or a suitable alloy and having a diameter of about 20 μm is turned around a plurality of bars 122 at a pitch of 40 μm, and the wire 121 together with the bars 122 are embedded in a resin body 123 such as of polyimide resin. Before embedding the metallic wire 121, powdered Ag is mixed in the resin material and the resin material was stirred so that the powdered Ag is dispersed in the resin material. The resin after setting serves as an insulator. After the setting of the resin, the resin body 123 is sliced as indicated by broken lines 124, whereby a plurality of pieces of elementary electric bonding intermediary 125 are obtained as shown in Figs. 10B and 10C.

Although in this embodiment the dispersion of the powder fillers is effected by stirring the resin, this is only illustrative and other suitable dispersing method can be used equally well.

In this electric bonding intermediary 125, the segments of the metallic wires 121 constitute the metallic members 107, while the resin body 123 constitutes the insulator 111.

In this electric bonding intermediary 125, the metallic wires 121 as the metallic members are insulated from one another by the resin 123. It will be seen that one ends of the metallic wires 121 are exposed on the surface of the electric bonding intermediary 125 adjacent to the first circuit board 101, while the other ends of the same are exposed on the surface of the electric bonding intermediary 125 adjacent to the second circuit board 104. These exposed portions of the metallic wires 121 constitute bonding areas 108, 109 where the bonding intermediary is to be bonded to the circuit boards 101 and 104.

The first and the second circuit boards 101 and 104 are then set together with the electric bonding intermediary 125 interposed therebetween. As will be seen from Figs. 9A and 9B, the circuit boards 101, 104 are provided with a multiplicity of bonding areas 102, 105 within the areas thereof.

The bonding areas 102 of the first circuit board 101 are exposed at positions corresponding to the bonding areas 105 of the second circuit board 104 and the bonding areas 108, 109 of the electric bonding intermediary 125.

Then, the first circuit board 101 and the electric bonding intermediary 125 are located with respect to each other such that the bonding areas 102 on the first circuit board 101 and the bonding areas 108 of the electric bonding intermediary 125 are aligned, and then the aligned bonding areas are mutually alloyed. Alternatively, the second circuit board 104 and the electric bonding intermediary 125 are located with respect to each other such that the bonding areas 105 on the second circuit board 104 and the bonding areas 109 of the electric bonding intermediary 125 are aligned, and then the aligned bonding areas are mutually connected.

The state of electrical connection or bonding in the 19th embodiment thus constructed was examined and superior reliability of the electrical connection was confirmed. Heat radiation characteristics also were found to be excellent.

(20th Embodiment)

Figs. 11A and 11B show a 20th embodiment of the invention.

The 20th embodiment was constructed by using, as the first electric circuit component, a circuit board 51 having bonding areas 52 and, as the second electric circuit component, a semiconductor device 4 having a multiplicity of bonding areas 5 within the area thereof.

The electric bonding intermediary 125, containing fillers in the form of powder particles and/or fibers dispersed therein, was designed to be equal in size to the semiconductor device 4.

Other portions are materially the same as those in the 19th embodiment.

Superior reliability of the electrical connection was confirmed also in this embodiment. Heat radiation characteristics also were excellent.

(21st Embodiment)

A 21st embodiment of the invention will be made with reference to Fig. 12.

The 21st embodiment is constructed by using the semiconductor device 4 as the first electric circuit component and the circuit board 51 as the second electric circuit component.

After the completion of the connection, a lead frame 1 was connected to the upper side of the circuit board 51 and then the upper surface of the thus obtained assembly was sealed with a resin 63.

Other portions are materially the same as those of the 19th embodiment.

Superior reliability of the electrical connection was confirmed also in this embodiment. Heat radiation characteristics also were found to be excellent.

(22nd Embodiment)

A 22nd embodiment of the present invention will be described with reference to Fig. 13.

The 22nd embodiment was constructed by using the semiconductor device 4 as the first electric circuit component and another semiconductor device 4' as the second electric circuit component.

In this embodiment, the electric bonding intermediary is designed to correspond in size to the semiconductor device 4' and a lead frame 1 is connected to the ends of the metallic members of the bonding intermediary 125 exposed to the same side as the semiconductor device 4.

Other portions are materially the same as those of the 21st embodiment.

Superior reliability of the electrical connection was confirmed also in this embodiment. Heat radiation characteristics also were excellent.

(23rd Embodiment)

A 23rd embodiment of the present invention will be described with reference to Figs. 14A and 14B.

In the 23rd embodiment, circuit boards 101, 104, which are coated by insulating films 103, 106 at portions other than the bonding areas, are used as the first and second electric circuit components, respectively.

As will be understood from Figs. 15A and 15B, in the electric bonding intermediary 125 used in this embodiment having an insulator containing fillers in the form of powder particles or fibers, the exposed ends of the metallic members 107 are slightly projected from the surfaces of the resin insulator 111.

This type of electric bonding intermediary 125 can be fabricated by preparing a member of the type shown in Figs. 10B and 10C described before by following the process explained in connection with the 19th embodiment, and subjecting the member to an etching until the metallic wires 121 project from the surfaces of the polyimide resin body 123 by a length of, for example, 10 μm or so.

The fabrication of this type os electric bonding intermediary by etching is only illustrative and other suitable chemical or mechanical methods can be used equally well.

Other portions are materially the same as those of the 19th embodiment.

It is possible to form bumps 150 as shown in Figs. 16A and 16B, by placing the electric bonding intermediary 125 between a pair of dies having recesses corresponding to the metallic wires 121 and then compacting the dies so as to collapse the projecting portions 126 of the metallic wires 121. The provision of the bumps 150 effectively prevent the metallic wires from coming off the insulator 111.

It will be seen that the segments of the metallic wire 121 constitute the metallic members 107, while the resin body 123 constitutes the insulator 111.

The formation of the bumps may be heating and melting the projections or by other suitable method.

High reliability of electrical connection was confirmed also in this case. Heat radiation characteristics also were found to be excellent.

(24th Embodiment)

A 24th embodiment will be described with reference to Figs. 17A and 17B. This embodiment features the use of a semiconductor device 4 as the first electric circuit component and a lead frame 1 as the second circuit component.

Other portions are materially the same as those in the 23rd embodiment.

A superior reliability of the electrical connection was confirmed also in this embodiment. Heat radiation characteristics also were found to be excellent.

(25th Embodiment)

A 25th embodiment will be described with reference to Figs. 18A and 18B.

This embodiment features the use of an electric bonding intermediary 125 which is a modification of that 125 used in the 23rd embodiment. More specifically, the bonding intermediary 125 used in the 25th embodiment has a smaller pitch of the metallic members than that in the 23rd embodiment. Thus, in the 23rd embodiment, the pitch of the metallic members 107 used in the electric bonding intermediary is smaller than the pitch of the bonding areas of the first electric circuit component.

The 23rd embodiment described before essentially requires that the electric bonding intermediary 125 be located with respect to the first and the second circuit boards 101, 104 because the bonding areas of the electric bonding intermediary 125 are positioned to correspond to the bonding areas of the first and the second circuit boards 101, 104. In the seventh embodiment, however, it is not necessary to precisely locate the electric bonding intermediary with respect to both circuit boards 101, 104, though these circuit boards 101, 104 have to be precisely located with respect to each other. Thus, in the seventh embodiment, it is possible to attain the electrical connection without requiring any precise location of the electric bonding intermediary 125 provided that the size and pitch (d11, P11) of the bonding areas of the first and second circuit boards and those (d12, P12) of the bonding areas of the electric bonding intermediary are suitably determined in relation to each other.

Superior reliability of the electrical connection was confirmed also in this case. Heat radiation characteristics also were found to be excellent.

(26th Embodiment)

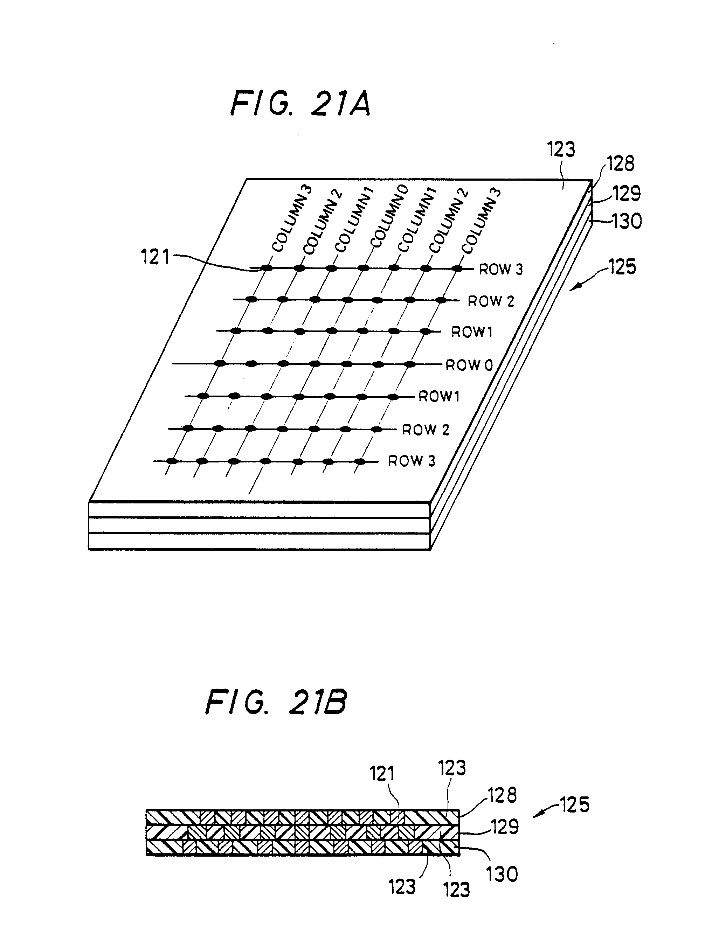

Figs. 21A and 21B show an electric bonding intermediary suitable for use in 26th embodiment of the present invention, in perspective view and in sectional view, respectively.

An example of the method for fabricating this electric bonding intermediary will be described hereinunder. Three pieces 128, 129 and 130 of elementary electric bonding intermediary are prepared by the method which was explained before in connection with the 19th embodiment.

In the first piece 128 of the electric bonding intermediary, the metallic wires 121 are so located that the position of the metallic wire 121 in a row $m$ and a column $n$ is offset from the center by amounts $ma$ and $nb$ in the line and column directions. In the second piece 129 of the electric bonding intermediary, the metallic wires 121 are so located that the position of the metallic wire 121 in row $m$ and column $n$ is offset from the center by amounts $mac$ and $nbc$ in the line and column directions. In the third piece 130 of the electric bonding intermediary, the metallic wires 121 are so located that the position of the metallic wire 121 in row $m$ and column $n$ is offset from the center by amounts $mad$ and $nbd$ in the line and column directions. The values $a$, $b$, $c$ and $d$ are so determined that the metallic members in each piece can make electric contact only with the metallic members which are immediately above and below these metallic members but do not contact with metallic members laterally offset therefrom. Then, the electric bonding intermediary 125 is completed by stacking three pieces of the member and then bonding them together by, for example, applying heat and pressure.

Although the metallic members in each piece of elementary bonding intermediary member are regularly arranged in the form of a matrix having m rows and n columns, this is not exclusive and the metallic members in each piece may be disposed in a random manner, provided that the metallic members in each piece can make electric contact only with the metallic members which are immediately above and below these metallic members but do not contact with metallic members laterally offset therefrom.

It is also to be understood that the electric bonding intermediary may be composed of two pieces of elementary members or four or more elementary members, although a bonding intermediary consisting of three elementary members was specifically mentioned.

The bonding by application of heat and pressure also is illustrative, and various other suitable methods such as a mere pressing and adhesion can be employed as the occasion demands.

The electric bonding intermediary may be modified such that it has projections as is the case of the bonding intermediary shown in Figs. 15A, 15B or such that it has bumps as is the case of the bonding intermediary shown in Figs. 16A, 16B.

Superior reliability of electrical connection was confirmed also in this case. Heat radiation characteristics also were found to be excellent.

(27th Embodiment)

Fig. 20A is a sectional view of a half-finished electric bonding intermediary suitable for use in the 27th embodiment of the present invention. Figs. 20B and 20C are a perspective view and a sectional view of the bonding intermediary.

This bonding intermediary is prepared by the following method. A pair of metal wire guide plates 131 and 132 are prepared and metal wires 121 are threaded through holes 133, 134 formed in these guide plates 131, 132. Then, the wires are tensed at a suitable level of tension. Subsequently, the space between the guide plates 131, 132 is filled with a resin 123. Before the filling, fillers in the form of powder particles or fibers are mixed and dispersed in the resin 123. After the setting of the resin, the guide plates 131, 132 are demounted, whereby the electric bonding intermediary 125 is formed. The electric bonding intermediary may be modified such that it has projections as is the case of the bonding intermediary shown in Figs. 15A, 15B or such that it has bumps as is the case of the bonding intermediary shown in Figs. 16A, 16B.

Each of the first and second electric circuit components 101 and 104 may be one selected from a group of components including semiconductor devices, circuit boards and lead frames.

Superior reliability of electrical connection was confirmed also in this embodiment. Heat radiation characteristics also were found to be excellent.

(28th Embodiment)

A 28th embodiment of the present invention will be described with specific reference to Figs. 9A, 9B and 10A to 10C.

The 28th embodiment is an electric circuit device which includes a circuit board 101 as a first electric circuit component with bonding areas 102, a second circuit board 104 as a second electric circuit component with bonding areas 105, and an electric bonding intermediary 125 placed between both circuit boards 101, 104 and bonded to the bonding areas 102, 105 thereby providing electrical connection between the first and the second circuit boards, wherein the electric bonding intermediary 125 includes an insulator 111 and a plurality of metallic members 107 embedded in the insulator 101 in such a manner that the metallic members 107 are electrically insulated from one another and that one ends of the metallic members 107 are exposed on one side of the insulator adjacent to the first circuit board 101 while other ends are exposed on the other side of the insulator 111 adjacent to the second circuit board 104, the insulator containing powder particles and/or fibers (both not shown) of a metal or an alloy, and wherein bonding is attained by alloying between the bonding areas 102 of the first circuit board 101 and the ends of the metallic members 107 exposed to the same side as the first circuit board 101 or, alternatively, between the bonding areas 105 of the second circuit board 104 and the ends of the metallic members 107 exposed to the same side as the second circuit board 104.

This embodiment will be described in more detail hereinunder. The electric bonding intermediary 125 will be described first through explanation of an example of a process for producing the same.

Figs. 10A to 10C illustrate an example of the process for producing the electric bonding intermediary 125 used in the first embodiment.

As shown in Fig. 10A, a metallic wire 121 made of a metal such as gold or a suitable alloy and having a diameter of about 20 $\mu m\varnothing$ is turned around a plurality of bars 122 at a pitch of 40 $\mu m$, and the wire 121 together with the bars 122 are embedded in a resin body 123 such as of polyimide resin. Before embedding the metallic wire 121 and the bars 122, powdered Ag is mixed with the resin and the resin is stirred so that the powder particles of Ag are dispersed in the resin 123. The resin 123 after setting serves as the insulator. After the setting of the resin, the resin body 123 is sliced as indicated by broken lines 124, whereby a plurality of pieces of elementary electric bonding intermediary 125 are obtained as shown in Figs. 10B and 10C.

Although the dispersion is effected in this embodiment by stirring the resin containing the powder particles mixed therein, the dispersion may be effected by other means than stirring.

In the electric bonding intermediary thus constructed, the segments of the metallic wire 121 constitute the metallic members 107, while the resin 123 constitutes the insulator 111.

In this electric bonding intermediary 125, the metallic wires 121 as the metallic members are insulated from one another by the resin 123. It will be seen that one ends of the metallic wires 121 are exposed on the surface of the electric bonding intermediary 125 adjacent to the first circuit board 101, while the other ends of the same are exposed on the surface of the electric bonding intermediary 125 adjacent to the second circuit board 104. These exposed portions of the metallic wires 121 constitute bonding areas 108, 109 where the bonding intermediary is to be bonded to the circuit boards 101 and 104.

The first and the second circuit boards 101 and 104 are then set together with the electric bonding intermediary 125 interposed therebetween. As will be seen from Figs. 9A and 9B, the circuit boards 101, 104 are provided with a multiplicity of bonding areas 102, 105 within the areas thereof.

The bonding areas 102 of the first circuit board 101 are exposed at positions corresponding to the bonding areas 105 of the second circuit board 104 and the bonding areas 108, 109 of the electric bonding intermediary 125.

Then, the first circuit board 101 and the electric bonding intermediary 125 are located with respect to each other such that the bonding areas 102 on the first circuit board 101 and the bonding areas 108 of the electric bonding intermediary 125 are aligned, and then one pair of the aligned bonding areas is connected by alloying. Another pair of the bonding areas is connected by any other suitable methods. Alternatively, the second circuit board 104 and the electric bonding intermediary 125 are located with respect to each other such that the bonding areas 105 on the second circuit board 104 and the bonding areas 109 of the electric bonding intermediary 125 are aligned, and then the aligned bonding areas are mutually alloyed. Then, the other circuit board is connected by another suitable connecting method.

Thus, the first embodiment can be assembled by either one of the following two methods (1) and (2).

(1) The first circuit board 101 is first located with respect to the electric bonding intermediary 125 and the bonding areas 102 of the first circuit board 101 are bonded by alloying to the bonding areas 108 of the electric bonding intermediary 125. Then, the second circuit board 104 is located with respect to the electric bonding intermediary 125 and the bonding areas 105 of the second circuit board 104 are connected to the bonding areas 109 of the electric bonding intermediary 125 by pressing.

(2) The second circuit board 104 is first located with respect to the electric bonding intermediary 125 and the bonding areas 105 of the second circuit board 104 are bonded by alloying to the bonding areas 109 of the electric bonding intermediary 125. Then, the first circuit board 101 is located with respect to the electric bonding intermediary 125 and the bonding areas 102 of the first circuit board 101 are connected to the bonding areas 108 of the electric bonding intermediary 125 by pressing.

The state of electrical connection or bonding in the first embodiment thus constructed was examined and superior reliability of the electrical connection was confirmed.

Heat radiation characteristics also were found to be excellent.

(29th Embodiment)

A 29th embodiment will be described with reference to Figs. 11A and 11B.

The 29th embodiment was constructed by using, as the first electric circuit component, a circuit board 51 having bonding areas 52 and, as the second electric circuit component, a semiconductor device 4 having a multiplicity of bonding areas 5 within the area thereof.

The bonding by alloying was effected to achieve electrical connection between the bonding areas 5 of the semiconductor device 4 and the bonding areas 54 of the electric bonding intermediary 125 containing powder particles and/or fibers of a metal or an alloy dispersed in the insulator thereof.

The electric bonding intermediary 125, containing powder particles and/or fibers of a metal or an alloy dispersed in the insulator thereof, was designed to be equal in size to the semiconductor device 4.

After the bonding by alloying, a lead frame 55 was connected to the underside of the circuit board 51.

Other portions are materially the same as those in the 28th embodiment.

Superior reliability of the electrical connection was confirmed also in this embodiment. Heat radiation characteristics also were found to be excellent.

(30th Embodiment)

A 30th embodiment will be described with reference to Fig. 12.

The 30th embodiment is constructed by using the semiconductor device 4 as the first electric circuit component and the circuit board 51 as the second electric circuit component.

After the completion of the connection, a lead frame 1 was connected to the upper side of the circuit board 51 and then the upper surface of the thus obtained assembly was sealed with a resin 63.

Other portions are materially the same as those of the 28th embodiment.

Superior reliability of the electrical connection was confirmed also in this embodiment. Heat radiation characteristics also were excellent.

(31st Embodiment)

A 31st embodiment of the invention will be described with reference to Fig. 13.

The 31st embodiment is constructed by using the semiconductor device 4 as the first electric circuit component and another semiconductor device 4' as the second electric circuit component.

In this embodiment, the electric bonding intermediary is designed to correspond in size to the semiconductor device 4' and a lead frame 1 is connected to the ends of the metallic members of the bonding intermediary 125 exposed to the same side as the semiconductor device 4.

Other portions are materially the same as those of the 30th embodiment.

Superior reliability of the electrical connection was confirmed also in this embodiment. Heat radiation characteristics also were found to be excellent.

(32nd Embodiment)

A 32nd embodiment of the invention will be described with reference to Figs. 14A and 14B. In the 32nd embodiment, circuit boards 101, 104, which are coated by insulating films 103, 106 at portions other than the bonding areas, are used as the first and second electric circuit components, respectively.

As will be understood from Figs. 15A and 15B, in the electric bonding intermediary 125 used in this embodiment, containing powder particles and/or fibers of a metal or an alloy dispersed in the insulator thereof, the exposed ends of the metallic members 107 are slightly projected from the surfaces of the resin insulator 111.

This type of electric bonding intermediary 125 can be fabricated by preparing a member of the type shown in Figs. 10B and 10C described before by following the process explained in connection with the 28th embodiment, and subjecting both surfaces of the member to an etching until the metallic wires 121 project from the surfaces of the polyimide resin body 123 by a length of, for example, 10 μm or so.

The fabrication of this type of electric bonding intermediary by etching is only illustrative and other suitable chemical or mechanical methods can be used equally well.

Other portions are materially the same as those of the 28th embodiment.

It is possible to form bumps 150 as shown in Figs. 16A and 16B, by placing the electric bonding intermediary 125 between a pair of dies having recesses corresponding to the metallic wires 121 and then compacting the dies so as to collapse the projecting portions 126 of the metallic wires 121. The provision of the bumps 150 effectively prevent the metallic wires from coming off the insulator 111.

In this embodiment also, the segments of the metallic wire 121 constitute the metallic members 107, while the resin 123 constitutes the insulator 111.

The bumps may also be formed by heating and melting the projections or other suitable method.

High reliability of electrical connection was confirmed also in this case. Heat radiation characteristics also were found to be excellent.

(33th Embodiment)

A 33th embodiment will be described with reference to Figs. 17A and 17B. This embodiment features the use of a semiconductor device 4 as the first electric circuit component and a lead frame 1 as the second circuit component.

Other portions are materially the same as those in the 32nd embodiment.

Superior reliability of the electrical connection was confirmed also in this embodiment. Heat radiation characteristics also were found to be excellent.

(34th Embodiment)

A 34th embodiment will be described with reference to Figs. 18A and 18B.

This embodiment features the use of an electric bonding intermediary 125 which is a modification of that 125 used in the 32nd embodiment. More specifically, the bonding intermediary 125 used in the 34th embodiment has a smaller pitch of the metallic members than that in the 32nd embodiment. Thus, in the 34th embodiment, the pitch of the metallic members 107 used in the electric bonding intermediary is smaller than the pitch of the bonding areas of the first electric circuit component.

The 32nd embodiment described before essentially requires that the electric bonding intermediary 125 be located with respect to the first and the second circuit boards 101, 104 because the bonding areas of the electric bonding intermediary 125 are positioned to correspond to the bonding areas of the first and the second circuit boards 101, 104. In the 34th embodiment, however, it is not necessary to precisely locate the electric bonding intermediary 125 with respect to both circuit boards 101, 104, though these circuit boards 101, 104 have to be precisely located with respect to each other. Thus, in the seventh embodiment, it is possible to attain the electrical connection without requiring any precise location of the electric bonding intermediary 125 provided that the size and pitch (d11, P11) of the bonding areas of the first and second circuit boards and those (d12, P12) of the bonding areas of the electric bonding intermediary are suitably determined in relation to each other.

Superior reliability of the electrical connection was confirmed also in this case. Heat radiation characteristics also were found to be excellent.

(35th Embodiment)

An electric bonding intermediary used in a 35th embodiment of the invention will be described by referring back to Figs. 21A and 21B which are a perspective view and a sectional view of the bonding intermediary.

An example of the method for fabricating this electric bonding intermediary will be described hereinunder. Three pieces 128, 129 and 130 of elementary electric bonding intermediary, each having an insulator containing powder particles and/or fibers of a metal or an alloy dispersed therein, are prepared by the method which was explained before in connection with the 28th embodiment.

In the first piece 128 of the electric bonding intermediary, the metallic wires 121 are so located that the position of the metallic wire 121 in a row $m$ and a column $n$ is offset from the center by amounts $ma$ and $nb$ in the line and column directions. In the second piece 129 of the electric bonding intermediary, the metallic wires 121 are so located that the position of the metallic wire 121 in row $m$ and column $n$ is offset from the center by amounts $mac$ and $nbc$ in the line and column directions. In the third piece 130 of the electric bonding intermediary, the metallic wires 121 are so located that the position of the metallic wire 121 in row $m$ and column $n$ is offset from the center by amounts $mad$ and $nbd$ in the line and column directions. The values $a$, $b$, $c$ and $d$ are so determined that the metallic members in each piece can make electric contact only with the metallic members which are immediately above and below these metallic members but do not contact with metallic members laterally offset therefrom. Then, the electric bonding intermediary 125 is completed by stacking three pieces of the member and then bonding them together by, for example, applying heat and pressure.

Although the metallic members in each piece of elementary bonding intermediary member are regularly arranged in the form of a matrix having $m$ rows and $n$ columns, this is not exclusive and the metallic members in each piece may be disposed in a random manner, provided that the metallic members in each piece can make electric contact only with the metallic members which are immediately above and below these metallic members but do not contact with metallic members laterally offset therefrom.

It is also to be understood that the electric bonding intermediary may be composed of two pieces of elementary members or four or more elementary members, although a bonding intermediary consisting of three elementary members was specifically mentioned.

The bonding by application of heat and pressure also is illustrative, and various other suitable methods such as a mere pressing and adhesion can be employed as the occasion demands.

The electric bonding intermediary may be modified such that it has projections as is the case of the bonding intermediary shown in Figs. 15A, 15B or such that it has bumps as is the case of the bonding intermediary shown in Figs. 16A, 16B.

Superior reliability of electrical connection was confirmed also in this case. Heat radiation characteristics also were found to be excellent.

(36th Embodiment)

An electric bonding intermediary suitable for use in a 36th embodiment will be described with reference to Figs. 20A to 20C. Fig. 20A is a sectional view of a half-finished electric bonding intermediary suitable for use in the 63rd embodiment of the present invention. Figs. 20B and 20C are a perspective view and a sectional view of the bonding intermediary.

This bonding intermediary is prepared by the following method. A pair of metal wire guide plates 131 and 132 are prepared and metal wires 121 are threaded through holes 133, 134 formed in these guide plates 131, 132. Then, the wires are tensed at a suitable level of tension. Subsequently, the space between the guide plates 131, 132 is filled with a resin 123. The fillers in the form of powder particles or fibers are beforehand added to and dispersed in the resin 123. After the setting of the resin, the guide plates 131, 132 are demounted, whereby the electric bonding intermediary 125 is formed. The electric bonding intermediary may be modified such that it has projections as is the case of the bonding intermediary shown in Figs. 15A, 15B or such that it has bumps as is the case of the bonding intermediary shown in Figs. 16A, 16B.

Each of the first and second electric circuit components 101 and 104 may be one selected from a group of components including semiconductor devices, circuit boards and lead frames.

Superior reliability of the electrical connection, as well as excellent heat radiation characteristics, was confirmed also in this embodiment.

(37th Embodiment)

A 37th embodiment of the present invention will be described by making reference back to Figs. 9A, 9B and 10A to 10C.

The 37th embodiment is an electric circuit device which includes a circuit board 101 as a first electric circuit component with bonding areas 102, a second circuit board 104 as a second electric circuit component with bonding areas 105, and an electric bonding intermediary 125 placed between both circuit boards 101, 104 and bonded to the bonding areas 102, 105 thereby providing electrical connection between the first and the second circuit boards, wherein the electric bonding intermediary 125 includes an insulator 111 and a plurality of metallic members 107 embedded in the insulator 101 in such a manner that the metallic members 107 are electrically insulated from one another and that one ends of the metallic members 107 are exposed on one side of the insulator adjacent to the first circuit board 101 while other ends are exposed on the other side of the insulator 111 adjacent to the second circuit board 104, the insulator 111 containing powder particles and/or fibers of a metal or an alloy dispersed therein, and wherein bonding is attained by alloying between the bonding areas 102 of the first circuit board 101 and the ends of the metallic members 107 exposed to the same side as the first circuit board 101 and also between the bonding areas 105 of the second circuit board 104 and the ends of the metallic members 107 exposed to the same side as the second circuit board 104.

This embodiment will be described in more detail hereinunder. The electric bonding intermediary 125 will be described first through explanation of an example of a process for producing the same.

Figs. 10A to 10C illustrate an example of the process for producing the electric bonding intermediary 125 used in the 37th embodiment.

As shown in Fig. 10A, a metallic wire 121 made of a metal such as gold or a suitable alloy and having a diameter of about 20 $\mu$m$\emptyset$ is turned around a plurality of bars 122 at a pitch of 40 $\mu$m, and the wire 121 together with the bars 122 are embedded in a resin body 123 such as of polyimide resin. Before the metallic wire 121 and the bars 122 are embedded, powdered Ag is added to the resin and the resin is stirred so that the particles of Ag are dispersed in the resin. The resin after setting serves as the insulator. After the setting of the resin, the resin body 123 is sliced as indicated by broken lines 124, whereby a plurality of pieces of electric bonding intermediary 125 are obtained as shown in Figs. 108 and 10C.

Although in this embodiment the dispersion of the powder particles is effected by stirring the resin, this method is only illustrative and the invention does not exclude the use of other suitable dispersion method.

In the thus completed electric bonding intermediary 125, the segments of the metal wires 121 constitute the metallic members 107, while the resin 123 constitutes the insulator 111.

In this electric bonding intermediary 125, the metallic wires 121 as the metallic members are insulated from one another by the resin 123. It will be seen that one ends of the metallic wires 121 are exposed on the surface of the electric bonding intermediary 125 adjacent to the first circuit board 101, while the other ends of the same are exposed on the surface of the electric bonding intermediary 125 adjacent to the second circuit board 104. These exposed portions of the metallic wires 121 constitute bonding areas 108, 109 where the bonding intermediary is to be bonded to the circuit boards 101 and 104.

The first and the second circuit boards 101 and 104 are then set together with the electric bonding intermediary 125 interposed therebetween. As will be seen from Figs. 9A and 9B, the circuit boards 101, 104 used in this embodiment are provided with a multiplicity of bonding areas 102, 105 within the areas thereof.

The bonding areas 102 of the first circuit board 101 are exposed at positions corresponding to the bonding areas 105 of the second circuit board 104 and the bonding areas 108, 109 of the electric bonding intermediary 125.

Then, the first circuit board 101 and the electric bonding intermediary 125 are located with respect to each other such that the bonding areas 102 on the first circuit board 101 and the bonding areas 108 of the electric bonding intermediary 125 are aligned, and then the aligned bonding areas are mutually alloyed. Alternatively, the second circuit board 104 and the electric bonding intermediary 125 are located with respect to each other such that the bonding areas 105 on the second circuit board 104 and the bonding areas 109 of the electric bonding intermediary 125 are aligned, and then the aligned bonding areas are mutually alloyed. Then, the other circuit board is connected by, for example, mechanical pressing.

The bonding of the first circuit board 101, electric bonding intermediary 125 and the second circuit board 104 can be conducted by any one of the following three methods (1), (2) and (3).

(1) The first circuit board 101, the electric bonding intermediary 125 and the second circuit board 104 are located with respect to one another, and then alloying operation is effected simultaneously at the juncture between the bonding area 102 of the first circuit board 101 and the bonding area 108 of the electric bonding intermediary 125 and at the juncture between the bonding area 105 of the second circuit board 104 and the bonding area 109 of the electric bonding intermediary 125, thereby simultaneously bonding both circuit boards to the electric bonding intermediary 125.

(2) The first circuit board 101 is first located with respect to the electric bonding intermediary 125 and the bonding areas 102 of the first circuit board 101 are bonded by alloying to the bonding areas 108 of the electric bonding intermediary 125. Then, the second circuit board 104 is located with respect to the electric bonding intermediary 125 and the bonding areas 105 of the second circuit board 104 are bonded by alloying to the bonding areas 109 of the electric bonding intermediary 125.

(3) The second circuit board 104 is first located with respect to the electric bonding intermediary 125 and the bonding areas 105 of the second circuit board 104 are bonded by alloying to the bonding areas 109 of the electric bonding intermediary 125. Then, the first circuit board 101 is located with respect to the electric bonding intermediary 125 and the bonding areas 102 of the first circuit board 101 are bonded by alloying to the bonding areas 108 of the electric bonding intermediary 125.

The state of electrical connection or bonding in the 10th embodiment thus constructed was examined and superior reliability of the electrical connection was confirmed. Heat radiation characteristics also were found to be excellent.

(38th Embodiment)

A 38th embodiment will be described by making reference back to Figs. 11A and 11B.

The 38th embodiment was constructed by using, as the first electric circuit component, a circuit board 51 having bonding areas 52 and, as the second electric circuit component, a semiconductor device 4 having a multiplicity of bonding areas 5 within the area thereof.

The bonding by alloying was effected to achieve electrical connection between the bonding areas 5 of the semiconductor device 4 and the bonding areas 54 of the electric bonding intermediary 125 which contains powder particles and/or fibers of a metal or an alloy, as well as between the bonding areas 52 of the circuit board 51 and the bonding areas of the electric bonding intermediary 125.

The electric bonding intermediary 125, which contains powder particles and/or fibers of a metal or an alloy, was designed to be equal in size to the semiconductor device 4.

After the bonding by alloying, a lead frame 55 was connected to the underside of the circuit board 51.

Other portions are materially the same as those in the 37th embodiment.

Superior reliability of the electrical connection was confirmed also in this embodiment. Heat radiation characteristics also were found to be excellent.

(39th Embodiment)

A 39th embodiment of the invention will be described by making reference back to Fig. 12.

The 39th embodiment is constructed by using the semiconductor device 4 as the first electric circuit component and the circuit board 51 as the second electric circuit component.

After the completion of the connection, a lead frame 1 is connected to the upper side of the circuit board 51 and then the upper surface of the thus obtained assembly is sealed with a resin 63.

Other portions are materially the same as those of the 37th embodiment.

Superior reliability of the electrical connection was confirmed also in this embodiment. Heat radiation characteristics also were found to be excellent.

(40th Embodiment)

A 40th embodiment will be described with reference to Fig. 13.

The 40th embodiment is constructed by using the semiconductor device 4 as the first electric circuit component and another semiconductor device 4' as the second electric circuit component.

In this embodiment, the electric bonding intermediary 125 is designed to correspond in size to the semiconductor device 4' and a lead frame 1 is connected to the ends of the metallic members of the bonding intermediary 125 exposed to the same side as the semiconductor device 4.

Other portions are materially the same as those of the 39th embodiment.

Superior reliability of the electrical connection was confirmed also in this embodiment. Heat radiation characteristics also were found to be excellent.

(41st Embodiment)

Figs. 14A and 14B show a 41st embodiment of the invention. In this 41st embodiment, circuit boards 101, 104, which are coated by insulating films 103, 106 at portions other than the bonding areas, are used as the first and second electric circuit components, respectively.

As will be understood from Figs. 15A and 15B, in the electric bonding intermediary 125 used in this embodiment, the exposed ends of the metallic members 107 are slightly projected from the surfaces of the resin insulator 111.

This type of electric bonding intermediary 125 can be fabricated, for example, by preparing a member of the type shown in Figs. 10B and 10C described before, and subjecting both surfaces of the member to an etching until the metallic wires 121 project from the surfaces of the polyimide resin body 123 by a length of, for example, 10 μm or so.

Then fabrication of this type os electric bonding intermediary by etching is only illustrative and other suitable chemical or mechanical methods can be used equally well.

Other portions are materially the same as those of the 37th embodiment.

It is possible to form bumps 150 as shown in Figs. 16A and 16B, by placing the electric bonding intermediary 125 between a pair of dies having recesses corresponding to the metallic wires 121 and then compacting the dies so as to collapse the projecting portions 126 of the metallic wires 121. The provision of the bumps 150 effectively prevent the metallic wires from coming off the insulator 111.

In this embodiment also, the segments of the metallic wire 121 constitute the metallic members 107, while the resin 123 constitutes the insulator 111.

The bumps may also be formed by heating and melting the projections or other suitable method.

High reliability of electrical connection was confirmed also in this case. Heat radiation characteristics also were found to be excellent.

(42nd Embodiment)

Figs. 17A and 17B show a 42nd embodiment. This embodiment features the use of a semiconductor device 4 as the first electric circuit component and a lead frame 1 as the second circuit component.

Other portions are materially the same as those in the 41st embodiment.

A superior reliability of the electrical connection was confirmed also in this embodiment. Heat radiation characteristics also were found to be excellent.

(43rd Embodiment)

Figs. 18A and 18B show a 43rd embodiment.

This embodiment features the use of an electric bonding intermediary 125 which is a modification of that 125 used in the 41st embodiment. More specifically, the bonding intermediary 125 used in the 43rd embodiment has a smaller pitch of the metallic members than that in the 41st embodiment. Thus, in the 43rd embodiment, the pitch of the metallic members 107 used in the electric bonding intermediary is smaller than the pitch of the bonding areas of the first electric circuit component.

The 41st embodiment described before essentially requires that the electric bonding intermediary 125 be located with respect to the first and the second circuit boards 101, 104 because the bonding areas of the electric bonding intermediary 125 are positioned to correspond to the bonding areas of the first and the second circuit boards 101, 104. In the 43rd embodiment, however, it is not necessary to precisely locate the electric bonding intermediary 125 with respect to both circuit boards 101, 104, though the circuit boards 101, 104 have to be precisely located with respect to each other. Thus, in the 14th embodiment, it is possible to attain the electrical connection without requiring any precise location of the electric bonding intermediary 125 provided that the size and pitch (d11, P11) of the bonding areas of the first and second circuit boards and those (d12, P12) of the bonding areas of the electric bonding intermediary are suitably determined in relation to each other.

A superior reliability of the electrical connection was confirmed also in this case. Heat radiation characteristics also were found to be excellent.

(44th Embodiment)

An electric bonding intermediary suitable for use in a 44th embodiment of the invention will be described by making reference back to Figs. 21A and 21B.

Figs. 21A and 21B show an electric bonding intermediary suitable for use in the 44th embodiment of the present invention, in perspective view and in sectional view, respectively.

An example of the method for fabricating this electric bonding intermediary will be described hereinunder. Three pieces 128, 129 and 130 of elementary electric bonding intermediary are prepared by the method which was explained before in connection with the 37th embodiment.

In the first piece 128 of the electric bonding intermediary, the metallic wires 121 are so located that the position of the metallic wire 121 in a row $m$ and a column $n$ is offset from the center by amounts $ma$ and $nb$ in the row and column directions. In the second piece 129 of the electric bonding intermediary, the metallic wires 121 are so located that the position of the metallic wire 121 in the row $m$ and column $n$ is offset from the center by amounts $mac$ and $nbc$ in the row and column directions. In the third piece 130 of the electric bonding intermediary, the metallic wires 121 are so located that the position of the metallic wire 121 in row $m$ and column $n$ is offset from the center by amounts $mad$ and $nbd$ in the line and column directions. The values $a$, $b$, $c$ and $d$ are so determined that the metallic members in each piece can make electric contact only with the metallic members which are immediately above and below these metallic members but do not contact with metallic members laterally offset therefrom. Then, the electric bonding intermediary 125 is completed by stacking three pieces of the member and then bonding them together by, for example, applying heat and pressure.

Although the metallic members in each piece of elementary bonding intermediary member are regularly arranged in the form of a matrix having $\underline{m}$ rows and $\underline{n}$ columns, this is not exclusive and the metallic members in each piece may be disposed in a random manner, provided that the metallic members in each piece can make electric contact only with the metallic members which are immediately above and below these metallic members but do not contact with metallic members laterally offset therefrom.

It is also to be understood that the electric bonding intermediary may be composed of two pieces of elementary members or four or more elementary members, although a bonding intermediary consisting of three elementary members was specifically mentioned.

The bonding by application of heat and pressure also is illustrative, and various other suitable methods such as a mere pressing and adhesion can be employed as the occasion demands.

The electric bonding intermediary may be modified such that it has projections as is the case of the bonding intermediary shown in Figs. 15A, 15B or such that it has bumps as is the case of the bonding intermediary shown in Figs. 16A, 16B.

Superior reliability of electrical connection was confirmed also in this case. Heat radiation characteristics also were found to be excellent.

(45th Embodiment)

A bonding intermediary suitable for use in the 45th embodiment will be described by making reference back to Figs. 20A to 20C. Fig. 20A is a sectional view of a half-finished electric bonding intermediary suitable for use in the 45th embodiment of the present invention. Figs. 20B and 20C are a perspective view and a sectional view of the bonding intermediary.

This bonding intermediary is prepared by the following method. A pair of metal wire guide plates 131 and 132 are prepared and metal wires 121 are threaded through holes 133, 134 formed in these guide plates 131, 132. Then, the wires are tensed at a suitable level of tension. Subsequently, the space between the guide plates 131, 132 is filled with a resin 123. Before the filling, the powdered particles and/or the fibers are added to and dispersed in the resin. After the setting of the resin, the guide plates 131, 132 are demounted, whereby the electric bonding intermediary 125 is formed. The electric bonding intermediary may be modified such that it has projections as is the case of the bonding intermediary shown in Figs. 15A, 15B or such that it has bumps as is the case of the bonding intermediary shown in Figs. 16A, 168.

Each of the first and second electric circuit components 101 and 104 may be one selected from a group of components including semiconductor devices, circuit boards and lead frames.

Superior reliability of electrical connection was confirmed, as well as excellent heat radiation characteristics.

(46th Embodiment)

A 46th embodiment of the present invention will be described with specific reference to Figs. 9A, 9B and 10A to 10C.

The 46th embodiment has an electric bonding intermediary 125 which includes an insulator 111 and a plurality of metallic members 107 of a metal or an alloy embedded in the insulator 101 in such a manner that the metallic members 107 are electrically insulated from one another and that one ends of the metallic members 107 are exposed on one side of the insulator adjacent to the first circuit board 101 while other ends are exposed on the other side of the insulator 111 adjacent to the second circuit board 104, the insulator 111 containing fillers (not shown) of an inorganic material in the form of powder particles or fibers dispersed therein. The electric circuit device of the 46th embodiment includes the circuit board 101 as a first electric circuit component with bonding areas 102, the second circuit board 104 as a second electric circuit component with bonding areas 105, and the electric bonding intermediary 125 placed between both circuit boards 101, 104 and connected to the bonding areas 102, 105 thereby providing electrical connection between the first and the second circuit boards 101 and 104.

This embodiment will be described in more detail hereinunder. The electric bonding intermediary 125 will be described first through explanation of an example of a process for producing the same.

Figs. 10A to 10C illustrate an example of the process for producing the electric bonding intermediary 125 used in the 46th embodiment.

As shown in Fig. 10A, a metallic wire 121 made of a metal such as gold or a suitable alloy and having a diameter of about 20 $\mu m \varnothing$ is turned around a plurality of bars 122 at a pitch of 40 $\mu m$, and the wire 121 together with the bars 122 are embedded in a resin body 123 such as of polyimide resin. Before embedding the metallic wire 121, powder of $SiO_2$ is mixed in the resin material and the resin material was stirred so that the powdered $SiO_2$ is dispersed in the resin material. The resin after setting serves as an insulator. After the setting of the resin, the resin body 123 is sliced as indicated by broken lines 124, whereby a plurality of pieces of elementary electric bonding intermediary 125 are obtained as shown in Figs. 10B and 10C.

Although in this embodiment the dispersion of the resin powder is effected by stirring the resin, this is only illustrative and other suitable dispersing method can be used equally well.

It is also to be noted that the use of $SiO_2$ powder is not exclusive and any other suitable inorganic material in the form of powder particles or fibers can be used instead the $SiO_2$ powder.

In this electric bonding intermediary 125, the segments of the metallic wires 121 constitute the metallic members 107, while the resin body 123 constitutes the insulator 111.

In this electric bonding intermediary 125, the metallic wires 121 as the metallic members are insulated from one another by the resin 123. It will be seen that one ends of the metallic wires 121 are exposed on the surface of the electric bonding intermediary 125 adjacent to the first circuit board 101, while the other ends of the same are exposed on the surface of the electric bonding intermediary 125 adjacent to the second circuit board 104. These exposed portions of the metallic wires 121 constitute bonding areas 108, 109 where the bonding intermediary is to be bonded to the circuit boards 101 and 104.

The first and the second circuit boards 101 and 104 are then set together with the electric bonding intermediary 125 interposed therebetween. As will be seen from Figs. 9A and 9B, the circuit boards 101, 104 are provided with a multiplicity of bonding areas 102, 105 within the areas thereof.

The bonding areas 102 of the first circuit board 101 are exposed at positions corresponding to the bonding areas 105 of the second circuit board 104 and the bonding areas 108, 109 of the electric bonding intermediary 125.

Then, the first circuit board 101 and the electric bonding intermediary 125 are located with respect to each other such that the bonding areas 102 on the first circuit board 101 and the bonding areas 108 of the electric bonding intermediary 125 are aligned, and then the aligned bonding areas are mutually alloyed. Alternatively, the second circuit board 104 and the electric bonding intermediary 125 are located with respect to each other such that the bonding areas 105 on the second circuit board 104 and the bonding areas 109 of the electric bonding intermediary 125 are aligned, and then the aligned bonding areas are mutually alloyed.

The state of electrical connection or bonding in the 46th embodiment thus constructed was examined and superior reliability of the electrical connection was confirmed.

(47th Embodiment)

A 47th embodiment will be described by making reference back to Figs. 11A and 11B.

The 47th embodiment is constructed by using, as the first electric circuit component, a circuit board 51 having bonding areas 52 and, as the second electric circuit component, a semiconductor device 4 having a multiplicity of bonding areas 5 within the area thereof.

The electric bonding intermediary 125, containing fillers in the form of powder particles and/or fibers dispersed therein, was designed to be equal in size to the semiconductor device 4.

Other portions are materially the same as those in the 46th embodiment.

Superior reliability of the electrical connection was confirmed also in this embodiment. Heat radiation characteristics also were excellent.

(48th Embodiment)

A 48th embodiment of the invention will be made with reference to Fig. 12.

The 48th embodiment is constructed by using the semiconductor device 4 as the first electric circuit component and the circuit board 51 as the second electric circuit component.

After the completion of the connection, a lead frame 1 was connected to the upper side of the circuit board 51 and then the upper surface of the thus obtained assembly was sealed with a resin 63.

Other portions are materially the same as those of the 46th embodiment.

Superior reliability of the electrical connection was confirmed also in this embodiment. Heat radiation characteristics also were found to be excellent.

(49th Embodiment)

A 49th embodiment of the present invention will be described with reference to Fig. 13.

The 49th embodiment was constructed by using the semiconductor device 4 as the first electric circuit component and another semiconductor device 4 as the second electric circuit component.

In this embodiment, the electric bonding intermediary is designed to correspond in size to the semiconductor device 4' and a lead frame 1 is connected to the ends of the metallic members of the bonding intermediary 125 exposed to the same side as the semiconductor device 4.

Other portions are materially the same as those of the 48th embodiment.

Superior reliability of the electrical connection was confirmed also in this embodiment. Heat radiation characteristics also were excellent.

(50th Embodiment)

A 50th embodiment of the present invention will be described with reference to Figs. 14A and 14B.

In the 50th embodiment, circuit boards 101, 104, which are coated by insulating films 103, 106 at portions other than the bonding areas, are used as the first and second electric circuit components, respectively.

As will be understood from Figs. 15A and 15B, in the electric bonding intermediary 125 used in this embodiment having an insulator containing fillers in the form of powder particles or fibers, the exposed ends of the metallic members 107 are slightly projected from the surfaces of the resin insulator 111.

This type of electric bonding intermediary 125 can be fabricated by preparing a member of the type shown in Figs. 10B and 10C described before by following the process explained in connection with the 46th embodiment, and subjecting both surfaces of the member to an etching until the metallic wires 121 project from the surfaces of the polyimide resin body 123 by a length of, for example. 10 μm or so.

The fabrication of this type of electric bonding intermediary by etching is only illustrative and other suitable chemical or mechanical methods can be used equally well.

Other portions are materially the same as those of the 46th embodiment.

It is possible to form bumps 150 as shown in Figs. 16A and 16B, by placing the electric bonding intermediary 125 between a pair of dies having recesses corresponding to the metallic wires 121 and then compacting the dies so as to collapse the projecting portions 126 of the metallic wires 121. The provision of the bumps 150 effectively prevent the metallic wires from coming off the insulator 111.

It will be seen that the segments of the metallic wire 121 constitute the metallic members 107, while the resin body 123 constitutes the insulator 111.

The formation of the bumps may be heating and melting the projections or by other suitable method.

High reliability of electrical connection was confirmed also in this case. Heat radiation characteristics also were found to be excellent.

(51st Embodiment)

A 51st embodiment will be described with reference to Figs. 17A and 17B. This embodiment features the use of a semiconductor device 4 as the first electric circuit component and a lead frame 1 as the second circuit component.

Other portions are materially the same as those in the 50th embodiment.

A superior reliability of the electrical connection was confirmed also in this embodiment. Heat radiation characteristics also were found to be excellent.

(52nd Embodiment)

A 52nd embodiment will be described with reference to Figs. 18A and 18B.

This embodiment features the use of an electric bonding intermediary 125 which is a modification of that 125 used in the 50th embodiment. More specifically. the bonding intermediary 125 used in the 52nd embodiment has a smaller pitch of the metallic members than that in the 50th embodiment. Thus, in the 50th embodiment, the pitch of the metallic members 107 used in the electric bonding intermediary is smaller than the pitch of the bonding areas of the first electric circuit component.

The 50th embodiment described before essentially requires that the electric bonding intermediary 125 be located with respect to the first and the second circuit boards 101, 104 because the bonding areas of the electric bonding intermediary 125 are positioned to correspond to the bonding areas of the first and the second circuit boards 101, 104. In the seventh embodiment, however, it is not necessary to precisely locate the electric bonding intermediary with respect to both circuit boards 101, 104, though these circuit boards 101, 104 have to be precisely located with respect to each other. Thus, in the seventh embodiment, it is possible to attain the electrical connection without requiring any precise location of the electric bonding intermediary 125 provided that the size and pitch (d11, P11) of the bonding areas of the first and second circuit boards and those (d12, P12) of the bonding areas of the electric bonding intermediary are suitably determined in relation to each other.

Superior reliability of the electrical connection was confirmed also in this case. Heat radiation characteristics also were found to be excellent.

(53rd Embodiment)

Figs. 21A and 21B show an electric bonding intermediary suitable for use in 53rd embodiment of the present invention, in perspective view and in sectional view, respectively.

An example of the method for fabricating this electric bonding intermediary will be described hereinunder. Three pieces 128, 129 and 130 of elementary electric bonding intermediary are prepared by the method which was explained before in connection with the 46th embodiment.

In the first piece 128 of the electric bonding intermediary, the metallic wires 121 are so located that the position of the metallic wire 121 in a row $m$ and a column $n$ is offset from the center by amounts $ma$ and $nb$ in the line and column directions. In the second piece 129 of the electric bonding intermediary, the metallic wires 121 are so located that the position of the metallic wire 121 in row $m$ and column $n$ is offset from the center by amounts $mac$ and $nbc$ in the line and column directions. In the third piece 130 of the electric bonding intermediary, the metallic wires 121 are so located that the position of the metallic wire 121 in row $m$ and column $n$ is offset from the center by amounts $mad$ and $nbd$ in the line and column directions. The values $a$, $b$, $c$ and $d$ are so determined that the metallic members in each piece can make electric contact only with the metallic members which are immediately above and below these metallic members but do not contact with metallic members laterally offset therefrom. Then, the electric bonding intermediary 125 is completed by stacking three pieces of the member and then bonding them together by,for example, applying heat and pressure.

Although the metallic members in each piece of elementary bonding intermediary member are regularly arranged in the form of a matrix having $m$ rows and $n$ columns, this is not exclusive and the metallic members in each piece may be disposed in a random manner, provided that the metallic members in each piece can make electric contact only with the metallic members which are immediately above and below these metallic members but do not contact with metallic members laterally offset therefrom.

It is also to be understood that the electric bonding intermediary may be composed of two pieces of elementary members or four or more elementary members, although a bonding intermediary consisting of three elementary members was specifically mentioned.

The bonding by application of heat and pressure also is illustrative, and various other suitable methods such as a mere pressing and adhesion can be employed as the occasion demands.

The electric bonding intermediary may be modified such that it has projections as is the case of the bonding intermediary shown in Figs. 15A, 15B or such that it has bumps as is the case of the bonding intermediary shown in Figs. 16A, 16B.

Superior reliability of electrical connection was confirmed also in this case. Heat radiation characteristics also were found to be excellent.

(54th Embodiment)

Fig. 20A is a sectional view of a half-finished electric bonding intermediary suitable for use in the 54th embodiment of the present invention. Figs. 20B and 20C are a perspective view and a sectional view of the bonding intermediary.

This bonding intermediary is prepared by the following method. A pair of metal wire guide plates 131 and 132 are prepared and metal wires 121 are threaded through holes 133, 134 formed in these guide plates 131, 132. Then, the wires are tensed at a suitable level of tension. Subsequently, the space between the guide plates 131, 132 is filled with a resin 123. Before the filling, fillers in the form of powder particles or fibers are mixed and dispersed in the resin 123. After the setting of the resin, the guide plates 131, 132 are demounted, whereby the electric bonding intermediary 125 is formed. The electric bonding intermediary may be modified such that it has projections as is the case of the bonding intermediary shown in Figs. 15A, 15B or such that it has bumps as is the case of the bonding intermediary shown in Figs. 16A, 16B. Each of the first and second electric circuit components 101 and 104 may be one selected from a group of components including semiconductor devices, circuit boards and lead frames.

Superior reliability of electrical connection was confirmed also in this embodiment. Heat radiation characteristics also were found to be excellent.

(55th Embodiment)

A 55th embodiment of the present invention will be described with specific reference to Figs. 9A, 9B and 10A to 10C.

The 55th embodiment is an electric circuit device which includes a circuit board 101 as a first electric circuit component with bonding areas 102, a second circuit board 104 as a second electric circuit component with bonding areas 105, and an electric bonding intermediary 125 placed between both circuit boards 101, 104 and bonded to the bonding areas 102, 105 thereby providing electrical connection between the first and the second circuit boards, wherein the electric bonding intermediary 125 includes an insulator 111 and a plurality of metallic members 107 embedded in the insulator 101 in such a manner that the metallic members 107 are electrically insulated from one another and that one ends of the metallic members 107 are exposed on one side of the insulator adjacent to the first circuit board 101 while other ends are exposed on the other side of the insulator 111 adjacent to the second circuit board 104, the insulator containing powder particles and/or fibers (both not shown) of an inorganic material, and wherein bonding is attained by alloying between the bonding areas 102 of the first circuit board 101 and the ends of the metallic members 107 exposed to the same side as the first circuit board 101 or between the bonding areas 105 of the second circuit board 104 and the ends of the metallic members 107 exposed to the same side as the second circuit board 104.

This embodiment will be described in more detail hereinunder. The electric bonding intermediary 125 will be described first through explanation of an example of a process for producing the same.

Figs. 10A to 10C illustrate an example of the process for producing the electric bonding intermediary 125 used in the first embodiment.

As shown in Fig. 10A, a metallic wire 121 made of a metal such as gold or a suitable alloy and having a diameter of about 20 $\mu m$ is turned around a plurality of bars 122 at a pitch of 40 $\mu m$, and the wire 121 together with the bars 122 are embedded in a resin body 123 such as of polyimide resin. Before embedding the metallic wire 121 and the bars 122, powder particles of $SiO_2$ are mixed with the resin and the resin is stirred so that the powder particles of $SiO_2$ are dispersed in the resin 123. The resin 123 after setting serves as the insulator. After the setting of the resin, the resin body 123 is sliced as indicated by broken lines 124, whereby a plurality of pieces of elementary electric bonding intermediary 125 are obtained as shown in Figs. 10B and 10C.

Although the dispersion is effected in this embodiment by stirring the resin containing the powder particles mixed therein, the dispersion may be effected by other means than stirring.

It is also to be noted that the use of $SiO_2$ powder particles is only illustrative and any other suitable inorganic material in the form of powder particles and/or fibers can be used equally well.

In the electric bonding intermediary thus constructed, the segments of the metallic wire 121 constitute the metallic members 107, while the resin 123 constitutes the insulator 111.

In this electric bonding intermediary 125, the metallic wires 121 as the metallic members are insulated from one another by the resin 123. It will be seen that one ends of the metallic wires 121 are exposed on the surface of the electric bonding intermediary 125 adjacent to the first circuit board 101, while the other ends of the same are exposed on the surface of the electric bonding intermediary 125 adjacent to the second circuit board 104. These exposed portions of the metallic wires 121 constitute bonding areas 108, 109 where the bonding intermediary is to be bonded to the circuit boards 101 and 104.

The first and the second circuit boards 101 and 104 are then set together with the electric bonding intermediary 125 interposed therebetween. As will be seen from Figs. 9A and 9B, the circuit boards 101, 104 are provided with a multiplicity of bonding areas 102, 105 within the areas thereof.

The bonding areas 102 of the first circuit board 101 are exposed at positions corresponding to the bonding areas 105 of the second circuit board 104 and the bonding areas 108, 109 of the electric bonding intermediary 125.

Then, the first circuit board 101 and the electric bonding intermediary 125 are located with respect to each other such that the bonding areas 102 on the first circuit board 101 and the bonding areas 108 of the electric bonding intermediary 125 are aligned, and then the aligned bonding areas are mutually alloyed. Alternatively, the second circuit board 104 and the electric bonding intermediary 125 are located with respect to each other such that the bonding areas 105 on the second circuit board 104 and the bonding areas 109 of the electric bonding intermediary 125 are aligned, and then one pair of the aligned bonding areas is connected by alloying. Then, another pair of the bonding areas is connected by any other suitable methods.

Thus, the first embodiment can be assembled by either one of the following two methods (1) and (2).

(1) The first circuit board 101 is first located with respect to the electric bonding intermediary 125 and the bonding areas 102 of the first circuit board 101 are bonded by alloying to the bonding areas 108 of the electric bonding intermediary 125. Then, the second circuit board 104 is located with respect to the electric bonding intermediary 125 and the bonding areas 105 of the second circuit board 104 are connected to the bonding areas 109 of the electric bonding intermediary 125 by pressing.

(2) The second circuit board 104 is first located with respect to the electric bonding intermediary 125 and the bonding areas 105 of the second circuit board 104 are bonded by alloying to the bonding areas 109 of the electric bonding intermediary 125. Then, the first circuit board 101 is located with respect to the electric bonding intermediary 125 and the bonding areas 102 of the first circuit board 101 are connected to the bonding areas 108 of the electric bonding intermediary 125 by pressing.

The state of electrical connection or bonding in the first embodiment thus constructed was examined and superior reliability of the electrical connection was confirmed.

Heat radiation characteristics also were found to be excellent.

(56th Embodiment)

A 56th embodiment will be described with reference to Figs. 11A and 11B.

The 56th embodiment was constructed by using, as the first electric circuit component, a circuit board 51 having bonding areas 52 and, as the second electric circuit component, a semiconductor device 4 having a multiplicity of bonding areas 5 within the area thereof.

The bonding by alloying was effected to achieve electrical connection between the bonding areas 5 of the semiconductor device 4 and the bonding areas 54 of the electric bonding intermediary 125 containing powder particles and/or fibers of inorganic material dispersed in the insulator thereof.

The electric bonding intermediary 125, containing powder particles and/or fibers of inorganic material in the insulator thereof, was designed to be equal in size to the semiconductor device 4.

After the bonding by alloying, a lead frame 55 was connected to the underside of the circuit board 51.

Other portions are materially the same as those in the 55th embodiment.

Superior reliability of the electrical connection was confirmed also in this embodiment. Heat radiation characteristics also were found to be excellent.

(57th Embodiment)

A 57th embodiment will be described with reference to Fig. 12.

The 57th embodiment is constructed by using the semiconductor device 4 as the first electric circuit component and the circuit board 51 as the second electric circuit component.

After the completion of the connection, a lead frame 1 was connected to the upper side of the circuit board 51 and then the upper surface of the thus obtained assembly was sealed with a resin 63.

Other portions are materially the same as those of the 55th embodiment.

Superior reliability of the electrical connection was confirmed also in this embodiment. Heat radiation characteristics also were excellent.

(58th Embodiment)

A 58th embodiment of the invention will be described with reference to Fig. 13.

The 58th embodiment is constructed by using the semiconductor device 4 as the first electric circuit component and another semiconductor device 4' as the second electric circuit component.

In this embodiment, the electric bonding intermediary is designed to correspond in size to the semiconductor device 4' and a lead frame 1 is connected to the ends of the metallic members of the bonding intermediary 125 exposed to the same side as the semiconductor device 4.

Other portions are materially the same as those of the 57thth embodiment.

Superior reliability of the electrical connection was confirmed also in this embodiment. Heat radiation characteristics also were found to be excellent.

(59th Embodiment)

A 59th embodiment of the invention will be described with reference to Figs. 14A and 14B. In the 59th embodiment, circuit boards 101, 104, which are coated by insulating films 103, 106 at portions other than the bonding areas, are used as the first and second electric circuit components, respectively.

As will be understood from Figs. 15A and 15B, in the electric bonding intermediary 125 used in this embodiment, containing powder particles and/or fibers of inorganic material dispersed in the insulator thereof, the exposed ends of the metallic members 107 are slightly projected from the surfaces of the resin insulator 111.

This type of electric bonding intermediary 125 can be fabricated by preparing a member of the type shown in Figs. 10B and 10C described before by following the method explained in connection with the 55th embodiment, and subjecting both surfaces of the member to an etching until the metallic wires 121 project from the surfaces of the polyimide resin body 123 by a length of, for example, 10 μm or so.

It is to be understood that the amount of projection of the metallic wires 121 may be set at any other values other than 10 μm.

The fabrication of this type of electric bonding intermediary by etching is only illustrative and other suitable chemical or mechanical methods can be used equally well.

Other portions are materially the same as those of the 57th embodiment.

It is possible to form bumps 150 as shown in Figs. 16A and 16B, by placing the electric bonding intermediary 125 between a pair of dies having recesses corresponding to the metallic wires 121 and then compacting the dies so as to collapse the projecting portions 126 of the metallic wires 121. The provision of the bumps 150 effectively prevent the metallic wires from coming off the insulator 111.

In this embodiment also, the segments of the metallic wire 121 constitutes the metallic members while the resin 123 constitutes the insulator.

The bumps may also be formed by heating and melting the projections or other suitable method.

High reliability of electrical connection was confirmed also in this case. Heat radiation characteristics also were found to be excellent.

(60th Embodiment)

A 60th embodiment will be described with reference to Figs. 17A and 17B. This embodiment features the use of a semiconductor device 4 as the first electric circuit component and a lead frame 1 as the second circuit component.

Other portions are materially the same as those in the 59th embodiment.

Superior reliability of the electrical connection was confirmed also in this embodiment. Heat radiation characteristics also were found to be excellent.

(61st Embodiment)

A 61st embodiment will be described with reference to Figs. 18A and 18B.

This embodiment features the use of an electric bonding intermediary 125 which is a modification of that 125 used in the 59th embodiment. More specifically, the bonding intermediary 125 used in the 59th embodiment has a smaller pitch of the metallic members than that in the 59th embodiment. Thus, in the 61st embodiment, the pitch of the metallic members 107 used in the electric bonding intermediary is smaller than the pitch of the bonding areas of the first electric circuit component.

The 59th embodiment described before essentially requires that the electric bonding intermediary 125 be located with respect to the first and the second circuit boards 101, 104 because the bonding areas of the electric bonding intermediary 125 are positioned to correspond to the bonding areas of the first and the second circuit boards 101, 104. In the 34th embodiment, however, it is not necessary to precisely locate the electric bonding intermediary 125 with respect to both circuit boards 101, 104, though these circuit boards 101, 104 have to be precisely located with respect to each other. Thus, in the seventh embodiment, it is possible to attain the electrical connection without requiring any precise location of the electric bonding intermediary 125 provided that the size and pitch (d11, P11) of the bonding areas of the first and second circuit boards and those (d12, P12) of the bonding areas of the electric bonding intermediary are suitably determined in relation to each other.

Superior reliability of the electrical connection was confirmed also in this case. Heat radiation characteristics also were found to be excellent.

(62nd Embodiment)

An electric bonding intermediary used in a 62nd embodiment of the invention will be described by referring back to Figs. 21A and 21B which are a perspective view and a sectional view of the bonding intermediary.

An example of the method for fabricating this electric bonding intermediary will be described hereinunder. Three pieces 128, 129 and 130 of elementary electric bonding intermediary, each having an insulator containing powder particles and/or fibers of an inorganic material dispersed therein, are prepared by the method which was explained before in connection with the 55th embodiment.

In the first piece 128 of the electric bonding intermediary, the metallic wires 121 are so located that the position of the metallic wire 121 in a row $\underline{m}$ and a column $\underline{n}$ is offset from the center by amounts $\underline{ma}$ and $\underline{nb}$ in the line and column directions. In the second piece 129 of the electric bonding intermediary, the metallic wires 121 are so located that the position of the metallic wire 121 in row $\underline{m}$ and column $\underline{n}$ is offset from the center by amounts $\underline{mac}$ and $\underline{nbc}$ in the line and column directions. In the third piece 130 of the electric bonding intermediary, the metallic wires 121 are so located that the position of the metallic wire 121 in row $\underline{m}$ and column $\underline{n}$ is offset from the center by amounts $\underline{mad}$ and $\underline{nbd}$ in the line and column directions. The values $\underline{a}$, $\underline{b}$, $\underline{c}$ and $\underline{d}$ are so determined that the metallic members in each piece can make electric contact only with the metallic members which are immediately above and below these metallic members but do not contact with metallic members laterally offset therefrom. Then, the electric bonding intermediary 125 is completed by stacking three pieces of the member and then bonding them together by, for example, applying heat and pressure.

Although the metallic members in each piece of elementary bonding intermediary member are regularly arranged in the form of a matrix having $m$ rows and $n$ columns, this is not exclusive and the metallic members in each piece may be disposed in a random manner, provided that the metallic members in each piece can make electric contact only with the metallic members which are immediately above and below these metallic members but do not contact with metallic members laterally offset therefrom.

It is also to be understood that the electric bonding intermediary may be composed of two pieces of elementary members or four or more elementary members, although a bonding intermediary consisting of three elementary members was specifically mentioned.

The bonding by application of heat and pressure also is illustrative, and various other suitable methods such as a mere pressing and adhesion can be employed as the occasion demands.

The electric bonding intermediary may be modified such that it has projections as is the case of the bonding intermediary shown in Figs. 15A, 15B or such that it has bumps as is the case of the bonding intermediary shown in Figs. 16A, 16B.

Superior reliability of electrical connection was confirmed also in this case. Heat radiation characteristics also were found to be excellent.

(63rd Embodiment)

An electric bonding intermediary suitable for use in a 63rd embodiment will be described with reference to Figs. 20A to 20C. Fig. 20A is a sectional view of a half-finished electric bonding intermediary suitable for use in the 63rd embodiment of the present invention. Figs. 20B and 20C are a perspective view and a sectional view of the bonding intermediary.

This bonding intermediary is prepared by the following method. A pair of metal wire guide plates 131 and 132 are prepared and metal wires 121 are threaded through holes 133, 134 formed in these guide plates 131, 132. Then, the wires are tensed at a suitable level of tension. Subsequently, the space between the guide plates 131, 132 is filled with a resin 123. The fillers in the form of powder particles or fibers are beforehand added to and dispersed in the resin 123. After the setting of the resin, the guide plates 131, 132 are demounted, whereby the electric bonding intermediary 125 is formed. The electric bonding intermediary may be modified such that it has projections as is the case of the bonding intermediary shown in Figs. 15A, 15B or such that it has bumps 150 as is the case of the bonding intermediary shown in Figs. 16A, 16B. Each of the first and second electric circuit components 101 and 104 may be one selected from a group of components including semiconductor devices, circuit boards and lead frames.

Superior reliability of the electrical connection, as well as excellent heat radiation characteristics, was confirmed also in this embodiment.

(64th Embodiment)

A 64th embodiment of the present invention will be described by making reference back to Figs. 9A, 9B and 10A to 10C.

The 64th embodiment is an electric circuit device which includes a circuit board 101 as a first electric circuit component with bonding areas 102, a second circuit board 104 as a second electric circuit component with bonding areas 105, and an electric bonding intermediary 125 placed between both circuit boards 101, 104 and bonded to the bonding areas 102, 105 thereby providing electrical connection between the first and the second circuit boards, wherein the electric bonding intermediary 125 includes an insulator 111 and a plurality of metallic members 107 embedded in the insulator 111 in such a manner that the metallic members 107 are electrically insulated from one another and that one ends of the metallic members 107 are exposed on one side of the insulator adjacent to the first circuit board 101 while other ends are exposed on the other side of the insulator 111 adjacent to the second circuit board 104, the insulator 111 containing powder particles and/or fibers of an inorganic material dispersed therein, and wherein bonding is attained by alloying between the bonding areas 102 of the first circuit board 101 and the ends of the metallic members 107 exposed to the same side as the first circuit board 101 and also between the bonding areas 105 of the second circuit board 104 and the ends of the metallic members 107 exposed to the same side as the second circuit board 104.

This embodiment will be described in more detail hereinunder. The electric bonding intermediary 125 will be described first through explanation of an example of a process for producing the same.

Figs. 10A to 10C illustrate an example of the process for producing the electric bonding intermediary 125 used in the 37th embodiment.

As shown in Fig. 10A, a metallic wire 121 made of a metal such as gold or a suitable alloy and having a diameter of about 20 $\mu m \emptyset$ is turned

around a plurality of bars 122 at a pitch of 40 $\mu$m, and the wire 121 together with the bars 122 are embedded in a resin body 123 such as of polyimide resin. Before the metallic wire 121 and the bars 122 are embedded, Powder particles of SiO$_2$ are added to the resin and the resin is stirred so that the powder particles of SiO$_2$ are dispersed in the resin. The resin after setting serves as the insulator. After the setting of the resin, the resin body 123 is sliced as indicated by broken lines 124, whereby a plurality of pieces of electric bonding intermediary 125 are obtained as shown in Figs. 10B and 10C.

Although in this embodiment the dispersion of the powder particles is effected by stirring the resin, this method is only illustrative and the invention does not exclude the use of other suitable dispersion method.

It is to be understood also that. although powder of SiO$_2$ is specifically mentioned, powder particles or fibers of other suitable inorganic materials can be used equally well.

In the thus completed electric bonding intermediary 125. the segments of the metal wires 121 constitute the metallic members 107, while the resin 123 constitutes the insulator 111.

In this electric bonding intermediary 125, the metallic wires 121 as the metallic members are insulated from one another by the resin 123. It will be seen that one ends of the metallic wires 121 are exposed on the surface of the electric bonding intermediary 125 adjacent to the first circuit board 101, while the other ends of the same are exposed on the surface of the electric bonding intermediary 125 adjacent to the second circuit board 104. These exposed portions of the metallic wires 121 constitute bonding areas 108, 109 where the bonding intermediary is to be bonded to the circuit boards 101 and 104.

The first and the second circuit boards 101 and 104 are then set together with the electric bonding intermediary 125 interposed therebetween. As will be seen from Figs. 9A and 9B, the circuit boards 101, 104 used in this embodiment are provided with a multiplicity of bonding areas 102, 105 within the areas thereof.

The bonding areas 102 of the first circuit board 101 are exposed at positions corresponding to the bonding areas 105 of the second circuit board 104 and the bonding areas 108, 109 of the electric bonding intermediary 125.

Then, the first circuit board 101 and the electric bonding intermediary 125 are located with respect to each other such that the bonding areas 102 on the first circuit board 101 and the bonding areas 108 of the electric bonding intermediary 125 are aligned, and then the aligned bonding areas are mutually alloyed. Alternatively, the second circuit board 104 and the electric bonding intermediary 125 are located with respect to each other such that the bonding areas 105 on the second circuit board 104 and the bonding areas 109 of the electric bonding intermediary 125 are aligned, and then the aligned bonding areas are mutually alloyed.

The bonding of the first circuit board 101. electric bonding intermediary 125 and the second circuit board 104 can be conducted by any one of the following three methods (1), (2) and (3).

(1) The first circuit board 101, the electric bonding intermediary 125 and the second circuit board 104 are located with respect to one another, and then alloying operation is effected simultaneously at the juncture between the bonding area 102 of the first circuit board 101 and the bonding area 108 of the electric bonding intermediary 125 and at the juncture between the bonding area 105 of the second circuit board 104 and the bonding area 109 of the electric bonding intermediary 125, thereby simultaneously bonding both circuit boards to the electric bonding intermediary 125.

(2) The first circuit board 101 is first located with respect to the electric bonding intermediary 125 and the bonding areas 102 of the first circuit board 101 are bonded by alloying to the bonding areas 108 of the electric bonding intermediary 125. Then, the second circuit board 104 is located with respect to the electric bonding intermediary 125 and the bonding areas 105 of the second circuit board 104 are bonded by alloying to the bonding areas 109 of the electric bonding intermediary 125.

(3) The second circuit board 104 is first located with respect to the electric bonding intermediary 125 and the bonding areas 105 of the second circuit board 104 are bonded by alloying to the bonding areas 109 of the electric bonding intermediary 125. Then, the first circuit board 101 is located with respect to the electric bonding intermediary 125 and the bonding areas 102 of the first circuit board 101 are bonded by alloying to the bonding areas 108 of the electric bonding intermediary 125.

The state of electrical connection or bonding in the 10th embodiment thus constructed was examined and superior reliability of the electrical connection was confirmed. Heat radiation characteristics also were found to be excellent.

(65th Embodiment)

A 65th embodiment will be described by making reference back to Figs. 11A and 11B.

The 65th embodiment is constructed by using, as the first electric circuit component, a circuit board 51 having bonding areas 52 and. as the second electric circuit component, a semiconductor device 4 having a multiplicity of bonding areas 5 within the area thereof.

The bonding by alloying is effected to achieve electrical connection between the bonding areas 5 of the semiconductor device 4 and the bonding areas 54 of the electric bonding intermediary 125 which contains powder particles and/or fibers of inorganic material, as well as between the bonding areas 52 of the circuit board 51 and the bonding areas of the electric bonding intermediary 125.

The electric bonding intermediary 125, which contains powder particles and/or fibers of inorganic material, was designed to be equal in size to the semiconductor device 4.

After the bonding by alloying, a lead frame 55 is connected to the underside of the circuit board 51.

Other portions are materially the same as those in the 64th embodiment.

Superior reliability of the electrical connection was confirmed also in this embodiment. Heat radiation characteristics also were found to be excellent.

(66th Embodiment)

A 66th embodiment of the invention will be described by making reference back to Fig. 12.

The 66th embodiment is constructed by using the semiconductor device 4 as the first electric circuit component and the circuit board 51 as the second electric circuit component.

After the completion of the connection, a lead frame 1 is connected to the upper side of the circuit board 51 and then the upper surface of the thus obtained assembly is sealed with a resin 63.

Other portions are materially the same as those of the 64th embodiment.

Superior reliability of the electrical connection was confirmed also in this embodiment. Heat radiation characteristics also were found to be excellent.

(67th Embodiment)

A 67th embodiment will be described with reference to Fig. 13.

The 67th embodiment is constructed by using the semiconductor device 4 as the first electric circuit component and another semiconductor device 4' as the second electric circuit component.

In this embodiment, the electric bonding intermediary 125 is designed to correspond in size to the semiconductor device 4' and a lead frame 1 is connected to the ends of the metallic members of the bonding intermediary 125 exposed to the same side as the semiconductor device 4.

Other portions are materially the same as those of the 66th embodiment.

Superior reliability of the electrical connection was confirmed also in this embodiment. Heat radiation characteristics also were found to be excellent.

(68th Embodiment)

Figs. 14A and 14B show a 68th embodiment of the invention. In this 68th embodiment, circuit boards 101, 104, which are coated by insulating films 103, 106 at portions other than the bonding areas, are used as the first and second electric circuit components, respectively.

As will be understood from Figs. 15A and 15B, in the electric bonding intermediary 125 used in this embodiment, the exposed ends of the metallic members 107 are slightly projected from the surfaces of the resin insulator 111 containing powder particles and/or fibers of inorganic material.

This type of electric bonding intermediary 125 can be fabricated, for example, by preparing a member of the type shown in Figs. 10B and 10C described before, and subjecting both surfaces of the member to an etching until the metallic wires 121 project from the surfaces of the polyimide resin body 123 by a length of, for example, 10 μm or so.

The fabrication of this type os electric bonding intermediary by etching is only illustrative and other suitable chemical or mechanical methods can be used equally well.

Other portions are materially the same as those of the 64th embodiment.

It is possible to form bumps 150 as shown in Figs. 16A and 16B, by placing the electric bonding intermediary 125 between a pair of dies having recesses corresponding to the metallic wires 121 and then compacting the dies so as to collapse the projecting portions 126 of the metallic wires 121. The provision of the bumps 150 effectively prevent the metallic wires from coming off the insulator 111.

In this embodiment also, the segments of the metallic wire 121 constitute the metallic members 107, while the resin 123 constitutes the insulator 111.

The bumps may also be formed by heating and melting the projections or other suitable method.

High reliability of electrical connection was confirmed also in this case. Heat radiation characteristics also were found to be excellent.

(69th Embodiment)

Figs. 17A and 17B show a 69th embodiment. This embodiment features the use of a semiconductor device 4 as the first electric circuit component and a lead frame 1 as the second circuit component.

Other portions are materially the same as those in the 68th embodiment.

A superior reliability of the electrical connection was confirmed also in this embodiment. Heat radiation characteristics also were found to be excellent. (70th Embodiment)

Figs. 18A and 18B show a 70th embodiment.

This embodiment features the use of an electric bonding intermediary 125 which is a modification of that 125 used in the 68th embodiment. More specifically, the bonding intermediary 125 used in the 70th embodiment has a smaller pitch of the metallic members than that in the 68th embodiment. Thus, in the 70th embodiment, the pitch of the metallic members 107 used in the electric bonding intermediary is smaller than the pitch of the bonding areas of the first electric circuit component.

The 68th embodiment described before essentially requires that the electric bonding intermediary 125 be located with respect to the first and the second circuit boards 101, 104 because the bonding areas of the electric bonding intermediary 125 are positioned to correspond to the bonding areas of the first and the second circuit boards 101, 104. In the 70th embodiment, however, it is not necessary to precisely locate the electric bonding intermediary 125 with respect to both circuit boards 101, 104, though the circuit boards 101, 104 have to be precisely located with respect to each other. Thus, in the 14th embodiment, it is possible to attain the electrical connection without requiring any precise location of the electric bonding intermediary 125 provided that the size and pitch (d11, P11) of the bonding areas of the first and second circuit boards and those (d12, P12) of the bonding areas of the electric bonding intermediary are suitably determined in relation to each other.

A superior reliability of the electrical connection was confirmed also in this case. Heat radiation characteristics also were found to be excellent.

(71st Embodiment)

An electric bonding intermediary suitable for use in a 71st embodiment of the invention will be described by making reference back to Figs 21A and 21B.

Figs. 21A and 21B show an electric bonding intermediary suitable for use in the 64th embodiment of the present invention, in perspective view and in sectional view, respectively.

An example of the method for fabricating this electric bonding intermediary will be described hereinunder. Three pieces 128, 129 and 130 of elementary electric bonding intermediary, each having an insulator containing powder particles and/or fibers of inorganic material, are prepared by the method which was explained before in connection with the 64th embodiment.

In the first piece 128 of the electric bonding intermediary, the metallic wires 121 are so located that the position of the metallic wire 121 in a row $m$ and a column $n$ is offset from the center by amounts $ma$ and $nb$ in the row and column directions. In the second piece 129 of the electric bonding intermediary, the metallic wires 121 are so located that the position of the metallic wire 121 in the row $m$ and column $n$ is offset from the center by amounts $mac$ and $nbc$ in the row and column directions. In the third piece 130 of the electric bonding intermediary, the metallic wires 121 are so located that the position of the metallic wire 121 in row $m$ and column $n$ is offset from the center by amounts $mad$ and $nbd$ in the line and column directions. The values $a$, $b$, $c$ and $d$ are so determined that the metallic members in each piece can make electric contact only with the metallic members which are immediately above and below these metallic members but do not contact with metallic members laterally offset therefrom. Then, the electric bonding intermediary 125 is completed by stacking three pieces of the member and then bonding them together by, for example, applying heat and pressure.

Although the metallic members in each piece of elementary bonding intermediary member are regularly arranged in the form of a matrix having $m$ rows and $n$ columns, this is not exclusive and the metallic members in each piece may be disposed in a random manner, provided that the metallic members in each piece can make electric contact only with the metallic members which are immediately above and below these metallic members but do not contact with metallic members laterally offset therefrom.

It is also to be understood that the electric bonding intermediary may be composed of two pieces of elementary members or four or more elementary members, although a bonding intermediary consisting of three elementary members was specifically mentioned.

The bonding by application of heat and pressure also is illustrative, and various other suitable methods such as a mere pressing and adhesion can be employed as the occasion demands.

The electric bonding intermediary may be modified such that it has projections as is the case of the bonding intermediary shown in Figs. 15A, 15B or such that it has bumps 150 as is the case of the bonding intermediary shown in Figs. 16A, 16B.

Superior reliability of electrical connection was confirmed also in this case. Heat radiation characteristics also were found to be excellent.

(72nd Embodiment)

A bonding intermediary suitable for use in the 72nd embodiment will be described by making reference back to Figs. 20A to 20C. Fig. 20A is a sectional view of a half-finished electric bonding intermediary suitable for use in the 72nd embodiment of the present invention. Figs. 20B and 20C are a perspective view and a sectional view of the bonding intermediary.

This bonding intermediary is prepared by the following method. A pair of metal wire guide plates 131 and 132 are prepared and metal wires 121 are threaded through holes 133, 134 formed in these guide plates 131, 132. Then, the wires are tensed at a suitable level of tension. Subsequently, the space between the guide plates 131, 132 is filled with a resin 123. Before the filling, the powdered particles and/or the fibers are added to and dispersed in the resin. After the setting of the resin, the guide plates 131, 132 are demounted, whereby the electric bonding intermediary 125 is formed. The electric bonding intermediary may be modified such that it has projections as is the case of the bonding intermediary shown in Figs. 15A, 15B or such that it has bumps 150 as is the case of the bonding intermediary shown in Figs. 16A, 16B. Each of the first and second electric circuit components 101 and 104 may be one selected from a group of components including semiconductor devices, circuit boards and lead frames.

Superior reliability of electrical connection was confirmed, as well as excellent heat radiation characteristics.

(73rd Embodiment)

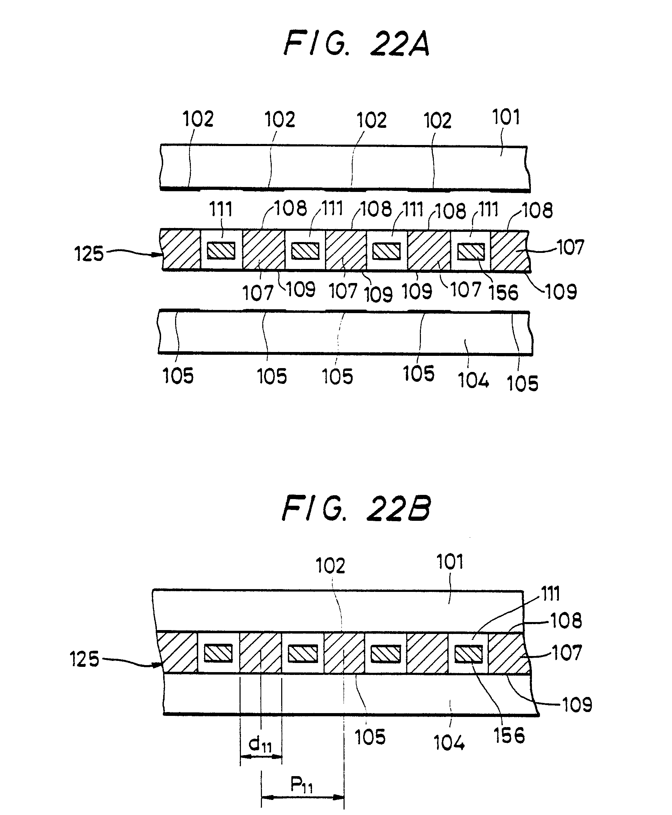

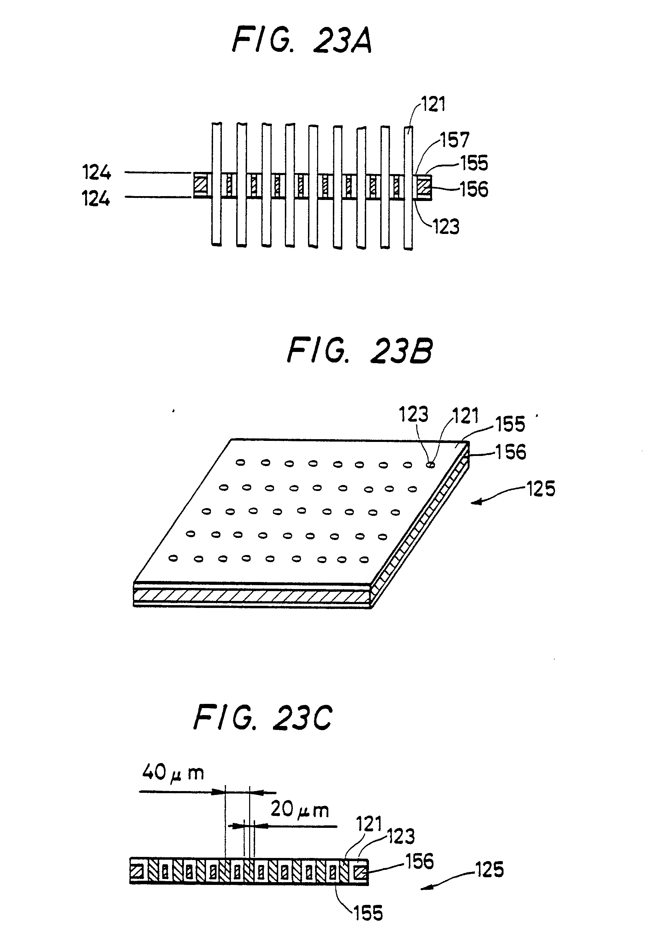

A embodiment of the present invention will be described with specific reference to Figs. 22A, 22B and 23A to 23C.

The 73rd embodiment has an electric bonding intermediary 125 which includes an insulator 111 and a plurality of metallic members 107 of a metal or an alloy embedded in the insulator 101 in such a manner that the metallic members 107 are electrically insulated from one another and that one ends of the metallic members 107 are exposed on one side of the insulator adjacent to the first circuit board 101 while other ends are exposed on the other side of the insulator 111 adjacent to the second circuit board 104, the insulator 111 containing iron plates 156 embedded therein. The electric circuit device of the 73rd embodiment includes the circuit board 101 as a first electric circuit component with bonding areas 102, the second circuit board 104 as a second electric circuit component with bonding areas 105, and the electric bonding intermediary 125 placed between both circuit boards 101, 104 and connected to the bonding areas 102, 105 thereby providing electrical connection between the first and the second circuit boards 101 and 104.

This embodiment will be described in more detail hereinunder. The electric bonding intermediary 125 will be described first through explanation of an example of a process for producing the same.

Figs. 23A to 23C illustrate an example of the process for producing the electric bonding intermediary 125 used in the 73rd embodiment.

As shown in Fig. 23A, an insulating sheet 155 is adhered to each side of an iron plate 156. Then, bores 157 are formed at a pitch of 40 $\mu$m at positions where a metallic wire 121 of a metal such as gold or an alloy, having a diameter of 20 $\mu$m$\emptyset$, is to be inserted. The diameter of the bores 157 is slightly greater than the diameter of the metallic wire 121. After threading the metallic wire 121 through the bores 157, the bores 157 are charged with a resin 123. After the setting, the resin 123 constitutes an insulator so that each section of the metallic wire is insulated from one another. After the setting of the resin, the resin body 123 is sliced as indicated by broken lines 124, whereby a plurality of pieces of elementary electric bonding intermediary 125 are obtained as shown in Figs. 23B and 23C.

Although in this embodiment the iron plates 156 are dispersed, this is only illustrative and the iron plates 156 may be substituted by other metallic materials or inorganic material in the form of bars, spheres or members of other shapes. It is also to be noted that the insulation between the iron plates 156 and the metallic wire 121, which is accomplished in the illustrated embodiment by the resin 123, may be achieved by effecting a suitable treatment to render the surfaces of the bores 157 in the iron plate 156 electrically insulating. The described method for preparing the bonding intermediary is only illustrative and any other suitable method can be employed.

In this electric bonding intermediary 125, the segments of the metallic wires 121 constitute the metallic members 107, while the resin body 123 constitutes the insulator the iron plate 156, insulating sheet 155 and the resin 123 constitute the insulator 111.

In this electric bonding intermediary 125, the segments of the metallic wires 121 as the metallic members are insulated from one another by the resin 123. It will be seen that one ends of the metallic wires 121 are exposed on the surface of the electric bonding intermediary 125 adjacent to the first circuit board 101, while the other ends of the same are exposed on the surface of the electric bonding intermediary 125 adjacent to the second circuit board 104. These exposed portions of the metallic wires 121 constitute bonding areas 108, 109 where the bonding intermediary is to be bonded to the circuit boards 101 and 104.

The first and the second circuit boards 101 and 104 are then set together with the electric bonding intermediary 125 interposed therebetween. As will be seen from Figs. 22A and 22B, the circuit boards 101, 104 are provided with a multiplicity of bonding areas 102, 105 within the areas thereof.

The bonding areas 102 of the first circuit board 101 are exposed at positions corresponding to the bonding areas 105 of the second circuit board 104 and the bonding areas 108, 109 of the electric bonding intermediary 125.

Then, the first circuit board 101 and the electric bonding intermediary 125 are located with respect to each other such that the bonding areas 102 on the first circuit board 101 and the bonding areas 108 of the electric bonding intermediary 125 are aligned, and then the aligned bonding areas are mutually alloyed. Alternatively, the second circuit board 104 and the electric bonding intermediary 125 are located with respect to each other such that the bonding areas 105 on the second circuit board 104 and the bonding areas 109 of the electric bonding intermediary 125 are aligned, and then the aligned bonding areas are mutually alloyed.

The state of electrical connection or bonding in the 73rd embodiment thus constructed was examined and superior reliability of the electrical connection was confirmed.

(74th Embodiment)

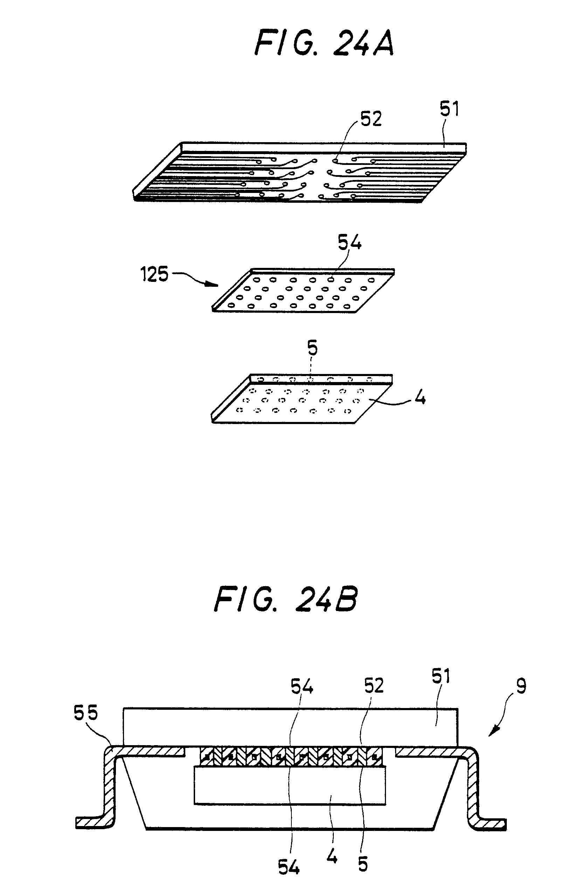

A 74th embodiment will be described by making reference to Figs. 24A and 24B.

The 74th embodiment is constructed by using, as the first electric circuit component, a circuit board 51 having bonding areas 52 and, as the second electric circuit component, a semiconductor device 4 having a multiplicity of bonding areas 5 within the area thereof.

The insulator contains fillers of a metal and/or an inorganic material having any suitable form. The electric bonding intermediary 125 was designed to be equal in size to the semiconductor device 4.

Other portions are materially the same as those in the 73rd embodiment.

Superior reliability of the electrical connection was confirmed also in this embodiment.

(75th Embodiment)

A 75th embodiment of the invention will be made with reference to Fig. 12.

The 21st embodiment is constructed by using the semiconductor device 4 as the first electric circuit component and the circuit board 51 as the second electric circuit component.

After the completion of the connection, a lead frame 1 was connected to the upper side of the circuit board 51 and then the upper surface of the thus obtained assembly was sealed with a resin 63.

Other portions are materially the same as those of the 73rd embodiment.

Superior reliability of the electrical connection was confirmed also in this embodiment.

(76th Embodiment)

A 76th embodiment of the present invention will be described with reference to Fig. 13.

The 76th embodiment was constructed by using the semiconductor device 4 as the first electric circuit component and another semiconductor device 4' as the second electric circuit component.

In this embodiment, the electric bonding intermediary is designed to correspond in size to the semiconductor device 4' and a lead frame 1 is connected to the ends of the metallic members of the bonding intermediary 125 exposed to the same side as the semiconductor device 4.

Other portions are materially the same as those of the 75th embodiment.

Superior reliability of the electrical connection was confirmed also in this embodiment.

(77th Embodiment)

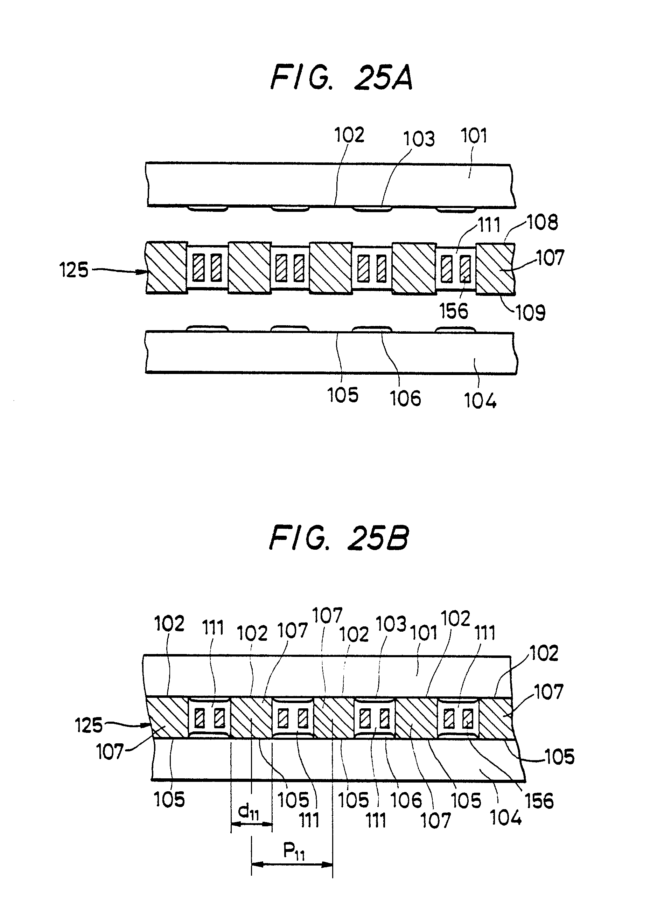

A 77th embodiment of the present invention will be described with reference to Figs. 25A and 25B.

In the 77th embodiment, circuit boards 101, 104, which are coated by insulating films 103, 106 at portions other than the bonding areas, are used as the first and second electric circuit components, respectively.

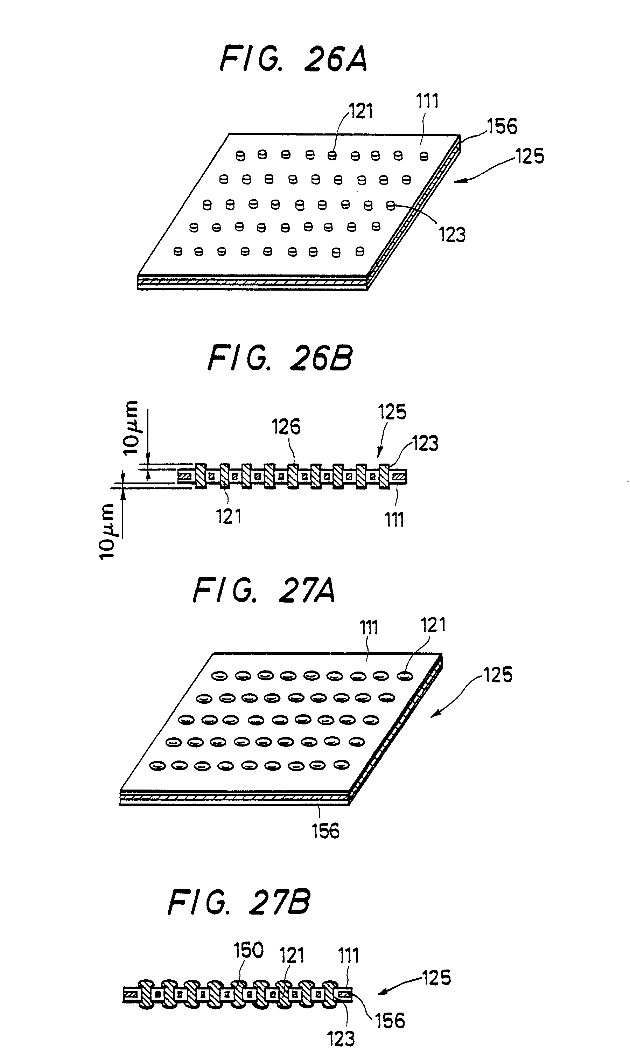

As will be understood from Figs. 26A and 26B, in the electric bonding intermediary 125 used in this embodiment having an insulator containing fillers in the form of powder particles or fibers, the exposed ends of the metallic members 107 are slightly projected from the surfaces of the resin insulator 111.

This type of electric bonding intermediary 125 can be fabricated by preparing a member of the type shown in Figs. 23B and 23C described before by following the process explained in connection with the 73rd embodiment, and subjecting both surfaces of the member to an etching until the metallic wires 121 project from the surfaces of the polyimide resin body 123 by a length of, for example, 10 μm or so.

The fabrication of this type os electric bonding intermediary by etching is only illustrative and other suitable chemical or mechanical methods can be used equally well.

Other portions are materially the same as those of the 73rd embodiment.

It is possible to form bumps 150 as shown in Figs. 27A and 27B, by placing the electric bonding intermediary 125 between a pair of dies having recesses corresponding to the metallic wires 121 and then compacting the dies so as to collapse the projecting portions 126 of the metallic wires 121. The provision of the bumps 150 effectively prevent the metallic wires from coming off the insulator 111.

It will be seen that the segments of the metallic wire 121 constitute the metallic members 107, while the resin body 123, the metal plate 156 and insulating sheet 155 constitute the insulator 111.

The formation of the bumps may be heating and melting the projections or by other suitable method.

High reliability of electrical connection was confirmed also in this case.

(78th Embodiment)

A 78th embodiment will be described with reference to Figs. 17A and 17B. This embodiment features the use of a semiconductor device 4 as the first electric circuit component and a lead frame 1 as the second circuit component.

Other portions are materially the same as those in the 77th embodiment.

A superior reliability of the electrical connection was confirmed also in this embodiment.

(79th Embodiment)

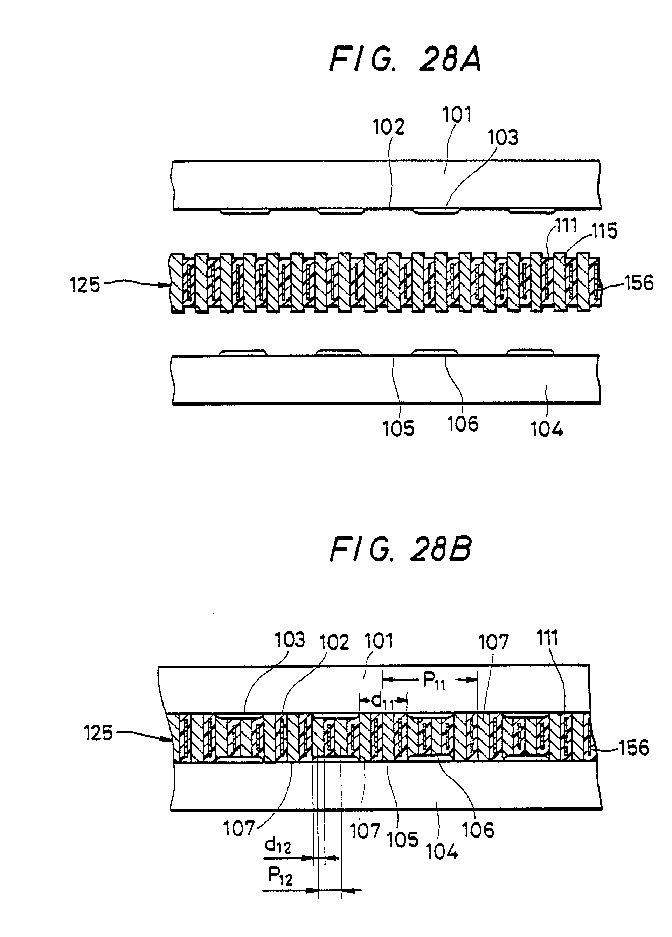

A 79th embodiment will be described with reference to Figs. 28A and 28B.

This embodiment features the use of an electric bonding intermediary 125 which is a modification of that 125 used in the 77th embodiment. More specifically, the bonding intermediary 125 used in the 79th embodiment has a smaller pitch of the metallic members than that in the 77th embodiment. Thus, in the 79th embodiment, the pitch of the metallic members 107 used in the electric bonding intermediary is smaller than the pitch of the bonding areas of the first electric circuit component.

The 77th embodiment described before essentially requires that the electric bonding intermediary 125 be located with respect to the first and the second circuit boards 101, 104 because the bonding areas of the electric bonding intermediary 125 are positioned to correspond to the bonding areas of the first and the second circuit boards 101, 104. In the seventh embodiment, however, it is not necessary to precisely locate the electric bonding intermediary with respect to both circuit boards 101, 104, though these circuit boards 101, 104 have to be precisely located with respect to each other. Thus, in the seventh embodiment, it is possible to attain the electrical connection without requiring any precise location of the electric bonding intermediary 125 provided that the size and pitch (d11, P11) of the bonding areas of the first and second circuit boards and those (d12, P12) of the bonding areas of the electric bonding intermediary are suitably determined in relation to each other.

Superior reliability of the electrical connection was confirmed also in this case.

(80th Embodiment)

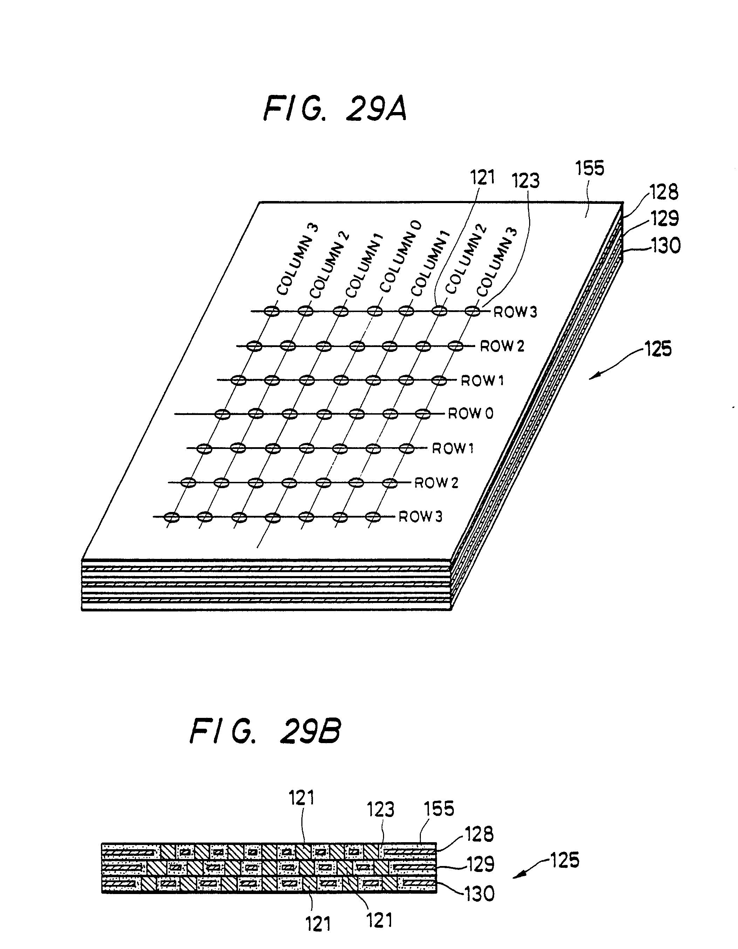

Figs. 29A and 29B show an electric bonding intermediary suitable for use in 80th embodiment of the present invention, in perspective view and in sectional view, respectively.

An example of the method for fabricating this electric bonding intermediary will be described hereinunder. Three pieces 128, 129 and 130 of elementary electric bonding intermediary, each having an insulator containing metallic fillers and/or inorganic fillers, are prepared by the method which was explained before in connection with the 73rd embodiment.

In the first piece 128 of the electric bonding intermediary, the metallic wires 121 are so located that the position of the metallic wire 121 in a row $m$ and a column $n$ is offset from the center by amounts $ma$ and $nb$ in the line and column directions. In the second piece 129 of the electric bonding intermediary, the metallic wires 121 are so located that the position of the metallic wire 121 in row $m$ and column $n$ is offset from the center by amounts $mac$ and $nbc$ in the line and column directions. In the third piece 130 of the electric bonding intermediary, the metallic wires 121 are so located that the position of the metallic wire 121 in row $m$ and column $n$ is offset from the center by amounts $mad$ and $nbd$ in the line and column directions. The values $a$, $b$, $c$ and $d$ are so determined that the metallic members in each piece can make electric contact only with the metallic members which are immediately above and below these metallic members but do not contact with metallic members laterally offset therefrom. Then, the electric bonding intermediary 125 is completed by stacking three pieces of the member and then bonding them together by, for example, applying heat and pressure.

Although the metallic members in each piece of elementary bonding intermediary member are regularly arranged in the form of a matrix having $m$ rows and $n$ columns, this is not exclusive and the metallic members in each piece may be disposed in a random manner. provided that the metallic members in each piece can make electric contact only with the metallic members which are immediately above and below these metallic members but do not contact with metallic members laterally offset therefrom.

It is also to be understood that the electric bonding intermediary may be composed of two pieces of elementary members or four or more elementary members, although a bonding intermediary consisting of three elementary members was specifically mentioned.

The bonding by application of heat and pressure also is illustrative, and various other suitable methods such as a mere pressing and adhesion can be employed as the occasion demands.

The electric bonding intermediary may be modified such that it has projections as is the case of the bonding intermediary shown in Figs. 26A, 26B or such that it has bumps as is the case of the bonding intermediary shown in Figs. 27A, 27B.

Superior reliability of electrical connection was confirmed also in this case.

(81st Embodiment)

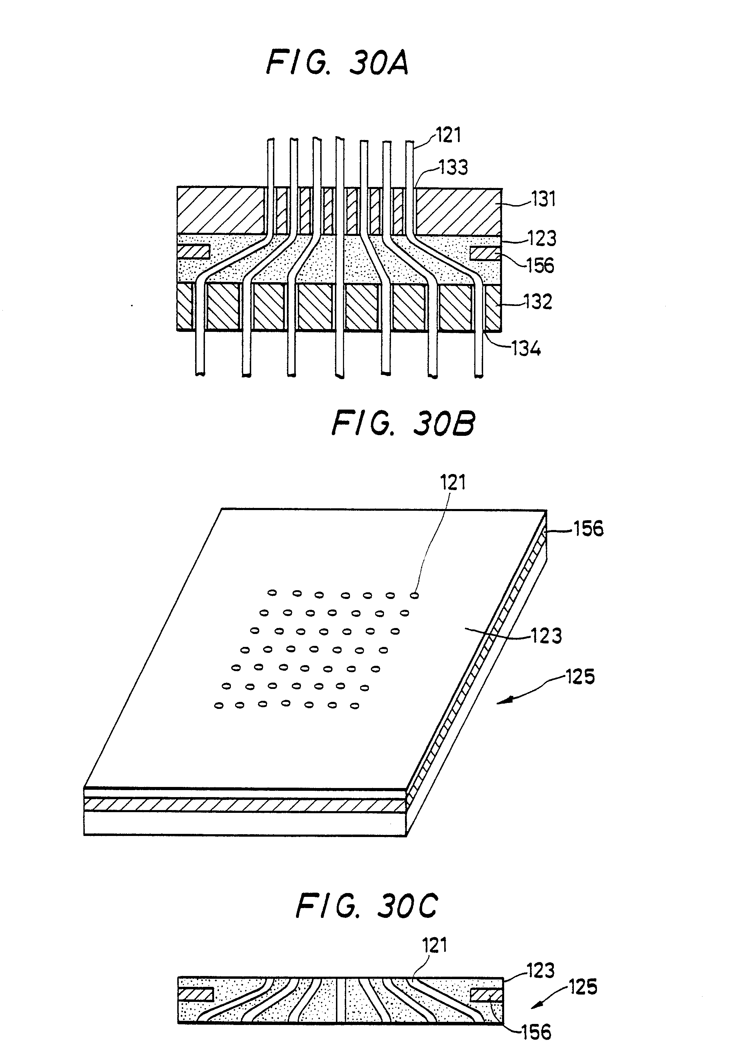

Fig. 30A is a sectional view of a half-finished electric bonding intermediary suitable for use in the 81st embodiment of the present invention. Figs. 30B and 30C are a perspective view and a sectional view of the bonding intermediary.

This bonding intermediary is prepared by the following method. A pair of metal wire guide plates 131 and 132 and an iron plate 156 are prepared and the iron plate 156 is placed and held between the metallic wire guide plates 131 and 132. Then, the metal wires 121 are threaded through holes 133, 134 formed in these guide plates 131, 132. Then, the wires are tensed at a suitable level of tension. Subsequently, the space between the guide plates 131, 132 is filled with a resin 123. After the setting of the resin, the guide plates 131, 132 are demounted, whereby the electric bonding intermediary 125 is formed. The electric bonding intermediary may be modified such that it has projections as is the case of the bonding intermediary shown in Figs. 26A, 26B or such that it has bumps as is the case of the bonding intermediary shown in Figs. 27A, 27B. Each of the first and second electric circuit components 101 and 104 may be one selected from a group of components including semiconductor devices, circuit boards and lead frames.

Superior reliability of electrical connection was confirmed also in this embodiment.

(82nd Embodiment)

An 82nd embodiment of the present invention will be described with specific reference to Figs. 22A, 22B and 23A to 23C.

The 55th embodiment is an electric circuit device which includes a circuit board 101 as a first electric circuit component with bonding areas 102, a second circuit board 104 as a second electric circuit component with bonding areas 105, and an electric bonding intermediary 125 placed between both circuit boards 101, 104 and bonded to the bonding areas 102, 105 thereby providing electrical connection between the first and the second circuit boards, wherein the electric bonding intermediary 125 includes an insulator 111 and a plurality of metallic members 107 embedded in the insulator 111 in such a manner that the metallic members 107 are electrically insulated from one another and that one ends of the metallic members 107 are exposed on one side of the insulator adjacent to the first circuit board 101 while other ends are exposed on the other side of the insulator 111 adjacent to the second circuit board 104, the insulator 111 containing an iron plate 156 embedded therein, and wherein bonding is attained by alloying between the bonding areas 102 of the first circuit board 101 and the ends of the metallic members 107 exposed to the same side as the first circuit board 101 or between the bonding areas 105 of the second circuit board 104 and the ends of the metallic members 107 exposed to the same side as the second circuit board 104.

This embodiment will be described in more detail hereinunder. The electric bonding intermediary 125 will be described first through explanation of an example of a process for producing the same.

Figs. 23A to 23C illustrate an example of the process for producing the electric bonding intermediary 125 used in the first embodiment.

As shown in Fig. 23A, an insulating sheet 155 is adhered to each side of the iron plate 156. Thereafter, bores 157 are formed at a pitch of 40 μm at positions where a metallic wire 121 of a metal such as gold or an alloy and having a diameter of 20 μm is to be threaded. The bores 157 has a diameter slightly greater than that of the metallic wire 121. The after threading the metallic wire 121 through the bores 157, the bores 157 are charged with a resin 123. The resin 123 after setting serves as the insulator, so that individual segments of the metallic wire 121 are insulated from one another. After the setting of the resin, the resin body 123 is sliced as indicated by broken lines 124, whereby a plurality of pieces of elementary electric bonding intermediary 125 are obtained as shown in Figs. 23B and 23C.

Although the described embodiment employs an iron plate 156, this is only illustrative and the iron plate 156 may be substituted by bars, spheres and so forth of other metallic materials or inorganic materials. In the described embodiment, the insulation between the iron plate 156 and the metallic wire 121 is achieved by the resin 123 charged into the bores 157 in the iron plate 156. This, however, is not exclusive and the insulation may be achieved by effecting a suitable treatment for rendering the surfaces of the bores 157 electrically insulating.

In the electric bonding intermediary thus constructed, the segments of the metallic wire 121 constitute the metallic members 107, while the iron plate 156, insulating sheets 155 and the resin 123 constitute the insulator 111.

In this electric bonding intermediary 125, the segments of metallic wires 121 as the metallic members are insulated from one another by the resin 123. It will be seen that one ends of the metallic wires 121 are exposed on the surface of the electric bonding intermediary 125 adjacent to the first circuit board 101, while the other ends of the same are exposed on the surface of the electric bonding intermediary 125 adjacent to the second circuit board 104. These exposed portions of the metallic wires 121 constitute bonding areas 108, 109 where the bonding intermediary is to be bonded to the circuit boards 101 and 104.

The first and the second circuit boards 101 and 104 are then set together with the electric bonding intermediary 125 interposed therebetween. As will be seen from Figs. 22A and 22B, the circuit boards 101, 104 are provided with a multiplicity of bonding areas 102, 105 within the areas thereof.

The bonding areas 102 of the first circuit board 101 are exposed at positions corresponding to the bonding areas 105 of the second circuit board 104 and the bonding areas 108, 109 of the electric bonding intermediary 125.

Then, the first circuit board 101 and the electric bonding intermediary 125 are located with respect to each other such that the bonding areas 102 on the first circuit board 101 and the bonding areas 108 of the electric bonding intermediary 125 are aligned, and then the aligned bonding areas are mutually alloyed. Alternatively, the second circuit board 104 and the electric bonding intermediary 125 are located with respect to each other such that the bonding areas 105 on the second circuit board 104 and the bonding areas 109 of the electric bonding intermediary 125 are aligned, and then the aligned bonding areas are mutually alloyed. Then, the other circuit board is connected by another suitable connecting method.

Thus, the first embodiment can be assembled by either one of the following two methods (1) and (2).

(1) The first circuit board 101 is first located with respect to the electric bonding intermediary 125 and the bonding areas 102 of the first circuit board 101 are bonded by alloying to the bonding areas 108 of the electric bonding intermediary 125. Then, the second circuit board 104 is located with respect to the electric bonding intermediary 125 and the bonding areas 105 of the second circuit board 104 are connected to the bonding areas 109 of the electric bonding intermediary 125 by pressing.

(2) The second circuit board 104 is first located with respect to the electric bonding intermediary 125 and the bonding areas 105 of the second circuit board 104 are bonded by alloying to the bonding areas 109 of the electric bonding intermediary 125. Then, the first circuit board 101 is located with respect to the electric bonding intermediary 125 and the bonding areas 102 of the first circuit board 101 are connected to the bonding areas 108 of the electric bonding intermediary 125 by pressing.

The state of electrical connection or bonding in the first embodiment thus constructed was examined and superior reliability of the electrical connection was confirmed.

(83rd Embodiment)

An 83rd embodiment will be described with reference to Figs. 24A and 24B.

The 83rd embodiment is constructed by using, as the first electric circuit component, a circuit board 51 having bonding areas 52 and, as the second electric circuit component, a semiconductor device 4 having a multiplicity of bonding areas 5 within the area thereof.

The bonding by alloying was effected to achieve electrical connection between the bonding areas 5 of the semiconductor device 4 and the bonding areas 54 of the electric bonding intermediary 125 containing fillers of a metal and/or an inorganic material of any desired shape.

The electric bonding intermediary 125, containing fillers of a metal and/or an inorganic material of any desired shape in the insulator thereof, was designed to be equal in size to the semiconductor device 4.

After the bonding by alloying, a lead frame 55 was connected to the underside of the circuit board 51.

Other portions are materially the same as those in the 82nd embodiment.

Superior reliability of the electrical connection was confirmed also in this embodiment. Heat radiation characteristics also were found to be excellent.

(84th Embodiment)

An 84th embodiment will be described with reference to Fig. 12.

The 84th embodiment is constructed by using the semiconductor device 4 as the first electric circuit component and the circuit board 51 as the second electric circuit component.

After the completion of the connection, a lead frame 1 was connected to the upper side of the circuit board 51 and then the upper surface of the thus obtained assembly was sealed with a resin 63.

Other portions are materially the same as those of the 82nd embodiment.

Superior reliability of the electrical connection was confirmed also in this embodiment. Heat radiation characteristics also were excellent.

(85th Embodiment)

An 85th embodiment of the invention will be described with reference to Fig. 13.

The 85th embodiment is constructed by using the semiconductor device 4 as the first electric circuit component and another semiconductor device 4' as the second electric circuit component.

In this embodiment, the electric bonding intermediary is designed to correspond in size to the semiconductor device 4' and a lead frame 1 is connected to the ends of the metallic members of the bonding intermediary 125 exposed to the same side as the semiconductor device 4.

Other portions are materially the same as those of the 84th embodiment.

Superior reliability of the electrical connection was confirmed also in this embodiment. Heat radiation characteristics also were found to be excellent.

(86th Embodiment)

An 86th embodiment of the invention will be described with reference to Figs. 25A and 25B. In the 86th embodiment, circuit boards 101, 104, which are coated by insulating films 103, 106 at portions other than the bonding areas, are used as the first and second electric circuit components, respectively.

As will be understood from Figs. 26A and 26B, in the electric bonding intermediary 125 used in this embodiment, containing the iron plate 156 embedded in the insulator thereof, the exposed ends of the metallic members 107 are slightly projected from the surfaces of the resin insulator 111.

This type of electric bonding intermediary 125 can be fabricated by preparing a member of the type shown in Figs. 23B and 23C described before by following the method explained in connection with the 82nd embodiment, and subjecting both surfaces of the member to an etching until the metallic wires 121 project from the surfaces of the an insulating sheet 155 by a length of, for example, 10 $\mu$m or so.

The fabrication of this type of electric bonding intermediary by etching is only illustrative and other suitable chemical or mechanical methods can be used equally well.

Other portions are materially the same as those of the 82nd embodiment.

It is possible to form bumps 150 as shown in Figs. 27A and 27B, by placing the electric bonding intermediary 125 between a pair of dies having recesses corresponding to the metallic wires 121 and then compacting the dies so as to collapse the projecting portions 126 of the metallic wires 121. The provision of the bumps 150 effectively prevent the metallic wires from coming off the insulator 111.

In this embodiment also, the segments of the metallic wire 121 constitutes the metallic members 107 while the iron plate 156, insulating sheets 155 and the resin 123 constitute the insulator 111.

The bumps may also be formed by heating and melting the projections or other suitable method.

High reliability of electrical connection was confirmed also in this case. Heat radiation characteristics also were found to be excellent.

(87th Embodiment)

An 87th embodiment will be described with reference to Figs. 17A and 17B. This embodiment features the use of a semiconductor device 4 as the first electric circuit component and a lead frame 1 as the second circuit component.

Other portions are materially the same as those in the 86th embodiment.

Superior reliability of the electrical connection was confirmed also in this embodiment. Heat radiation characteristics also were found to be excellent.

(88th Embodiment)

An 88th embodiment will be described with reference to Figs. 28A and 28B.

This embodiment features the use of an electric bonding intermediary 125 which is a modification of that 125 used in the 86th embodiment. More specifically, the bonding intermediary 125 used in the 88th embodiment has a smaller pitch of the metallic members than that in the 86th embodiment. Thus, in the 88th embodiment, the pitch of the metallic members 107 used in the electric bonding intermediary is smaller than the pitch of the bonding areas of the first electric circuit component.

The 86th embodiment described before essentially requires that the electric bonding intermediary 125 be located with respect to the first and the second circuit boards 101, 104 because the bonding areas of the electric bonding intermediary 125 are positioned to correspond to the bonding areas of the first and the second circuit boards 101, 104. In the 34th embodiment, however, it is not necessary to precisely locate the electric bonding intermediary 125 with respect to both circuit boards 101, 104, though these circuit boards 101, 104 have to be precisely located with respect to each other. Thus, in the seventh embodiment, it is possible to attain the electrical connection without requiring any precise location of the electric bonding intermediary 125 provided that the size and pitch (d11, P11) of the bonding areas of the first and second circuit boards and those (d12, P12) of the bonding areas of the electric bonding intermediary are suitably determined in relation to each other.

Superior reliability of the electrical connection was confirmed also in this case. Heat radiation characteristics also were found to be excellent.

(89th Embodiment)

An electric bonding intermediary used in an 89th embodiment of the invention will be described by referring to Figs. 29A and 29B which are a perspective view and a sectional view of the bonding intermediary.

An example of the method for fabricating this electric bonding intermediary will be described hereinunder. Three pieces 128, 129 and 130 of elementary electric bonding intermediary, each having an insulator containing powder particles and/or fibers of an inorganic material dispersed therein, are prepared by the method which was explained before in connection with the 28th embodiment.

In the first piece 128 of the electric bonding intermediary, the metallic wires 121 are so located that the position of the metallic wire 121 in a row $m$ and a column $n$ is offset from the center by amounts $ma$ and $nb$ in the line and column directions. In the second piece 129 of the electric bonding intermediary, the metallic wires 121 are so located that the position of the metallic wire 121 in row $m$ and column $n$ is offset from the center by amounts $mac$ and $nbc$ in the line and column directions. In the third piece 130 of the electric bonding intermediary, the metallic wires 121 are so located that the position of the metallic wire 121 in row $m$ and column $n$ is offset from the center by amounts $mad$ and $nbd$ in the line and column directions. The values $a$, $b$, $c$ and $d$ are so determined that the metallic members in each piece can make electric contact only with the metallic members which are immediately above and below these metallic members but do not contact with metallic members laterally offset therefrom. Then, the electric bonding intermediary 125 is completed by stacking three pieces of the member and then bonding them together by, for example, applying heat and pressure.

Although the metallic members in each piece of elementary bonding intermediary member are regularly arranged in the form of a matrix having $m$ rows and $n$ columns, this is not exclusive and the metallic members in each piece may be disposed in a random manner, provided that the metallic members in each piece can make electric contact only with the metallic members which are immediately above and below these metallic members but do not contact with metallic members laterally offset therefrom.

It is also to be understood that the electric bonding intermediary may be composed of two pieces of elementary members or four or more elementary members, although a bonding intermediary consisting of three elementary members was specifically mentioned.

The bonding by application of heat and pressure also is illustrative, and various other suitable methods such as a mere pressing and adhesion can be employed as the occasion demands.

The electric bonding intermediary may be modified such that it has projections as is the case of the bonding intermediary shown in Figs. 26A, 26B or such that it has bumps 150 as is the case of the bonding intermediary shown in Figs. 27A, 27B.

Superior reliability of electrical connection was confirmed also in this case. Heat radiation characteristics also were found to be excellent.

(90th Embodiment)

An electric bonding intermediary suitable for use in a 90th embodiment will be described with reference to Figs. 30A to 30C. Fig. 30A is a sectional view of a half-finished electric bonding intermediary suitable for use in the 63rd embodiment of the present invention. Figs. 30B and 30C are a perspective view and a sectional view of the bonding intermediary.

This bonding intermediary is prepared by the following method. A pair of metal wire guide plates 131 and 132 and an iron plate 156 are prepared and the iron plate 156 is placed and held between the metallic wire guide plates 131, 132. Then, the metal wires 121 are threaded through holes 133, 134 formed in these guide plates 131, 132. Then, the wires are tensed at a suitable level of tension. Subsequently, the space between the guide plates 131, 132 is filled with a resin 123. The fillers in the form of powder particles or fibers are beforehand added to and dispersed in the resin 123. After the setting of the resin, the guide plates 131, 132 are demounted, whereby the electric bonding intermediary 125 is formed. The electric bonding intermediary may be modified such that it has projections as is the case of the bonding intermediary shown in Figs. 26A, 26B or such that it has bumps 150 as is the case of the bonding intermediary shown in Figs. 27A, 27B. Each of the first and second electric circuit components 101 and 104 may be one selected from a group of components including semiconductor devices, circuit boards and lead frames.

Superior reliability of the electrical connection, as well as excellent heat radiation characteristics, was confirmed also in this embodiment.

(91st Embodiment)

A 91st embodiment of the present invention will be described by making reference back to Figs. 22A, 22B and 23A to 23C.

The 91st embodiment is an electric circuit device which includes a circuit board 101 as a first electric circuit component with bonding areas 102, a second circuit board 104 as a second electric circuit component with bonding areas 105, and an electric bonding intermediary 125 placed between both circuit boards 101, 104 and bonded to the bonding areas 102, 105 thereby providing electrical connection between the first and the second circuit boards, wherein the electric bonding intermediary 125 includes an insulator 111 and a plurality of metallic members 107 embedded in the insulator 111 in such a manner that the metallic members 107 are electrically insulated from one another and that one ends of the metallic members 107 are exposed on one side of the insulator adjacent to the first circuit board 101 while other ends are exposed on the other side of the insulator 111 adjacent to the second circuit board 104, the insulator 111 containing a metallic and/or inorganic member of any desired shape embedded therein, and wherein bonding is attained by alloying between the bonding areas 102 of the first circuit board 101 and the ends of the metallic members 107 exposed to the same side as the first circuit board 101 and also between the bonding areas 105 of the second circuit board 104 and the ends of the metallic members 107 exposed to the same side as the second circuit board 104.

This embodiment will be described in more detail hereinunder. The electric bonding intermediary 125 will be described first through explanation of an example of a process for producing the same.

Figs. 23A to 23C illustrate an example of the process for producing the electric bonding intermediary 125 used in the 37th embodiment.

As shown in Fig. 23A, an insulating sheet 155 is adhered to each side of an iron plate 156. Then, bores 157 are formed at a pitch of 40 μm in the portions of the iron plate 156 where a metallic wire of a metal such as gold or an alloy and having a diameter of 20 μm is to be inserted. Then, the metallic wire 121 is threaded through the bores 157 and the bores 157 are charged with the resin 123. The resin 123 after setting serves as the insulator. After the setting of the resin, the metallic wires 121 are insulated each other and the resin body 123 is sliced as indicated by broken lines 124, whereby a plurality of pieces of electric bonding intermediary 125 are obtained as shown in Figs. 23B and 23C.

Although the iron plate 156 is used in the described embodiment, this is only illustrative and

53

the iron plate 156 may be substituted by other types of members of a metallic or an inorganic material in the form of bars or spheres. The insulation between the segments of the metallic wire 121 and the iron plate 156, which is achieved in the illustrated embodiment by the resin 123 charged into the bores 157 in the iron pate 156, may be accomplished by effecting a suitable treatment so as to render the surfaces of the bores 157 electrically insulating.

The described method of fabricating the electric bonding intermediary is only illustrative and may be modified in various forms.

In the thus completed electric bonding intermediary 125, the segments of the metal wires 121 constitute the metallic members 107, while the iron plate 156, insulating sheets 155 and the resin 123 constitute the insulator 111.

In this electric bonding intermediary 125, the segments of the metallic wire 121 as the metallic members are insulated from one another by the resin 123. It will be seen that one ends of the metallic wires 121 are exposed on the surface of the electric bonding intermediary 125 adjacent to the first circuit board 101, while the other ends of the same are exposed on the surface of the electric bonding intermediary 125 adjacent to the second circuit board 104. These exposed portions of the metallic wires 121 constitute bonding areas 108, 109 where the bonding intermediary is to be bonded to the circuit boards 101 and 104.

The first and the second circuit boards 101 and 104 are then set together with the electric bonding intermediary 125 interposed therebetween. As will be seen from Figs. 22A and 22B, the circuit boards 101, 104 used in this embodiment are provided with a multiplicity of bonding areas 102, 105 within the areas thereof.

The bonding areas 102 of the first circuit board 101 are exposed at positions corresponding to the bonding areas 105 of the second circuit board 104 and the bonding areas 108, 109 of the electric bonding intermediary 125.

Then, the first circuit board 101 and the electric bonding intermediary 125 are located with respect to each other such that the bonding areas 102 on the first circuit board 101 and the bonding areas 108 of the electric bonding intermediary 125 are aligned, and then the aligned bonding areas are mutually alloyed. Alternatively, the second circuit board 104 and the electric bonding intermediary 125 are located with respect to each other such that the bonding areas 105 on the second circuit board 104 and the bonding areas 109 of the electric bonding intermediary 125 are aligned, and then the aligned bonding areas are mutually alloyed.

The bonding of the first circuit board 101, electric bonding intermediary 125 and the second circuit board 104 can be conducted by any one of the following three methods (1), (2) and (3).

(1) The first circuit board 101, the electric bonding intermediary 125 and the second circuit board 104 are located with respect to one another, and then alloying operation is effected simultaneously at the juncture between the bonding area 102 of the first circuit board 101 and the bonding area 108 of the electric bonding intermediary 125 and at the juncture between the bonding area 105 of the second circuit board 104 and the bonding area 109 of the electric bonding intermediary 125, thereby simultaneously bonding both circuit boards to the electric bonding intermediary 125.

(2) The first circuit board 101 is first located with respect to the electric bonding intermediary 125 and the bonding areas 102 of the first circuit board 101 are bonded by alloying to the bonding areas 108 of the electric bonding intermediary 125. Then, the second circuit board 104 is located with respect to the electric bonding intermediary 125 and the bonding areas 105 of the second circuit board 104 are bonded by alloying to the bonding areas 109 of the electric bonding intermediary 125.

(3) The second circuit board 104 is first located with respect to the electric bonding intermediary 125 and the bonding areas 105 of the second circuit board 104 are bonded by alloying to the bonding areas 109 of the electric bonding intermediary 125. Then, the first circuit board 101 is located with respect to the electric bonding intermediary 125 and the bonding areas 102 of the first circuit board 101 are bonded by alloying to the bonding areas 108 of the electric bonding intermediary 125.

The state of electrical connection or bonding in the 10th embodiment thus constructed was examined and superior reliability of the electrical connection was confirmed. Heat radiation characteristics also were found to be excellent.

(92nd Embodiment)

A 92nd embodiment will be described by making reference back to Figs. 24A and 24B.

The 92nd embodiment is constructed by using, as the first electric circuit component, a circuit board 51 having bonding areas 52 and, as the second electric circuit component, a semiconductor device 4 having a multiplicity of bonding areas 5 within the area thereof.

The bonding by alloying is effected to achieve electrical connection between the bonding areas 5 of the semiconductor device 4 and the bonding areas 54 of the electric bonding intermediary 125 which contains metallic and/or inorganic filler of any desired shape embedded in the insulator thereof, as well as between the bonding areas 52 of the circuit board 51 and the bonding areas of the electric bonding intermediary 125.

The electric bonding intermediary 125, which contains powder particles and/or fibers of inorganic material, was designed to be equal in size to the semiconductor device 4.

After the bonding by alloying, a lead frame 55 is connected to the underside of the circuit board 51.

Other portions are materially the same as those in the 91st embodiment.

Superior reliability of the electrical connection was confirmed also in this embodiment. Heat radiation characteristics also were found to be excellent.

(93rd Embodiment)

A 93rd embodiment of the invention will be described by making reference back to Fig. 12.

The 93rd embodiment is constructed by using the semiconductor device 4 as the first electric circuit component and the circuit board 51 as the second electric circuit component.

After the completion of the connection, a lead frame 1 is connected to the upper side of the circuit board 51 and then the upper surface of the thus obtained assembly is sealed with a resin 63.

Other portions are materially the same as those of the 91st embodiment.

Superior reliability of the electrical connection was confirmed also in this embodiment. Heat radiation characteristics also were found to be excellent.

(94th Embodiment)

A 94th embodiment will be described with reference to Fig. 13.

In this embodiment, the semiconductor element 4 is used as the first electric circuit component and the semiconductor element 4' is used as the second electric circuit component. In this embodiment, as the electrical bonding intermediary, one having dimensions corresponding to the semiconductor element 4' is used, and the lead frame 1 is connected to the metallic members provided in the electrical bonding intermediary 125 and exposed on the side of the first semiconductor element 4.

The other aspects are the same as those of the 93rd embodiment.

In this embodiment as well, it was confirmed that the bonds display a high degree of reliability in terms of electrical connection.

In addition, heat radiation characteristics were also excellent.

(95th Embodiment)

Figs. 25A and 25B illustrate a 95th embodiment.

The 95th embodiment is an example in which the circuit boards 101 and 104 in which portions other than the bonding portions are covered with insulating films 103, 106 are used as the first electric circuit component and the second electric circuit component.

In addition, as the electrical bonding intermediary, the one shown in Figs. 26A and 26B is used. Namely, in the electrical bonding intermediary 125 in which the iron plate 156 is buried in the insulator 111, as shown in Fig. 26A, exposed portions of the metallic members 107 project from the surface of the resin insulator 111. The production of such an electrical bonding intermediary 125 may be effected, for instance, as follows.

First, the electrical bonding intermediary as shown in Figs. 23B, 23C is prepared in accordance with the method described in the 91st embodiment. Next, it suffices if both surfaces of the electrical bonding intermediary are provided with etching until the metallic wires 121 project from each insulating sheet 155 by 10 μm or thereabout.

Although, in this embodiment, the amount of projection of the metallic wires 121 is set to 10 μm or thereabout, but any amount will suffice.

In addition, the method of causing the metallic wires 121 to project is not restricted to etching, and a different chemical or mechanical method may be used.

The other aspects are the same as those of the 91st embodiment.

Incidentally, it is also possible to provide an arrangement in which the projecting portions are formed such that the electrical bonding intermediary 125 is clamped between dies having recesses at the positions of the metallic wires 121 and the projections 126 are crushed to form bumps 150 such as those shown in Fig. 27B. In this case, it becomes difficult for the metallic wires 121 to come off the insulator 111.

Incidentally, in this embodiment as well, the metallic wires 121 constitute the metallic members 107, while the iron plate 156, the insulating sheets 155, and the resin 123 constitute the insulator 111.

Also, it should be noted that the bumps may be formed by thermally fusing the projections or by any other means.

In this embodiment as well, it was confirmed that the bonds display a high degree of reliability in terms of electrical connection.

In addition, heat radiation characteristics were also excellent.

(96th Embodiment)

A 96th embodiment will now be described by referring back to Figs. 17A and 17B.

In this embodiment, the semiconductor element 4 is used as the first electric circuit component, and the lead frame 1 is used as the second electric component.

The other aspects are the same as those of the 95th embodiment.

In this embodiment as well, it was confirmed that the bonds display a high degree of reliability in terms of electrical connection.

In addition, heat radiation characteristics were also excellent.

(97th embodiment)

A 97th embodiment will now be described by referring back to Figs. 28A and 28B.

In this embodiment, the electrical bonding intermediary 125 is different from that shown in the 95th embodiment. Namely, in the electrical bonding intermediary 125 in accordance with this embodiment, the pitch between the adjacent metallic members is narrower than that shown in the 95th embodiment. In other words, in this embodiment, the pitch between the adjacent metallic members 107 is set to be narrower than that between the adjacent bonding areas of the first circuit board.

Namely, in the 95th embodiment, since the bonding areas of the electrical bonding intermediary 125 are disposed such as to align with the bonding areas of the first and second circuit boards 101, 104, it is necessary to effect positioning of the electrical bonding intermediary 125 with respect to those bonding areas. In this embodiment, however, although the positioning of the first and second circuit boards 101, 104 with respect to each other is necessary, the positioning of the electrical bonding intermediary 125 with respect to those bonding areas becomes unnecessary. For this reason, If appropriate values are selected as bonding pitches (d11, P11) for the first and second circuit boards and as bonding pitches (d12, P12) for the electrical bonding intermediary 125, it is possible to effect bonding without performing the positioning of the electrical bonding intermediary 125 with respect to the first and second circuit boards. In this embodiment as well, it was confirmed that the bonds display a high degree of reliability in terms of electrical connection.

In addition, heat radiation characteristics were also excellent.

(98th Embodiment)

An electrical bonding intermediary used in a 98th embodiment will now be described by referring back to Figs. 29A and 29B.

Fig. 29A is a perspective view of the electrical bonding intermediary, while Fig. 29B is a cross-sectional view thereof.

An example of preparing such a electrical bonding intermediary will now be described.

First, three bonding intermediaries 128, 129, 130 in which the iron plates 156 are respectively buried in the insulators are prepared by using the production method shown in the 91st embodiment.

The position of each of the metallic wires 121 in the first sheet 128 is offset from a center by amounts ma, nb at row m and column n. The position of each of the metallic wires 121 in the second sheet 129 is offset from the center by amounts mac, nbc at row m and column n. The position of the metallic wire 121 in the third sheet 130 is offset from the center by amounts mad, nbd at row m and column. With respect to the values a, b, c, and d, those that allow the respective superposed metallic wires 121 to be conductive vertically but do not allow them to be conductive horizontally are selected. The three bonding intermediaries are positioned and are laminated by thermocompression bonding or another similar method, thereby preparing the electrical bonding intermediary 125.

It should be noted that although, in this embodiment, as for the positions of the metallic wires of the electrical bonding intermediary, regular positions, such as those located at row m and column n, are selected, random positions may be adopted if the respective superposed metallic wires are made conductive with each other and are not made conductive with each other in the horizontal direction.

In addition, although, in this embodiment, a description has been made of a case where the electrical bonding intermediary is laminated into a three-layered structure, any number of layers may be formed insofar as two or more layers are formed. Furthermore, although it has been described that the lamination is effected by thermocompression bonding or another similar method, compression bonding, adhesion, or the like may be used. In addition, projections such as those shown in Fig. 26 may be provided by machining the electrical bonding intermediary of this embodiment, and the bumps 150 shown in Fig. 27 may also be provided.

In this embodiment as well, it was confirmed that the bonds display a high degree of reliability in terms of electrical connection.

In addition, heat radiation characteristics were also excellent.

(99th Embodiment)

Figs. 30A to 30C illustrate an electrical bonding intermediary used in a 99th embodiment.

First, the metallic wire guide plats 131, 132 and the iron plate 156 are prepared. The iron plate 156 is inserted between the metallic wire guide plates 131, 132 and is held therebetween. Subsequently, the metallic wires 121 are respectively inserted through the predetermined holes 133, 134 provided in the the metallic wire guide plates 131, 132 and are stretched with appropriate tension. Subsequently, the resin 123 is poured into the space between the metallic wire guide plates 131, 132 and is allowed to harden. In due course of time, the guide plates are removed, thereby to prepare the electrically bonding intermediary 125.

In addition, by machining the electrically bonding intermediary of this embodiment, it is possible to provide projections such as those shown in Fig. 26 and provide bumps 150 such as those shown in Fig. 27.

The first electric circuit component and the second electric circuit component of this embodiment are selected from circuit base materials such as a semiconductor element, circuit board, and lead frame.

In this embodiment as well, it was confirmed that the bonds display a high degree of reliability in terms of electrical connection.

In addition, heat radiation characteristics were also excellent.

(100th Embodiment)

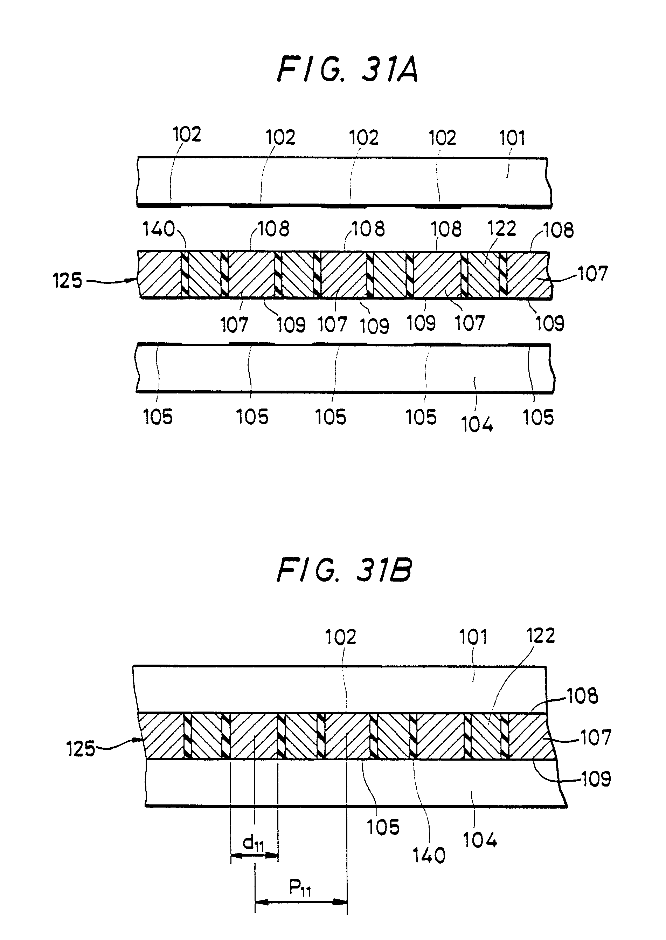

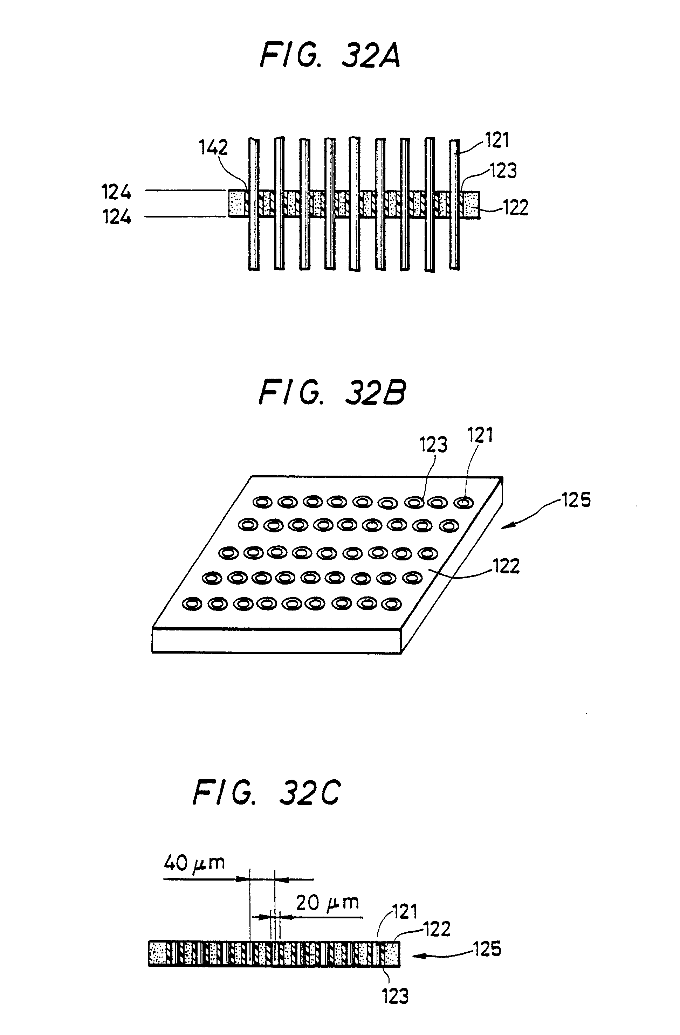

A description will be made hereafter of a 100th embodiment with reference to Figs. 31A, 31B, and 32A to 32C.

In this embodiment, the electrical bonding intermediary 125 is arranged as follows: The plurality of metallic members 107 formed of a metal or an alloy are buried in a holder 122 formed of a metal or an alloy with an insulating material 140 disposed around each of the metallic members 107 in such a manner that one end of each of the metallic members 107 is exposed on the side of the first circuit board 101 and the other end thereof is exposed on the side of the second circuit board 104.

The electric circuit device is arranged such that the circuit board 101 which has the bonding areas 102 and constitutes the first electric circuit component and the circuit board 104 which has the bonding areas 105 and constitutes the second electric circuit component are connected to each other at the bonding areas 102, 105 of the two circuit boards 101, 104 with the electrical bonding intermediary 125 interposed therebetween to electrically connect the two circuit boards 101, 104.

A more detailed description of this embodiment will be made hereafter.

First, the electrical bonding intermediary 125 will be described concurrently with a description of an example of producing the electrical bonding intermediary 125.

An example of production is shown in Figs. 32A to 32C.

The holes 142 with an inside diameter greater than 20 $\mu$m are bored in the holder 122 consisting of aluminum at pitches of 40 $\mu$m. Subsequently, the holder 122 is subjected to anodization treatment, and then the metallic wires 121 having a 20 $\mu$m-diameter and formed of a metal such as gold or an alloy are inserted through the holes 142 of the holder 122. The resin 123 is then poured into spaces between the holder 122 formed of aluminum and the metallic wires 121, and the resin 123 is allowed to harden. The hardened resin 123 and anodized aluminum films (not shown) formed by anodization treatment serve as insulators. Subsequently, the metallic wires 121 are sliced at the positions of the dotted lines 124 thereby to prepare the electrical bonding intermediary 125.

The electrical bonding intermediary thus prepared is shown in Figs. 32B, 32C.

Incidentally, in this embodiment, after the holder 122 is subjected to anodization treatment, the metallic wires 121 are inserted and the resin 123 is then allowed to harden. However, anodization treatment may be provided after hardening of the resin 123. In addition, it is possible to apply the resin 123 uniformly to the metallic wires 121 and then allow the metallic wires 121 to be inserted through the holes 142 of the holder 122.

Furthermore, the slicing of the metallic wires 121 may be effected in a process preceding or following the process of anodization treatment.

In addition, although, in this embodiment, the resin 123 is placed between each of the metallic wires 121 and aluminum holder 122, any electrically insulating material may be used instead of the resin 123. Furthermore, without using the resin 123, the metallic wires 121 may be brought into direct contact with the anodized aluminum films of the aluminum holder 122. In this case, the anodization treatment is effected before the electric wires 121 are inserted.

In addition, grinding may be performed to eliminate any drooping portions of the metallic wires 121. Furthermore, the drooping portions may be eliminated by another method without relaying on grinding.

In this embodiment, an example in which anodization treatment is provided has been illustrated, but since the resin 123, even if used singly, can serve as an insulating material, anodization treatment may not be carried out.

In such an electrical bonding intermediary 125 thus prepared, the metallic wires 121 constitute the metallic members 107, the resin 123 and the anodized aluminum films constitute the insulators 140, and the holder 122, the insulators 140, and the metallic members 107 constitute the electrical bonding intermediary 125.

In this electrical bonding intermediary 125, the metallic wires 121 serving as the metallic members are electrically insulated from each other by means of the resin 123. In addition, one end of each of the metallic wires 121 is exposed on the side of the circuit board 101, while the other end thereof is exposed on the side of the circuit board 104. These exposed portions constitute bonding areas 108, 109 to be electrically connected with the circuit boards 101, 104, respectively.

Next, the first circuit board 101, the electrical bonding intermediary 125, and the second circuit board 104 are prepared. The circuit boards 101, 104 that are used in this embodiment are provided with the multiplicity of bonding areas 102, 105, as shown in Figs. 31A, 31B.

Incidentally, each of the bonding areas 102 of the first circuit board 101 has a metal exposed at a position corresponding to the bonding area 105 of the second circuit board 104 and each of the bonding areas 108, 109 of the electrical bonding intermediary 125.

Positioning is effected in such a manner that the bonding areas 102 of the first circuit board 101 respectively correspond with the bonding areas 108 of the electrical bonding intermediary 125, or the bonding areas 105 of the second circuit board 104 respectively correspond with the bonding areas 109 of the electrical bonding intermediary 125, and bonding is effected after the positioning.

When the state of electrical connection was examined with respect to the electric circuit device thus prepared, it was confirmed that the bonds display a high degree of reliability in terms of electrical connection.

(101st Embodiment)

A description of a 101st embodiment will now be made by referring back to Figs. 24A and 24B.

In this embodiment, the circuit board 51 is used as the first electric circuit component having the bonding areas 52, and the semiconductor element 4 having the multiplicity of bonding areas 5 is used as the second electric circuit component.

It should be noted that, as the electrical bonding intermediary 125, one having dimensions corresponding to the semiconductor element 4 was used.

The other aspects are the same as those as the 100th embodiment.

In this embodiment as well, it was confirmed that the bonds display a high degree of reliability in terms of electrical connection.

(102nd Embodiment)

A description will be given of a 102nd embodiment by referring back to Fig. 12.

In this embodiment, an example is shown in which the semiconductor element 4 is used as the first electric circuit component and the circuit board 51 is used as the second electric circuit component.

It should be noted, after bonding, the lead frame 1 is connected to the upper surface of the circuit board 51, and the two members are sealed with the sealant 63.

The other aspects are the same as those of the 100th embodiment.

In this embodiment as well, it was confirmed that the bonds display a high degree of reliability in terms of electrical connection.

(103rd Embodiment)

A description of a 103rd embodiment will be made by referring back to Fig. 13.

In this embodiment, the semiconductor element 4 is used as the first electric circuit component, and the semiconductor element 4' is used as the second electric circuit component. In this embodiment, as the electrical bonding intermediary, one having dimensions corresponding to the semiconductor element 4' is used, and the lead frame 1 is bonded to the metallic members provided in the electrical bonding intermediary 125 and exposed on the side of the first semiconductor element 4.

The other aspects are the same as those of the 102nd embodiment.

In this embodiment as well, it was confirmed that the bonds display a high degree of reliability in terms of electrical connection.

(104th Embodiment)

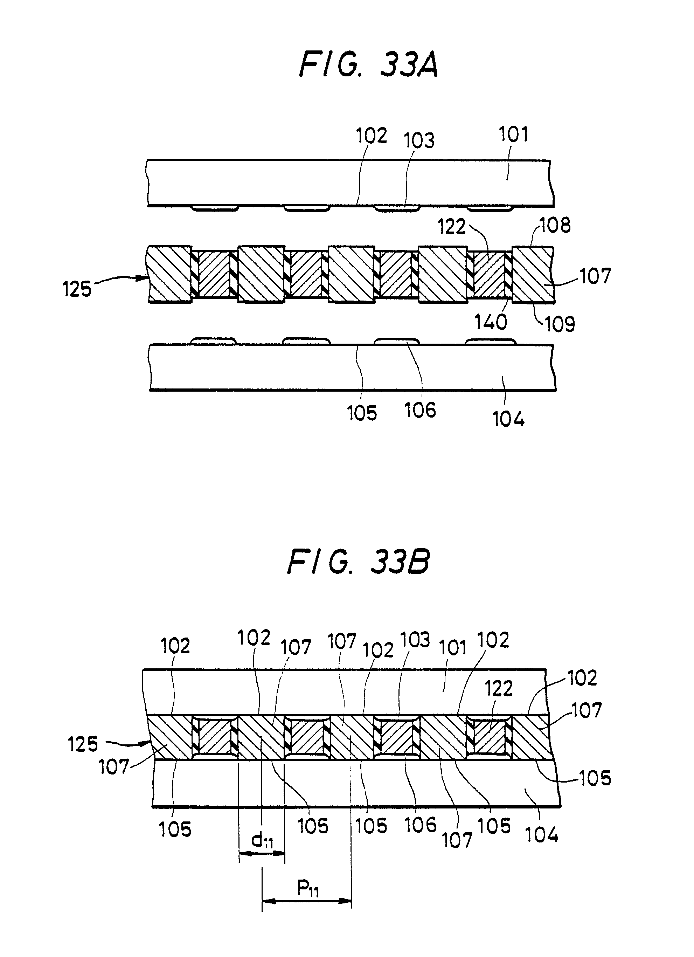

Figs. 33A and 33B illustrate 104th embodiment.

In the 104th embodiment, the circuit boards 101, 104 in which portions other than the bonding areas are covered with the insulating films 103, 106 are used as the first and second electric circuit components.

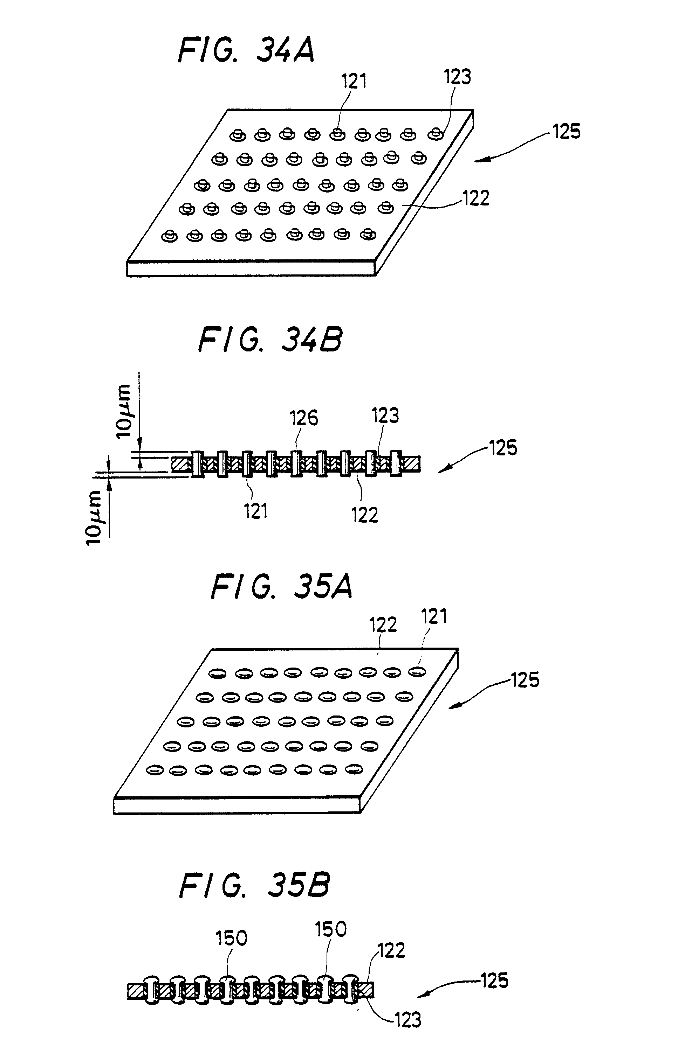

In addition, as the electrical bonding intermediary, the one shown in Fig. 34 is used. Namely, as shown in Fig. 34, in the electrical bonding intermediary 125 in which the metallic members 107 are buried in the holder 122 formed of a metal or an alloy, via the resin 123, i.e., an insulating material. the exposed portions of the metallic members 107 project from both surfaces of the holder 122. The preparation of such an electrical bonding intermediary 125 may, for example, be effected as follows.

First, as in the case of the method described in the 100th embodiment, after each of the metallic wires is inserted into each hole of the holder 122 formed of aluminum, the resin is applied to the surfaces of the holder 122 with a thickness of 10 μm or thereabout, and is allowed to harden. Subsequently, the metallic wires 121 are cut at the positions at which they project 10μm or thereabout from both surfaces of the holder 122. Subsequently, if the applied resin is removed by etching, the electrical bonding intermediary 125 in which the metallic wires 121 projecting by 10 μm from both surfaces of the holder 122 is obtained.

Incidentally, although, in this embodiment, the amount of projection of the metallic wires 121 is set to be 10 μm, any amount will suffice.

In addition, the method of causing the metallic wires 121 to project is not restricted to etching, and a different chemical or mechanical method may be employed.

The other aspects are the same as those of the 100th embodiment.

Alternatively, the projecting portions may be formed such that the electrical bonding intermediary 125 is clamped by dies having recesses at the positions of the metallic wires 121, and the bumps 150 such as those shown in Fig. 35 may be formed by crushing the projections 126 of the metallic wires 121. In this case, it becomes difficult for the metallic wires 121 to come off from the holder 122.

In this embodiment as well, the metallic wires 121 constitute the metallic members 107, the holder 122 is formed of aluminum, and the anodized aluminum films (not shown) and the resin 123 constitute the insulating material 140.

Incidentally, the bumps may be formed by thermally fusing the projections or by any other method.

In this embodiment as well, it was confirmed that the bonds display a high degree of reliability in terms of electrical connection.

(105th embodiment)

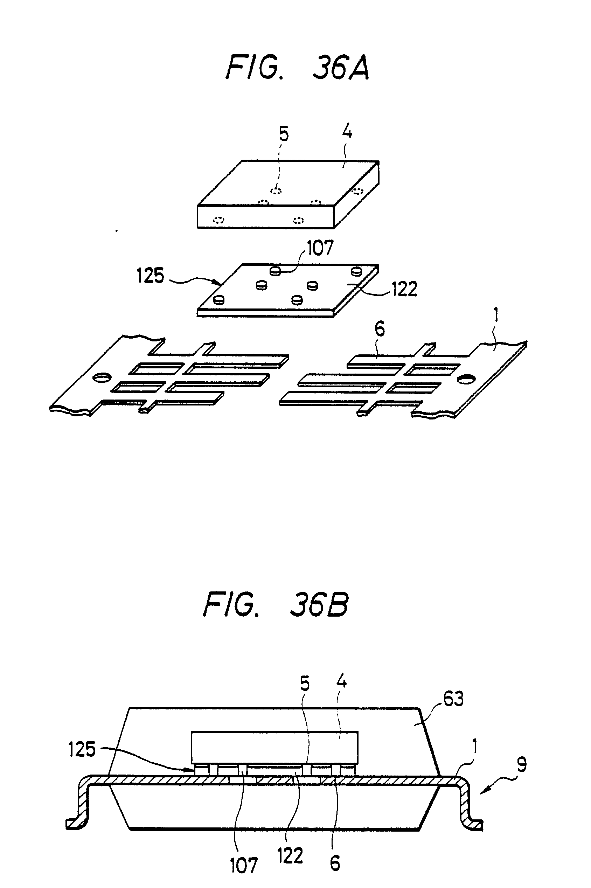

Figs. 36A and 36B illustrate a 105th embodiment.

In this embodiment, the semiconductor element 4 is used as the first electric circuit component, and the lead frame 1 as the second electric circuit component.

The other aspects are the same as those of the 104th embodiment.

In this embodiment as well, it was confirmed that the bonds display a high degree of reliability in terms of electrical connection.

(106th Embodiment)

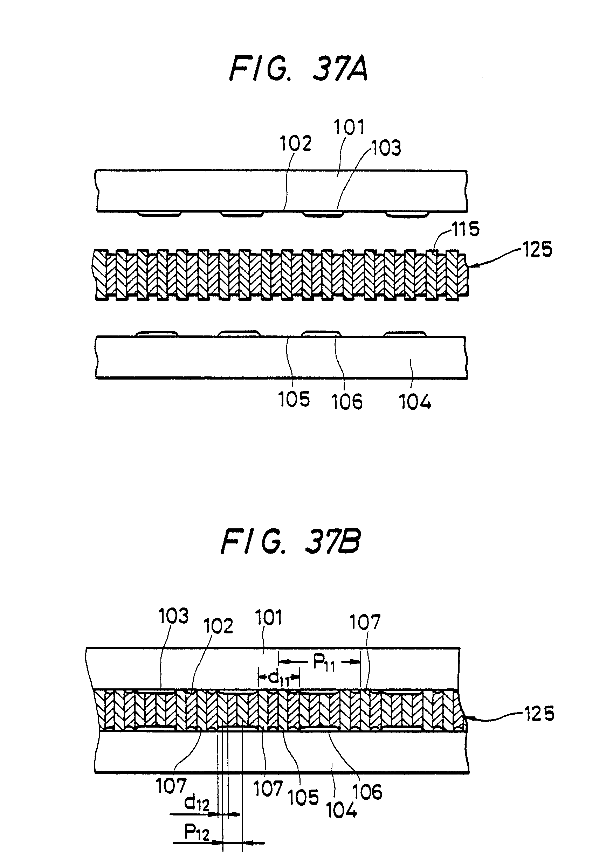

Figs. 37A and 37B illustrate a 106th embodiment.

In this embodiment, the electrical bonding intermediary 125 differs from that shown in the 104th embodiment. Namely, in the electrical bonding intermediary 125 of this embodiment, the pitches between the adjacent metallic members are narrower than those shown in the 104th embodiment. In other words, in this embodiment, the pitches of the adjacent metallic members 107 are set to be narrower than those of the bonding areas of the first circuit board.

Namely, in the 104th embodiment, since the bonding areas of the electrical bonding intermediary 125 are disposed such as to align with the bonding areas of the first and second circuit boards 101, 104, it is necessary to effect positioning of the electrical bonding intermediary 125 with respect to those bonding areas. In this embodiment, however, although the positioning of the first and second circuit boards 101, 104 with respect to each other is necessary, the positioning of the electrical bonding intermediary 125 with respect to those bonding areas becomes unnecessary. For this reason, If appropriate values are selected as bonding pitches (d11, P11) for the first and second circuit boards and as bonding pitches (d12, P12) for the electrical bonding intermediary 125, it is possible to effect bonding without performing the positioning of the electrical bonding intermediary 125 with respect to the first and second circuit boards.

In this embodiment, the holder formed of aluminum is subjected to anodization to form anodized films, and these films are used as the insulating material.

In this embodiment as well, it was confirmed that the bonds display a high degree of reliability in terms of electrical connection.

(107th Embodiment)

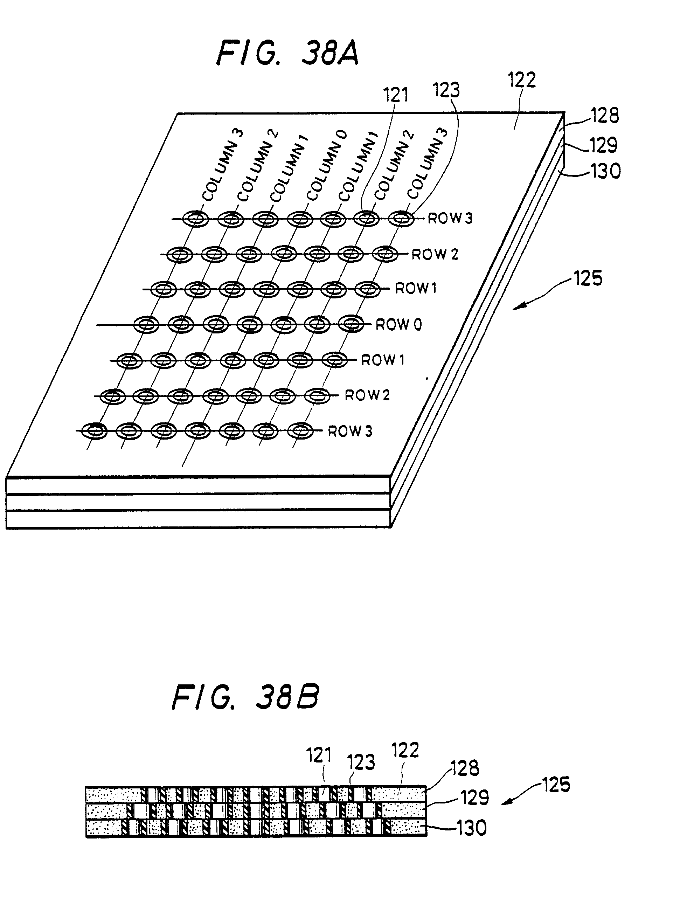

Figs. 38A and 38B illustrate the electrical bonding intermediary used in a 107th embodiment.

Figs. 38A is a perspective view of the electrical bonding intermediary, while Fig. 38B is a cross-sectional view thereof.

An example of preparing such an electrical bonding intermediary will now be described.

First, three bonding intermediaries 128, 129, 130 in which the metallic members are respectively buried in the holder via the insulating material are prepared by using the production method shown in the 100th embodiment.

The position of each of the metallic wires 121 in the first sheet 128 is offset from a center by amounts ma, nb at row m and column n. The position of each of the metallic wires 121 in the second sheet 129 is offset from the center by amounts mac, nbc at row m and column n. The position of the metallic wire 121 in the third sheet 130 is offset from the center by amounts mad, nbd at row m and column. With respect to the values a, b, c, and d, those that allow the respective superposed metallic wires 121 to be conductive vertically but do not allow them to be conductive horizontally are selected. The three bonding intermediaries are positioned and are laminated by thermocompression bonding or another similar method, thereby preparing the electrical bonding intermediary 125.

It should be noted that although, in this embodiment, as for the positions of the metallic wires of the electrical bonding intermediary, regular positions, such as those located at row m and column n, are selected, random positions may be adopted if the respective superposed metallic wires are made conductive with each other and are not made conductive with each other in the horizontal direction.

In addition, although, in this embodiment, a description has been made of a case where the electrical bonding intermediary is laminated into a three-layered structure, any number of layers may be formed insofar as two or more layers are formed. Furthermore, although it has been described that the lamination is effected by thermocompression bonding or the like, compression bonding, adhesion, or another similar method may be used. In addition, projections such as those shown in Fig. 34 may be provided by machining the electrical bonding intermediary of this embodiment, and the bumps 150 shown in Fig. 35 may also be provided.

In this embodiment as well, it was confirmed that the bonds display a high degree of reliability in terms of electrical connection.

In addition, heat radiation characteristics were also excellent.

(108th Embodiment)

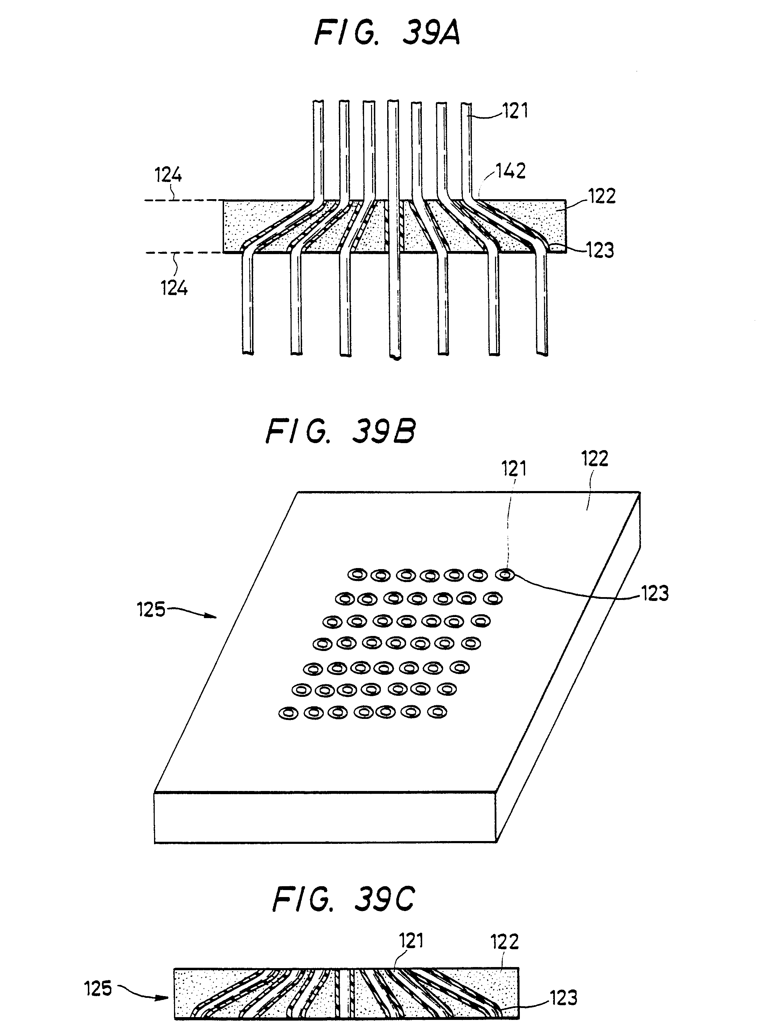

Figs. 39A to 39C illustrate the electrical bonding intermediary used in a 108th embodiment.

Fig. 39A is a cross-sectional view of the electrical bonding intermediary being processed, Fig. 39B is a perspective view thereof, and Fig. 39C is a cross-sectional view thereof.

A description will now be given of an example of producing the electrical bonding intermediary 125 in accordance with this embodiment.

The holes 142 with an inside diameter greater than 20 $\mu$m are bored in the holder 122 provided with insulating films in advance. Subsequently, the metallic wires 121 having a 20 $\mu$m-diameter and formed of a metal such as gold or an alloy are inserted through the holes 142, the resin 123 is poured into spaces between the holder 122 and the metallic wires 121 and is allowed to harden. The hardened resin 123 and the insulating films serve as insulating materials. Subsequently, the metallic wires 121 are sliced at the positions of the dotted lines 124 thereby to prepare the electrical bonding intermediary 125. The electrical bonding intermediary 125 thus prepared is shown in Figs. 39B, 39C.

In addition, projections may be provided by machining the electrical bonding intermediary of this embodiment, as shown in Fig. 34, or the bumps 150 may be provided, as shown in Fig. 35.

A circuit base material such as a semiconductor element, circuit board, or lead frame is used as the first and second electric circuit components of this embodiment, respectively. In this embodiment as well, it was confirmed that the bonds display a high degree of reliability in terms of electrical connection.

(109th Embodiment)

With reference to Figs. 31A, 31B, and 32A to 32C, a description will now be given of a 109th embodiment.

In this embodiment, the circuit board 101 serving as the first electric circuit component having the bonding areas 102 and the circuit board 104 serving as the second electric circuit component having the bonding areas 105 are connected to each other at the bonding areas 102, 105 of the two circuit boards 101, 104 with the electrical bonding intermediary 125 interposed therebetween to electrically connect the two circuit boards 101, 104.

The electrical bonding intermediary 125 is arranged such that the plurality of metallic members 107 formed of a metal or an alloy are buried in a holder consisting of a metal or an alloy via an insulating material with one end of each of the metallic members 107 exposed on the side of the first circuit board 101 and the other end of each of the metallic members 107 exposed on the side of the second circuit board 104. Each of the bonding areas 102 of the first circuit board 101 and one end of each of the metallic members 107 exposed on the side of the first circuit board 101 are bonded to each other by being formed into an alloy, or each of the bonding areas 105 of the second circuit board 104 and one end of each of the metallic members 107 exposed on the side of the second circuit board 104 are bonded to each other by being formed into an alloy.

A more detailed description will be given hereafter.

First, the electrical bonding intermediary 125 will be described concurrently with a description of an example of producing the electrical bonding intermediary 125.

Fig. 32 illustrates an example of production.

The holes 142 with an inside diameter greater than 20 $\mu$m are bored in the holder 122 consisting of aluminum at pitches of 40 $\mu$m. Subsequently, the holder 122 is subjected to anodization treatment, and then the metallic wires 121 having a 20 $\mu$m-diameter and formed of a metal such as fold or an alloy are inserted through the holes 142 of the holder 122. The resin 123 is then poured into spaces between the holder 122 formed of aluminum and the metallic wires 121, and the resin 123 is allowed to harden. The hardened resin 123 and anodized aluminum films (not shown) formed by anodization treatment serve as insulators. Subsequently, the metallic wires 121 are sliced at the positions of the dotted lines 124 thereby to prepare the electrical bonding intermediary 125.

The electrical bonding intermediary thus prepared is shown in Figs. 32B, 32C.

Incidentally, in this embodiment, after the holder 122 is subjected to anodization treatment, the metallic wires 121 are inserted and the resin 123 is then allowed to harden. However, anodization treatment may be provided after hardening of the resin 123. In addition, it is possible to apply the resin 123 uniformly to the metallic wires 121 and then allow the metallic wires 121 to be inserted through the holes 142 of the holder 122.

Furthermore, the slicing of the metallic wires 121 may be effected in a process preceding or following the process of anodization treatment.

In addition, although, in this embodiment, the resin 123 is placed between each of the metallic wires 121 and aluminum holder 122, any electrically insulating material may be used instead of the resin 123. Furthermore, without using the resin 123, the metallic wires 121 may be brought into direct contact with the anodized aluminum films of the aluminum holder 122. In this case, the anodization treatment is effected before the electric wires 121 are inserted.

In addition, grinding may be performed to eliminate any drooping portions of the metallic wires 121. Furthermore, the drooping portions may be eliminated by another method without relaying on grinding.

In this embodiment, an example in which anodization treatment is provided has been illustrated, but since the resin 123, even if used singly, can serve as an insulating material, anodization treatment may not be carried out.

In such an electrical bonding intermediary 125 thus prepared, the metallic wires 121 constitute the metallic members 107, the resin 123 and the anodized aluminum films constitute the insulators 140, and the holder 122, the insulators 140, and the metallic members 107 constitute the electrical bonding intermediary 125.

In this electrical bonding intermediary 125, the metallic wires 121 serving as the metallic members are electrically insulated from each other by means of the resin 123. In addition, one end of each of the metallic wires 121 is exposed on the side of the circuit board 101, while the other end thereof is exposed on the side of the circuit board 104. These exposed portions constitute bonding areas 108, 109 to be electrically connected with the circuit boards 101, 104, respectively.

Next, the first circuit board 101, the electrical bonding intermediary 125, and the second circuit board 104 are prepared. The circuit boards 101, 104 that are used in this embodiment are provided with the multiplicity of bonding areas 102, 105, as shown in Figs. 31A, 31B.

Incidentally, each of the bonding areas 102 of the first circuit board 101 has a metal exposed at a position corresponding to the bonding area 105 of the second circuit board 104 and each of the bonding areas 108, 109 of the electrical bonding intermediary 125.

Positioning is effected in such a manner that the bonding areas 102 of the first circuit board 101 respectively correspond with the bonding areas 108 of the electrical bonding intermediary 125, or the bonding areas 105 of the second circuit board 104 respectively correspond with the bonding areas 109 of the electrical bonding intermediary 125, and, after positioning, either group of the bonding areas are bonded to each other by being formed into an alloy, and the other group of the bonding areas are bonded to each other by another method.

At this juncture, the following two methods are available to connect the first circuit board 101, the electrical bonding intermediary 125. and the second circuit board 104, but either method may be used.

(1) After the first circuit board 101 and the electrical bonding intermediary 125 are positioned, the bonding areas 102 of the first circuit board 101 and the bonding areas 108 of the electrical bonding intermediary 125 are bonded to each other by being formed into an alloy. Subsequently, the second circuit board 104 is positioned. and the bonding areas 105 of the second circuit board 104 and the bonding areas 109 of the electrical bonding intermediary 125 are bonded to each other by pressing.

(2) After the second circuit board 104 and the electrical bonding intermediary 125 are positioned, the bonding areas 105 of the second circuit board 104 and the bonding areas 109 of the electrical bonding intermediary 125 are bonded to each other by being formed into an alloy. Subsequently, the first circuit board 101 is positioned, and the bonding areas 102 of the first circuit board 101 and the bonding areas 109 of the electrical bonding intermediary 125 are bonded to each other by pressing.

When the state of electrical connection was examined with respect to the electric circuit device thus prepared, it was confirmed that the bonds display a high degree of reliability in terms of electrical connection.

(110th Embodiment)

A 110th embodiment will now be described by referring back to Figs. 24A and 24B.

In this embodiment, the circuit board 51 is used as the first electric circuit component having the bonding areas 52, and the semiconductor element 4 having the multiplicity of bonding areas 5 is used as the second electric circuit component.

It should be noted that, as the electrical bonding intermediary 125, one having dimensions corresponding to the semiconductor element 4 was used.

The other aspects are the same as those as the 109th embodiment.

In this embodiment as well. it was confirmed that the bonds display a high degree of reliability in terms of electrical connection.

(111th Embodiment)

A description will now be given of a 111th embodiment by referring back to Fig. 12.

In this embodiment, an example is shown in which the semiconductor element 4 is used as the first electric circuit component and the circuit board 51 is used as the second electric circuit component.

It should be noted. after bonding, the lead frame 1 is connected to the upper surface of the circuit board 51, and the two members are sealed with the sealant 63.

The other aspects are the same as those of the 109th embodiment.

In this embodiment as well. it was confirmed that the bonds display a high degree of reliability in terms of electrical connection.

(112nd Embodiment)

A description of a 112nd embodiment will be made by referring back to Fig. 13.

In this embodiment. the semiconductor element 4 is used as the first electric circuit component. and the semiconductor element 4' is used as the second electric circuit component. In this embodiment, as the electrical bonding intermediary, one having dimensions corresponding to the semiconductor element 4' is used, and the lead frame 1 is bonded to the metallic members provided in the electrical bonding intermediary 125 and exposed on the side of the first semiconductor element 4.

The other aspects are the same as those of the 111th embodiment.

In this embodiment as well, it was confirmed that the bonds display a high degree of reliability in terms of electrical connection.

(113th Embodiment)

Figs. 33A and 33B illustrate a 113th embodiment.

In the 113th embodiment, the circuit boards 101, 104 in which portions other than the bonding areas are covered with the insulating films 103, 106 are used as the first and second electric circuit components.

In addition. as the electrical bonding intermediary, the one shown in Fig. 34 is used. Namely, as shown in Fig. 34, in the electrical bonding intermediary 125 in which the metallic members 107 are buried in the holder 122 formed of a metal or an alloy, via the resin 123, i.e., an insulating material, the exposed portions of the metallic members 107 project from both surfaces of the holder 122. The preparation of such an electrical bonding intermediary 125 may, for example, be effected as follows.

First, as in the case of the method described in the 109th embodiment, after each of the metallic wires is inserted into each hole of the holder 122 formed of aluminum, the resin is applied to the surfaces of the holder 122 with a thickness of 10 μm or thereabout, and is allowed to harden. Subsequently, the metallic wires 121 are cut at the positions at which they project 10μm or thereabout from both surfaces of the holder 122. Subsequently, if the applied resin is removed by etching, the electrical bonding intermediary 125 in which the metallic wires 121 projecting by 10 μm from both surfaces of the holder 122 is obtained.

Incidentally, although, in this embodiment, the amount of projection of the metallic wires 121 is set to be 10 μm, any amount will suffice.

In addition, the method of causing the metallic wires 121 to project is not restricted to etching, and a different chemical or mechanical method may be employed.

The other aspects are the same as those of the 109th embodiment.

Alternatively, the projecting portions may be formed such that the electrical bonding intermediary 125 is clamped by dies having recesses at the positions of the metallic wires 121, and the bumps 150 such as those shown in Fig. 35 may be formed by crushing the projections 126 of the metallic wires 121. In this case, it becomes difficult for the metallic wires 121 to come off from the holder 122.

In this embodiment as well, the metallic wires 121 constitute the metallic members 107, the holder 122 is formed of aluminum, and the anodized aluminum films (not shown) and the resin 123 constitute the insulating material 140.

Incidentally, the bumps may be formed by thermally fusing the projections or by any other method.

In this embodiment as well, it was confirmed that the bonds display a high degree of reliability in terms of electrical connection.

(114th Embodiment)

A description of a 114th embodiment will now be made by referring back to Figs. 36A and 36B.

In this embodiment, the semiconductor element 4 is used as the first electric circuit component, and the lead frame 1 as the second electric circuit component.

The other aspects are the same as those of the 113th embodiment.

In this embodiment as well, it was confirmed that the bonds display a high degree of reliability in terms of electrical connection.

(115th Embodiment)

A 115th embodiment will now be described by referring back to Figs. 37A and 37B.

In this embodiment, the electrical bonding intermediary 125 differs from that shown in the 113th embodiment. Namely, in the electrical bonding intermediary 125 of this embodiment, the pitches between the adjacent metallic members are narrower than those shown in the 113th embodiment. In other words, in this embodiment, the pitches of the adjacent metallic members 107 are set to be narrower than those of the bonding areas of the first circuit board.

Namely, in the 113th embodiment, since the bonding areas of the electrical bonding intermediary 125 are disposed such as to align with the bonding areas of the first and second circuit boards 101, 104, it is necessary to effect positioning of the electrical bonding intermediary 125 with respect to those bonding areas. In this embodiment, however, although the positioning of the first and second circuit boards 101, 104 with respect to each other is necessary, the positioning of the electrical bonding intermediary 125 with respect to those bonding areas becomes unnecessary. For this reason, If appropriate values are selected as bonding pitches (d11, P11) for the first and second circuit boards and as bonding pitches (d12, P12) for the electrical bonding intermediary 125, it is possible to effect bonding without performing the positioning of the electrical bonding intermediary 125 with respect to the first and second circuit boards.

In this embodiment, the holder formed of aluminum is subjected to anodization to form anodized films, and these films are used as the insulating material.

In this embodiment as well, it was confirmed that the bonds display a high degree of reliability in terms of electrical connection.

(116th Embodiment)

An electrical bonding intermediary used in a 116th embodiment will now be described by referring back to Figs. 38A and 38B.

Figs. 38A is a perspective view of the electrical bonding intermediary, while Fig. 38B is a cross-sectional view thereof.

An example of preparing such an electrical bonding intermediary will now be described.

First, three bonding intermediaries 128, 129, 130 in which the metallic members are respectively buried in the holder via the insulating material are prepared by using the production method shown in the 100th embodiment.

The position of each of the metallic wires 121 in the first sheet 128 is offset from a center by amounts ma, nb at row m and column n. The position of each of the metallic wires 121 in the second sheet 129 is offset from the center by amounts mac, nbc at row m and column n. The position of the metallic wire 121 in the third sheet 130 is offset from the center by amounts mad, nbd at row m and column. With respect to the values a, b, c, and d, those that allow the respective superposed metallic wires 121 to be conductive vertically but do not allow them to be conductive horizontally are selected. The three bonding intermediaries are positioned and are laminated by thermocompression bonding or another similar method, thereby preparing the electrical bonding intermediary 125.

It should be noted that although, in this embodiment, as for the positions of the metallic wires of the electrical bonding intermediary, regular positions, such as those located at row m and column n, are selected, random positions may be adopted if the respective superposed metallic wires are made conductive with each other and are not made conductive with each other in the horizontal direction.

In addition, although, in this embodiment, a description has been made of a case where the electrical bonding intermediary is laminated into a three-layered structure, any number of layers may be formed insofar as two or more layers are formed. Furthermore, although it has been described that the lamination is effected by thermocompression bonding or the like, compression bonding, adhesion, or another similar method may be used. In addition, projections such as those shown in Fig. 34 may be provided by machining the electrical bonding intermediary of this embodiment, and the bumps 150 shown in Fig. 35 may also be provided.

In this embodiment as well, it was confirmed that the bonds display a high degree of reliability in terms of electrical connection.

In addition, heat radiation characteristics were also excellent.

(117th Embodiment)

An electrical bonding intermediary used in a 117th embodiment will be described by referring back to Figs. 39A to 39C.

Fig. 39A is a cross-sectional view of the electrical bonding intermediary being processed. Fig. 39B is a perspective view thereof, and Fig. 39C is a cross-sectional view thereof.

A description will now be given of an example of producing the electrical bonding intermediary 125 in accordance with this embodiment.

The holes 142 with an inside diameter greater than 20 $\mu$m are bored in the holder 122 provided with insulating films in advance. Subsequently, the metallic wires 121 having a 20 $\mu$m-diameter and formed of a metal such as gold or an alloy are inserted through the holes 142. the resin 123 is poured into spaces between the holder 122 and the metallic wires 121 and is allowed to harden. The hardened resin 123 and the insulating films serve as insulating materials. Subsequently, the metallic wires 121 are sliced at the positions of the dotted lines 124 thereby to prepare the electrical bonding intermediary 125. The electrical bonding intermediary 125 thus prepared is shown in Figs. 39B, 39C.

In addition, projections may be provided by machining the electrical bonding intermediary of this embodiment. as shown in Fig. 34. or the bumps 150 may be provided. as shown in Fig. 35.

A circuit base material such as a semiconductor element, circuit board, or lead frame is used as the first and second electric circuit components of this embodiment, respectively. In this embodiment as well, it was confirmed that the bonds display a high degree of reliability in terms of electrical connection.

(118th Embodiment)

A description will now be given of a 118th embodiment by referring back to Figs. 31A, 31B, and 32A to 32C.

In this embodiment, the circuit board 101 serving as the first electric circuit component having the bonding area 102 and the circuit board 104 serving as the second electric circuit component having the bonding area 105 are connected to each other at the bonding areas 102. 105 of the two circuit boards 101, 104 with the electrical bonding intermediary 125 interposed therebetween to electrically connect the two circuit boards 101. 104.

The electrical bonding intermediary 125 is arranged such that the plurality of metallic members 107 formed of a metal or an alloy are buried through the insulating material in a holder 122 consisting of a metal or an alloy in such a manner that the respective metallic members 107 are electrically insulated from each other, with one end of each of the metallic members 107 exposed on the side of the first circuit board 101 and the other end of each of the metallic members 107 exposed on the side of the second circuit board 104. Each of the bonding areas 102 of the first circuit board 101 and one end of each of the metallic members 107 exposed on the side of the first circuit board 101 are bonded to each other by being formed into an alloy, or each of the bonding areas 105 of the second circuit board 104 and one end of each of the metallic members 107 exposed on the side of the second circuit board 104 are bonded to each other by being formed into an alloy.

A more detailed description will be given hereafter.

First, the electrical bonding intermediary 125 will be described concurrently with a description of an example of producing the electrical bonding intemediary 125.

Fig. 32 illustrates an example of production.

The holes 142 with an inside diameter greater than 20 μm are bored in the holder 122 consisting of aluminum at pitches of 40 μm. Subsequently, the holder 122 is subjected to anodization treatment, and then the metallic wires 121 having a 20 μm-diameter and formed of a metal such as gold or an alloy are inserted through the holes 142 of the holder 122. The resin 123 is then poured into spaces between the holder 122 formed of aluminum and the metallic wires 121, and the resin 123 is allowed to harden. The hardened resin 123 and anodized aluminum films (not shown) formed by anodization treatment serve as insulators. Subsequently, the metallic wires 121 are sliced at the positions of the dotted lines 124 thereby to prepare the electrical bonding intermediary 125.

The electrical bonding intermediary thus prepared is shown in Figs. 32B, 32C.

Incidentally, in this embodiment, after the holder 122 is subjected to anodization treatment, the metallic wires 121 are inserted and the resin 123 is then allowed to harden. However, anodization treatment may be provided after hardening of the resin 123. In addition, it is possible to apply the resin 123 uniformly to the metallic wires 121 and then allow the metallic wires 121 to be inserted through the holes 142 of the holder 122.

Furthermore, the slicing of the metallic wires 121 may be effected in a process preceding or following the process of anodization treatment.

In addition, although, in this embodiment, the resin 123 is placed between each of the metallic wires 121 and aluminum holder 122, any electrically insulating material may be used instead of the resin 123. Furthermore, without using the resin 123, the metallic wires 121 may be brought into direct contact with the anodized aluminum films of the aluminum holder 122. In this case, the anodization treatment is effected before the electric wires 121 are inserted.

In addition, grinding may be performed to eliminate any drooping portions of the metallic wires 121. Furthermore, the drooping portions may be eliminated by another method without relaying on grinding.

In this embodiment, an example in which anodization treatment is provided has been illustrated, but since the resin 123, even if used singly, can serve as an insulating material, anodization treatment may not be carried out.

In such an electrical bonding intermediary 125 thus prepared, the metallic wires 121 constitute the metallic members 107, the resin 123 and the anodized aluminum films constitute the insulators 140, and the holder 122, the insulators 140, and the metallic members 107 constitute the electrical bonding intermediary 125.

In this electrical bonding intermediary 125, the metallic wires 121 serving as the metallic members are electrically insulated from each other by means of the resin 123. In addition, one end of each of the metallic wires 121 is exposed on the side of the circuit board 101, while the other end thereof is exposed on the side of the circuit board 104. These exposed portions constitute bonding areas 108, 109 to be electrically connected with the circuit boards 101, 104, respectively.

Next, the first circuit board 101, the electrical bonding intermediary 125, and the second circuit board 104 are prepared. The circuit boards 101, 104 that are used in this embodiment are provided with the multiplicity of bonding areas 102, 105, as shown in Figs. 31A, 31B.

Incidentally, each of the bonding areas 102 of the first circuit board 101 has a metal exposed at a position corresponding to the bonding area 105 of the second circuit board 104 and each of the bonding areas 108, 109 of the electrical bonding intermediary 125.

Positioning is effected in such a manner that the bonding areas 102 of the first circuit board 101 respectively correspond with the bonding areas 108 of the electrical bonding intermediary 125, or the bonding areas 105 of the second circuit board 104 respectively correspond with the bonding areas 109 of the electrical bonding intermediary 125, and, bonding is performed after positioning.

When the state of electrical connection was examined with respect to the electric circuit device thus prepared, it was confirmed that the bonds display a high degree of reliability in terms of electrical connection.

(119th Embodiment)

A 119th embodiment will now be described by referring back to Figs. 24A and 24B.

In this embodiment, the circuit board 51 is used as the first electric circuit component having the bonding areas 52, and the semiconductor element 4 having the multiplicity of bonding areas 5 is used as the second electric circuit component.

It should be noted that, as the electrical bonding intermediary 125, one having dimensions corresponding to the semiconductor element 4 was used.

The other aspects are the same as those as the 118th embodiment.

In this embodiment as well, it was confirmed that the bonds display a high degree of reliability in terms of electrical connection.

(120th Embodiment)

A description will be given of a 120th embodiment by referring back to Fig. 12.

In this embodiment, an example is shown in which the semiconductor element 4 is used as the first electric circuit component and the circuit board 51 is used as the second electric circuit component.

It should be noted, after bonding, the lead frame 1 is connected to the upper surface of the circuit board 51, and the two members are sealed with the sealant 63.

The other aspects are the same as those of the 118th embodiment.

In this embodiment as well, it was confirmed that the bonds display a high degree of reliability in terms of electrical connection.

(121st Embodiment)

A description of a 121st embodiment will be made by referring back to Fig. 13.

In this embodiment, the semiconductor element 4 is used as the first electric circuit component, and the semiconductor element 4' is used as the second electric circuit component. In this embodiment, as the electrical bonding intermediary, one having dimensions corresponding to the semiconductor element 4' is used, and the lead frame 1 is bonded to the metallic members provided in the electrical bonding intermediary 125 and exposed on the side of the first semiconductor element 4.

The other aspects are the same as those of the 120th embodiment.

In this embodiment as well, it was confirmed that the bonds display a high degree of reliability in terms of electrical connection.

(122nd Embodiment)

A 122nd embodiment will now be described by referring back to Figs. 33A and 33B.

In the 113th embodiment, the circuit boards 101, 104 in which portions other than the bonding areas are covered with the insulating films 103, 106 are used as the first and second electric circuit components.

In addition, as the electrical bonding intermediary, the one shown in Fig. 34 is used. Namely, as shown in Fig. 34, in the electrical bonding intermediary 125 in which the metallic members 107 are buried in the holder 122 formed of a metal or an alloy, via the resin 123, i.e., an insulating material, the exposed portions of the metallic members 107 project from both surfaces of the holder 122. The preparation of such an electrical bonding intermediary 125 may, for example, be effected as follows.

First, as in the case of the method described in the 118th embodiment, after each of the metallic wires is inserted into each hole of the holder 122 formed of aluminum, the resin is applied to the surfaces of the holder 122 with a thickness of 10 μm or thereabout, and is allowed to harden. Subsequently, the metallic wires 121 are cut at the positions at which they project 10μm or thereabout from both surfaces of the holder 122. Subsequently, if the applied resin is removed by etching, the electrical bonding intermediary 125 in which the metallic wires 121 projecting by 10 μm from both surfaces of the holder 122 is obtained.

Incidentally, although, in this embodiment, the amount of projection of the metallic wires 121 is set to be 10 μm, any amount will suffice.

In addition, the method of causing the metallic wires 121 to project is not restricted to etching, and a different chemical or mechanical method may be employed.

The other aspects are the same as those of the 118th embodiment.

Alternatively, the projecting portions may be formed such that the electrical bonding intermediary 125 is clamped by dies having recesses at the positions of the metallic wires 121, and the bumps 150 such as those shown in Fig. 35 may be formed by crushing the projections 126 of the metallic wires 121. In this case, it becomes difficult for the metallic wires 121 to come off from the holder 122.

In this embodiment as well, the metallic wires 121 constitute the metallic members 107, the holder 122 is formed of aluminum, and the anodized aluminum films (not shown) and the resin 123 constitute the insulating material 140.

Incidentally, the bumps may be formed by thermally fusing the projections or by any other method.

In this embodiment as well, it was confirmed that the bonds display a high degree of reliability in terms of electrical connection.

(123rd Embodiment)

A 123rd embodiment will now be described by referring back to Figs. 36A and 36B.

In this embodiment, the semiconductor element 4 is used as the first electric circuit component, and the lead frame 1 as the second electric circuit component.

The other aspects are the same as those of the 122nd embodiment.

In this embodiment as well, it was confirmed that the bonds display a high degree of reliability in terms of electrical connection.

(124th Embodiment)

A 124th embodiment will now be descrbed by referring back to Figs. 37A and 37B.

In this embodiment, the electrical bonding intermediary 125 differs from that shown in the 122nd embodiment. Namely, in the electrical bonding intermediary 125 of this embodiment, the pitches between the adjacent metallic members are narrower than those shown in the 113th embodiment. In other words, in this embodiment, the pitches of the adjacent metallic members 107 are set to be narrower than those of the bonding areas of the first circuit board.

Namely, in the 122nd embodiment, since the bonding areas of the electrical bonding intermediary 125 are disposed such as to align with the bonding areas of the first and second circuit boards 101, 104, it is necessary to effect positioning of the electrical bonding intermediary 125 with respect to those bonding areas. In this embodiment, however, although the positioning of the first and second circuit boards 101, 104 with respect to each other is necessary, the positioning of the electrical bonding intermediary 125 with respect to those bonding areas becomes unnecessary. For this reason, If appropriate values are selected as bonding pitches (d11, P11) for the first and second circuit boards and as bonding pitches (d12, P12) for the electrical bonding intermediary 125, it is possible to effect bonding without performing the positioning of the electrical bonding intermediary 125 with respect to the first and second circuit boards.

In this embodiment, the holder formed of aluminum is subjected to anodization to form anodized films, and these films are used as the insulating material.

In this embodiment as well, it was confirmed that the bonds display a high degree of reliability in terms of electrical connection.

(125th Embodiment)

An electrical bonding intermediary used in a 125th embodiment will now be described by referring back to Figs. 38A and 38B.

Figs. 38A is a perspective view of the electrical bonding intermediary, while Fig. 38B is a cross-sectional view thereof.

An example of preparing such an electrical bonding intermediary will now be described.

First, three bonding intermediaries 128, 129, 130 in which the metallic members are respectively buried in the holder via the insulating material are prepared by using the production method shown in the 118th embodiment.

The position of each of the metallic wires 121 in the first sheet 128 is offset from a center by amounts ma, nb at row m and column n. The position of each of the metallic wires 121 in the second sheet 129 is offset from the center by amounts mac, nbc at row m and column n. The position of the metallic wire 121 in the third sheet 130 is offset from the center by amounts mad, nbd at row m and column. With respect to the values a, b, c, and d, those that allow the respective superposed metallic wires 121 to be conductive vertically but do not allow them to be conductive horizontally are selected. The three bonding intermediaries are positioned and are laminated by thermocompression bonding or another similar method, thereby preparing the electrical bonding intermediary 125.

It should be noted that although, in this embodiment, as for the positions of the metallic wires of the electrical bonding intermediary, regular positions, such as those located at row m and column n, are selected, random positions may be adopted if the respective superposed metallic wires are made conductive with each other and are not made conductive with each other in the horizontal direction.

In addition, although, in this embodiment, a description has been made of a case where the electrical bonding intermediary is laminated into a three-layered structure, any number of layers may be formed insofar as two or more layers are formed. Furthermore, although it has been described that the lamination is effected by thermocompression bonding or the like, compression bonding, adhesion, or another similar method may be used. In addition, projections such as those shown in Fig. 34 may be provided by machining the electrical bonding intermediary of this embodiment, and the bumps 150 shown in Fig. 35 may also be provided.

In this embodiment as well, it was confirmed that the bonds display a high degree of reliability in terms of electrical connection.

In addition, heat radiation characteristics were also excellent.

(126th Embodiment)

A description will be given of an electrical bonding intermediary used in a 126th embodiment by referring back to Figs. 39A to 39C.

Fig. 39A is a cross-sectional view of the electrical bonding intermediary being processed, Fig. 39B is a perspective view thereof, and Fig. 39C is a cross-sectional view thereof.

A description will now be given of an example of producing the electrical bonding intermediary 125 in accordance with this embodiment.

The holes 142 with an inside diameter greater than 20 μm are bored in the holder provided with insulating films in advance. Subsequently, the metallic wires 121 having a 20 μm-diameter and formed of a metal such as gold or an alloy are inserted through the holes 142, the resin 123 is poured into spaces between the holder 122 and the metallic wires 121 and is allowed to harden. The hardened resin 123 and the insulating films serve as insulating materials. Subsequently, the metallic wires 121 are sliced at the positions of the dotted lines 124 thereby to prepare the electrical bonding intermediary 125. The electrical bonding intermediary 125 thus prepared is shown in Figs. 39B, 39C.

In addition, projections may be provided by machining the electrical bonding intermediary of this embodiment, as shown in Fig. 34, or the bumps 150 may be provided, as shown in Fig. 35.

A circuit base material such as a semiconductor element, circuit board, or lead frame is used as the first and second electric circuit components of this embodiment, respectively. In this embodiment as well, it was confirmed that the bonds display a high degree of reliability in terms of electrical connection.

(127th Embodiment)

With reference to Figs. 31A, 31B, and 32A to 32C, a description will be made of a 127th embodiment of the present invention.

In this embodiment, the electrical bonding intermediary 125 is arranged as follows: The plurality of metallic members 107 formed of a metal or an alloy are buried in the holder 122 formed of an inorganic material in such a manner that one end of each of the metallic members 107 is exposed on the side of the first circuit board 101 and the other end thereof is exposed on the side of the second circuit board 104.

The electric circuit device is arranged such that the circuit board 101 which has the bonding areas 102 and constitutes the first electric circuit component and the circuit board 104 which has the bonding areas 105 and constitutes the second electric circuit component are connected to each other at the bonding areas 102, 105 of the two circuit boards 101, 104 with the electrical bonding intermediary 125 interposed therebetween to electrically connect the two circuit boards 101, 104.

A more detailed description of this embodiment will be made hereafter.

First, the electrical bonding intermediary 125 will be described concurrently with a description of an example of producing the electrical bonding intermediary 125.

An example of production is shown in Figs. 32A to 32C.

The holes 142 with an inside diameter greater than 20 μm are bored in the holder 122 consisting of an alumina ceramic at pitches of 40 μm. Subsequently, the metallic wires 121 having a 20 μm-diameter and formed of a metal such as gold or an alloy are inserted through the holes 142 of the holder 122. The resin 123 is then poured into spaces between the holder 122 formed of the alumina ceramic and the metallic wires 121, and the resin 123 is allowed to harden. Subsequently, the metallic wires 121 are sliced at the positions of the dotted lines 124 thereby to prepare the electrical bonding intermediary 125.

The electrical bonding intermediary 125 thus prepared is shown in Figs. 32B, 32C.

Incidentally, in this embodiment, after the metallic wires 121 are inserted, the resin 123 is allowed to harden. However, the resin 123 may be applied uniformly to the metallic wires 121, which may then be inserted through the holes 142 of the holder 122. The hardening of the resin 123 may be effected prior to or subsequent to the insertion of the metallic wires 121 through the holes 142.

In addition, although, in this embodiment, the resin 123 is placed between each of the metallic wires 121 and the holder 122 formed of the alumina ceramic, any electrically insulating material may be used instead of the resin 123. Furthermore, without using the resin 123, the metallic wires 121 may be brought into direct contact with the holder 122 formed of the alumina ceramic.

In addition, grinding may be performed to eliminate any drooping portions of the metallic wires 121. Furthermore, the drooping portions may be eliminated by another method without relaying on grinding. Moreover, although in this embodiment, the alumina ceramic is used as the inorganic material, another inorganic material may be used.

In such an electrical bonding intermediary 125 thus prepared, the metallic wires 121 constitute the metallic members 107, the resin 123 consitutes the insulators 140, and the holder 122, the insulators 140, and the metallic members 107 constitute the electrical bonding intermediary 125.

In this electrical bonding intermediary 125, the metallic wires 121 serving as the metallic members are electrically insulated from each other by means of the holder 122 constituted by the alumina ceramic or the resin 123. In addition, one end of each of the metallic wires 121 is exposed on the side of the circuit board 101, while the other end thereof is exposed on the side of the circuit board 104. These exposed portions constitute bonding areas 108, 109 to be electrically connected with the circuit boards 101, 104, respectively.

Next, the first circuit board 101, the electrical bonding intermediary 125, and the second circuit board 104 are prepared. The circuit boards 101, 104 that are used in this embodiment are provided with the multiplicity of bonding areas 102, 105, as shown in Figs. 31A, 31B.

Incidentally, each of the bonding areas 102 of the first circuit board 101 has a metal exposed at a position corresponding to the bonding area 105 of the second circuit board 104 and each of the bonding areas 108, 109 of the electrical bonding intermediary 125.

Positioning is effected in such a manner that the bonding areas 102 of the first circuit board 101 respectively correspond with the bonding areas 108 of the electrical bonding intermediary 125, or the bonding areas 105 of the second circuit board 104 respectively correspond with the bonding areas 109 of the electrical bonding intermediary 125, and bonding is effected after the positioning.

When the state of electrical connection was examined with respect to the electric circuit device thus prepared, it was confirmed that the bonds display a high degree of reliability in terms of electrical connection.

(128th Embodiment)

A description of a 128th embodiment will now be made by referring back to Figs. 24A and 24B.

In this embodiment, the circuit board 51 is used as the first electric circuit component having the bonding areas 52, and the semiconductor element 4 having the multiplicity of bonding areas 5 is used as the second electric circuit component.

It should be noted that, as the electrical bonding intermediary 125, one having dimensions corresponding to the semiconductor element 4 was used.

The other aspects are the same as those as the 127th embodiment.

In this embodiment as well, it was confirmed that the bonds display a high degree of reliability in terms of electrical connection.

(129th Embodiment)

A description will be given of a 129th embodiment by referring back to Fig. 12.

In this embodiment, an example is shown in which the semiconductor element 4 is used as the first electric circuit component and the circuit board 51 is used as the second electric circuit component.

It should be noted, after bonding, the lead frame 1 is connected to the upper surface of the circuit board 51, and the two members are sealed with the sealant 63.

The other aspects are the same as those of the 127th embodiment.

In this embodiment as well, it was confirmed that the bonds display a high degree of reliability in terms of electrical connection.

(130th Embodiment)

A description of a 130th embodiment will be made by referring back to Fig. 13.

In this embodiment, the semiconductor element 4 is used as the first electric circuit component, and the semiconductor element 4' is used as the second electric circuit component. In this embodiment, as the electrical bonding intermediary, one having dimensions corresponding to the semiconductor element 4' is used, and the lead frame 1 is bonded to the metallic members provided in the electrical bonding intermediary 125 and exposed on the side of the first semiconductor element 4.

The other aspects are the same as those of the 129th embodiment.

In this embodiment as well, it was confirmed that the bonds display a high degree of reliability in terms of electrical connection.

(131st Embodiment)

A 131st embodiment will now be described by referring back to Figs. 33A and 33B.

In the 131st embodiment, the circuit boards 101, 104 in which portions other than the bonding areas are covered with the insulating films 103, 106 are used as the first and second electric circuit components.

In addition, as the electrical bonding intermediary, the one shown in Fig. 34 is used. Namely, as shown in Fig. 34, in the electrical bonding intermediary 125 in which the metallic members 107 are buried in the holder 122 formed of an inorganic material, the exposed portions of the metallic members 107 project from both surfaces of the holder 122. The preparation of such an electrical bonding intermediary 125 may, for example, be effected as follows.

First, as in the case of the method described in the 127th embodiment, after each of the metallic wires is inserted into each hole of the holder 122 formed of an alumina ceramic, the resin is applied to the surfaces of the holder 122 with a thickness of 10 $\mu$m or thereabout, and is allowed to harden. Subsequently, the metallic wires 121 are cut at the positions at which they project 10$\mu$m or thereabout from both surfaces of the holder 122. Subsequently, if the applied resin is removed by etching, the electrical bonding intermediary 125 in which the metallic wires 121 projecting by 10 $\mu$m from both surfaces of the holder 122 is obtained.

Incidentally, although, in this embodiment, the amount of projection of the metallic wires 121 is set to be 10 $\mu$m, any amount will suffice.

In addition, the method of causing the metallic wires 121 to project is not restricted to etching, and a different chemical or mechanical method may be employed.

The other aspects are the same as those of the 127th embodiment.

Alternatively, the projecting portions may be formed such that the electrical bonding intermediary 125 is clamped by dies having recesses at the positions of the metallic wires 121, and the bumps 150 such as those shown in Fig. 35 may be formed by crushing the projections 126 of the metallic wires 121. In this case, it becomes difficult for the metallic wires 121 to come off from the holder 122.

In this embodiment as well, the metallic wires 121 constitute the metallic members 107, the resin 127 constitutes the insulators 140, the metallic members 107, the insulators 140, and the holder 122 constituted by the alumina ceramic constitute the electrical bonding intermediary 125.

Incidentally, the bumps may be formed by thermally fusing the projections or by any other method.

In this embodiment as well, it was confirmed that the bonds display a high degree of reliability in terms of electrical connection.

(132nd Embodiment)

A 132nd embodiment will now be described by referring back to Figs. 36A and 36B.

In this embodiment, the semiconductor element 4 is used as the first electric circuit component, and the lead frame 1 as the second electric circuit component.

The other aspects are the same as those of the 131st embodiment.

In this embodiment as well, it was confirmed that the bonds display a high degree of reliability in terms of electrical connection.

(133rd Embodiment)

A 133rd embodiment will be decribed by referring back to Figs. 37A and 37B.

In this embodiment, the electrical bonding intermediary 125 differs from that shown in the 131st embodiment. Namely, in the electrical bonding intermediary 125 of this embodiment, the pitches between the adjacent metallic members are narrower than those shown in the 131st embodiment. In other words, in this embodiment, the pitches of the adjacent metallic members 107 are set to be narrower than those of the bonding areas of the first circuit board.

Namely, in the 131st embodiment, since the bonding areas of the electrical bonding intermediary 125 are disposed such as to align with the bonding areas of the first and second circuit boards 101, 104, it is necessary to effect positioning of the electrical bonding intermediary 125 with respect to those bonding areas. In this embodiment, however, although the positioning of the first and second circuit boards 101, 104 with respect to each other is necessary, the positioning of the electrical bonding intermediary 125 with respect to those bonding areas becomes unnecessary. For this reason, If appropriate values are selected as bonding pitches (d11, P11) for the first and second circuit boards and as bonding pitches (d12, P12) for the electrical bonding intermediary 125, it is possible to effect bonding without performing the positioning of the electrical bonding intermediary 125 with respect to the first and second circuit boards.

In this embodiment as well, it was confirmed that the bonds display a high degree of reliability in terms of electrical connection.

(134th Embodiment)

Figs. 38A and 38B illustrate the electrical bonding intermediary used in a 137th embodiment.

Figs. 38A is a perspective view of the electrical bonding intermediary, while Fig. 38B is a cross-sectional view thereof.

An example of preparing such an electrical bonding intermediary will now be described.

First, three bonding intermediaries 128, 129, 130 in which the metallic members are respectively buried in the holder via the insulating material are prepared by using the production method shown in the 127th embodiment.

The position of each of the metallic wires 121 in the first sheet 128 is offset from a center by amounts ma, nb at row m and column n. The position of each of the metallic wires 121 in the second sheet 129 is offset from the center by amounts mac, nbc at row m and column n. The position of the metallic wire 121 in the third sheet 130 is offset from the center by amounts mad, nbd at row m and column. With respect to the values a, b, c, and d, those that allow the respective superposed metallic wires 121 to be conductive vertically but do not allow them to be conductive horizontally are selected. The three bonding intermediaries are positioned and are laminated by thermocompression bonding or another similar method, thereby preparing the electrical bonding intermediary 125.

It should be noted that although, in this embodiment, as for the positions of the metallic wires of the electrical bonding intermediary, regular positions, such as those located at row m and column n, are selected, random positions may be adopted if the respective superposed metallic wires are made conductive with each other and are not made conductive with each other in the horizontal direction.

In addition, although, in this embodiment, a description has been made of a case where the electrical bonding intermediary is laminated into a three-layered structure, any number of layers may be formed insofar as two or more layers are formed. Furthermore, although it has been described that the lamination is effected by thermocompression bonding or the like, compression bonding, adhesion, or another similar method may be used. In addition, projections such as those shown in Fig. 34 may be provided by machining the electrical bonding intermediary of this embodiment, and the bumps 150 shown in Fig. 35 may also be provided.

In this embodiment as well, it was confirmed that the bonds display a high degree of reliability in terms of electrical connection.

In addition, heat radiation characteristics were also excellent.

(135th Embodiment)

A description of an electrical bonding intermediary used in a 135th embodiment will be given by referring back to Figs. 39A to 39C.

Fig. 39A is a cross-sectional view of the electrical bonding intermediary being processed, Fig. 39B is a perspective view thereof, and Fig. 39C is a cross-sectional view thereof.

A description will now be given of an example of producing the electrical bonding intermediary 125 in accordance with this embodiment.

The holes 142 with an inside diameter greater than 20 μm are bored in the holder 122 formed of an alumina ceramic in advance. Subsequently, the metallic wires 121 having a 20 μm-diameter and formed of a metal or an alloy are inserted through the holes 142, the resin 123 is poured into spaces between the holder 122 and the metallic wires 121 and is allowed to harden. The hardened resin 123 serves as an insulating material. Subsequently, the metallic wires 121 are sliced at the positions of the dotted lines 124 thereby to prepare the electrical bonding intermediary 125. The electrical bonding intermediary 125 thus prepared is shown in Figs. 39B, 39C.

In addition, projections may be provided by machining the electrical bonding intermediary of this embodiment, as shown in Fig. 34, or the bumps 150 may be provided, as shown in Fig. 35.

A circuit base material such as a semiconductor element, circuit board, or lead frame is used as the first and second electric circuit components of this embodiment, respectively. In this embodiment as well, it was confirmed that the bonds display a high degree of reliability in terms of electrical connection.

(136th Embodiment)

A description will now be given of a 136th embodiment by referring back to Figs. 31A, 31B, and 32A to 32C.

In this embodiment, the circuit board 101 serving as the first electric circuit component having the bonding areas 102 and the circuit board 104 serving as the second electric circuit component having the bonding areas 105 are connected to each other at the bonding areas 102, 105 of the two circuit boards 101, 104 with the electrical bonding intermediary 125 interposed therebetween to electrically connect the two circuit boards 101, 104.

The electrical bonding intermediary 125 is arranged such that the plurality of metallic members 107 formed of a metal or an alloy are buried in a holder consisting of an inorganic material via an insulating material with one end of each of the metallic members 107 exposed on the side of the first circuit board 101 and the other end of each of the metallic members 107 exposed on the side of the second circuit board 104. Each of the bonding areas 102 of the first circuit board 101 and one end of each of the metallic members 107 exposed on the side of the first circuit board 101 are bonded to each other by being formed into an alloy, or each of the bonding areas 105 of the second circuit board 104 and one end of each of the metallic members 107 exposed on the side of the second circuit board 104 are bonded to each other by being formed into an alloy.

A more detailed description of this embodiment will be given hereafter.

First, the electrical bonding intermediary 125 will be described concurrently with a description of an example of producing the electrical bonding intermediary 125.

An example of production is shown in Figs. 32A to 32C.

The holes 142 with an inside diameter greater than 20 $\mu$m are bored in the holder 122 consisting of an alumina ceramic at pitches of 40 $\mu$m. Subsequently, the metallic wires 121 having a 20 $\mu$m-diameter and formed of a metal such as gold or an alloy are inserted through the holes 142 of the holder 122. The resin 123 is then poured into spaces between the holder 122 formed of the alumina ceramic and the metallic wires 121, and the resin 123 is allowed to harden. Subsequently, the metallic wires 121 are sliced at the positions of the dotted lines 124 thereby to prepare the electrical bonding intermediary 125.

The electrical bonding intermediary 125 thus prepared is shown in Figs. 32B, 32C.

Incidentally, in this embodiment, after the metallic wires 121 are inserted, the resin 123 is allowed to harden. However, the resin 123 may be applied uniformly to the metallic wires 121, which may then be inserted through the holes 142 of the holder 122. The hardening of the resin 123 may be effected prior to or subsequent to the insertion of the metallic wires 121 through the holes 142.

In addition, although, in this embodiment, the resin 123 is placed between each of the metallic wires 121 and the holder 122 formed of the alumina ceramic, any electrically insulating material may be used instead of the resin 123. Furthermore, without using the resin 123, the metallic wires 121 may be brought into direct contact with the holder 122 formed of the alumina ceramic.

In addition, grinding may be performed to eliminate any drooping portions of the metallic wires 121. Furthermore, the drooping portions may be eliminated by another method without relaying on grinding. Moreover, although in this embodiment, the alumina ceramic is used as the inorganic material, another inorganic material may be used.

In such an electrical bonding intermediary 125 thus prepared, the metallic wires 121 constitute the metallic members 107, the resin 123 consitutes the insulators 140, and the holder 122, the insulators 140, and the metallic members 107 constitute the electrical bonding intermediary 125.

In this electrical bonding intermediary 125, the metallic wires 121 serving as the metallic members are electrically insulated from each other by means of the holder 122 constituted by the alumina ceramic or the resin 123. In addition, one end of each of the metallic wires 121 is exposed on the side of the circuit board 101, while the other end thereof is exposed on the side of the circuit board 104. These exposed portions constitute bonding areas 108, 109 to be electrically connected with the circuit boards 101, 104, respectively.

Next, the first circuit board 101, the electrical bonding intermediary 125, and the second circuit board 104 are prepared. The circuit boards 101, 104 that are used in this embodiment are provided with the multiplicity of bonding areas 102, 105, as shown in Figs. 31A and 31B.

Incidentally, each of the bonding areas 102 of the first circuit board 101 has a metal exposed at a position corresponding to the bonding area 105 of the second circuit board 104 and each of the bonding areas 108, 109 of the electrical bonding intermediary 125.

Positioning is effected in such a manner that the bonding areas 102 of the first circuit board 101 respectively correspond with the bonding areas 108 of the electrical bonding intermediary 125, or the bonding areas 105 of the second circuit board 104 respectively correspond with the bonding areas 109 of the electronical bonding intermediary 125, and, after positioning, either group of the bonding areas are bonded to each other by being formed into an alloy, and the other group of the bonding areas are bonded to each other by another method.

At this juncture, the following two methods are available to connect the first circuit board 101, the electrical bonding intermediary 125, and the second circuit board 104, but either method may be used.

(1) After the first circuit board 101 and the electrical bonding intermediary 125 are positioned, the bonding areas 102 of the first circuit board 101 and the bonding areas 108 of the electrical bonding intermediary 125 are bonded to each other by being formed into an alloy. Subsequently, the second circuit board 104 is positioned, and the bonding areas 105 of the second circuit board 104 and the bonding areas 109 of the electrical bonding intermediary 125 are bonded to each other by pressing.

(2) After the second circuit board 104 and the electrical bonding intermediary 125 are positioned, the bonding areas 105 of the second circuit board 104 and the bonding areas 109 of the electrical bonding intermediary 125 are bonded to each other by being formed into an alloy. Subsequently, the first circuit board 101 is positioned, and the bonding areas 102 of the first circuit board 101 and the bonding areas 108 of the electrical bonding intermediary 125 are bonded to each other by pressing.

When the state of electrical connection was examined with respect to the electric circuit device thus prepared, it was confirmed that the bonds display a high degree of reliability in terms of electrical connection.

(137th Embodiment)

A description of a 137th embodiment will now be made by referring back to Figs. 24A and 24B.

In this embodiment, the circuit board 51 is used as the first electric circuit component having the bonding areas 52, and the semiconductor element 4 having the multiplicity of bonding areas 5 is used as the second electric circuit component.

It should be noted that, as the electrical bonding intermediary 125, one having dimensions corresponding to the semiconductor element 4 was used.

The other aspects are the same as those as the 136th embodiment.

In this embodiment as well, it was confirmed that the bonds display a high degree of reliability in terms of electrical connection.

(138th Embodiment)

A description will be given of a 138th embodiment by referring back to Fig. 12.

In this embodiment, an example is shown in which the semiconductor element 4 is used as the first electric circuit component and the circuit board 51 is used as the second electric circuit component.

It should be noted, after bonding, the lead frame 1 is connected to the upper surface of the circuit board 51, and the two members are sealed with the sealant 63.

The other aspects are the same as those of the 136th embodiment.

In this embodiment as well, it was confirmed that the bonds display a high degree of reliability in terms of electrical connection.

(139th Embodiment)

A description of a 139th embodiment will be made by referring back to Fig. 13.

In this embodiment, the semiconductor element 4 is used as the first electric circuit component, and the semiconductor element 4' is used as the second electric circuit component. In this embodiment, as the electrical bonding intermediary, one having dimensions corresponding to the semiconductor element 4' is used, and the lead frame 1 is bonded to the metallic members provided in the electrical bonding intermediary 125 and exposed on the side of the first semiconductor element 4.

The other aspects are the same as those of the 138th embodiment.

In this embodiment as well, it was confirmed that the bonds display a high degree of reliability in terms of electrical connection.

(140th Embodiment)

A 140th embodiment will now be described by referring back to Figs. 33A and 33B.

In the 140th embodiment, the circuit boards 101, 104 in which portions other than the bonding areas are covered with the insulating films 103, 106 are used as the first and second electric circuit components.

In addition, as the electrical bonding intermediary, the one shown in Fig. 34 is used. Namely, as shown in Fig. 34, in the electrical bonding intermediary 125 in which the metallic members 107 are buried in the holder 122 formed of an inorganic material, the exposed portions of the metallic members 107 project from both surfaces of the holder 122. The preparation of such an electrical bonding intermediary 125 may, for example, be effected as follows.

First, as in the case of the method described in the 127th embodiment, after each of the metallic wires is inserted into each hole of the holder 122 formed of an alumina ceramic, the resin is applied to the surfaces of the holder 122 with a thickness of 10 μm or thereabout, and is allowed to harden. Subsequently, the metallic wires 121 are cut at the positions at which they project 10μm or thereabout from both surfaces of the holder 122. Subsequently, if the applied resin is removed by etching, the electrical bonding intermediary 125 in which the metallic wires 121 projecting by 10 μm from both surfaces of the holder 122 is obtained.

Incidentally, although, in this embodiment, the amount of projection of the metallic wires 121 is set to be 10 μm, any amount will suffice.

In addition, the method of causing the metallic wires 121 to project is not restricted to etching, and a different chemical or mechanical method may be employed.

The other aspects are the same as those of the 136th embodiment.

Alternatively, the projecting portions may be formed such that the electrical bonding intermediary 125 is clamped by dies having recesses at the positions of the metallic wires 121, and the bumps 150 such as those shown in Fig. 35 may be formed by crushing the projections 126 of the metallic wires 121. In this case, it becomes difficult for the metallic wires 121 to come off from the holder 122.

In this embodiment as well, the metallic wires 121 constitute the metallic members 107, the resin 127 constitutes the insulators 140, the metallic members 107, the insulators 140, and the holder 122 constituted by the alumina ceramic constitute the electrical bonding intermediary 125.

Incidentally, the bumps may be formed by thermally fusing the projections or by any other method.

In this embodiment as well, it was confirmed that the bonds display a high degree of reliability in terms of electrical connection.

(141st Embodiment)

A 141st embodiment will now be described by referring back to Figs. 36A and 36B.

In this embodiment, the semiconductor element 4 is used as the first electric circuit component, and the lead frame 1 as the second electric circuit component.

The other aspects are the same as those of the 140th embodiment.

In this embodiment as well, it was confirmed that the bonds display a high degree of reliability in terms of electrical connection.

(142nd Embodiment)

A 142nd embodiment will be decribed by referring back to Figs. 37A and 37B.

In this embodiment, the electrical bonding intermediary 125 differs from that shown in the 140th embodiment. Namely, in the electrical bonding intermediary 125 of this embodiment, the pitches between the adjacent metallic members are narrower than those shown in the 140th embodiment. In other words, in this embodiment, the pitches of the adjacent metallic members 107 are set to be narrower than those of the bonding areas of the first circuit board.

Namely, in the 140th embodiment, since the bonding areas of the electrical bonding intermediary 125 are disposed such as to align with the bonding areas of the first and second circuit boards 101, 104, it is necessary to effect positioning of the electrical bonding intermediary 125 with respect to those bonding areas. In this embodiment, however, although the positioning of the first and second circuit boards 101, 104 with respect to each other is necessary, the positioning of the electrical bonding intermediary 125 with respect to those bonding areas becomes unnecessary. For this reason. If appropriate values are selected as bonding pitches (d11, P11) for the first and second circuit boards and as bonding pitches (d12, P12) for the electrical bonding intermediary 125, it is possible to effect bonding without performing the positioning of the electrical bonding intermediary 125 with respect to the first and second circuit boards.

In this embodiment as well, it was confirmed that the bonds display a high degree of reliability in terms of electrical connection.

(143rd Embodiment)

A description will be made of an electrical bonding intermediary used in a 143rd embodiment by referring back to Figs. 38A and 38B.

Figs. 38A is a perspective view of the electrical bonding intermediary, while Fig. 38B is a cross-sectional view thereof.

An example of preparing such an electrical bonding intermediary will now be described.

First, three bonding intermediaries 128, 129, 130 in which the metallic members are respectively buried in the holder via the insulating material are prepared by using the production method shown in the 136th embodiment.

The position of each of the metallic wires 121 in the first sheet 128 is offset from a center by amounts ma, nb at row m and column n. The position of each of the metallic wires 121 in the second sheet 129 is offset from the center by amounts mac, nbc at row m and column n. The position of the metallic wire 121 in the third sheet 130 is offset from the center by amounts mad, nbd at row m and column. With respect to the values a, b, c, and d, those that allow the respective superposed metallic wires 121 to be conductive vertically but do not allow them to be conductive horizontally are selected. The three bonding intermediaries are positioned and are laminated by thermocompression bonding or another similar method, thereby preparing the electrical bonding intermediary 125.

It should be noted that although, in this embodiment, as for the positions of the metallic wires of the electrical bonding intermediary, regular positions, such as those located at row m and column n, are selected, random positions may be adopted if the respective superposed metallic wires are made conductive with each other and are not made conductive with each other in the horizontal direction.

In addition, although, in this embodiment, a description has been made of a case where the electrical bonding intermediary is laminated into a three-layered structure, any number of layers may be formed insofar as two or more layers are formed. Furthermore, although it has been described that the lamination is effected by thermocompression bonding or the like, compression bonding, adhesion, or another similar method may be used. In addition, projections such as those shown in Fig. 34 may be provided by machining the electrical bonding intermediary of this embodiment, and the bumps 150 shown in Fig. 35 may also be provided.

In this embodiment as well, it was confirmed that the bonds display a high degree of reliability in terms of electrical connection.

In addition, heat radiation characteristics were also excellent.

(144th Embodiment)

A description of an electrical bonding intermediary used in a 144th embodiment will be given by referring back to Figs. 39A to 39C.

Fig. 39A is a cross-sectional view of the electrical bonding intermediary being processed, Fig. 39B is a perspective view thereof, and Fig. 39C is a cross-sectional view thereof.

A description will now be given of an example of producing the electrical bonding intermediary 125 in accordance with this embodiment.

The holes 142 with an inside diameter greater than 20 μm are bored in the holder 122 formed of an alumina ceramic in advance. Subsequently, the metallic wires 121 having a 20 μm-diameter and formed of a metal or an alloy are inserted through the holes 142, the resin 123 is poured into spaces between the holder 122 and the metallic wires 121 and is allowed to harden. The hardened resin 123 serves as an insulating material. Subsequently, the metallic wires 121 are sliced at the positions of the dotted lines 124 thereby to prepare the electrical bonding intermediary 125. The electrical bonding intermediary 125 thus prepared is shown in Figs. 39B, 39C.

In addition, projections may be provided by machining the electrical bonding intermediary of this embodiment, as shown in Fig. 34, or the bumps 150 may be provided, as shown in Fig. 35.

A circuit base material such as a semiconductor element, circuit board, or lead frame is used as the first and second electric circuit components of this embodiment, respectively. In this embodiment as well, it was confirmed that the bonds display a high degree of reliability in terms of electrical connection.

(145th Embodiment)

A description will now be given of a 145th embodiment by referring back to Figs. 31A, 31B, and 32A to 32C.

In this embodiment, the circuit board 101 serving as the first electric circuit component having the bonding areas 102 and the circuit board 104 serving as the second electric circuit component having the bonding areas 105 are connected to each other at the bonding areas 102, 105 of the two circuit boards 101, 104 with the electrical bonding intermediary 125 interposed therebetween to electrically connect the two circuit boards 101, 104.

The electrical bonding intermediary 125 is arranged such that the plurality of metallic members 107 formed of a metal or an alloy are buried in a holder consisting of an inorganic material via an insulating material with one end of each of the metallic members 107 exposed on the side of the first circuit board 101 and the other end of each of the metallic members 107 exposed on the side of the second circuit board 104. Each of the bonding areas 102 of the first circuit board 101 and one end of each of the metallic members 107 exposed on the side of the first circuit board 101 are bonded to each other by being formed into an alloy, or each of the bonding areas 105 of the second circuit board 104 and one end of each of the metallic members 107 exposed on the side of the second circuit board 104 are bonded to each other by being formed into an alloy.

A more detailed description of this embodiment will be given hereafter.

First, the electrical bonding intermediary 125 will be described concurrently with a description of an example of producing the electrical bonding intermediary 125.

An example of production is shown in Figs.

32A to 32C.

The holes 142 with an inside diameter greater than 20 μm are bored in the holder 122 consisting of an alumina ceramic at pitches of 40 μm. Subsequently, the metallic wires 121 having a 20 μm-diameter and formed of a metal such as gold or an alloy are inserted through the holes 142 of the holder 122. The resin 123 is then poured into spaces between the holder 122 formed of the alumina ceramic and the metallic wires 121, and the resin 123 is allowed to harden. Subsequently, the metallic wires 121 are sliced at the positions of the dotted lines 124 thereby to prepare the electrical bonding intermediary 125.

The electrical bonding intermediary thus prepared is shown in Figs. 32B, 32C.

Incidentally, in this embodiment, after the metallic wires 121 are inserted, the resin 123 is allowed to harden. However, the resin 123 may be applied uniformly to the metallic wires 121, which may then be inserted through the holes 142 of the holder 122. The hardening of the resin 123 may be effected prior to or subsequent to the insertion of the metallic wires 121 through the holes 142.

In addition, although, in this embodiment, the resin 123 is placed between each of the metallic wires 121 and the holder 122 formed of the alumina ceramic, any electrically insulating material may be used instead of the resin 123. Furthermore, without using the resin 123, the metallic wires 121 may be brought into direct contact with the holder 122 formed of the alumina ceramic.

In addition, grinding may be performed to eliminate any drooping portions of the metallic wires 121. Furthermore, the drooping portions may be eliminated by another method without relaying on grinding. Moreover, although in this embodiment, the alumina ceramic is used as the inorganic material, another inorganic material may be used.

In such an electrical bonding intermediary 125 thus prepared, the metallic wires 121 constitute the metallic members 107, the resin 123 consitutes the insulators 140, and the holder 122, the insulators 140, and the metallic members 107 constitute the electrical bonding intermediary 125.

In this electrical bonding intermediary 125, the metallic wires 121 serving as the metallic members are electrically insulated from each other by means of the holder 122 constituted by the alumina ceramic or the resin 123. In addition, one end of each of the metallic wires 121 is exposed on the side of the circuit board 101, while the other end thereof is exposed on the side of the circuit board 104. These exposed portions constitute bonding areas 108, 109 to be electrically connected with the circuit boards 101, 104, respectively.

Next, the first circuit board 101, the electrical bonding intermediary 125, and the second circuit board 104 are prepared. The circuit boards 101, 104 that are used in this embodiment are provided with the multiplicity of bonding areas 102, 105, as shown in Figs. 31A and 31B.

Incidentally, each of the bonding areas 102 of the first circuit board 101 has a metal exposed at a position corresponding to the bonding area 105 of the second circuit board 104 and each of the bonding areas 108, 109 of the electrical bonding intermediary 125.

Positioning is effected in such a manner that the bonding areas 102 of the first circuit board 101 respectively correspond with the bonding areas 108 of the electrical bonding intermediary 125, or the bonding areas 105 of the second circuit board 104 respectively correspond with the bonding areas 109 of the electrical bonding intermediary 125, and, after positioning, either group of the bonding areas are bonded to each other by being formed into an alloy, and the other group of the bonding areas are bonded to each other by another method.

At this juncture, the following two methods are available to connect the first circuit board 101, the electrical bonding intermediary 125, and the second circuit board 104, but either method may be used.

(1) After the first circuit board 101 and the electrical bonding intermediary 125 are positioned, the bonding areas 102 of the first circuit board 101 and the bonding areas 108 of the electrical bonding intermediary 125 are bonded to each other by being formed into an alloy. Subsequently, the second circuit board 104 is positioned, and the bonding areas 105 of the second circuit board 104 and the bonding areas 109 of the electrical bonding intermediary 125 are bonded to each other by pressing.

(2) After the second circuit board 104 and the electrical bonding intermediary 125 are positioned, the bonding areas 105 of the second circuit board 104 and the bonding areas 109 of the electrical bonding intermediary 125 are bonded to each other by being formed into an alloy. Subsequently, the first circuit board 101 is positioned, and the bonding areas 102 of the first circuit board 101 and the bonding areas 108 of the electrical bonding intermediary 125 are bonded to each other by pressing.

When the state of electrical connection was examined with respect to the electric circuit device thus prepared, it was confirmed that the bonds display a high degree of reliability in terms of electrical connection.

(3) The second circuit board 104 and the electrical bonding intermediary are positioned at the predetermined location and the bonding areas 105 of the second circuit 104 are connected by alloying to the bonding areas 109 of the electrical bonding intermediary 125. Then the first circuit board 101 is positioned at the predetermined location and finally the bonding areas 108 of the electrical bonding intermediary 125 is connected by alloying to the bonding areas 102 of the first circuit board 101.

It was confirmed that the electrical bonding intermediaries were connected each other at the high degree of reliability.

(146th Embodiment)

A description of a 146th embodiment will now be made by referring back to Figs. 24A and 24B.

In this embodiment, the circuit board 51 is used as the first electric circuit component having the bonding areas 52, and the semiconductor element 4 having the multiplicity of bonding areas 5 is used as the second electric circuit component.

It should be noted that, as the electrical bonding intermediary 125, one having dimensions corresponding to the semiconductor element 4 was used.

The other aspects are the same as those as the 145th embodiment.

In this embodiment as well, it was confirmed that the bonds display a high degree of reliability in terms of electrical connection.

(147th Embodiment)

A description will be given of a 147th embodiment by referring back to Fig. 12.

In this embodiment, an example is shown in which the semiconductor element 4 is used as the first electric circuit component and the circuit board 51 is used as the second electric circuit component.

It should be noted, after bonding, the lead connected to the upper surface of the circuit board 51, and the two members are sealed with the sealant 63.

The other aspects are the same as those of the 145th embodiment.

In this embodiment as well, it was confirmed that the bonds display a high degree of reliability in terms of electrical connection.

(148th Embodiment)

A description of a 148th embodiment will be made by referring back to Fig. 13.

In this embodiment, the semiconductor element 4 is used as the first electric circuit component, and the semiconductor element 4' is used as the second electric circuit component. In this embodiment, as the electrical bonding intermediary, one having dimensions corresponding to the semiconductor element 4' is used, and the lead frame 1 is bonded to the metallic members provided in the electrical bonding intermediary 125 and exposed on the side of the first semiconductor element 4.

The other aspects are the same as those of the 147th embodiment.

In this embodiment as well, it was confirmed that the bonds display a high degree of reliability in terms of electrical connection.

(149th Embodiment)

A 149th embodiment will now be described by referring back to Figs. 33A and 33B.

In the 140th embodiment, the circuit boards 101, 104 in which portions other than the bonding areas are covered with the insulating films 103, 106 are used as the first and second electric circuit components.

In addition, as the electrical bonding intermediary, the one shown in Fig. 34 is used. Namely, as shown in Fig. 34, in the electrical bonding intermediary 125 in which the metallic members 107 are buried in the holder 122 formed of an inorganic material, the exposed portions of the metallic members 107 project from both surfaces of the holder 122. The preparation of such an electrical bonding intermediary 125 may, for example, be effected as follows.

First, as in the case of the method described in the 145th embodiment, after each of the metallic wires is inserted into each hole of the holder 122 formed of an alumina ceramic, the resin is applied to the surfaces of the holder 122 with a thickness of 10 μm or thereabout, and is allowed to harden. Subsequently, the metallic wires 121 are cut at the positions at which they project 10μm or thereabout from both surfaces of the holder 122. Subsequently, if the applied resin is removed by etching, the electrical bonding intermediary 125 in which the metallic wires 121 projecting by 10 μm from both surfaces of the holder 122 is obtained.

Incidentally, although, in this embodiment, the amount of projection of the metallic wires 121 is set to be 10 μm, any amount will suffice.

In addition, the method of causing the metallic wires 121 to project is not restricted to etching, and a different chemical or mechanical method may be employed.

The other aspects are the same as those of the 145th embodiment.

Alternatively, the projecting portions may be formed such that the electrical bonding intermediary 125 is clamped by dies having recesses at the positions of the metallic wires 121, and the bumps 150 such as those shown in Fig. 35 may be formed by crushing the projections 126 of the metallic wires 121. In this case, it becomes difficult for the metallic wires 121 to come off from the holder 122.

In this embodiment as well, the metallic wires 121 constitute the metallic members 107, the resin 127 constitutes the insulators 140, the metallic members 107, the insulators 140, and the holder 122 constituted by the alumina ceramic constitute the electrical bonding intermediary 125.

Incidentally, the bumps may be formed by thermally fusing the projections or by any other method.

In this embodiment as well, it was confirmed that the bonds display, a high degree of reliability in terms of electrical connection.

(150th Embodiment)

A 150th embodiment will now be described by referring back to Figs. 36A and 36B.

In this embodiment, the semiconductor element 4 is used as the first electric circuit component, and the lead frame 1 as the second electric circuit component.

The other aspects are the same as those of the 149th embodiment.

In this embodiment as well, it was confirmed that the bonds display a high degree of reliability in terms of electrical connection.

(151st Embodiment)

A 151st embodiment will be decribed by referring back to Figs. 37A and 37B.

In this embodiment, the electrical bonding intermediary 125 differs from that shown in the 149th embodiment. Namely, in the electrical bonding intermediary 125 of this embodiment, the pitches between the adjacent metallic members are narrower than those shown in the 149th embodiment. In other words, in this embodiment, the pitches of the adjacent metallic members 107 are set to be narrower than those of the bonding areas of the first circuit board.

Namely, in the 149th embodiment, since the bonding areas of the electrical bonding intermediary 125 are disposed such as to align with the bonding areas of the first and second circuit boards 101, 104, it is necessary to effect positioning of the electrical bonding intermediary 125 with respect to those bonding areas. In this embodiment, however, although the positioning of the first and second circuit boards 101, 104 with respect to each other is necessary, the positioning of the electrical bonding intermediary 125 with respect to those bonding areas becomes unnecessary. For this reason, if appropriate values are selected as bonding pitches (d11, P11) for the first and second circuit boards and as bonding pitches (d12, P12) for the electrical bonding intermediary 125, it is possible to effect bonding without performing the positioning of the electrical bonding intermediary 125 with respect to the first and second circuit boards.

In this embodiment as well, it was confirmed that the bonds display a high degree of reliability in terms of electrical connection.

(152nd Embodiment)

A description will be made of an electrical bonding intermediary used in a 152nd embodiment by referring back to Figs. 38A and 38B.

Figs. 38A is a perspective view of the electrical bonding intermediary, while Fig. 38B is a cross-sectional view thereof.

An example of preparing such an electrical bonding intermediary will now be described.

First, three bonding intermediaries 128, 129, 130 in which the metallic members are respectively buried in the holder via the insulating material are prepared by using the production method shown in the 145th embodiment.

The position of each of the metallic wires 121 in the first sheet 128 is offset from a center by amounts ma, nb at row m and column n. The position of each of the metallic wires 121 in the second sheet 129 is offset from the center by amounts mac, nbc at row m and column n. The position of the metallic wire 121 in the third sheet 130 is offset from the center by amounts mad, nbd at row m and column. With respect to the values a, b, c, and d, those that allow the respective superposed metallic wires 121 to be conductive vertically but do not allow them to be conductive horizontally are selected. The three bonding intermediaries are positioned and are laminated by thermocompression bonding or another similar method, thereby preparing the electrical bonding intermediary 125.

It should be noted that although, in this embodiment, as for the positions of the metallic wires of the electrical bonding intermediary, regular positions, such as those located at row m and column n, are selected, random positions may be adopted if the respective superposed metallic wires are made conductive with each other and are not made conductive with each other in the horizontal direction.

In addition, although, in this embodiment, a description has been made of a case where the electrical bonding intermediary is laminated into a three-layered structure, any number of layers may be formed insofar as two or more layers are formed. Furthermore, although it has been described that the lamination is effected by thermocompression bonding or the like, compression bonding, adhesion, or another similar method may be used. In addition, projections such as those shown in Fig. 34 may be provided by machining the electrical bonding intermediary of this embodiment, and the bumps 150 shown in Fig. 35 also be provided.

In this embodiment as well, it was confirmed that the bonds display a high degree of reliability in terms of electrical connection.

In addition, heat radiation characteristics were also excellent.

(153rd Embodiment)

A description of an electrical bonding intermediary used in a 153rd embodiment will be given by referring back to Figs. 39A to 39C.

Fig. 39A is a cross-sectional view of the electrical bonding intermediary being processed, Fig. 39B is a perspective view thereof, and Fig. 39C is a cross-sectional view thereof.

A description will now be given of an example of producing the electrical bonding intermediary 125 in accordance with this embodiment.

The holes 142 with an inside diameter greater than 20 μm are bored in the holder 122 formed of an alumina ceramic in advance. Subsequently, the metallic wires 121 having a 20 μm-diameter and formed of a metal or an alloy are inserted through the holes 142, the resin 123 is poured into spaces between the holder 122 and the metallic wires 121 and is allowed to harden. The hardened resin 123 serves as an insulating material. Subsequently, the metallic wires 121 are sliced at the positions of the dotted lines 124 thereby to prepare the electrical bonding intermediary 125. The electrical bonding intermediary 125 thus prepared is shown in Figs. 39B and 39C.

In addition, projections may be provided by machining the electrical bonding intermediary of this embodiment, as shown in Fig. 34, or the bumps 150 may be provided, as shown in Fig. 35.

A circuit base material such as a semiconductor element, circuit board, or lead frame is used as the first and second electric circuit components of this embodiment, respectively. In this embodiment as well, it was confirmed that the bonds display a high degree of reliability in terms of electrical connection.

(Embodiment 154)

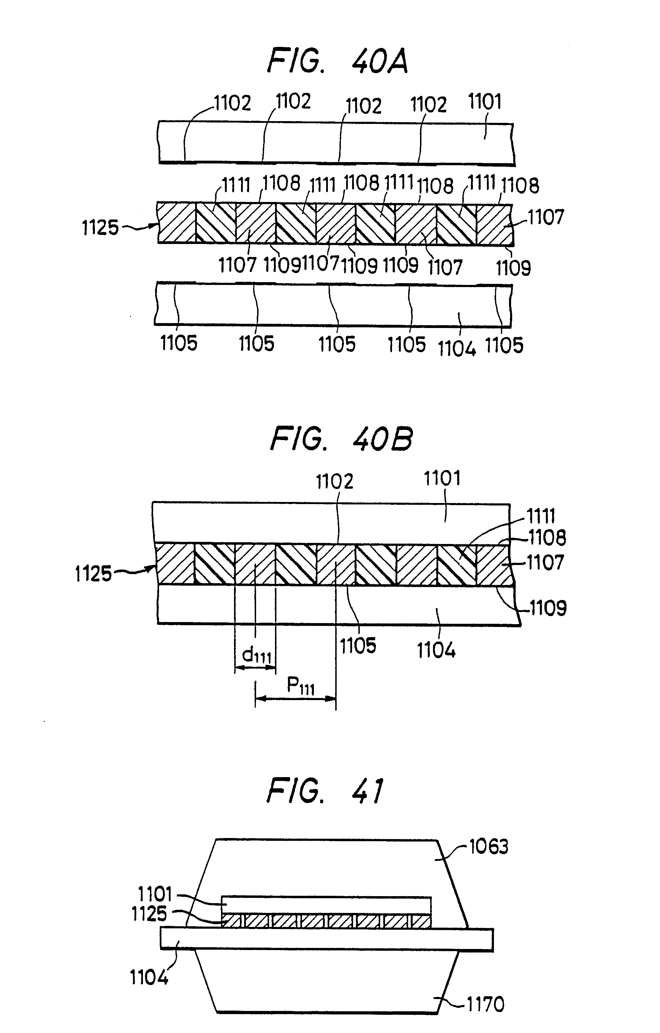

The 154th embodiment of the present invention will be explained below referring to Figures 40A, 40B 41, 42A, 42B, and 42C.

An electric circuit device of the instant embodiment comprises at least: an electrically connecting member 1125 having a holder 1111 of an organic material and metal members 1107 being electrically conductive members embedded in the holder 1111, one end of said metal members 1107 being exposed at one face of the holder 1111 and the other end of said metal members 1107 being exposed at the other face of the holder; a semiconductor element 1101 having connecting portions 1102 which are alloyed with the exposed metal members at said one face of the holder 1111 so as to effect connection therebetween; and a circuit plate 1104 having connecting portions 1105 which are alloyed with the exposed metal members at the other face of the holder 1111; wherein both the semiconductor element 1101 and the circuit plate 1104 are sealed by sealing materials 1170.

There will be the subject embodiment detailed below.

The electrically connecting member 1125 will be explained first describing a manufacturing example thereof.

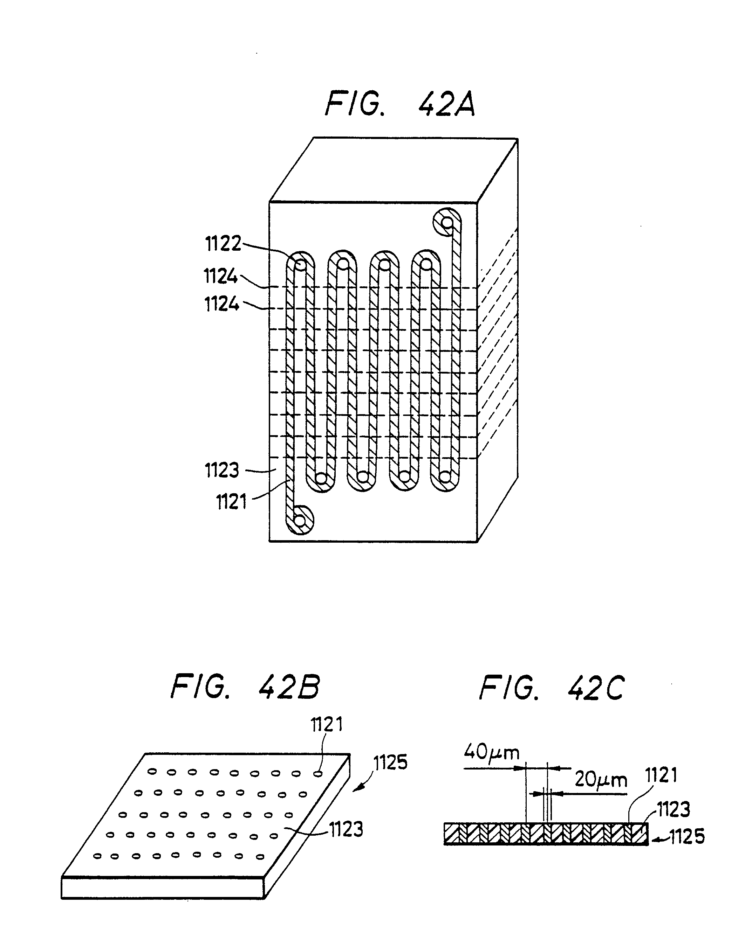

Figs. 42A, 42B, and 42C show the manufacturing example of the electrically connecting member 1125.

Metal wires 1121 of a metal such as gold or an alloy thereof having a diameter of 20 μm, are wound around rods 1122 at a pitch of 40 μm. Then, the metal wires 1121 are embedded into a resin 1128 such as polyimides. The resin 1128 is cured after the embedding. The cured resin becomes electrically insulative. The cured body is sliced along dotted lines into the electrically connecting members 1125. The electrically connecting member 1125 thus manufactured is illustrated in Figs. 42B and 42C.

In the connecting member 1125, the metal wires 1121 constitute the metal members 1107, and the resin 1123 does the holder 1111.

The metal wires 1121 constituting the metal members are electrically insulated from each other by the resin 1123 in the connecting member 1125. One end of the metal wires 1121 is exposed to the semiconductor element 1101 and the other end thereof to the circuit plate 1104. The exposed parts of the wires serve as connecting portions 1108, 1109 to the semiconductor element 1101 and the circuit plate 1104, respectively.

For a further step, there are prepared the semiconductor element 1101, the electrically connecting member 1125, and the circuit plate 1104. The semiconductor element 1101 and the circuit plate 1104 used in the present embodiment have respective, numerous internal, connecting portions 1102, 1105 as shown in Figs. 40A and 40B.

The connecting portions 1102 of the semiconductor element 1101 are formed by metals exposed at respective positions corresponding to the connecting portions 1105 of the circuit plate 1104 and the connecting portions 1108, 1109 of the connecting member 1125.

The three elements 1101, 1125, 1104 are connected after positioning: The connecting portions 1102 of the semiconductor element 1101 are positioned against the connecting portions 1108 of the connecting member 1125, or the connecting portions 1105 of the circuit plate 1104 against the connecting portions 1109 of the connecting member 1125; after the positioning, the connection is performed either between aluminum (Aℓ) of the connecting portions 1102 of the semiconductor element 1101 and gold (Au) of the connecting portions 1108 of the connecting member 1125, or between gold (Au) of the connecting portions 1109 of the connecting member 1125 and gold (Au) of the connecting portions 1105 of the circuit plate 1104 by metallizing and/or alloying therebetween.

There are three possible methods for the connection by metallizing and/or alloying between the semiconductor element 1101 and the electrically connecting member 1125 and between the member 1125 and the circuit plate 1104. Any of the following three methods may be employed for the connection.

## The first method

After the semiconductor element 1101, the electrically connecting member 1125, and the circuit plate 1104 are positioned with each other, the connection is effected simultaneously between the portions 1102 of the element 1101 and the portions 1108 of the member 1125 and between the portions 1105 of the circuit plate 1104 and the portions 1109 of the member 1125, by the metallization and/or the alloying.

## The second method

First, after positioning the semiconductor element 1101 and the connecting member 1125, the connecting portions 1102 of the semiconductor element 1101 and the connecting portions of the connecting member 1125 are alloyed to connect to each other. Second, after positioning the circuit plate 1104, the connecting portions 1109 of the connecting member 1125 and the connecting portions 1105 of the circuit plate 1104 are metallized and/or alloyed to connect to each other.

## The third method

First, after positioning the circuit plate 1104 and the connecting member 1125, the connecting portions 1105 of the circuit plate 1104 and the connecting portions 1109 of the connecting member 1125 are metallized and or alloyed to connect to each other. Second, after positioning the semiconductor element 1101, the connecting portion 1108 of the connecting member 1125 and the connecting portions 1102 of the semiconductor element 1101 are metallized and or alloyed to connect to each other.

After the completion of the connection, electric circuit parts of the thus assembled members or electric circuit member are sealed. In this embodiment, both the semiconductor element and the circuit plate 1104 are sealed. The sealing material is a thermoplastic resin, and the sealing is conducted by an injection molding method.

It is assured that the electric circuit device as manufactured following the above steps has a high reliability on the connection between the connecting portions. Furthermore, the device showed superior reliabilities on various properties.

(Embodiment 155)

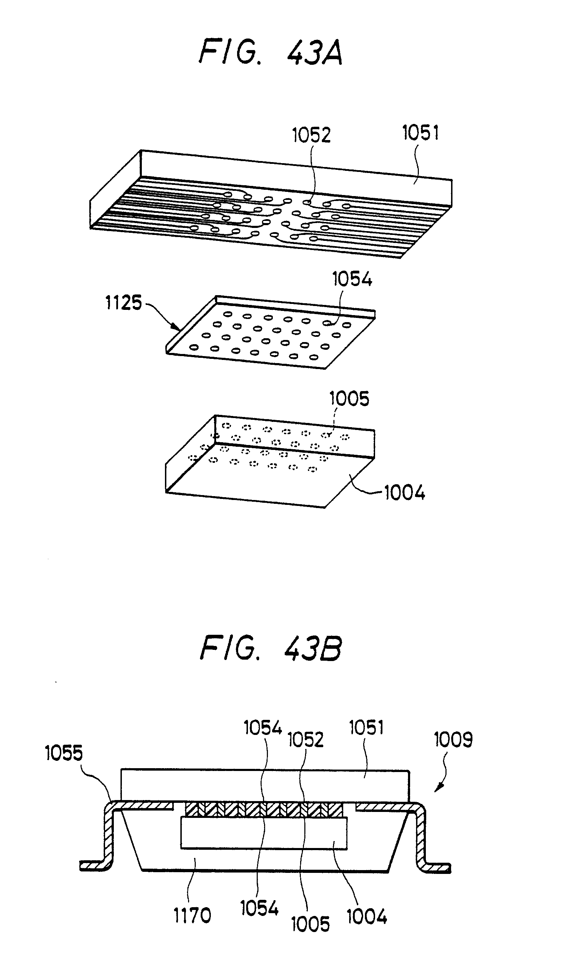

The 155th embodiment is illustrated in Figs. 43A and 43B.

This embodiment employs a circuit plate 1051 having connecting portions 1052 as a first electric circuit part and a semiconductor element 1004 having numerous internal connecting portions 1005 as a second electric circuit part.

In an electrically connecting member 1125 of the instant embodiment, a holder is made of an organic material with powders comprising silica (SiO₂) dispersed therein.

The connecting portions 1052 of the circuit plate 1051 and connecting portions 1054 of the connecting member 1125 are metallized and/or alloyed to complete connection therebetween. However, the connecting member 1125 and the semiconductor element 1004 are connected to each other by a method other than the metallization and the alloying. In details, while the semiconductor element 1004 is just held on the connecting member 1125, they are sealed.

The electrically connecting member 1125 corresponds in dimension to the semiconductor element 1004.

Lead frame 1055 is connected to the bottom face of the circuit plate 1051.

The sealing is effected only over the semiconductor element 1004 in this embodiment. The sealing material is a thermoplastic resin with powers comprising $SiO_2$ dispersed therein.

The other steps follow the 154th embodiment.

The connections of this embodiment also provided a high reliability.

The subject embodiment is superior in reliability on various properties.

(Embodiment 156)

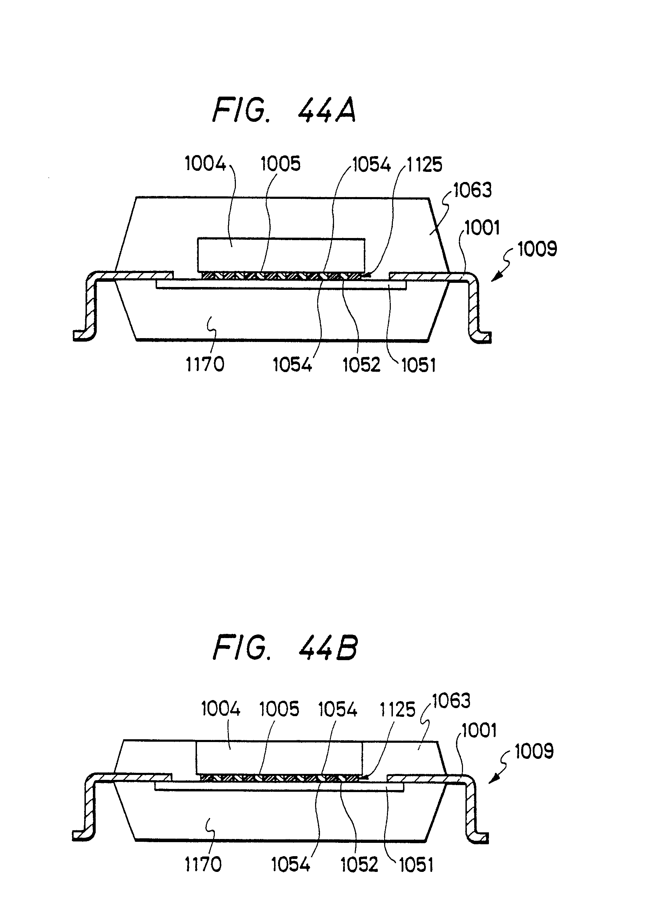

The 156th embodiment is shown in Figs. 44A and 44B.

In this embodiment, a first electric circuit part is a semiconductor element 1004 and a second circuit part is a circuit plate 1051.

Lead frame 1001 is connected to the top face of the circuit plate 1051 after connection of the elements. Then, the electric circuit member is set in a molding cavity and sealed by injection molding as shown, so as to form sealings 1063, 1170.

Fig. 44A shows an example in which the semiconductor element 1004 is sealed completely in the sealing, and Fig. 44B shows an example in which the top face of the semiconductor element 1004 is exposed to the circumstance and its sides are sealed by the sealing.

The others follow the 154th embodiment.

The connections of this embodiment also showed a high reliability.

The instant embodiment is superior in various respects or properties.

(Embodiment 157)

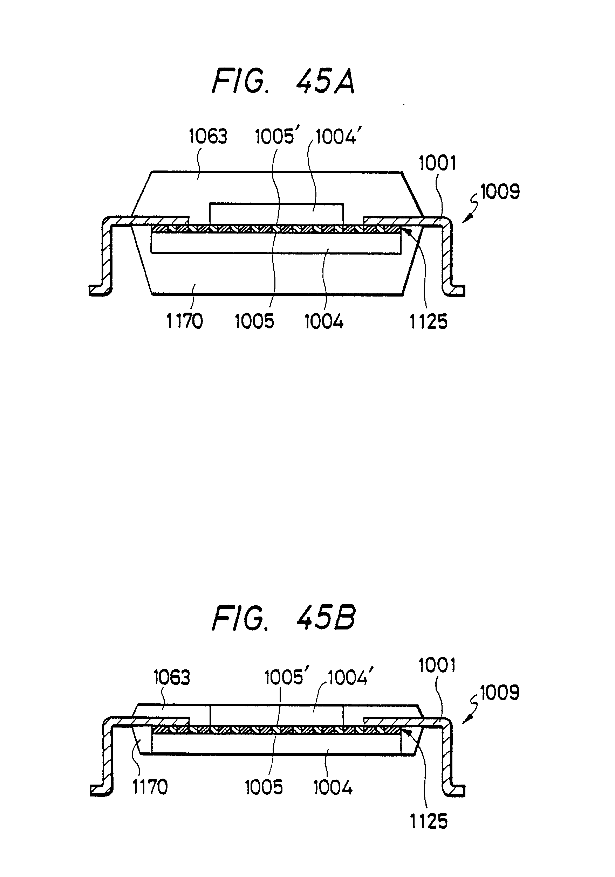

Figs. 45A and 45B show the 157th embodiment.

In this embodiment, a first circuit part is a semiconductor element 1004, and a second circuit part is a semiconductor element 1004. An electrically connecting member corresponds in dimension to the semiconductor element 1004, and a lead frame 1001 is connected to a metal member exposed at the first semiconductor element side of the connecting member 1125.

Insulator of the connecting member 1125 is made of an organic material with either or both of metal powders and fibers dispersed therein. Fig. 45B shows an example in which neither of connections is effected by the metallization or the alloying. That is, the semiconductor elements 1004, 1004' are just held tight in situ during the sealing.

Fig. 45A shows an example in which the semiconductor elements 1004, 1004' are sealed completely in the sealings and Fig. 45B shows an example in which the outer faces of the semiconductor elements 1004, 1004' are exposed to the circumstance and their sides are sealed by the sealing.

The others follow the 156th embodiment.

The connections of the subject embodiment were high in reliability and superior in various properties.

(Embodiment 158)

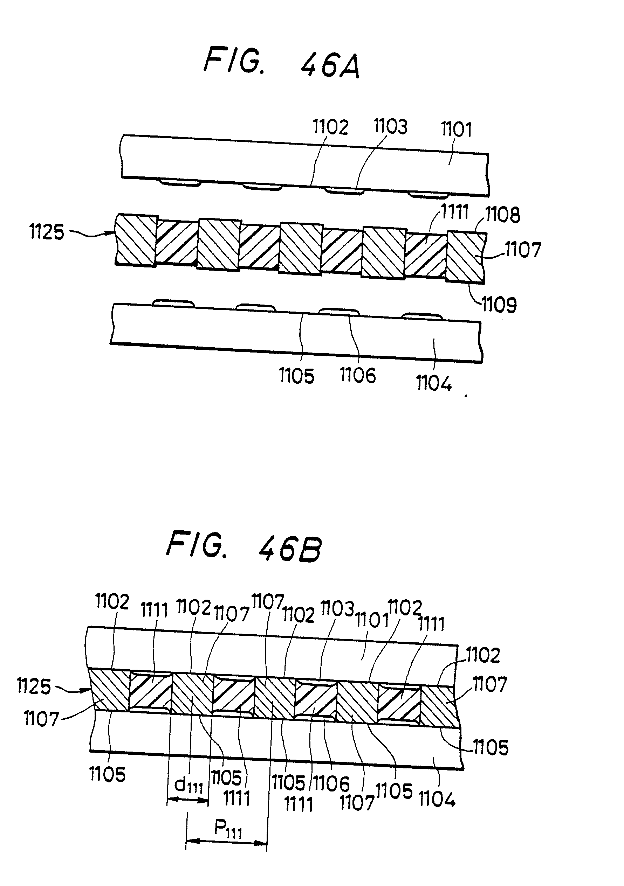

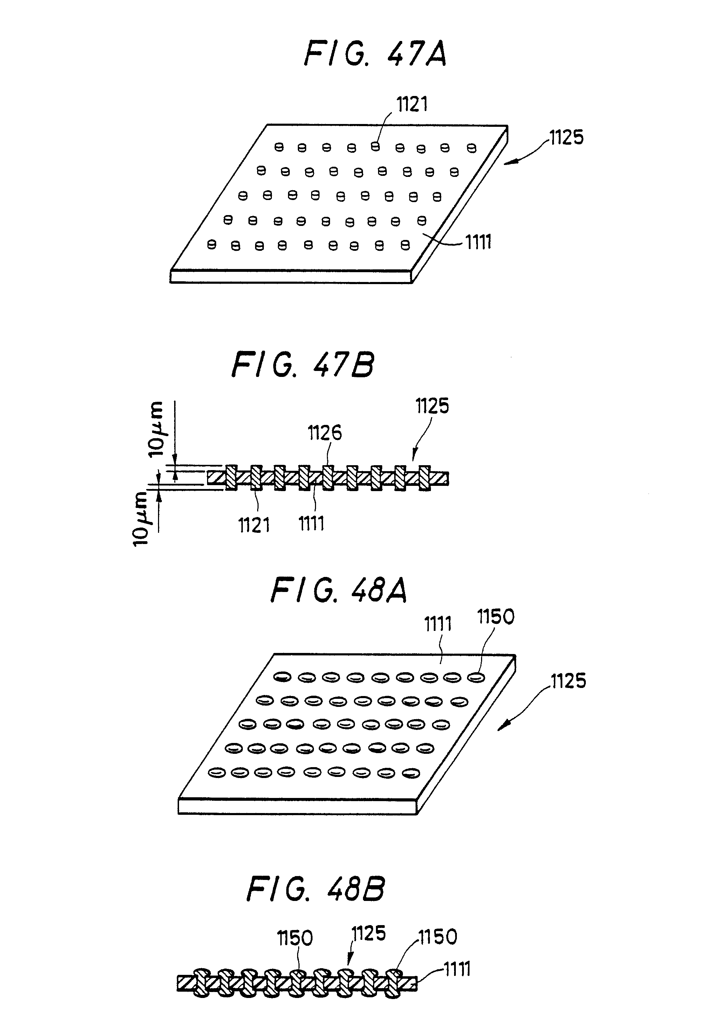

Fig. 46 shows the 158th embodiment.

This embodiment shows an example in which used as first and second electric circuit parts are circuit plates 1101, 1104 covered with insulator membranes 1103, 1106 excluding connecting portions.

An electrically connecting member as shown in Figs. 47A and 47B is employed in this embodiment. In the connecting member as shown, metal members 1107 are projected from a holder (resin insulator) 1111 to be exposed. Such a connecting member 1125 may be obtained in the following steps.

First, the connecting member as shown in Figs. 42B and 42C may be prepared following the method of the 154th embodiment. Then, the both faces of the connecting member are etched to reveal projections of about 10 μm of metal wires 1121 from polyimide resin 1123.

The height of projections can be arbitrary while it is of 10 μm in the present embodiment.

Further, the projections of the metal wires may be performed not only by the etching, but also by other chemical or mechanical method.

The others follow the 154th embodiment.

The projections can be formed as bumps 1150 as shown in Figs. 48A and 48B by pinching the connecting member 1125 in dies having recesses at positions of the metal wires 1121 and further pressing the projections 1126 of the metal wires 1121. The bumps 1150 may keep the metal wires in the insulator 1111 avoiding drop therefrom.

In the instant embodiment, metal wires 1121 serve as metal members 1107 and the resin 1123 serves as insulator 1111.

The bumps may also be formed by fusing the projections or any other methods.

The connections of this embodiment also showed high reliability. And the embodiment is superior in various properties.

(Embodiment 159)

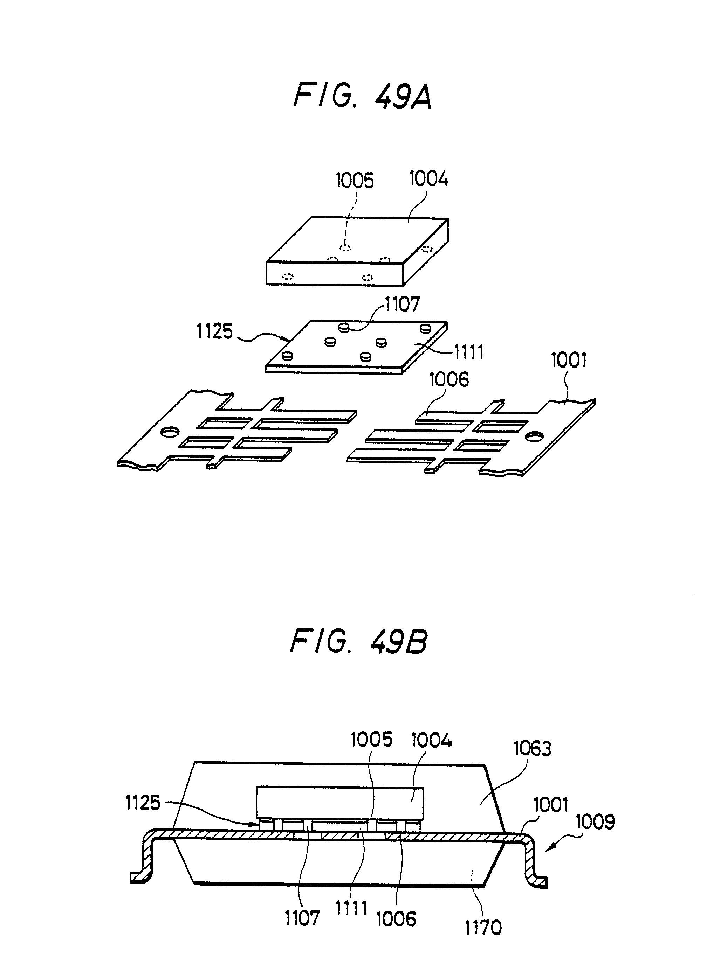

Figs. 49A and 49B show the 159th embodiment.

In this embodiment, a first electric circuit part is a semiconductor element 1004 and a second electric circuit part is a lead frame 1001.

Connecting portions 1006 of the lead frame 1001 are 42 Alloy covered with silver plating. Connections are conducted by heat pressing with ultrasonic waves.

The others follow the 158th embodiment.

The connections of this embodiment showed a high reliability. The device according to this embodiment is superior in various poroperties.

(Embodiment 160)

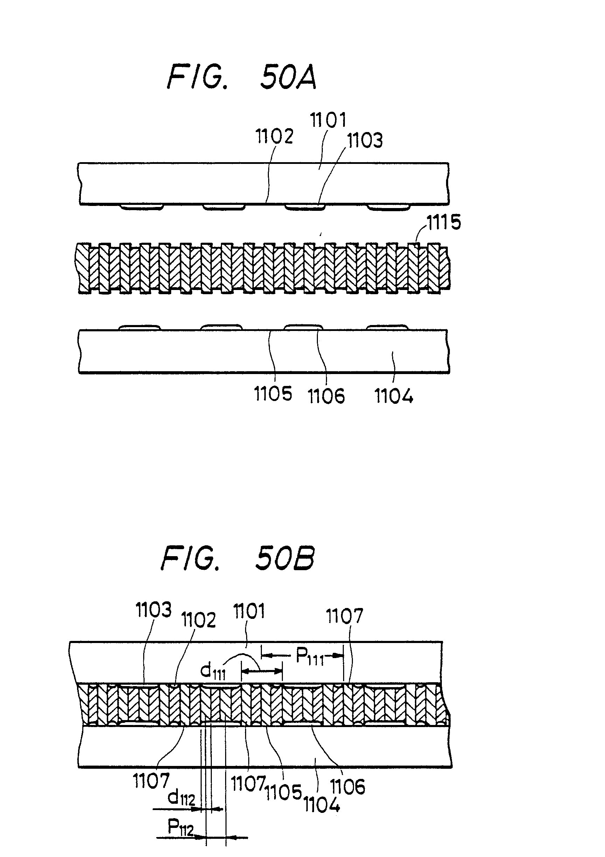

Figs. 50A and 50B show the 160th embodiment.

An electrically connecting member 1125 of this embodiment is different from that of the 158th embodiment. In details, a pitch between metal members in the connecting member 1125 of the subject embodiment is smaller than that in the 158th embodiment. In other words, the pitch between the metal members 1107 is set smaller than that between connecting portions of a first circuit plate.

Although the positioning of the electrically connecting member 1125 is essential in the 158th embodiment because the connection positions of the connecting member 1125 are located at the connecting portions of the first and the second circuit plates 1101, 1104, the connecting member 1125 needs no positioning with respect to the first and the second circuit plates 1101, 1104, though necessary to position the circuit plates with each other. Further, the connections can be done without positioning if lengths (d111, p111) of the first and the second circuit plates 1101 and 1104 and lengths (d112, p112) of the connecting member are determined suitably.

The others follow the 154th embodiment.

The connections of this embodiment showed a high reliability. The device of the present embodiment is also superior in various properties.

(Embodiment 161)

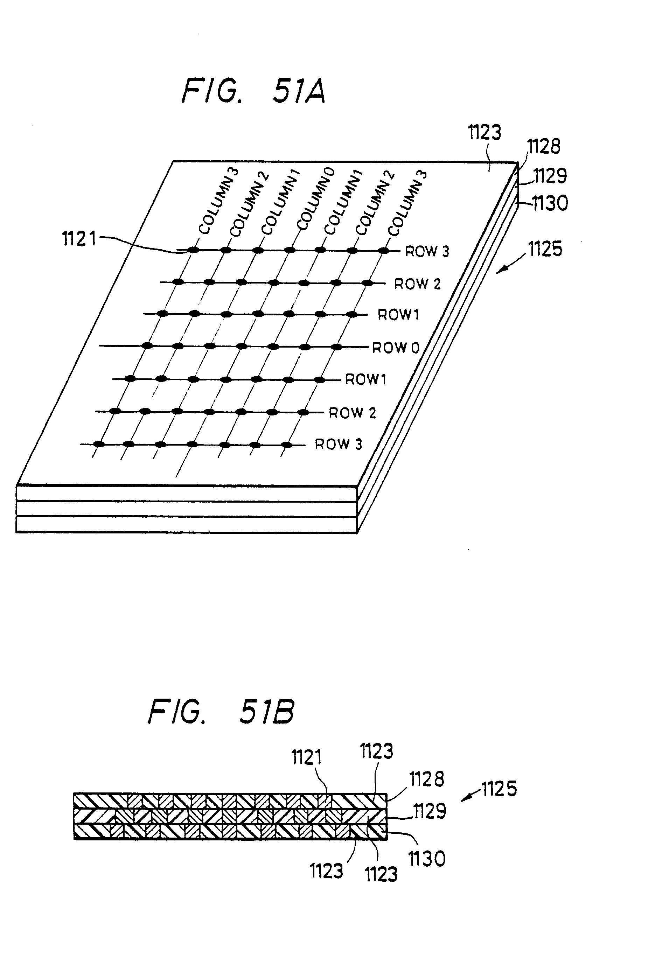

Figs. 51A and 51B show an electrically connecting member for use in the 161st embodiment.

Fig. 51A is a perspective view of the connecting member and Fig. 51B is a cross-sectional view of the connecting member.

There will be described a manufacturing example of such a connecting member.

Three connecting members 1128, 1129, and 1130 are prepared according to the method of the 154th embodiment. In the first connecting member 1128, a metal wire 1121 of row $m$ and column $n$ is displaced from the center by (ma, nb). In the second connecting member 1129, a metal wire 1121 of row $m$ and column $n$ is displaced from the center by (mac, nbc). And in the third connecting member 1130, a metal wire 1121 of row $m$ and column $n$ is displaced from the center by (mad, nbd). The values of a, b, c, and d are determined such that the metal wires 1121 are electrically connected vertically, but unconnected horizontally with each other. After positioning the three connecting members, they are connected by a method such as heat pressing to form a laminated, connecting member 1125.

In this embodiment, the metals are regularly located, in a matrix such as $m$ rows and $n$ columns. However, the metals may be placed at random in such a condition that the vertical connection through the metals may be maintained and the horizontal connection through the deviated metals may be avoided.

Further, the subject embodiment concerns the three layers laminated. But the lamination is not necessarily limited to three layers, but can be of plural layers. Also, the lamination may be effected by methods such as pressing and adhesion as well as heat pressing. The connecting member may be formed to have the projections as shown in Figs. 47A and 47B, and the bumps 1150 as shown in Figs. 48A nad 48B.

The others follow the 154th embodiment.

In this embodiment, the connections showed a high reliability. Also, the device of the instant embodiment is superior in various properties.

(Embodiment 162)

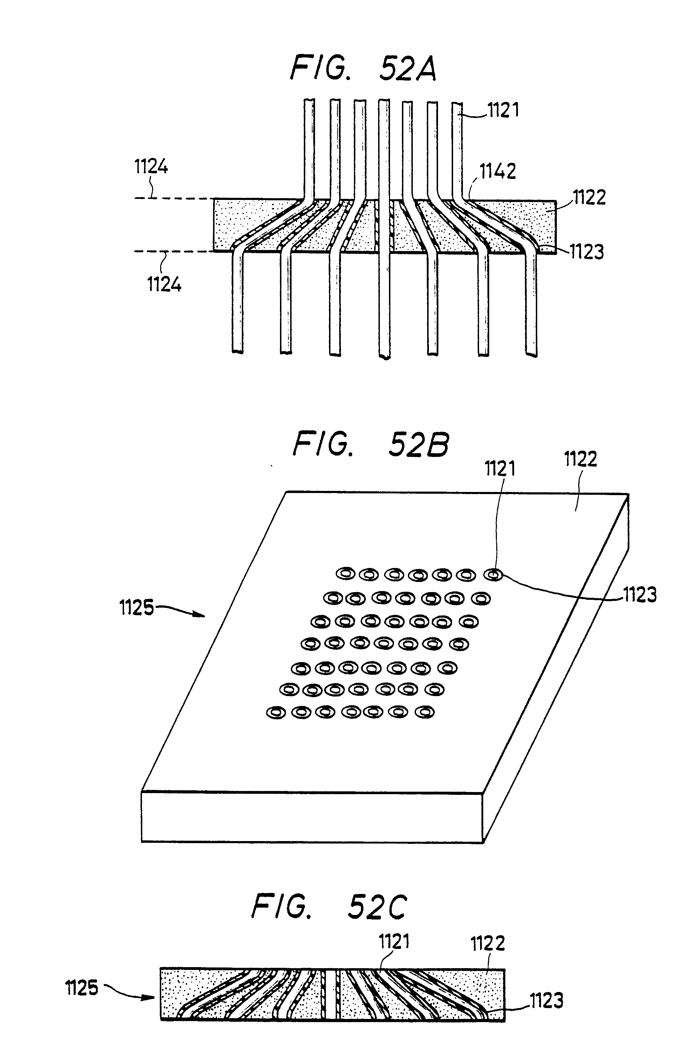

Figs. 52A, 52B, and 52C show an electrically connecting member for use in the 162nd embodiment.

Fig. 52A is a cross-sectional view of the connecting member on the way of manufacturing, Fig. 52B is a perspective view of the connecting member, and Fig. 52C is a cross-sectional view of the connecting member.

Holes 1142 of a larger diameter than 20 μm are preliminarily perforated through a holder 1122 of alumina ceramics. Then, metal wires 1121 of a metal such as gold or an alloy thereof having a diameter of 20 μm are passed through the holes 1142. After that, a resin 1123 is introduced into between the holder 1122 and the metal wires 1121, and then cured therein. The cured resin 1123 becomes intermediates. After the curing, the metal wires 1121 are cut along dotted lines 1124 so as to form an electrically connecting member 1125. The thus formed connecting member 1125 is illustrated in Figs. 52B and 52C.

The connecting member may be formed to have the projections as shown in Figs. 47A and 47B and the bumps 1150 as shown in Figs. 48A and 48B.

The others follow the 154th embodiment.

In this embodiment, the connections also showed a high reliability. Further, the device of this embodiment is superior in various properties.

(Embodiment 163)

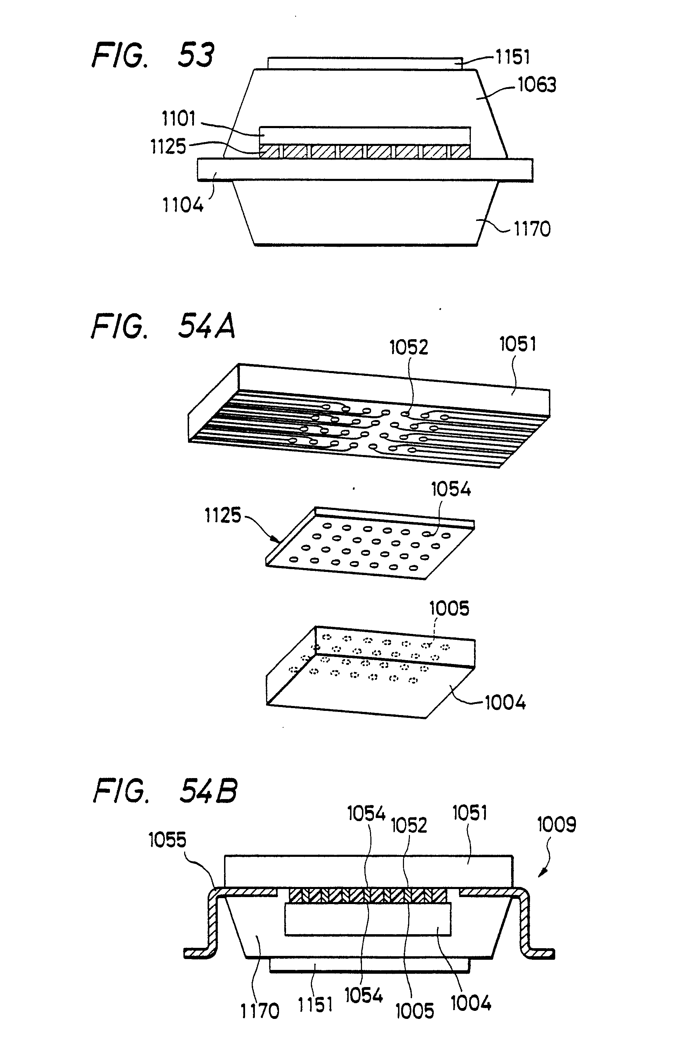

The 163rd embodiment as shown in Fig. 53 includes a stainless steel plate 1151 of 0.1 mm thickness sticked to one of the sealings 1170 in the electric circuit device of the 154th embodiment.

The electric circuit device thus obtained provided highly reliable connections at its connecting portions, and was superior in reliability on various properties.

(Embodiment 164)

In the 164th embodiment, a plate 1151 is sticked X as shown in Figs. 54A and 54B to a surface of the sealing 1170 in the device of the 155th embodiment.

The other elements are the same as in the 155th embodiment.

The device of this embodiment maintained highly reliable connections at its connecting portions and was highly reliable in respect to various properties.

(Embodiment 165)

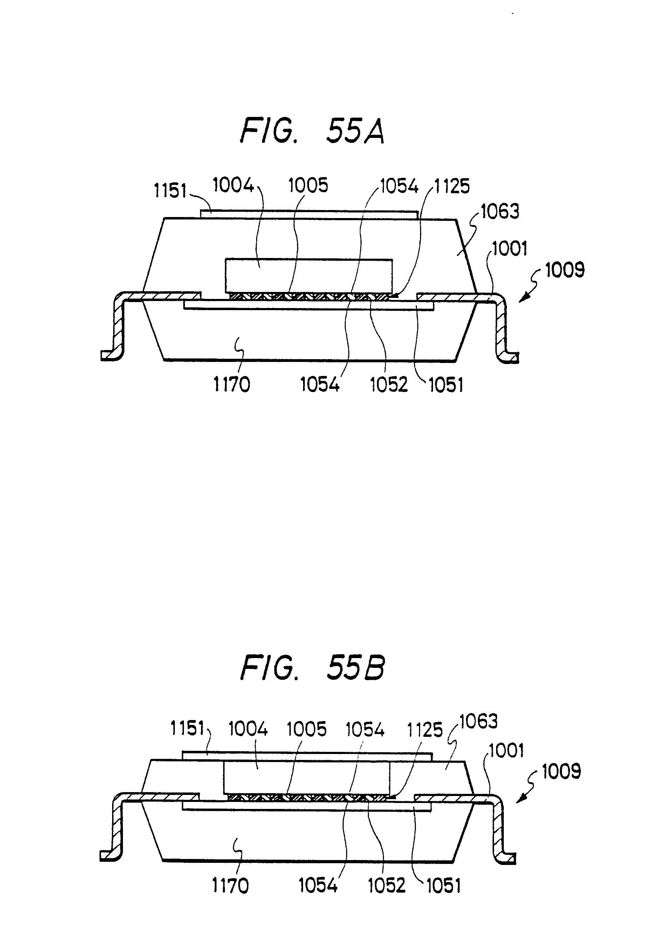

Figs. 55A and 55B show the 165th embodiment.

In this embodiment, a first electric circuit part is a semiconductor element 1004 and a second circuit part is a circuit plate 1051.

Lead frame 1001 is connected to the top face of the circuit plate 1051 after connection of the elements. Then, the electric circuit member is set in a molding cavity and sealed by injection molding of a resin as shown, so as to form sealings 1063.

Fig. 55A shows an example in which the semiconductor element is sealed completely in the sealing 1063 and a plate 1151 is sticked onto the sealing. Fig. 55B shows an example in which the top face of the semiconductor element 1004 is exposed to the circumstance, its sides are sealed by the sealing 1063, and a plate 1151 is sticked onto the sealing 1063 and over the exposed face of the semiconductor element 1004.

The other elements and steps are the same as in the 163rd embodiment.

The device of this embodiment also provided highly reliable connections and was highly reliable in respect to various properties.

(Embodiment 166)

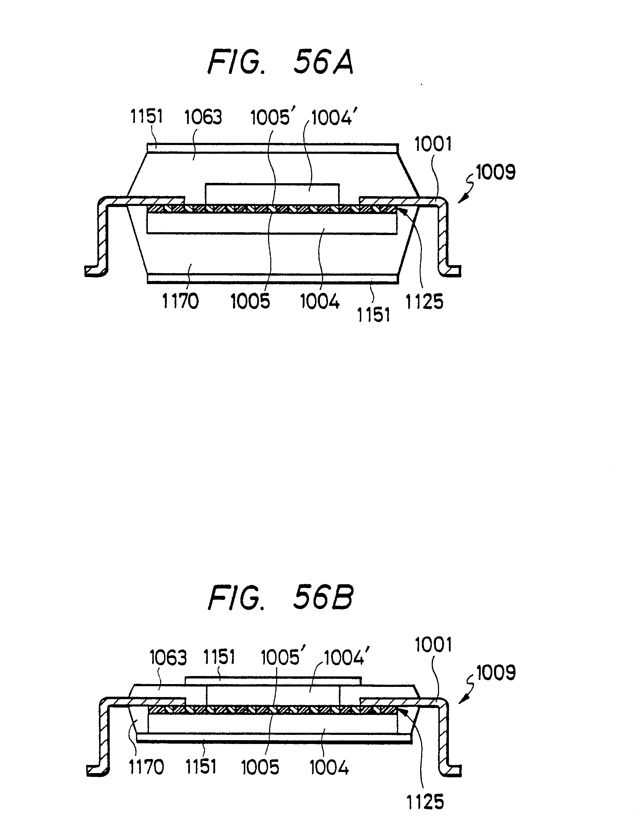

Figs. 56A and 56B show the 166th embodiment.

In this embodiment, a first circuit part is a semiconductor element 1004' and a second circuit part is a semiconductor element 1004. An electrically connecting member corresponds in dimension to the semiconductor element 1004 and a lead frame 1001 is connected to a metal member exposed at the first semiconductor element side of the connecting member 1125.

Insulator of the connecting member 1125 is made of an organic material with either or both of metal powders and fibers dispersed therein. Fig. 56B shows an example in which neither of connections is effected by the metallization or the alloying. That is, the semiconductor elements 1004, 1004' are just held tight in situ during the sealing.

Fig. 56A shows an example in which the semiconductor elements 1004, 1004' are sealed completely in the sealings 1170. Fig. 56B shows an example in which the sides of the semiconductor elements 1004, 1004' are sealed in the sealings 1170 excluding the outer faces thereof and respective plates are sticked onto the outer faces of the elements 1004, 1004' and the sealings 1170.

The device of this embodiment also provided highly reliable connections and was highly reliable in respect to various properties.

(Embodiment 167)

An electric circuit device of the 167th embodiment is made by sticking a plate 1151 onto a surface of each of the sealings 1170 in the 158th embodiment. The 167th embodiment is the same as the 158th embodiment except the plates 1151 accordingly.

The circuit device also provided highly reliable connections and was highly reliable in respect to various properties.

(Embodiment 168)

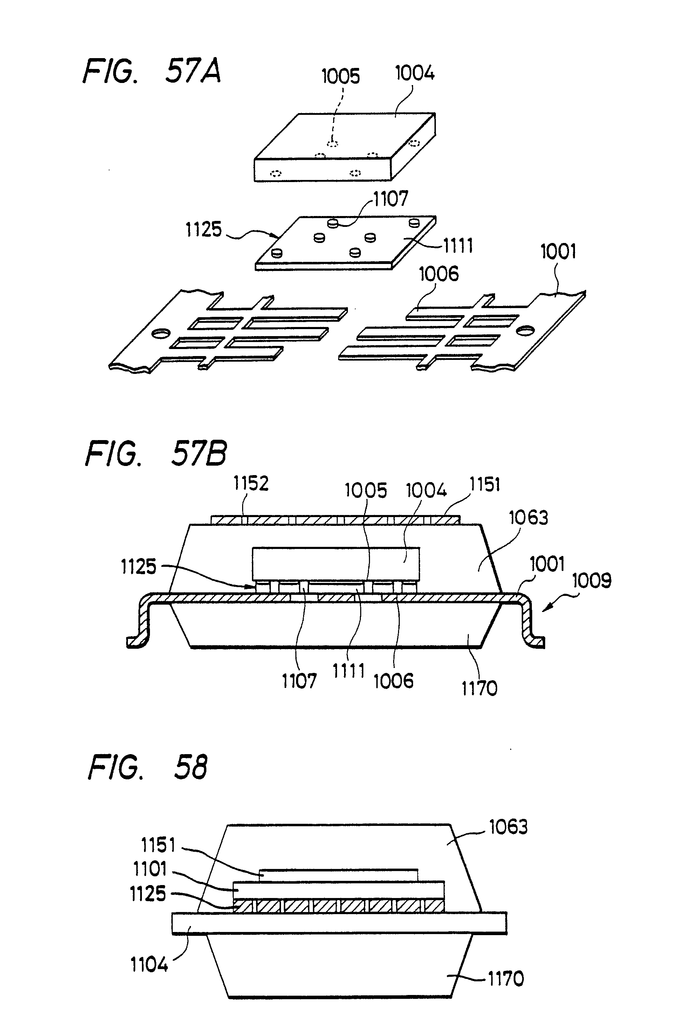

Figs. 57A and 57B show the 168th embodiment.

In this embodiment, a first electric circuit part is a semiconductor element 1004 and a second electric circuit part is a lead frame 1001.

Connecting portions 1006 of the lead frame 1001 are 42 Alloy with a surface thereof having silver plating. Connections are conducted by heat pressing with ultrasonic waves.

Plates 1151 sticked to the sealings 1170 are perforated to have holes 1152.

The others follow the 167th embodiment.

The circuit device of the subject embodiment also showed a high reliability of the connections and was highly reliable in respect to various properties.

(Embodiment 169)

An electric circuit device of the 169th embodiment is made by sticking a plate 1151 onto a surface of each of the sealings 1170 in the 160th embodiment. The 169th embodiment is the same as the 160th embodiment except the plates 1151 accordingly.

The circuit device of this embodiment also provided highly reliable connections and was highly reliable in respect to various properties.

(Embodiment 170)

An electric circuit device of the 170th embodiment is made by sticking a plate 1151 onto a surface of each of the sealings 1170 in the 161st embodiment. The 170th embodiment is the same as the 161st embodiment except the plates 1151 accordingly.

The circuit device of this embodiment also provided highly reliable connections and was highly reliable in respect to various properties.

(Embodiment 171)

An electric circuit device of the 171st embodiment is made by sticking a plate 1151 onto a surface of each of the sealings 1170 in the 162nd embodiment. The 171st embodiment is the same as the 162nd embodiment except the plates 1151 accordingly.

The circuit device of this embodiment also provided highly reliable connections and was highly reliable in respect to various properties.

(Embodiment 172)

An electric circuit device of the 172nd embodiment as shown in Fig. 58 is made by sticking a stainless steel plate 1151 of 0.1 mm thickness to a face of the semiconductor element 1101 of an electric circuit member, which face is opposite to the face of the connection to the electrically connecting member 1125. The plate is sticked only to the semiconductor element 1101 in this embodiment. It is of course that the both first and second electric circuit parts can have respective plates sticked thereonto.

After the sticking of the plate, the assembly of the semiconductor element 1101. the circuit plate 1104, and the plate 1151 is sealed by a resin. Both the semiconductor element 1101 and the circuit plate 1104 are sealed in the resin. The sealing is effected by an injection molding method.

The electric circuit device according to the above also showed a high reliability of the connections and was highly reliable in various properties.

(Embodiment 173)

An electric circuit device of the 173rd embodiment is made by sticking a plate 1151 to a surface of the semiconductor element 1004 in the electric circuit device of the 155th embodiment and thereafter sealing the plate-sticked circuit device in a resin.

The 173rd embodiment is the same as the 155th embodiment except the plate 1151 sticked to the semiconductor element 1004 before the sealing.

The electric circuit device of this embodiment also provided highly reliable connections and was highly reliable in various properties.

(Embodiment 174)

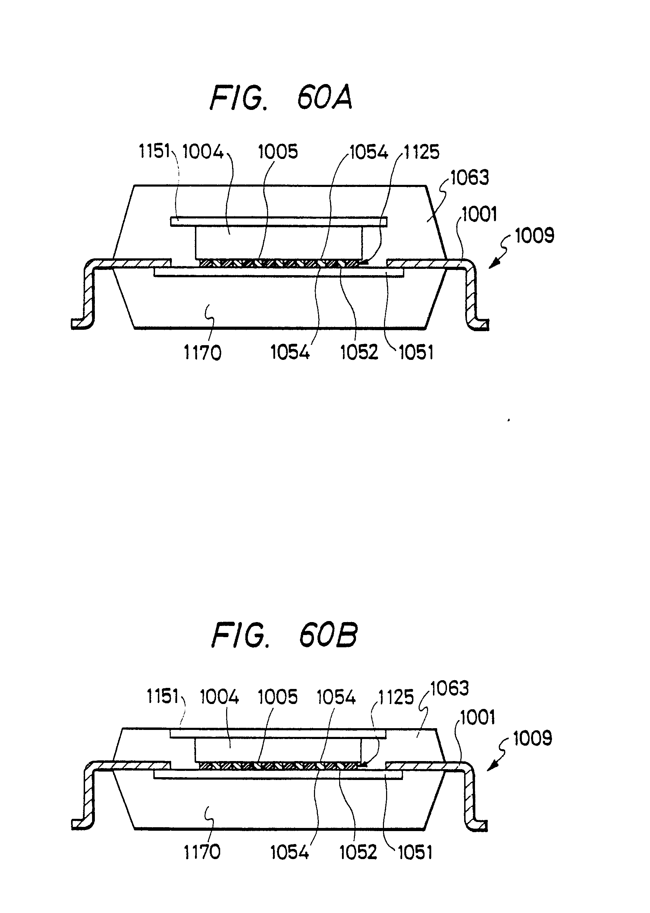

Figs. 60A and 60B show the 174th embodiment.

In this embodiment, a first electric circuit part is a semiconductor element 1004 and a second circuit part is a circuit plate 1051.

Lead frame 1001 is connected to the top face of the circuit plate 1051 after connection of the elements.

Then, a plate 1151 is sticked to a face of the semiconductor element 1004 opposite the electrically connecting member 1125.

The electric circuit member is set in a molding cavity and sealed in sealings 1063 by injection molding of a resin.

Fig. 60A shows an example in which the plate 1151 sticked to the semiconductor 1004 is sealed completely in the sealing 1063 and Fig. 60B shows an example in which only the sides of the plate 1151 and the element 1004 are sealed by the sealing 1063 exposing the top face of the plate 1151.

Elements and steps other than the above are the same as in the 172nd embodiment.

The device of this embodiment also provided highly reliable connections and was highly reliable in various properties.

(Embodiment 175)

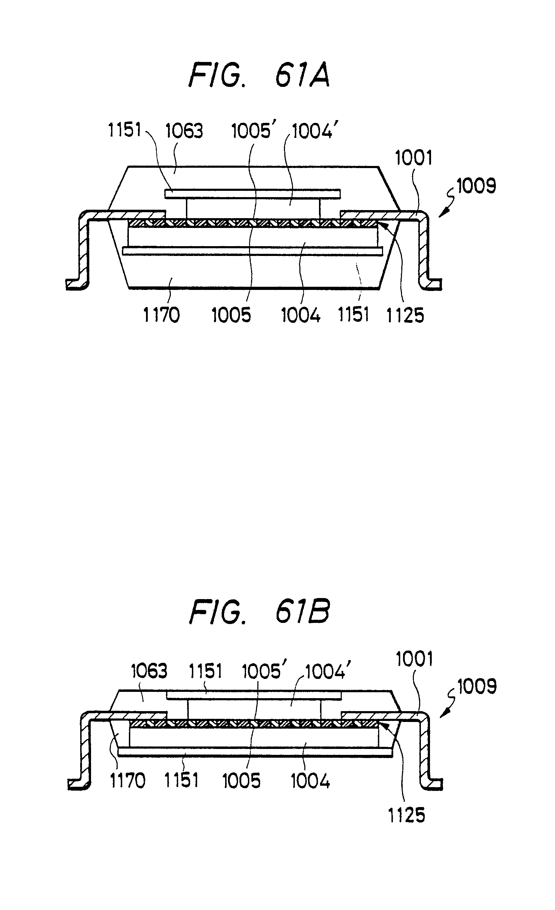

Figs. 61A and 61B show the 175th embodiment.

In this embodiment, a first circuit part is a semiconductor element 1004' and a second circuit part is a semiconductor element 1004. An electrically connecting member corresponds in dimension to the semiconductor element 1004 and a lead frame 1001 is connected to a metal member exposed at the first semiconductor element side of the connecting member 1125.

Insulator of the connecting member 1125 is made of an organic material with either or both of metal powders and fibers dispersed therein. Fig. 61B shows an example in which neither of connections is effected by the metallization or the alloying. That is, the semiconductor elements 1004, 1004' are just held tight in situ during the sealing.

Fig. 61A shows an example in which plates 1170 sticked to the semiconductor elements 1004, 1004' are sealed completely in the sealings 1170 and Fig. 61B shows an example in which the sites of the plates 1151 and the elements 1004, 1004' are sealed in the sealings 1170 exposing the outer faces of the elements 1004, 1004'.

The other elements and steps are the same as in the 174th embodiment.

The device of this embodiment also provided highly reliable connections and was highly reliable in various properties.

(Embodiment 176)

An electric circuit device of the 176th embodiment is made by sticking a plate 1151 to a surface of the circuit plate 1101 in the electric circuit device of the 158th embodiment and thereafter sealing the plate-sticked circuit device in a resin.

The 176th embodiment is the same as the 158 embodiment except the plate 1151 sticked to the circuit plate 1004 before the sealing.

The electric circuit device of this embodiment also provided highly reliable connections and was highly reliable in various properties.

(Embodiment 177)

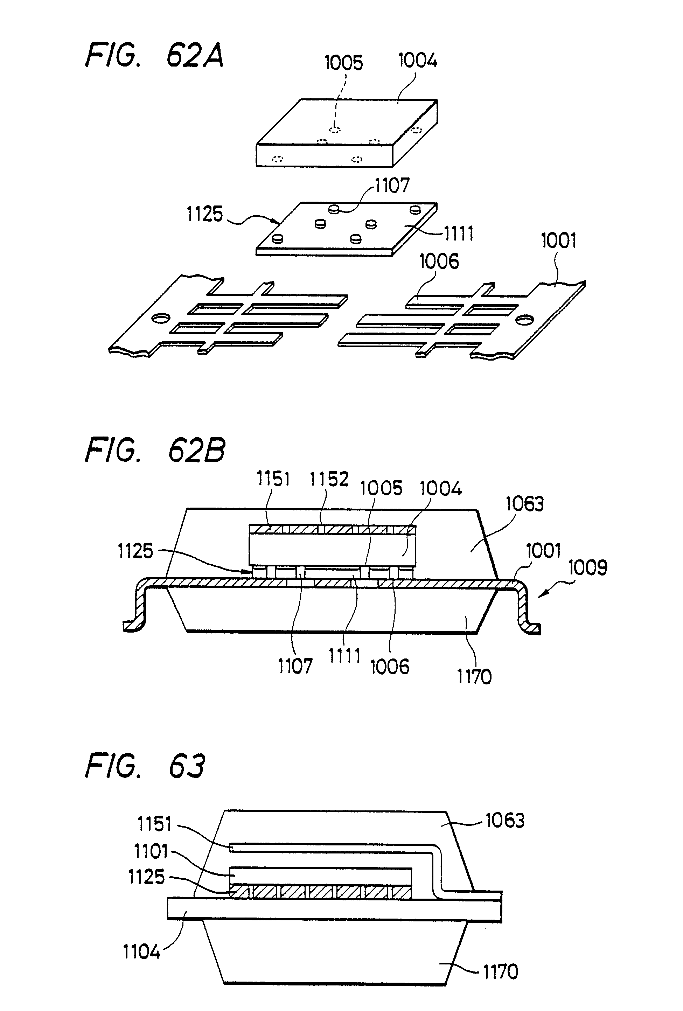

Figs. 62A and 62B show the 177th embodiment.

In this embodiment, a first elecatric circuit part is a semiconductor element 1004 and a second electric circuit part is a lead frame 1001.

Connecting portions 1006 of the lead frame 1001 are 42 Alloy covered with silver plating. Connections are conducted by heat pressing with ultrasonic waves.

A plate 1151 sticked to the element 1004 has holes 1152 therethrough.

In this embodiment, the plate 1151 is sticked only to the semiconductor element 1004 being the first electric circuit part. And the plate 1151 is sealed completely in sealing 1063.

The other elements and steps are the same as in the 176th embodiment.

The connections of this embodiment showed a high reliability and the circuit device was highly reliable in many respects.

(Embodiment 178)

An electric circuit device of the 178th embodiment is made by sticking a plate 1151 to a surface of the circuit plate 1101 in the electric circuit device of the 160th embodiment and thereafter sealing the plate-sticked circuit device in a resin.

The 178th embodiment is the same as the 160th embodiment except the plate 1151 sticked to the circuit plate 1004 before the sealing.

The electric circuit device of this embodiment also provided highly reliable connections and was highly reliable in various properties.

(Embodiment 179)

An electric circuit device of the 179th embodiment is made by sticking a plate 1151 to a surface of the semiconductor element 1101 in the electric circuit device of the 161st embodiment and thereafter sealing the plate-sticked circuit device in a resin.

The 179th embodiment is the same as the 161st embodiment except the plate 1151 sticked to the semiconductor element 1101 before the sealing.

The electric circuit device of this embodiment also provided highly reliable connections and was highly reliable in various properties.

(Embodiment 180)

An electric circuit device of the 180th embodiment is made by sticking a plate 1151 to a surface of the semiconductor element 1101 in the electric circuit device of the 162nd embodiment and thereafter sealing the plate-sticked circuit device in a resin.

The 180th embodiment is the same as the 162nd embodiment except the plate 1151 sticked to the semiconductor element 1101 before the sealing.

The electric circuit device of this embodiment also provided highly reliable connections and was highly reliable in various properties.

(Embodiment 181)

An electric circuit device of the 181st embodiment as shown in Fig. 63 is made by disposing a stainless steel plate of 0.1 mm thickness near a semiconductor element 1101 of an electric circuit member and then sealing the plate 1151 together with the semiconductor element 1101 and a circuit plate 1104 in a resin. In this embodiment, both the element 1101 and the circuit plate 1104 are sealed in the resin. The sealing material is a thermoplastic resin and the sealing method is an injection molding method.

The electric circuit device according to the above also showed a high reliability of the connections and was highly reliable in various properties.

(Embodiment 182)

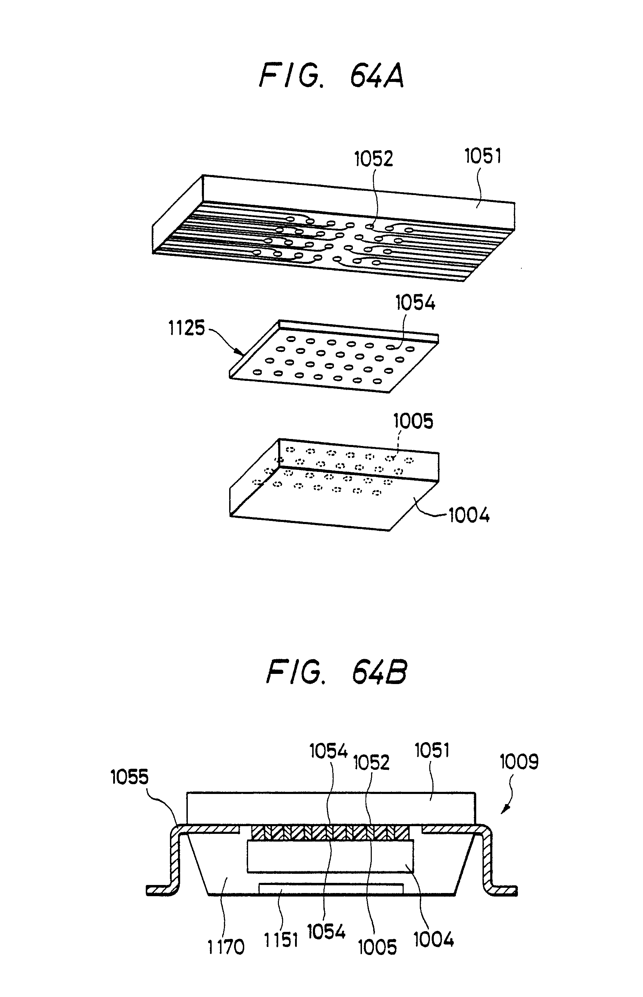

An electric circuit device of the 182nd embodiment is made as shown in Figs. 64A and 64B by placing a plate 1151 near the semiconductor element 1004 in the circuit device of the 155th embodiment and then sealing them in a resin.

The 182nd embodiment is the same as the 155th embodiment except the plate 1151 disposed near the semiconductor element 1004 before the sealing.

The electric circuit device of this embodiment also provided highly reliable connections and was highly reliable in various properties.

(Embodiment 183)

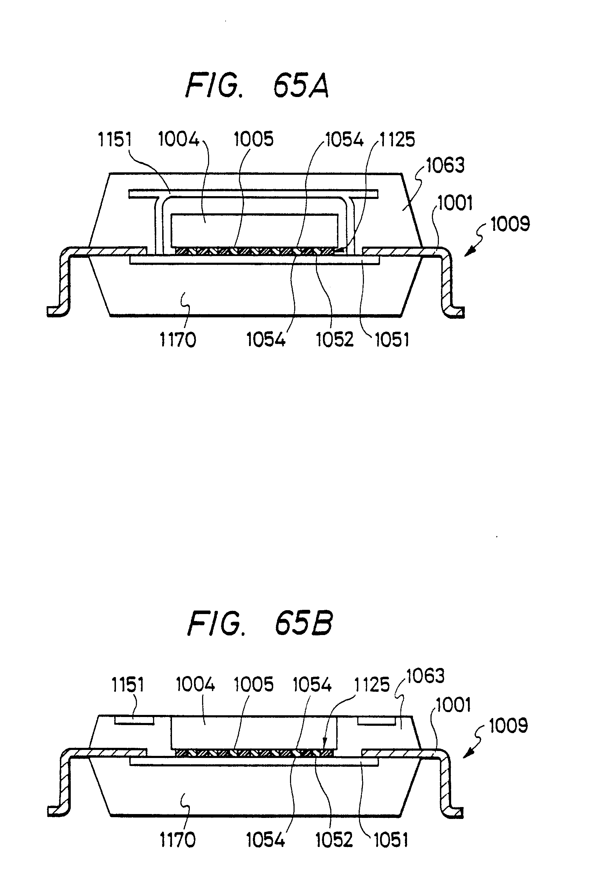

Figs. 65A and 65B show the 183rd embodiment.

In this embodiment, a first electric circuit part is a semiconductor element 1004 and a second electric part is a circuit plate 1051.

Lead frame 1001 is connected to the top face of the circuit plate 1051 after connection of the elements.

Then, a plate assembly 1151 as shown in Fig. 65A is set on the plate 1051 and the combination of the assembly and the electric circuit member is set in a molding cavity. The combination is sealed in sealings 1063 by injection molding of a resin.

Fig. 65B shows a modification of this embodiment in which two plates 1151 are set in the molding cavity together with the electric circuit member and the injection is then performed into the cavity to form the sealings 1063. In this modification, the top faces of the plates 1151 are exposed to the circumstance.

The other elements and steps are the same as in the 181st embodiment.

The device of this embodiment also provided highly reliable connections and was highly reliable in various properties.

(Embodiment 184)

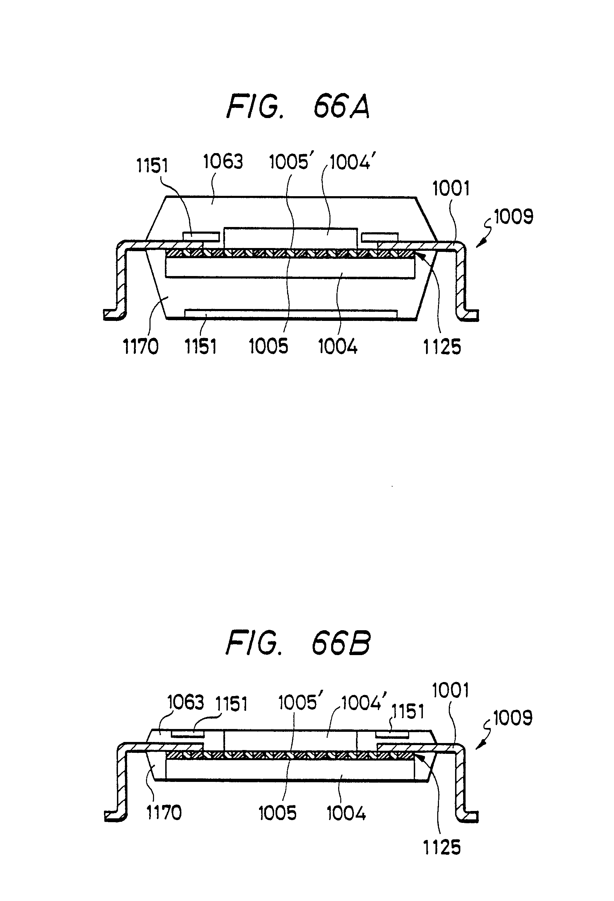

Figs. 66A and 66B show the 184th embodiment.

In this embodiment, a first circuit part is a semiconductor element 1004', and a second circuit part is a semiconductor element 1004. An electrically connecting member corresponds in dimension to the semiconductor element 1004 and a lead frame 1001 is connected to a metal member exposed at the first semiconductor element side of the connecting member 1125.

Two plates 1151 are located beside the first semiconductor element 1004' and sealed by sealing 1170. Fig. 66A shows an example in which upper plates 1151 are sealed completely in the sealing 1170 and the lower plate 1151 reveals its outer face outside the sealing 1170. Fig. 66B shows an example in which the top faces of the plates 1151 are exposed to the circumstance.

Insulator of the electrically connecting member 1125 is made of an organic material with either or both of metal powders and fibers dispersed therein.

Fig. 66B shows an example in which neither of connections is effected by the metallization or the alloying. That is, the semiconductor elements 1004, 1004' are just held tight in situ during the sealing.

The other elements and steps are the same as in the 183rd embodiment.

The device of this embodiment also provided highly reliable connection and was highly reliable in various properties.

(Embodiment 185)

An electric circuit device of the 185th embodiment is made by disposing a plate 1151 near the circuit plate 1101 in the circuit device of the 158th embodiment and then sealing them in a resin.

The 185th embodiment is the same as the 158th embodiment except the plate 1151 disposed near the circuit plate 1101 before the sealing.

The electric circuit device of this embodiment also provided highly reliable connections and was highly reliable in various properties.

(Embodiment 186)

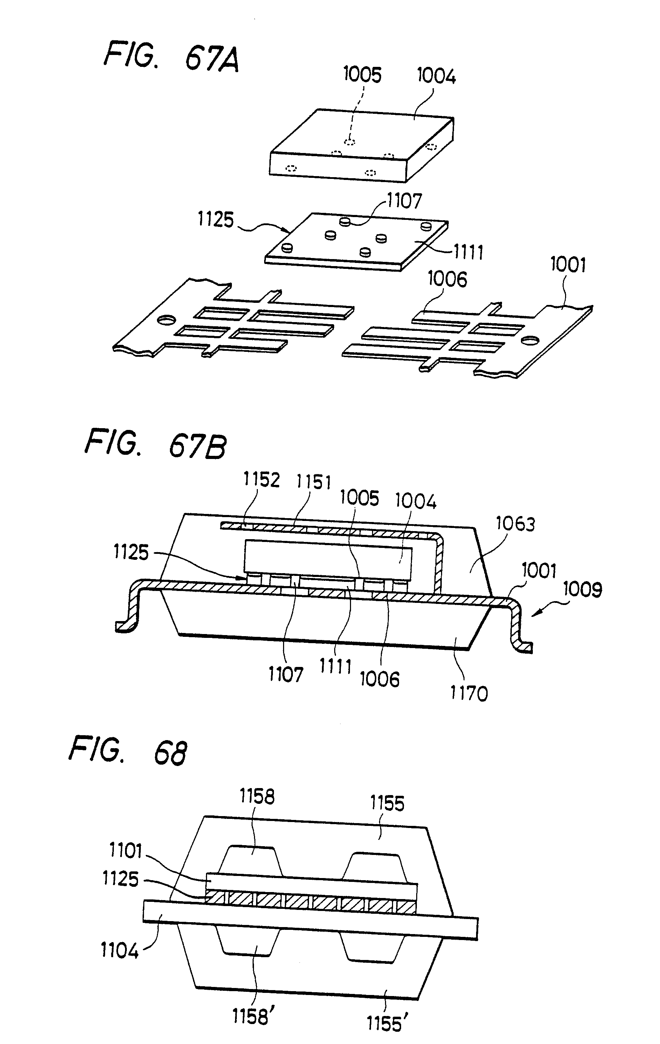

Figs. 67A and 67B show the 186th embodiment.

In this embodiment, a first electric circuit part is a semiconductor element 1004 and a second electric circuit part is a lead frame 1001.

Connecting portions 1006 of the lead frame 1001 are 42 Alloy covered with silver plating. Connections are conducted by heat pressing with ultrasonic waves.

A bent plate 1151 with holes 1152 is placed near the semiconductor element 1004.

The plate 1151 is sticked only to the semiconductor element 1004 being the first electric circuit part, and sealed completely in a sealing 1063.

The other elements and steps follow the 185th embodiment.

The connections of this embodiment showed a high reliability. The device of this embodiment is superior in various properties.

(Embodiment 187)

An electric circuit device of the 187th embodiment is made by disposing a plate 1151 near the circuit plate 1101 in the circuit device of the 160th embodiment and then sealing them in a resin.

The 187th embodiment is the same as the 160th embodiment except the plate 1151 disposed near the circuit plate 1101 before the sealing.

The electric circuit device of this embodiment also provided highly reliable connections and was highly reliable in various properties.

(Embodiment 188)

An electric circuit device of the 188th embodiment is obtained by disposing a plate 1151 near the semiconductor element 1101 in the circuit device of the 161st embodiment and then sealing them in a resin.

The 188th embodiment is the same as the 161st embodiment except the plate 1151 disposed near the semiconductor element 1101 before the sealing.

The electric circuit device of this embodiment also provided highly reliable connections and was highly reliable in various properties.

(Embodiment 189)

An electric circuit device of the 189th embodiment is obtained by disposing a plate 1151 near the semiconductor element 1101 in the circuit device of the 162nd embodiment and then sealing them in a resin.

The 189th embodiment is the same as the 162nd embodiment except the plate 1151 disposed near the semiconductor element 1101 before the sealing.

The electric circuit device of this embodiment also provided highly reliable connections and was highly reliable in various properties.

(Embodiment 190)

An electric circuit device of the 190th embodiment as shown in Fig. 68 is obtained by cap-sealing the electric circuit parts of the electric circuit member of the 154th embodiment. In this embodiment both the semiconductor element 1101 and the circuit plate 1104 are cap-sealed.

The caps 1155, 1155' are in a shape as illustrated in Fig. 68, having two recesses, respectively. The recesses provide spaces 1158, 1158' and contacts to the outer surfaces of the semiconductor element 1101 and the circuit plate 1104 which are held tight against the electrically connecting member 1125.

The caps 1155, 1155' are sticked to each other with an adhesive.

The electric circuit device of this embodiment also provided highly reliable connections. Further, a heat dissipation property of the device was also superior. The device was highly reliable in various properties.

(Embodiment 191)

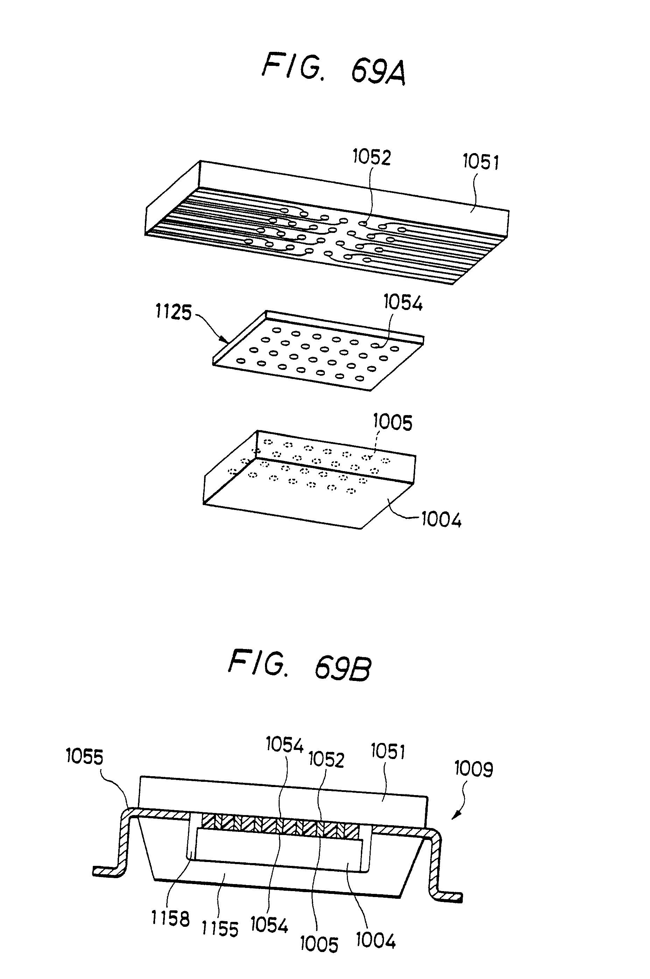

Figs. 69A and 69B show the 191st embodiment.

This embodiment employs a circuit plate 1051 having connecting portions 1052 as a first electric circuit part and a semiconductor element 1004 having numerous internal connecting portions 1005 as a second electric circuit part.

In an electrically connecting member 1125 of the subject embodiment, a holder is made of an organic material with powders comprising silica ($SiO_2$) dispersed therein.

The connecting portions 1052 of the circuit plate 1051 and connecting portions 1054 of the connecting member 1125 are metallized and or alloyed to complete connection therebetween. However, the connecting member 1125 and the semiconductor element 1004 are connected to each other by a method other than the metallization and the alloying.

The electrically connecting member 1125 corresponds in dimension to the semiconductor element 1004.

After the connection, a lead frame 1055 is connected to the bottom face of the circuit plate 1051. Then a cap 1155 is adhered to the lead frame 1055 and the circuit plate 1051 to seal the semiconductor element 1004. The cap can also be sticked to them by any other method. The cap may also be adhered to the semiconductor element 1004.

This embodiment has such a structure that the semiconductor element is not supported by the semiconductor element 1004.

The other elements and steps are the same as those of the 190th embodiment.

The electric circuit device of this embodiment also provided highly reliable connections and a superior heat dissipation property. The device was highly reliable in various properties.

(Embodiment 192)

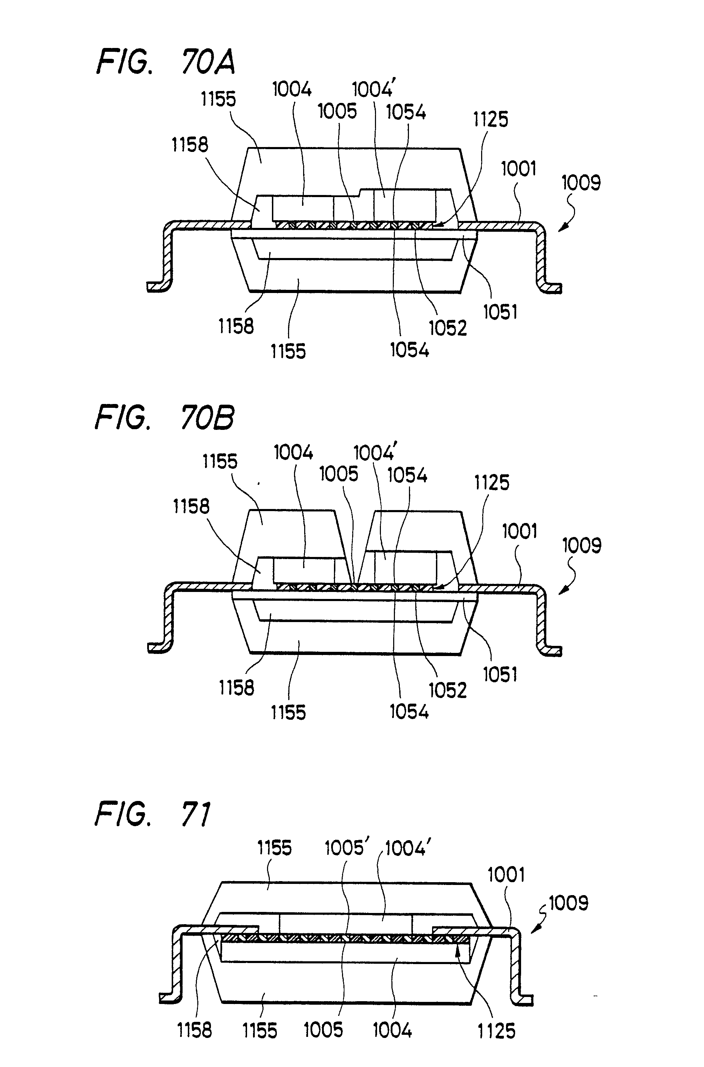

Figs. 70A and 70B show the 192nd embodiment.

In this embodiment, a first electric circuit part is comprised of semiconductor elements 1004, 1004' and a second electric circuit part is comprised of a circuit plate 1051.

The semiconductor element 1004 is connected to a connecting portion 1125 by the alloying.

After connection, a lead frame 1001 is connected to the top face of the circuit plate 1051 and the cap-sealing is effected by caps 1155.

Fig. 70A shows an example in which the inside of the cap 1155 is shaped to fit the semiconductor

elements 1004, 1004' is height. Fig. 7B shows an example in which the semiconductor elements 1004, 1004' are sealed by separate caps.

The other elements and steps are the same as in the 190th embodiment.

The electric circuit device of this embodiment also provided highly reliable connections and a superior heat dissipation property. The device was highly reliable in various properties.

(Embodiment 193)

Fig. 71 shows the 193rd embodiment.

In this embodiment, a first circuit part is a semiconductor element 1004' and a second circuit part is a semiconductor element 1004. An electrically connecting member corresponds in dimension to the semiconductor element 1004 and a lead frame 1001 is connected to a metal member exposed at the first semiconductor element side of the connecting member 1125.

Insulator of the connecting member 1125 is made of an organic material with either or both of metal powders and fibers dispersed therein.

Fig. 71 shows an example in which neither of connections is effected by the metallization or the alloying. That is, the semiconductor elements 1004, 1004' are just held tight in situ during the sealing.

The other elements and steps are the same as in the 192nd embodiment.

The electric circuit device of this embodiment also provided highly reliable connections and a superior heat dissipation property. The device was highly reliable in various properties.

(Embodiment 194)

An electric circuit device of the 194th embodiment is obtained by replacing the resin sealing by the cap-sealing in the electric circuit device of the 158th embodiment.

The 194th embodiment is the same as the 158th embodiment except the sealing by capping.

The electric circuit device of this embodiment also provided highly reliable connections and a superior heat dissipation property. The device was highly reliable in various properties.

(Embodiment 195)

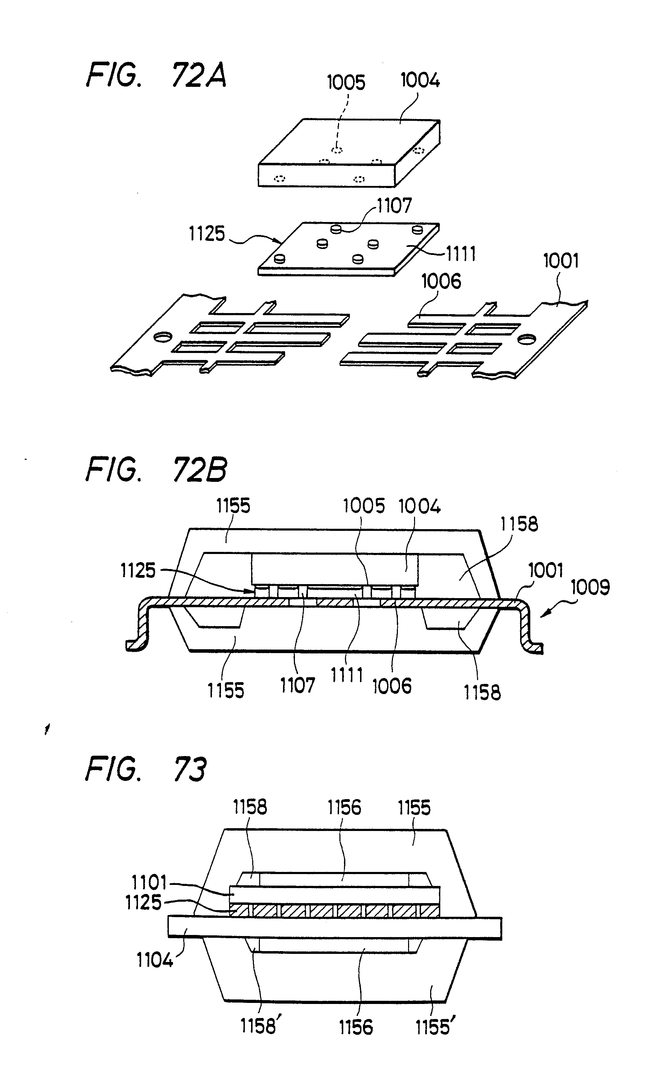

Figs. 72A and 72B show the 195th embodiment.

In this embodiment, a first electric circuit part is a semiconductor element 1004 and a second electric circuit part is a lead frame 1001.

Connecting portions 1006 of the lead frame 1001 are 42 Alloy covered with silver plating. Connections are conducted by heat pressing with ultrasonic waves.

The other elements and steps are the same as in the 194th embodiment.

The electric circuit device of this embodiment also provided highly reliable connections and a superior heat dissipation property. The device was highly reliable in various properties.

(Embodiment 196)

An electric circuit device of the 196th embodiment is obtained by replacing the resin sealing by the cap-sealing in the electric circuit device of the 160th embodiment.

The 196th embodiment is the same as the 160th embodiment except the sealing by capping.

The electric circuit device of this embodiment also provided highly reliable connections and a superior heat dissipation property. The device was highly reliable in various properties.

(Embodiment 197)

An electric circuit device of the 197th embodiment is obtained by replacing the resin sealing by the cap-sealing in the electric circuit device of the 161st embodiment.

The 197th embodiment is the same as the 161st embodiment except the sealing by capping.

The electric circuit device of this embodiment also provided highly reliable connections and a superior heat dissipation property. The device was highly reliable in various properties.

(Embodiment 198)

An electric circuit device of the 198th embodiment is obtained by replacing the resin sealing by the cap-sealing in the electric circuit device of the 162nd embodiment.

The 198th embodiment is the same as the 162nd embodiment except the sealing by capping.

The electric circuit device of this embodiment also provided highly reliable connections and a superior heat dissipation property. The device was highly reliable in various properties.

(Embodiment 199)

An electric circuit device of the 199th embodiment as shown in Fig. 73 is obtained by cap-sealing the electric circuit parts of the electric circuit member of the 154th embodiment. In this embodiment both the semiconductor element 1101 and the circuit plate 1104 are cap-sealed.

The caps 1155, 1155' are in a shape as illustrated in Fig. 73, each having a recess. The recesses of the caps provide spaces 1158, 1158'. Adjusting members 1156 are disposed between the caps and the elements 1101, 1104 inside the recesses. respectively. The semiconductor element 1101 and the circuit 1104 are thus held tight against the electrically connecting member 1125 in the recesses.

In this embodiment the caps 1155, 1155' are adhered to each other with an adhesive.

The electric circuit device of this embodiment also provided highly reliable connections. Further, a heat dissipation property of the device was also superior. The device was highly reliable in various properties.

(Embodiment 200)

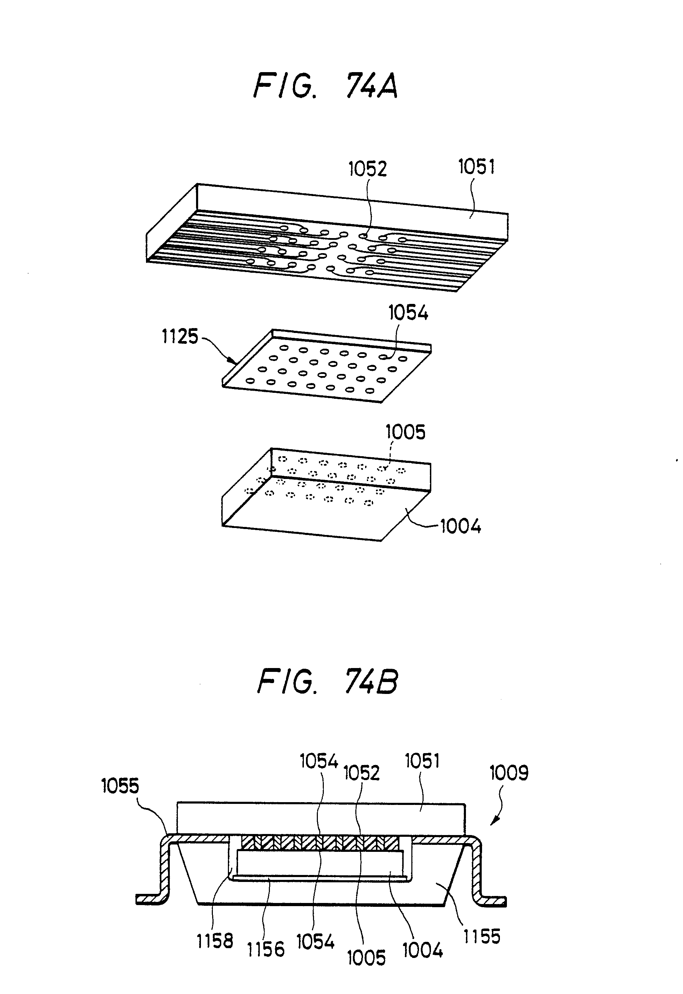

In the 200th embodiment as shown in Figs. 74A and 74B, an adjusting member 1156 is placed between a semiconductor element 1004 and a cap 1155. The cap 1155 is adhered to a lead frame 1055 and a circuit plate 1051. The semiconductor element 1004 is sealed through the intervening adjusting member 1156 by the cap 1155.

The connection of the cap can be done by any method including the adhesion. Further, the adjusting member 1156, the cap 1155 and the semiconductor element 1004 may be held by adhesion or other method as well as the intervention.

The other elements and steps are the same as in the 199th embodiment.

The electric circuit device of this embodiment also provided highly reliable connections and a superior heat dissipation property. The device was highly reliable in various properties.

(Embodiment 201)

Fig . 75 show the 201st embodiment.

In this embodiment, a first electric circuit part is comprised of semiconductor elements 1004, 1004' and a second electric circuit part is comprised of a circuit plate 1051.

The semiconductor element 1004 is connected to a connecting portion 1125 by the alloying.

After connection, a lead frame 1001 is connected to the top face of the circuit plate 1051 and an adjusting member 1156 is placed between the semiconductor element 1004 and a cap 1155. The cap-sealing is effected by the cap 1155.

The semiconductor elements 1004, 1004' are different in height from each other.

The others are the same as in the 199th embodiment.

The electric circuit device of this embodiment also provided highly reliable connections and a superior heat dissipation property. The device was highly reliable in various properties.

(Embodiment 202)

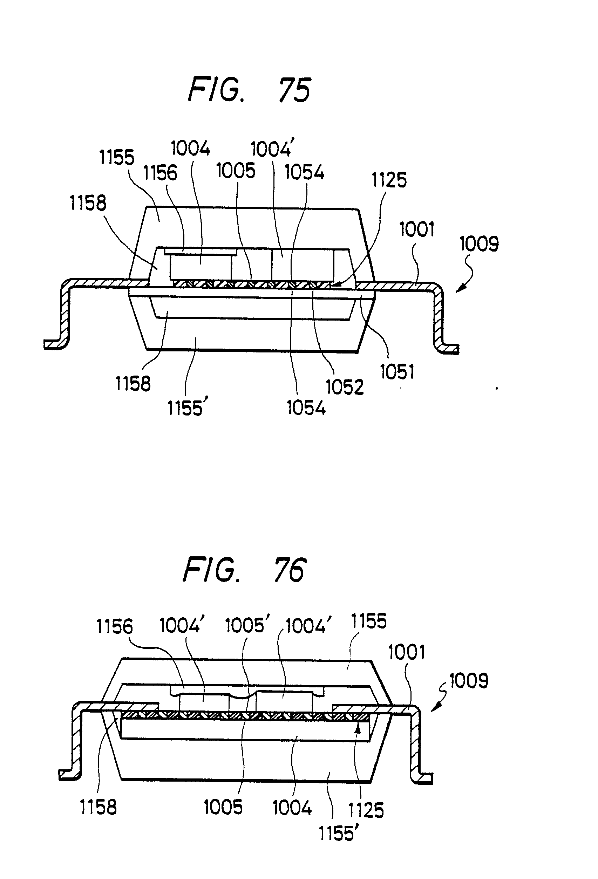

Fig. 76 shows the 202nd embodiment.

In this embodiment, a first circuit part is a semiconductor element 1004' and a second circuit part is a semiconductor element 1004. An electrically connecting member corresponds in dimension to the semiconductor element 1004 and a lead frame 1001 is connected to a metal member exposed at the first semiconductor element side of the connecting member 1125.

An adjusting member 1156 is placed between the semiconductor element 1004' and a cap 1155.

Insulator of the connecting member 1125 is made of an organic material with either or both of metal powders and fibers dispersed therein.

Fig. 76 shows an example in which neither of connections is effected by the metallization or the alloying. That is, the semiconductor elements 1004, 1004' are just held tight in situ during the sealing.

The others are the same as in the 201st embodiment.

The electric circuit device of this embodiment also provided highly reliable connections and a superior heat dissipation property. The device was highly reliable in various properties.

(Embodiment 203)

An electric circuit device of the 203rd embodiment is obtained by placing an adjusting member between the semiconductor element and the cap in the electric circuit device of the 194th embodiment. After the placing of the adjusting member, the cap-sealing is conducted.

The 203rd embodiment is the same as the 194th embodiment except the intervention of the adjusting member.

The electric circuit device of this embodiment also provided highly reliable connections and a superior heat dissipation property. The device was highly reliable in various properties.

(Embodiment 204)

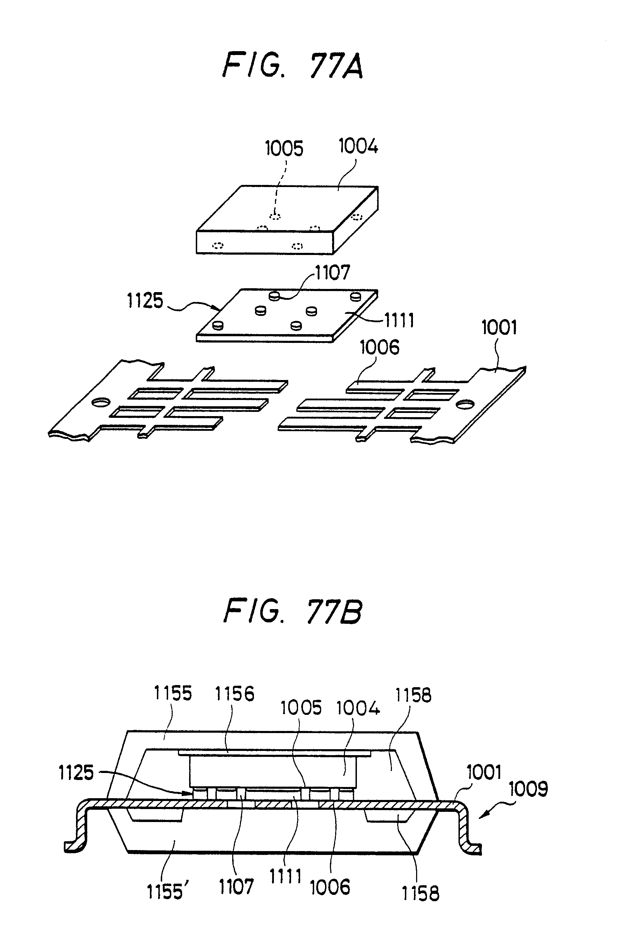

Figs. 77A and 77B show the 204th embodiment.

In this embodiment, a first electric circuit part is a semiconductor element 1004 and a second electric circuit part is a lead frame 1001.

Connecting portions 1006 of the lead frame 1001 are 42 Alloy covered with silver plating. Connections are conducted by heat pressing with ultrasonic waves.

An adjusting member 1156 is placed between the semiconductor element 1004 and the cap 1155. Numeral 1158 denotes spaces unoccupied.

The others are the same as in the 203rd embodiment.

The electric circuit device of this embodiment also provided highly reliable connections and a superior heat dissipation property. The device was highly reliable in various properties.

(Embodiment 205)

An electric circuit device of the 205th embodiment is obtained by placing an adjusting member between the semiconductor element and the cap in the electric circuit device of the 196th embodiment. After the placing of the adjusting member, the cap-sealing is conducted.

The 205th embodiment is the same as the 196th embodiment except the intervention of the adjusting member.

The electric circuit device of this embodiment also provided highly reliable connections and a superior heat dissipation property. The device was highly reliable in various properties.

(Embodiment 206)

An electric circuit device of the 206th embodiment is obtained by placing an adjusting member between the semiconductor element and the cap in the electric circuit device of the 197th embodiment. After the placing of the adjusting member, the cap-sealing is conducted.

The 206th embodiment is the same as the 197th embodiment except the intervention of the adjusting member.

The electric circuit device of this embodiment also provided highly reliable connections and a superior heat dissipation property. The device was highly reliable in various properties.

(Embodiment 207)

An electric circuit device of the 207th embodiment is obtained by placing an adjusting member between the semiconductor element and the cap in the electric circuit device of the 198th embodiment. After the placing of the adjusting member, the cap-sealing is conducted.

The 207th embodiemnt is the same as the 198th embodiment except the intervention of the adjusting member.

The electric circuit device of this embodiment also provided highly reliable connections and a superior heat dissipation property. The device was highly reliable in various properties.

According to the present invention, since the above-explained electrically connecting member connects between the first and the second electric circuit parts, the connecting portions of the electric circuit parts may be located at an inside area thereof and the number of the connecting portions may be increased, thus enabling high concentration of the connections.

The electrically connecting member may be made thinner, thus enabling reduction of thickness of the electric circuit member.

In addition, since an amount of the metal members used for the electrically connecting member is small, the total cost will be low even if expensive gold is used as the metal member.

The present invention as described has numerous advantages as follows:

1. Highly reliable connection may be obtained between a semiconductor element and a circuit element such as a circuit plate and a lead frame. The connection of the present invention may be used instead of a wire bonding method, a TAB method and a CCB method.

2. Since the connecting portion of the electric circuit parts may be located at any position, especially inside area, multiple connections more than the wire bonding method and the TAB method are allowed to suit for a multi-pin connection.

Further, since there is an insulating material between neigboring metals of the electrically connecting member, electric conduction is prohibited between the neighboring metals, which results in allowing more connections than those by the CCB method.

3. Since a very small amount of metal members is used in the electrically connecting member as compared with the conventional methods, the total cost is cheaper even if expensive metal such as gold is used for the metal members.

4. The present invention provides a highly concentrated semiconductor device and the like.

Moreover. since the electrically conductive members of the electrically connecting member are embedded in the holder, they are not affected by a sealing pressure, a sealing speed and other upon injection of the sealing material. For this, any sealing process is available in the present invention. Accordingly, the sealing can be effected not only by thermosetting resins for a constant pressure transfer, but also by thermoplastic resins which cannot have been used because of extremely high pressure injection.

In addition, according to the electric circuit device of the present invention with the cap-sealing, even when heat is generated in the electric circuit parts, the heat is dissipated to the outside through the electrically connecting member and the cap. Thus, the present invention provides an electric circuit device superior in heat dissipation.

Further, a space between the cap and the electric circuit part may effectively prevent reliability problems such as deterioration of property of the electric circuit part and cracks of the cap caused by thermal stress due to a heat expansion coefficient difference in case that the electirc circuit part is embedded in the sealing. The space is specifically effective when the difference of heat expansion coefficient is significant between the electric circuit part and the sealing.

If the cap is made of a metal such as iron or an iron alloy, noises from the outside and electromagnetic noises generated from the electric circuit parts may be effectively prevented, providing an electric circuit device superior in property.

An element for use in electrical connection comprises a holding member (125) having an insulator (111) and metallic powder dispersed in said insulator and a conductive member (107) laid in said holding member said conductive member has an end which is exposed on the surface of one side of said holding member and another end which is exposed on the surface of the other side of said holding member.

## Claims

1. An element for use in electrical connection comprising:

a holding member having an insulator and metallic powder and/or metallic fiber dispersed in said insulator; and

a conductive member laid in said holding member;

said conductive member having an end which is exposed on the surface of one side of said holding member and another end which is exposed on the surface of the other side of said holding member.

2. An element according to claim 1, wherein said metallic powder and/or metallic fiber comprises at least one selected from the group of Au, Cu, Ag, Al, Be, Ca, Mg, Mo, Ni, Si and W.

3. An element for use in electrical connection comprising:

a holding member having an insulator and metallic body laid in said insulator; and

a conductive member laid in said holding member;

said conductive member having an end which is exposed on the surface of one side of said holding member and another end which is exposed on the surface of the other side of said holding member.

4. An element according to claim 3, wherein said metallic body has plate-like, bar-like or ball-like shape.

5. An element according to claim 3 or 4, wherein said metallic body comprises at least one selected from the group of Au, Cu, Ag, Al, Be, Ca, Mg, Mo, Ni, Si, W, Fe, Sn, and Zn.

6. An element according to one of the claims 1 to 5, wherein said insulator comprises organic material.

7. An element according to claim 6, wherein said organic material comprises resin.

8. An element according to claim 7, wherein said resin comprises at least one selected from the group of thermosetting resin, thermoplastic resin and ultraviolet curing resin.

9. An element according to claim 7 or 8, wherein said resin comprises at least one selected from the resin group of polyimide, polyphenylenesulfide, polyethersulfone, polyetherimide, polysulfone, silicone resin, fluorine plastics, polycarbonate, polydiphenylether, polybenzylimidazole, phenol, ureas, melamine, alkyd resin, epocy resin, polyamide-imide resin, polypropylene, polyvinyl chloride, polystyrene, methacrylate methyl, polyphenylene oxide, methacrylic resins, vinylidene chloride.

10. An element for use in electrical connection comprising:

a holding member having an inorganic insulator; and

a conductive member laid in said holding member;

said conductive member having an end which is exposed on the surface of one side of said holding member and another end which is exposed on the surface of the other side of said holding member.

11. An element according to claim 10, wherein said inorganic insulator comprises at least one selected from the group of $SiO_2$, $B_2O_3$, $Al_2O_3$, $Na_2O$,

$K_2O$, $CaO$, $ZnO$, $BaO$, $PbO$, $Sb_2O_3$, $As_2O_3$, $La_2O_3$, $ZrO_2$, $BaO$, $P_2O_5$, $TiO_2$, $MgO$, $SiC$, $BeO$, $BP$, $BN$, $A1N$, $B_4C$, $TaC$, $TiB_2$, $CrB_2$, $TiN$, $Si_3N_4$ and $Ta_2O_5$.

12. An element according to one of the claims 1 to 11, wherein said conductive member comprises metallic material.

13. An element according to claim 12, wherein said metallic material comprises at least one selected from group of Au, Ag, Be, Ca, Mg, Mo, Ni, W, Fe, Ti, In, Ta and Zn.

14. An element according to one of the claims 1 to 13, wherein the exposed portion of said conductive member is formed as the same surface as the surface of said holding member.

15. An element according to one of the claims 1 to 13, wherein the exposed portion of said conductive member has protrusions protruded through the surface of said holding member.

16. An element according to claim 15, wherein said protrusions have bump-shape.

17. An element according to one of the claims 1 to 16, wherein said conductive member is arranged perpendicularly to the main surface of said holding member.

18. An element according to one of the claims 1 to 16, wherein said conductive member is arranged inclining from one main surface to another main surface of said holding member.

19. An electrical circuit element comprising:

a holding member;

a conductive member laid in said holding member, said conductive member having one end which is exposed on the surface of one side of said holding member and another end which is exposed on the surface of the other side of said holding member;

a first electrical circuit member having a first connection portion to which said one end of said conductive member is connected; and

a second electrical circuit member having a second connecting portion to which said another end of said conductive member is connected.

20. An electrical circuit device according to claim 19, comprising

a sealing element for sealing at least one of said first electrical circuit member and said second electrical circuit member by laying therein.

21. An electrical circuit device according to claim 20, further comprising a plate jointed on the surface of said sealing element.

22. An electrical circuit device according to claim 20 or 21, further comprising a plate jointed on the surface of said first and/or second electrical circuit members.

23. An electrical circuit device according to claim 20 or 21, further comprising a plate provided in the vicinity of said first and or second electrical circuit members.

24. An electrical circuit device according to claim 19, comprising

a cap for cap-sealing at least one of said first electrical circuit member and said second electrical circuit member.

25. An electrical circuit device according to claim 24, further comprising an adjusting member provided between said cap and said first electrical circuit member and between said cap and said second electrical circuit member.

26. An electrical circuit device according to claim 25, wherein said adjusting member comprises elastic material.

27. An electrical circuit device according to one of the claims 19 to 26, wherein said first connecting portion and said one end and/or said second connecting portion and said another end are connected by alloying.

28. An electrical circuit element according to one of the claims 19 to 27, wherein said first electrical circuit member and/or said second electrical circuit member is at least one selected from the group of the semiconductor device, the circuit board and the lead frame.

29. An electrical circuit element according to one of the claims 19 to 28, wherein said first connecting portion and said one end and/or said second connecting portion and said another end are formed by the same metal material.

30. An electrical circuit element according to one of the claims 19 to 28, wherein said first connecting portion and said one end and/or said second connecting portion and said another end are formed by different metal material.

## FIG. 1
## PRIOR ART

## FIG. 2
## PRIOR ART

## FIG. 3
## PRIOR ART

0 284 820

## FIG. 4
### PRIOR ART

## FIG. 5
### PRIOR ART

## FIG. 6
### PRIOR ART

FIG. 7
PRIOR ART

FIG. 8
PRIOR ART

FIG. 9A

FIG. 9B

## FIG. 10A

122
124
124

123
121

## FIG. 10B

121

125

123

## FIG. 10C

40μm

20μm

121

123

125

## FIG. 11A

## FIG. 11B

## FIG. 12

## FIG. 13

## FIG. 14A

## FIG. 14B

## FIG. 15A

## FIG. 15B

## FIG. 16A

## FIG. 16B

## FIG. 17A

## FIG. 17B

## FIG. 18A

## FIG. 18B

## FIG. 19A

COLUMN3
COLUMN2
COLUMN1
COLUMN0
COLUMN1
COLUMN2
COLUMN3

ROW 3
ROW 2
ROW 1
ROW 0
ROW 1
ROW 2
ROW 3

121  123
128
129
130
125

## FIG. 19B

121  123  128
129  125
130
123  123

## FIG. 20A

## FIG. 20B

## FIG. 20C

# FIG. 21A

COLUMN 3
COLUMN 2
COLUMN 1
COLUMN 0
COLUMN 1
COLUMN 2
COLUMN 3

121

123
128
129
130
125

ROW 3
ROW 2
ROW 1
ROW 0
ROW 1
ROW 2
ROW 3

# FIG. 21B

121   123   128   125
129
130

123   123

# FIG. 22A

102   102   102   102   101

111  108  111  108  111  108  111  108

125   107

107 109  107 109  109  107  156   109

105   105   105   105   104  105

# FIG. 22B

102   101

111
108
107

125

109

156

$d_{11}$

$P_{11}$

105   104

## FIG. 23A

## FIG. 23B

## FIG. 23C

# FIG. 24A

# FIG. 24B

## FIG. 25A

102 103 101
111 108
125 107
109
156
105 106 104

## FIG. 25B

102 111 102 107 107 102 103 101 102 111
102
107
125
107
105
105 105 105 106 105 104 156
$d_{11}$ 111 111 107
$P_{11}$

## FIG. 26A

## FIG. 26B

## FIG. 27A

## FIG. 27B

# FIG. 28A

125 → 156

101
102
103
111 115

105 106 104

# FIG. 28B

103 102 101 107 111

$P_{11}$
$d_{11}$

125 → 156

107 107 105 104 106

$d_{12}$
$P_{12}$

# FIG. 29A

COLUMN 3
COLUMN 2
COLUMN 1
COLUMN 0
COLUMN 1
COLUMN 2
COLUMN 3

121   123   155
128
129
130

ROW 3
ROW 2
ROW 1
ROW 0
ROW 1
ROW 2
ROW 3

125

# FIG. 29B

121   123   155
128
129
130

125

121   121

## FIG. 30A

## FIG. 30B

## FIG. 30C

## FIG. 31A

102    102    102    102    101

140    108    108    108    122    108

125    107

107  109  107  109  109  107    109

105    105    105    105    104    105

## FIG. 31B

102    101    122

108

125    107

109

$d_{11}$

$P_{11}$

105    140    104

## FIG. 32A

142 — 121
124 — 123
124 — 122

## FIG. 32B

123  121
125
122

## FIG. 32C

40 μm
20 μm — 121
122
125
123

## FIG. 33A

## FIG. 33B

## FIG. 34A

121   123

125

122

## FIG. 34B

$10\mu m$   $10\mu m$

126   123

125

121   122

## FIG. 35A

122   121

125

## FIG. 35B

150   150

122

125

123

## FIG. 36A

## FIG. 36B

## FIG. 37A

## FIG. 37B

## FIG. 38A

COLUMN 3
COLUMN 2
COLUMN 1
COLUMN 0
COLUMN 1
COLUMN 2
COLUMN 3

121   123   122
128
129
130

ROW 3
ROW 2
ROW 1
ROW 0
ROW 1
ROW 2
ROW 3

125

## FIG. 38B

121   123   122
128
129
130
125

## FIG. 39A

121

124

142

122

123

124

## FIG. 39B

121

122

125

123

## FIG. 39C

125

121

122

123

## FIG. 40A

1102   1102   1102   1102   1101

1111 1108 1111 1108 1111 1108 1111 1108

1125

1107

1107 1109 1107 1109 1109 1107   1109

1105   1105   1105   1105   1104 1105

## FIG. 40B

1102   1101

1111
1108
1107

1125

1109

$d_{111}$

1105   1104

$P_{111}$

## FIG. 41

1063

1101
1125

1104

1170

## FIG. 42A

1122
1124
1124
1123
1121

## FIG. 42B

1121
1125
1123

## FIG. 42C

40μm
20μm
1121
1123
1125

# FIG. 43A

1052　　1051

1054

1125

1005

1004

# FIG. 43B

1055　　1054 1052 1051　　1009

1170　　1054　　1005　　1004

## FIG. 44A

1004  1005  1054 /1125
1063
1001
1009

1170  1054  1052  1051

## FIG. 44B

1004  1005  1054  1125 /1063
1001
1009

1170  1054  1052  1051

## FIG. 45A

1063　1005'　1004'　　1001　　1009

1170　1005　1004　　1125

## FIG. 45B

1063　　1005'　1004'　　1001　　1009

1170　1005　1004　　1125

# FIG. 46A

1102  1103  1101

1125

1111  1108

1107

1109

1105  1106  1104

# FIG. 46B

1102  1111  1102  1107  1107  1102  1103  1101  1102  1111

1102

1125

1107

1105

1107

1105

$d_{111}$  1105  1105  1106  1105  1104

1111  1111  1107

$P_{111}$

# FIG. 47A

1121

1125

1111

# FIG. 47B

10 μm

10 μm

1126

1125

1121   1111

# FIG. 48A

1111   1150

1125

# FIG. 48B

1150   1125   1150

1111

## FIG. 49A

## FIG. 49B

# FIG. 50A

1102  1101  1103

1115

1105  1106  1104

# FIG. 50B

1103  1102  1101  1107

$d_{111}$  $P_{111}$

1107  1107 1105 1104 1106

$d_{112}$

$P_{112}$

## FIG. 51A

## FIG. 51B

## FIG. 52A

1121

1124

1142

1122

1124

1123

## FIG. 52B

1121

1122

1125

1123

## FIG. 52C

1121

1122

1125

1123

FIG. 53

1151
1063
1101
1125
1104
1170

FIG. 54A

1052
1051
1054
1125
1005
1004

FIG. 54B

1054
1052
1051
1009
1055
1170
1151
1054
1005
1004

# FIG. 55A

1151  1004  1005  1054  1125  1063  1001  1009

1170  1054  1052  1051

# FIG. 55B

1151  1004  1005  1054  1125  1063  1001  1009

1170  1054  1052  1051

## FIG. 56A

1151   1063   1005'  1004'   1001   1009

1170   1005   1004   1151   1125

## FIG. 56B

1063  1151   1005'  1004'   1001   1009

1170   1151   1005   1004   1125

## FIG. 57A

1005  1004
1107
1125  1111
1006  1001

## FIG. 57B

1152  1005  1004  1151
1063
1125
1001  1009
1107  1111  1006  1170

## FIG. 58

1151
1101
1125
1104
1063
1170

# FIG. 59A

1052    1051

1054

1125

1005

1004

# FIG. 59B

1055    1054  1052    1051    1009

1170   1151   1054   1005   1004

## FIG. 60A

1151  1004  1005  1054  1125  1063  1001  1009

1170  1054  1052  1051

## FIG. 60B

1151  1004  1005  1054  1125  1063  1001  1009

1170  1054  1052  1051

## FIG. 61A

1151  1063  1005'  1004'  1001  1009

1170  1005  1004  1151  1125

## FIG. 61B

1063  1151  1005'  1004'  1001  1009

1170  1151  1005  1004  1125

FIG. 62A

1005  1004

1107

1125  1111

1006  1001

FIG. 62B

1151  1152  1005  1004  1063

1125  1001  1009

1107  1111  1006  1170

FIG. 63

1151
1101  1063
1125

1104

1170

# FIG. 64A

1052 1051 1054 1125 1005 1004

# FIG. 64B

1055 1054 1052 1051 1009 1170 1151 1054 1005 1004

## FIG. 65A

1151  1004  1005  1054  1125  1063  1001  1009

1170  1054  1052  1051

## FIG. 65B

1151  1004  1005  1054  1125  1063  1001  1009

1170  1054  1052  1051

## FIG. 66A

1151　　1063　　1005′　1004′　　　　1001　　　1009

1170　1151　　1005　　1004　　　1125

## FIG. 66B

1063　1151　　1005′　1004′　1151　1001　　1009

1170　　　1005　　1004　　　　1125

FIG. 67A

1005   1004

1107

1125   1111

1006   1001

FIG. 67B

1152  1151  1005  1004

1063

1125   1001  1009

1107  1111  1006   1170

FIG. 68

1158   1155

1101
1125
1104

1158'   1155'

## FIG. 69A

1052   1051

1125   1054

1005

1004

## FIG. 69B

1055   1054 1052 1051   1009

1158 1155 1054 1005 1004

FIG. 70A

1155 1004 1004'
1158 1005 1054 1125
1001 1009
1158
1155 1054
1052 1051

FIG. 70B

1155 1004 1004'
1158 1005 1054 1125
1001 1009
1158
1155 1054
1052 1051

FIG. 71

1155 1005' 1004'
1001
1009
1158 1155 1005 1004 1125

FIG. 72A

FIG. 72B

FIG. 73

## FIG. 74A

## FIG. 74B

## FIG. 75

## FIG. 76

# FIG. 77A

1005   1004

1107

1125   1111

1006   1001

# FIG. 77B

1155   1156   1005   1004   1158

1125   1001   1009

1155'   1107   1111   1006   1158